# EUROPEAN PATENT APPLICATION

(11) **EP 4 808 320 A1**
(43) Date of publication of application: **16.09.2026**
(21) Application number: 26150267.8
(22) Date of filing: 05.01.2026
(51) Int. Cl.: H10K 50/12, H10K 85/30, H10K 85/60, H10K 101/20

(54) **LIGHT-EMITTING DEVICE AND ELECTRONIC APPARATUS INCLUDING THE SAME**

(30) Priority: 13.03.2025 KR 20250032935; 29.12.2025 KR 20250211869
(71) Applicant: Samsung Display Co., Ltd., Yongin-si, Gyeonggi-do 17113 (KR)
(72) Inventor: LEE, Sunghun, 16678 Gyeonggi-do (KR); KOISHIKAWA, Yasushi, 16678 Gyeonggi-do (KR); KIM, Jiheon, 16678 Gyeonggi-do (KR); SIM, Myungsun, 16678 Gyeonggi-do (KR); LEE, Minhan, 16678 Gyeonggi-do (KR); LEE, Yong Joo, 16678 Gyeonggi-do (KR); LEE, Hongsoo, 16678 Gyeonggi-do (KR); CHO, Oul, 16678 Gyeonggi-do (KR)
(74) Representative: Elkington and Fife LLP

(57) **Abstract**

Provided are a light-emitting device and an electronic apparatus including the same, the light-emitting device including a first electrode, a second electrode, and an interlayer arranged between the first electrode and the second electrode and including an emission layer, wherein the emission layer includes a host, a sensitizer, and a fluorescent emitter, the host includes a first host, the sensitizer includes a transition metal, the fluorescent emitter is metal-free, DT^{FE} is about 200 microseconds or more, and the light-emitting device satisfies at least one of Condition A or Condition B:
Condition A ${DF}^{SE + FE}$ is about 20 % or less
Condition B ${DF}^{SE + FE} / {DF}^{FE}$ is about 0.5 or less,
wherein, for descriptions of DT^{FE}, DF^{SE+FE}, DF^{FE}, Condition A, and Condition B, reference may be made to the present specification.

## Description

### FIELD OF THE INVENTION

The subject matter relates to a light-emitting device and an electronic apparatus including the same.

### BACKGROUND OF THE INVENTION

From among light-emitting devices, organic light-emitting devices OLEDs are self-emission devices, which have improved characteristics in terms of viewing angles, response time, luminance, driving voltage, and response speed. In addition, OLEDs can produce full-color images.

In an example, an organic light-emitting device includes an anode, a cathode, and an interlayer that is arranged between the anode and the cathode and includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. When the excitons transition from an excited state to a ground state, light is emitted.

### SUMMARY OF THE INVENTION

Provided are a light-emitting device having excellent luminescence efficiency characteristics and an electronic apparatus including the light-emitting device.

Additional aspects will be set forth in part in the detailed description that follows and, in part, will be apparent from the detailed description, or may be learned by practice of the presented exemplary embodiments.

According to an aspect, a light-emitting device includes:
a first electrode,
a second electrode, and
an interlayer arranged between the first electrode and the second electrode,
wherein the interlayer includes an emission layer,
wherein the emission layer includes a host, a sensitizer, and a fluorescent emitter,
the host includes a first host,
the sensitizer includes a transition metal,
the fluorescent emitter is metal-free,
DT^{FE} is about 200 microseconds (µs) or more,
the DT^{FE} is a decay time of a delayed fluorescence component from a time-resolved photoluminescence (TRPL) spectrum of a first film,
the first film is a two-component film including the first host and the fluorescent emitter, and
the light-emitting device satisfies at least one of Condition A or Condition B: ${DF}^{SE + FE}$ is 20 % or less ${DF}^{SE + FE} / {DF}^{FE}$ is 0.5 or less wherein, in Condition A and Condition B,
   DF^{SE+FE} is a proportion of a delayed fluorescence component to total luminescence components of the second film, as evaluated from a TRPL spectrum of a second film,
   the second film is a three-component film including the first host, the sensitizer, and the fluorescent emitter, and
   DF^{FE} is a proportion of a delayed fluorescence component to total luminescence components of the first film, as evaluated from a TRPL spectrum of the first film.

According to another aspect, an electronic apparatus includes the light-emitting device.

### BRIEF DESCRIPTION OF THE DRAWINGS

The above and other aspects, features, and advantages of certain exemplary embodiments will be more apparent from the following detailed description taken in conjunction with the accompanying drawings, in which:
FIG. 1 is a schematic view of a light-emitting device according to one or more embodiments;
FIG. 2 is a schematic view of a light-emitting device according to one or more embodiments;
FIG. 3 is a graph of photoluminescence (PL) intensity (arbitrary units, a.u.) versus wavelength (nanometers, nm) and shows, regarding Compound FE1, a photoluminescence spectrum in solution (see "PLS1") and a photoluminescence spectrum (see "PLT1") for T₁ energy level evaluation;
FIG. 4 is a graph of photoluminescence (PL) intensity (a.u.) versus time (milliseconds, msec) and shows a time-resolved photoluminescence (TRPL) spectrum of Film FE1;
FIG. 5 is a graph of photoluminescence (PL) intensity (a.u.) versus time (msec) and shows TRPL spectra for Film FE4 and Film FE5;
FIG. 6 is a graph of photoluminescence (PL) intensity (a.u.) versus time (msec) and shows TRPL spectra for Film FE1 and Film SE1_FE1;
FIG. 7 is a graph of photoluminescence (PL) intensity (a.u.) versus time (msec) and shows TRPL spectra for Film FE1 and Film SE2_FE1;
FIG. 8 is a graph of photoluminescence (PL) intensity (a.u.) versus time (msec) and shows TRPL spectra for Film FE1 and Film SE3_FE1;
FIG. 9 is a graph of photoluminescence (PL) intensity (a.u.) versus time (msec) and shows TRPL spectra for Film FE4 and Film SE1_FE4;
FIG. 10 is a graph of photoluminescence (PL) intensity (a.u.) versus time (msec) and shows TRPL spectra for Film FE5 and Film SE1_FE5; and
FIG. 11 is a graph of photoluminescence (PL) intensity (a.u.) versus time (msec) and shows TRPL spectra for Film FE8 and Film SE1_FE8.

### DETAILED DESCRIPTION OF THE EMBODIMENTS

Reference will now be made in further detail to embodiments, examples of which are illustrated in the accompanying drawings, wherein like reference numerals refer to like elements throughout the specification. In this regard, the present embodiments may have different forms and should not be construed as being limited to the detailed descriptions set forth herein. Accordingly, the embodiments are merely described in further detail below, and by referring to the figures, to explain certain aspects and features. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

An aspect provides a light-emitting device including a first electrode, a second electrode, and an interlayer arranged between the first electrode and the second electrode, wherein the interlayer includes an emission layer, and wherein the emission layer includes a host, a sensitizer, and a fluorescent emitter.

A host included in the emission layer of the interlayer may include only one compound, or may include two or more (e.g., two, three, or four or more) different hosts.

The host includes a first host. For example, the host may include only the first host, or may further include other hosts in addition to the first host. A description of the first host will be provided below.

A weight of the host included in the emission layer may be greater than the total weight of the sensitizer and the fluorescent emitter combined that are included in the same emission layer. For example, the amount of the host included in the emission layer may be about 60 weight percent (wt%) to about 99 wt%, about 70 wt% to about 97 wt%, or about 80 wt% to about 96 wt%, based on 100 wt% of the emission layer.

When the emission layer includes two different hosts, (i.e., when a different host is included in addition to the first host), a weight ratio between the two different hosts included in the emission layer may be about 10 : 90 to about 90 : 10, about 20 : 80 to about 80 : 20, about 30 : 70 to about 70 : 30, or about 40 : 60 to about 60 : 40. When the weight ratio within the ranges above is satisfied, the transfer of holes and electrons in the emission layer may be efficiently achieved.

In the emission layer, the host, the sensitizer, and the fluorescent emitter may be different from each other. For example, in the emission layer, the first host, the sensitizer, and the fluorescent emitter may be different from each other.

The sensitizer includes a transition metal. For example, the sensitizer may include iridium, platinum, palladium, rhodium, osmium, or a combination thereof.

In one or more embodiments, the sensitizer may include iridium or platinum.

In one or more embodiments, the sensitizer may be an iridium-containing organometallic compound or a platinum-containing organometallic compound.

The fluorescent emitter is metal-free.

A proportion of the fluorescent component emitted from the fluorescent emitter to total luminescent components emitted from the emission layer may be about 50 % or more. For example, the proportion of the fluorescent component emitted from the fluorescent emitter to total luminescent components emitted from the emission layer may be about 50 % to about 100 %, about 50 % to about 95 %, about 50 % to about 90 %, about 50 % to about 85 %, about 50 % to about 80 %, about 60 % to about 100 %, about 60 % to about 95 %, about 60 % to about 90 %, about 60 % to about 85 %, about 60 % to about 80 %, about 70 % to about 100 %, about 70 % to about 95 %, about 70 % to about 90 %, about 70 % to about 85 %, or about 70 % to about 80 %.

The fluorescent component emitted from the fluorescent emitter may be a luminescent component emitted as excitons of the fluorescent emitter transit from a singlet excited state to a ground state. Therefore, the emission layer may be a fluorescent emission layer. Such a fluorescent emission layer is obviously distinct from a phosphorescent emission layer that includes a phosphorescent emitter (e.g., an organometallic compound including a transition metal) and in which a proportion of a phosphorescent component emitted from the phosphorescent emitter to total luminescent components is 50 % or more.

The light-emitting device satisfies the condition that DT^{FE} is about 200 microseconds (µs) or more. The DT^{FE} is a decay time of a delayed fluorescence component from a time-resolved photoluminescence (TRPL) spectrum of a first film, wherein the first film is a two-component film including the first host and the fluorescent emitter. As used herein, the term "two-component film including the first host and the fluorescent emitter" may refer to a film consisting of the first host and the fluorescent emitter. In some aspects, it is to be understood that the two-component film including the first host and the fluorescent emitter does not further include the sensitizer. One or more embodiments of a method of evaluating the DT^{FE} may be referred to Evaluation Example 2.

For example, the DT^{FE} may be about 200 µs to about 2,000 µs, about 200 µs to about 1,500 µs, about 200 µs to about 1,000 µs, about 200 µs to about 650 µs, about 200 µs to about 550 µs, about 200 µs to about 520 µs, about 300 µs to about 2,000 µs, about 300 µs to about 1,500 µs, about 300 µs to about 1,000 µs, about 300 µs to about 650 µs, about 300 µs to about 550 µs, about 300 µs to about 520 µs, about 350 µs to about 2,000 µs, about 350 µs to about 1,500 µs, about 350 µs to about 1,000 µs, about 350 µs to about 650 µs, about 350 µs to about 550 µs, about 350 µs to about 520 µs, about 360 µs to about 520 µs, about 300 µs to about 700 µs, or about 360 µs to about 650 µs.

The light-emitting device satisfies at least one of Condition A or Condition B: ${DF}^{SE + FE} is about 20 % or less$ ${DF}^{SE + FE} {/ DF}^{FE} is about 0.5 or less ,$ wherein, in Condition A and Condition B,
DF^{SE+FE} is a proportion of a delayed fluorescence component to total luminescence components of a second film, as evaluated from a TRPL spectrum of the second film,
the second film is a three-component film including the first host, the sensitizer, and the fluorescent emitter, and
DF^{FE} is a proportion of a delayed fluorescence component to the total luminescence components of the first film, as evaluated from a TRPL spectrum of the first film.

As used herein, the "three-component film including the first host, the sensitizer, and the fluorescent emitter" may refer to a film consisting of the first host, the sensitizer, and the fluorescent emitter.

In one or more embodiments, the light-emitting device may satisfy Condition A.

For example, the DF^{SE+FE} of the light-emitting device satisfying Condition A may be about 0 % to about 20 %, about 1 % to about 18 %, about 0 % to about 16 %, about 0 % to about 14 %, about 0 % to about 12 %, about 0 % to about 10.53 %, about 0.1 % to about 20 %, about 0.1 % to about 18 %, about 0.1 % to about 16 %, about 0.1 % to about 14 %, about 0.1 % to about 12 %, about 0.1 % to about 10.53 %, about 1 % to about 20 %, about 1 % to about 18 %, about 1 % to about 16 %, about 1 % to about 14 %, about 1 % to about 12 %, about 1 % to about 10.53 %, about 2 % to about 20 %, about 2 % to about 18 %, about 2 % to about 16 %, about 2 % to about 14 %, about 2 % to about 12 %, about 2 % to about 10.53 %, about 2.06 % to about 20 %, about 2.06 % to about 18 %, about 2.06 % to about 16 %, about 2.06 % to about 14 %, about 2.06 % to about 12 %, or about 2.06 % to about 10.53 %.

In one or more embodiments, the light-emitting device may satisfy Condition B.

For example, the DF^{SE+FE} / DF^{FE} of the light-emitting device satisfying Condition B may be about 0 to about 0.5, about 0 to about 0.3, about 0 to about 0.25, about 0 to about 0.18, about 0.01 to about 0.5, about 0.01 to about 0.3, about 0.01 to about 0.25, about 0.01 to about 0.18, about 0.05 to about 0.5, about 0.05 to about 0.3, about 0.05 to about 0.25, about 0.05 to about 0.18, or about 0.03 to about 0.3.

In one or more embodiments, the light-emitting device may satisfy both Condition A and Condition B.

In the emission layer, singlet excitons formed in the host with a ratio of 25 % may be transferred to the sensitizer through Förster energy transfer, and triplet excitons formed in the host with a ratio of 75 % may transition to a singlet excited state and a triplet excited state of the sensitizer. Singlet excitons of the sensitizer may be transferred to a triplet excited state via intersystem crossing, and most of the triplet excitons of the sensitizer may transition to a singlet excited state of the fluorescent emitter through Förster energy transfer. Accordingly, singlet excitons and triplet excitons generated in the emission layer may transition to a singlet excited state of the fluorescent emitter. Here, if the transition from the singlet excited state to a triplet excited state of the fluorescent emitter is substantially prevented, all of the singlet excited states of the fluorescent emitter may undergo radiative transition to the ground state, thereby causing the emission of fluorescence with high luminescence efficiency, i.e., hyper-fluorescence.

When the emission layer of the light-emitting device i) has the DT^{FE} of about 200 µs or more and ii) satisfies at least one of Condition A or Condition B, the intersystem crossing from the singlet excited state to the triplet excited state of the fluorescent emitter in the emission layer is substantially prevented, and thus short luminescence transition times may be achieved by singlet emission of the fluorescent emitter in the emission layer. Accordingly, i) the luminescence transition rate constant in the fluorescent emitter is greater than the intersystem crossing (ISC) rate constant, such that the decay time of the emission layer of the light-emitting device may be reduced, thereby minimizing bimolecular annihilation, such as triplet-triplet annihilation (TTA) and triplet-polaron quenching (TPQ), in the emission layer, and ii) a rate limiting step of the transition of excitons in the emission layer may be regarded as a rate of energy transfer from the sensitizer to the fluorescent emitter. As a result, the light-emitting device may not only have high luminescence efficiency and a long lifespan (e.g., high efficiency and long lifespan at high luminance), but also maintain the high luminescence efficiency even over a relatively wide luminance range and/or a relatively wide current density range. In addition, the decay time of the emission layer is relatively short, which reduces the population of triplet excitons in the emission layer, and thus the light-emitting device may have a further improved lifespan. Therefore, by using the light-emitting device, a high-quality electronic apparatus may be manufactured.

In one or more embodiments, the light-emitting device may additionally satisfy the condition that (S1^{FE} - T1^{FE}) may be about 0.8 eV or less. The S1^{FE} is a lowest excited singlet energy level (eV) of the fluorescent emitter, the T1^{FE} is a lowest excited triplet energy level (eV) of the fluorescent emitter, and the S1^{FE} and the T1^{FE} are evaluated from a photoluminescence (PL) spectrum of the fluorescent emitter, e.g., a photoluminescence spectrum in solution of the fluorescent emitter. One or more embodiments of a method of evaluating the S1^{FE} and the T1^{FE} may be referred to Evaluation Example 1.

In one or more embodiments, the S1^{FE} - T1^{FE} may be about 0.4 eV or less. For example, the S1^{FE} - T1^{FE} may be about 0.001 eV to about 0.4 eV, about 0.01 eV to about 0.4 eV, about 0.05 eV to about 0.4 eV, about 0.1 eV to about 0.4 eV, about 0.11 eV to about 0.4 eV, about 0.001 eV to about 0.3 eV, about 0.01 eV to about 0.3 eV, about 0.05 eV to about 0.3 eV, about 0.1 eV to about 0.3 eV, about 0.11 eV to about 0.3 eV, about 0.001 eV to about 0.24 eV, about 0.01 eV to about 0.24 eV, about 0.05 eV to about 0.24 eV, about 0.1 eV to about 0.24 eV, about 0.11 eV to about 0.24 eV, about 0.001 eV to about 0.2 eV, about 0.01 eV to about 0.2 eV, about 0.05 eV to about 0.2 eV, about 0.1 eV to about 0.2 eV, about 0.11 eV to about 0.2 eV, about 0.001 eV to about 0.14 eV, about 0.01 eV to about 0.14 eV, about 0.05 eV to about 0.14 eV, about 0.1 eV to about 0.14 eV, about 0.11 eV to about 0.14 eV, or about 0.11 eV to about 0.24 eV.

In one or more embodiments, the S1^{FE} - T1^{FE} may be greater than about 0.4 eV and less than or equal to about 0.8 eV (or, greater than about 0.4 eV but not more than about 0.8 eV). For example, the S1^{FE} - T1^{FE} may be about 0.41 eV to about 0.8 eV, about 0.43 eV to about 0.8 eV, about 0.45 eV to about 0.8 eV, about 0.41 eV to about 0.7 eV, about 0.43 eV to about 0.7 eV, about 0.45 eV to about 0.7 eV, about 0.41 eV to about 0.62 eV, about 0.43 eV to about 0.62 eV, or about 0.45 eV to about 0.62 eV.

In one or more embodiments, the S1^{FE} may be about 2.0 eV to about 3.0 eV, about 2.2 eV to about 3.0 eV, about 2.38 eV to about 3.0 eV, about 2.0 eV to about 2.6 eV, about 2.2 eV to about 2.6 eV, about 2.38 eV to about 2.6 eV, about 2.0 eV to about 2.46 eV, about 2.2 eV to about 2.46 eV, or about 2.38 eV to about 2.46 eV.

In one or more embodiments, the T1^{FE} may be about 1.3 eV to about 3.0 eV, about 1.5 eV to about 3.0 eV, about 1.81 eV to about 3.0 eV, about 1.3 eV to about 2.5 eV, about 1.5 eV to about 2.5 eV, about 1.81 eV to about 2.5 eV, about 1.3 eV to about 2.33 eV, about 1.5 eV to about 2.33 eV, or about 1.81 eV to about 2.33 eV.

In one or more embodiments, the first host, the sensitizer, and the fluorescent emitter in the light-emitting device may satisfy S1^{HOST} > T1^{SE} > S1^{FE}. The S1^{HOST} is a lowest excited singlet energy level of the first host, the T1^{SE} is a lowest excited triplet energy level of the sensitizer, the S1^{HOST} is evaluated from a photoluminescence spectrum of the first host, and the T1^{SE} is evaluated from a photoluminescence spectrum of the sensitizer, and methods of evaluating the S1^{HOST} and the T1^{SE} may be referred to, for example, Table 1.

In one or more embodiments, the sensitizer and the fluorescent emitter in the light-emitting device may satisfy T1^{SE} > T1^{FE}. The T1^{SE} is a lowest excited triplet energy level of the sensitizer and is evaluated from a photoluminescence spectrum of the sensitizer, and a method of evaluating the T1^{SE} may be referred to, for example, Table 1.

In one or more embodiments, the first host and the fluorescent emitter in the light-emitting device may satisfy T1^{HOST} > T1^{FE}. The T1^{HOST} is a lowest excited triplet energy level of the first host and is evaluated from a photoluminescence spectrum of the first host.

When the energy relationship as described above is satisfied, the transfer of excitons from the first host and/or the sensitizer to the fluorescent emitter may be effectively achieved. In addition, phosphorescence from the sensitizer and fluorescence from the fluorescent emitter may be emitted simultaneously from the emission layer.

In the light-emitting device, PLₘₐₓ^{FE} of the fluorescent emitter may be about 500 nm to about 550 nm, about 510 nm to about 550 nm, about 520 nm to about 550 nm, about 525 nm to about 550 nm, about 500 nm to about 540 nm, about 510 nm to about 540 nm, about 520 nm to about 540 nm, or about 525 nm to about 540 nm, and FWHM^{FE} of the fluorescent emitter may be about 5 nm to about 50 nm, about 5 nm to about 40 nm, about 5 nm to about 35 nm, about 5 nm to about 30 nm, about 5 nm to about 25 nm, about 15 nm to about 50 nm, about 15 nm to about 40 nm, about 15 nm to about 35 nm, about 15 nm to about 30 nm, about 15 nm to about 25 nm, about 20 nm to about 50 nm, about 20 nm to about 40 nm, about 20 nm to about 35 nm, about 20 nm to about 30 nm, or about 20 nm to about 25 nm. The PLₘₐₓ^{FE} is a peak wavelength of a peak having a maximum emission intensity in a photoluminescence (PL) spectrum of the fluorescent emitter, and the FWHM^{FE} is a full width at half maximum (FWHM) of a peak having a maximum emission intensity in a photoluminescence (PL) spectrum of the fluorescent emitter.

The light-emitting device may emit a red light, a yellow-green light, a green light, a blue-green light, or a blue light. For example, the light-emitting device may emit a green light.

In one or more embodiments, the light-emitting device may not emit white light. Description of host

The first host included in the host of the emission layer may be a hole-transporting compound.

In one or more embodiments, the host may include only the first host which is a hole-transporting compound.

In one or more embodiments, the host may further include, in addition to the first host, a second host, wherein the second host may be an electron-transporting compound, a bipolar compound, or a combination thereof. For example, the second host may be an electron-transporting compound.

None of the first host or the second host may include a transition metal.

In one or more embodiments, the hole-transporting compound may be a compound including at least one π electron-rich C₃-C₆₀ cyclic group and not including an electron-transporting group. Examples of the electron-transporting group may include a cyano group, a fluoro group, a π-electron deficient nitrogen-containing cyclic group, a phosphine oxide group, a sulfoxide group, or the like, or a combination thereof.

The term "π-electron deficient nitrogen-containing cyclic group" as used herein may refer to a C₁-C₆₀ heterocyclic group including at least one *-N=*' moiety as a ring-forming moiety. Examples of the π-electron deficient nitrogen-containing cyclic group may include a triazine group, an imidazole group, or the like, or a combination thereof.

The term "π electron-rich C₃-C₆₀ cyclic group" as used herein may refer to a C₃-C₆₀ cyclic group not including *-N=*' moiety as a ring-forming moiety. Examples of the π electron-rich C₃-C₆₀ cyclic group may include a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrobenzothiophene group, a naphthocarbazole group, a dinaphthofuran group, a dinaphthothiophene group, a dibenzocarbazole group, or the like, or a combination thereof.

For example, the hole-transporting compound may include two or more carbazole groups.

In one or more embodiments, the electron-transporting compound may be a compound including at least one electron-transporting group. Examples of the electron-transporting group may include a cyano group, a fluoro group, a π electron deficient nitrogen-containing C₁-C₆₀ cyclic group, a phosphine oxide group, a sulfoxide group, or the like, or a combination thereof. In one or more embodiments, the electron-transporting compound may include a triazine group.

For example, the electron-transporting compound may include at least one electron-transporting group (e.g., a triazine group or the like) and at least one π electron-rich C₃-C₆₀ cyclic group (e.g., a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrobenzothiophene group, a naphthocarbazole group, a dinaphthofuran group, a dinaphthothiophene group, a dibenzocarbazole group, or the like, or a combination thereof).

In one or more embodiments, the hole-transporting compound may be a compound represented by Formula 6: 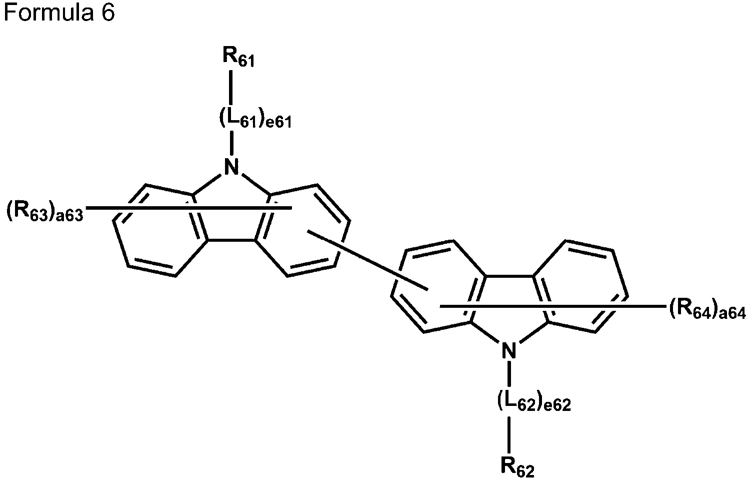 wherein, in Formula 6,
L₆₁ and L₆₂ may each independently be a π electron-rich C₃-C₆₀ cyclic group unsubstituted or substituted with deuterium, a C₁-C₂₀ alkyl group, a deuterated C₁-C₂₀ alkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, -Si(Q₃₃)(Q₃₄)(Q₃₅), or a combination thereof,
e61 and e62 may each independently be an integer from 1 to 6,
R₆₁ to R₆₄ may each independently be:
   hydrogen, deuterium, a C₁-C₂₀ alkyl group, or a deuterated C₁-C₂₀ alkyl group;
   a π electron-rich C₃-C₆₀ cyclic group unsubstituted or substituted with deuterium, a C₁-C₂₀ alkyl group, a deuterated C₁-C₂₀ alkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, - Si(Q₃₃)(Q₃₄)(Q₃₅), or a combination thereof; or
   -Si(Q₃)(Q₄)(Q₅), and
   a63 and a64 may each independently be an integer from 0 to 7.
Q₃ to Q₅ and Q₃₃ to Q₃₅ may each be the same as described herein.

In one or more embodiments, the hole-transporting compound may be a compound represented by one of Formulae 6-1, 6-2, or 6-3: 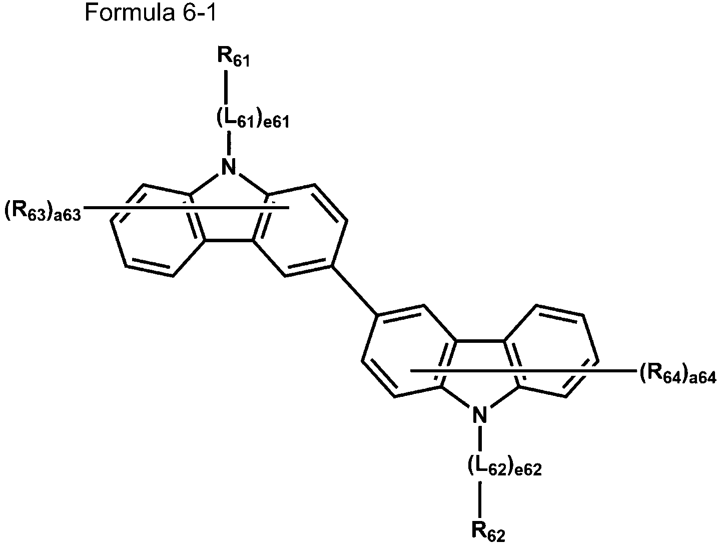 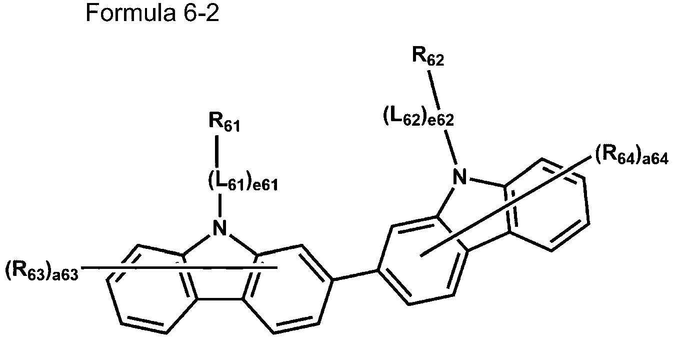 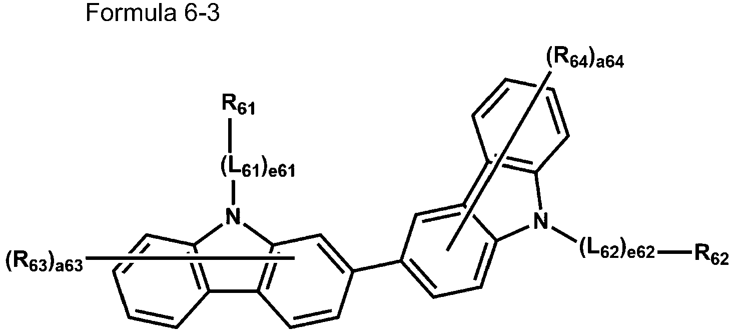 wherein, in Formulae 6-1 to 6-3, L₆₁, L₆₂, R₆₁ to R₆₄, e61, e62, a63, and a64 may each be the same as described herein.

In one or more embodiments, the hole transport compound may be one of Compounds HTH1 to HTH7:

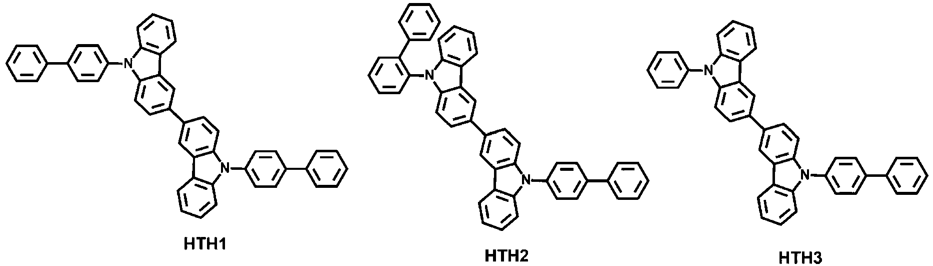

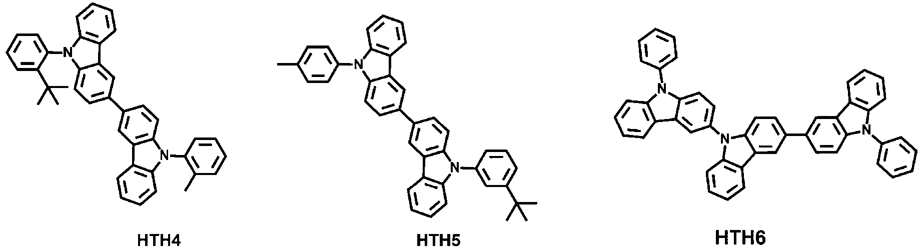

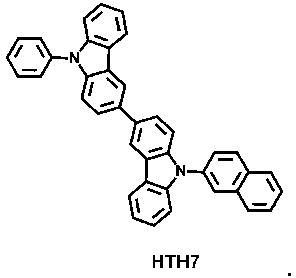

In one or more embodiments, the electron-transporting compound may be a compound represented by Formula 7: 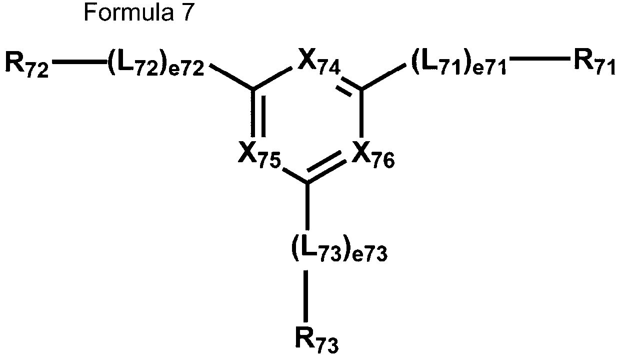 wherein, in Formula 7,
X₇₄ may be C(R₇₄) or N, X₇₅ may be C(R₇₅) or N, X₇₆ may be C(R₇₆) or N, and at least one of X₇₄ to X₇₆ may be N,
L₇₁ to L₇₃ may each independently be a C₅-C₃₀ carbocyclic group or a C₁-C₃₀ heterocyclic group, each unsubstituted or substituted with deuterium, - F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated phenyl group, a (C₁-C₂₀ alkyl)biphenyl group, -Si(Q₃₃)(Q₃₄)(Q₃₅), or a combination thereof,
e71 to e73 may each independently be an integer from 1 to 10,
R₇₁ to R₇₆ may each independently be:
   hydrogen, deuterium, -F, or a cyano group;
   a C₁-C₂₀ alkyl group that is unsubstituted or substituted with deuterium, -F, a cyano group, or a combination thereof;
   a C₅-C₃₀ carbocyclic group or a C₁-C₃₀ heterocyclic group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated phenyl group, a (C₁-C₂₀ alkyl)biphenyl group, -Si(Q₃₃)(Q₃₄)(Q₃₅), or a combination thereof; or
   -Si(Q₃)(Q₄)(Q₅).
Q₃ to Q₅ and Q₃₃ to Q₃₅ may each be the same as described herein.

In one or more embodiments, each of X₇₄ to X₇₆ in Formula 7 may be N.

In one or more embodiments, L₇₁ to L₇₃ in Formula 7 may each independently be a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrobenzothiophene group, a naphthocarbazole group, a dinaphthofuran group, a dinaphthothiophene group, or a dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated phenyl group, a (C₁-C₂₀ alkyl)biphenyl group, -Si(Q₃₃)(Q₃₄)(Q₃₅), or a combination thereof.

In one or more embodiments, in Formula 7, at least one of L₇₁ in the number of e71, at least one of L₇₂ in the number of e72, at least one of L₇₃ in the number of e73, or a combination thereof may each independently be a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrobenzothiophene group, a naphthocarbazole group, a dinaphthofuran group, a dinaphthothiophene group, or a dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated phenyl group, a (C₁-C₂₀ alkyl)biphenyl group, -Si(Q₃₃)(Q₃₄)(Q₃₅), or a combination thereof.

In one or more embodiments, in Formula 7, at least one of L₇₁ in the number of e71, at least one of L₇₂ in the number of e72, at least one of L₇₃ in the number of e73, or a combination thereof may each independently include a carbazole group, an indolocarbazole group, a benzocarbazole group, a naphthocarbazole group, or a dibenzocarbazole group, wherein a nitrogen atom of a pyrrole group in the carbazole group, the indolocarbazole group, the benzocarbazole group, the naphthocarbazole group, or the dibenzocarbazole group may be linked to a carbon atom of a 6-membered ring including X₇₄ to X₇₆ in Formula 7, via a single bond or neighboring L₇₁, L₇₂, and/or L₇₃.

In one or more embodiments, in Formula 7, e71 to e73 indicate the numbers of L₇₁ to L₇₃, respectively, and may each independently be 1, 2, 3, 4, or 5.

In one or more embodiments, R₇₁ to R₇₆ in Formula 7 may each independently be:
hydrogen, deuterium, -F, or a cyano group;
a C₁-C₂₀ alkyl group that is unsubstituted or substituted with deuterium, -F, a cyano group, or a combination thereof;
a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrobenzothiophene group, a naphthocarbazole group, a dinaphthofuran group, a dinaphthothiophene group, or a dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated phenyl group, a (C₁-C₂₀ alkyl)biphenyl group, -Si(Q₃₃)(Q₃₄)(Q₃₅), or a combination thereof; or
-Si(Q₃)(Q₄)(Q₅).

In one or more embodiments, the electron transport compound may be one of Compounds ETH1 to ETH9:

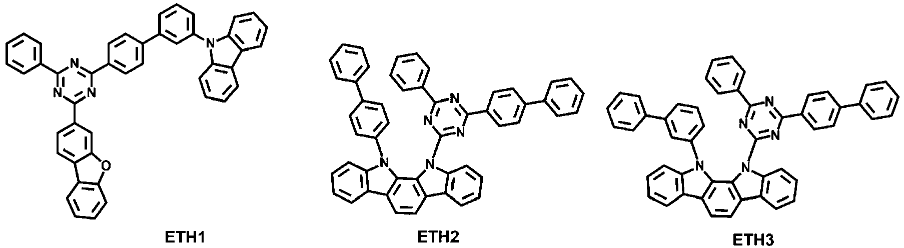

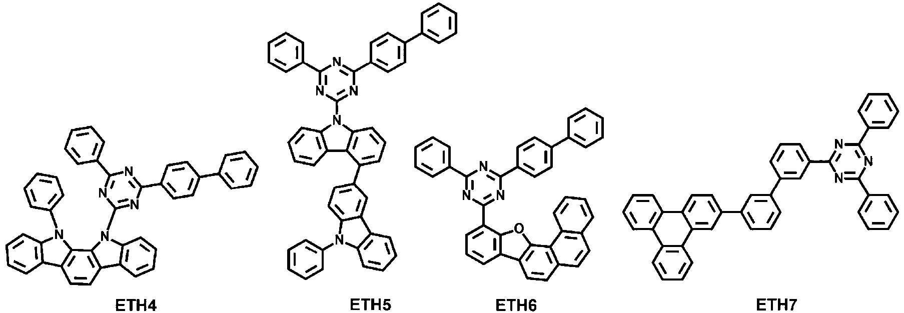

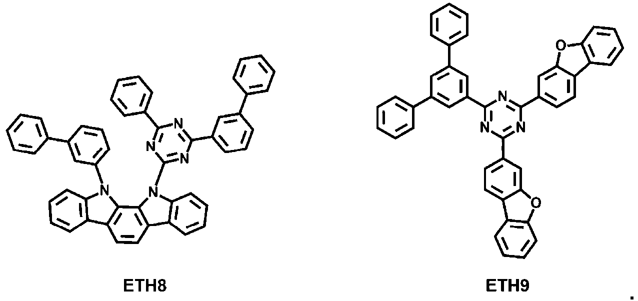

### Description of sensitizer

The sensitizer includes a transition metal. The sensitizer may be electrically neutral.

For example, the sensitizer may include iridium or platinum.

For example, the sensitizer may include platinum.

For example, the sensitizer may include a platinum-containing organometallic compound, wherein the platinum-containing organometallic compound may include platinum and a tetradentate ligand bonded to the platinum.

In one or more embodiments, at least one of the chemical bonds between the platinum and the tetradentate ligand may be a platinum-carbon chemical bond (e.g., a coordinate bond or a covalent bond).

In one or more embodiments, at least one of the chemical bonds between the platinum and the tetradentate ligand may be a platinum-carbon coordinate bond. That is, the platinum-containing organometallic compound may be a carbene-containing organometallic compound.

In one or more embodiments, at least one of the chemical bonds between the platinum and the tetradentate ligand may be a platinum-carbon covalent bond.

In one or more embodiments, at least one of the chemical bonds between the platinum and the tetradentate ligand may be a platinum-carbon chemical bond, and a different chemical bond may be a platinum-oxygen chemical bond.

In one or more embodiments, the platinum-containing organometallic compound may include a) a chemical bond (e.g., a covalent bond) between a carbon atom of the tetradentate ligand the and the platinum, b) a chemical bond (e.g., a covalent bond) between an oxygen atom (O) of the tetradentate ligand and the platinum, and c) a chemical bond (e.g., a coordinate bond) between a nitrogen atom of the tetradentate ligand and the platinum.

In one or more embodiments, the platinum-containing organometallic compound may include a) a chemical bond (e.g., a covalent bond) between a carbon atom of the tetradentate ligand and the platinum, b) a chemical bond (e.g., a covalent bond) between a sulfur atom (S) of the tetradentate ligand and the platinum, and c) a chemical bond (e.g., a coordinate bond) between a nitrogen atom of the tetradentate ligand and the platinum.

In one or more embodiments, the tetradentate ligand may include a benzimidazole group. For example, the number of benzimidazole groups in the tetradentate ligand may be 1.

In one or more embodiments, the sensitizer may include iridium.

For example, the sensitizer may include an iridium-containing organometallic compound including: iridium; and a first ligand, a second ligand, and a third ligand, each bonded to the iridium.

For example, each of the first ligand, the second ligand, and the third ligand may be a bidentate ligand bonded to the iridium of the iridium-containing organometallic compound via a nitrogen atom and a carbon atom, wherein a) the first ligand, the second ligand, and the third ligand may be identical to each other, b) the first ligand and the second ligand may be identical to each other, and the second ligand and the third ligand may be different from each other, c) the first ligand and the second ligand may be different from each other, and the second ligand and the third ligand may be identical to each other, or d) the first ligand, the second ligand, and the third ligand may be different from each other.

In one or more embodiments, the iridium-containing organometallic compound (e.g., the first ligand, the second ligand, the third ligand, or a combination thereof in the iridium-containing organometallic compound) may include a benzofuran group, a benzothiophene group, a benzoselenophene group, a benzosilole group, a benzogermole group, a dibenzofuran group, a dibenzothiophene group, a dibenzoselenophene group, a dibenzosilole group, a dibenzogermole group, a naphthobenzofuran group, a naphthobenzothiophene group, a naphthobenzoselenophene group, a naphthobenzosilole group, a naphthobenzogermole group, a phenanthrobenzofuran group, a phenanthrobenzothiophene group, a phenanthrobenzoselenophene group, a phenanthrobenzosilole group, a phenanthrobenzogermole group, an azabenzofuran group, an azabenzothiophene group, an azabenzoselenophene group, an azabenzosilole group, an azabenzogermole group, an azadibenzofuran group, an azadibenzothiophene group, an azadibenzoselenophene group, an azadibenzosilole group, an azadibenzogermole group, an azanaphthobenzofuran group, an azanaphthobenzothiophene group, an azanaphthobenzoselenophene group, an azanaphthobenzosilole group, an azanaphthobenzogermole group, an azaphenanthrobenzofuran group, an azaphenanthrobenzothiophene group, an azaphenanthrobenzoselenophene group, an azaphenanthrobenzosilole group, or an azaphenanthrobenzogermole group, each bonded to the iridium via a carbon atom.

In one or more embodiments, the iridium-containing organometallic compound (e.g., the first ligand, the second ligand, the third ligand, or a combination thereof in the iridium-containing organometallic compound) may include a benzofuran group, a benzothiophene group, a dibenzofuran group, a dibenzothiophene group, a naphthobenzofuran group, a naphthobenzothiophene group, a phenanthrobenzofuran group, a phenanthrobenzothiophene group, an azabenzofuran group, an azabenzothiophene group, an azadibenzofuran group, an azadibenzothiophene group, an azanaphthobenzofuran group, an azanaphthobenzothiophene group, an azaphenanthrobenzofuran group, or an azaphenanthrobenzothiophene group, each bonded to the iridium via a carbon atom.

In one or more embodiments, the iridium-containing organometallic compound (e.g., the first ligand, the second ligand, the third ligand, or a combination thereof in the iridium-containing organometallic compound) may include a benzimidazole group, a benzoxazole group, a benzthiazole group, a naphthoimidazole group, a naphthoxazole group, a naphthothiazole group, a phenanthroimidazole group, a phenanthrooxazole group, a phenanthrothiazole group, a pyridoimidazole group, a pyridooxazole group, a pyridothiazole group, a pyridine group, a pyrimidine group, a pyrazine group, a pyridazine group, a quinoline group, or isoquinoline group, each bonded to the iridium via a nitrogen atom.

In one or more embodiments, the iridium-containing organometallic compound (e.g., the first ligand, the second ligand, the third ligand, or a combination thereof in the iridium-containing organometallic compound) may include a benzimidazole group, a naphthoimidazole group, a phenanthroimidazole group, or a pyridine group, each bonded to the iridium via a nitrogen atom.

In one or more embodiments, the iridium-containing organometallic compound may include ring A₃ bonded to the iridium via a nitrogen atom and ring A₄ bonded to the iridium via a carbon atom, wherein ring A₃ and ring A₄ may be linked to each other via a single bond, ring A₃ may include a benzimidazole group, a benzoxazole group, a benzthiazole group, a naphthoimidazole group, a naphthoxazole group, a naphthothiazole group, a phenanthroimidazole group, a phenanthrooxazole group, a phenanthrothiazole group, a pyridoimidazole group, a pyridooxazole group, a pyridothiazole group, a pyridine group, a pyrimidine group, a pyrazine group, a pyridazine group, a quinoline group, an isoquinoline group, a furopyridine group, a benzofuropyridine group, a thienopyridine group, or a benzothienopyridine group, and ring A₄ may include a benzofuran group, a benzothiophene group, a dibenzofuran group, dibenzothiophene group, a naphthobenzofuran group, a naphthobenzothiophene group, a phenanthrobenzofuran group, a phenanthrobenzothiophene group, an azadibenzofuran group, an azadibenzothiophene group, an azanaphthobenzofuran group, an azanaphthobenzothiophene group, an azaphenanthrobenzofuran group, or an azaphenanthrobenzothiophene group.

In one or more embodiments, each of the first ligand and the second ligand may be a bidentate ligand bonded to the iridium of the iridium-containing organometallic compound via a nitrogen atom and a carbon atom, and the third ligand may be a bidentate ligand bonded to the iridium of the iridium-containing organometallic compound via two oxygen atoms, wherein the first ligand and the second ligand may be identical to or different from each other.

In one or more embodiments, the iridium-containing organometallic compound (e.g., the first ligand, the second ligand, or a combination thereof in the iridium-containing organometallic compound) may include a quinoline group, an isoquinoline group, a benzoquinoline group, a benzoisoquinoline group, a naphthoquinoline group, a naphthoisoquinoline group, a thienopyridine group, a benzothienopyridine group, a thienopyrimidine group, a benzothienopyrimidine group, a furopyridine) group, a benzofuropyridine group, a furopyrimidine group, or a benzofuropyrimidine group, each bonded to the iridium via a nitrogen atom.

In one or more embodiments, the iridium-containing organometallic compound may include ring A₅ bonded to the iridium via a nitrogen atom and ring A₆ bonded to the iridium via a carbon atom, wherein ring A₅ and ring A₆ may be linked to each other via a single bond, ring A₅ may include a quinoline group, an isoquinoline group, a benzoquinoline group, a benzoisoquinoline group, a naphthoquinoline group, a naphthoisoquinoline group, a thienopyridine group, a benzothienopyridine group, a thienopyrimidine group, a benzothienopyrimidine group, a furopyridine group, a benzofuropyridine group, a furopyrimidine group, or a benzofuropyrimidine group, and ring A₆ may include a benzene group, a naphthalene group, a benzofuran group, a benzothiophene group, a dibenzofuran group, a dibenzothiophene group, a carbazole group, or a fluorene group.

In one or more embodiments, the platinum-containing organometallic compound may be an organometallic compound represented by Formula 1, and the iridium-containing organometallic compound may be an organometallic compound represented by Formula 2A, an organometallic compound represented by Formula 2B, an organometallic compound represented by Formula 2C1, an organometallic compound represented by Formula 2C2, or an organometallic compound represented by Formula 2D:

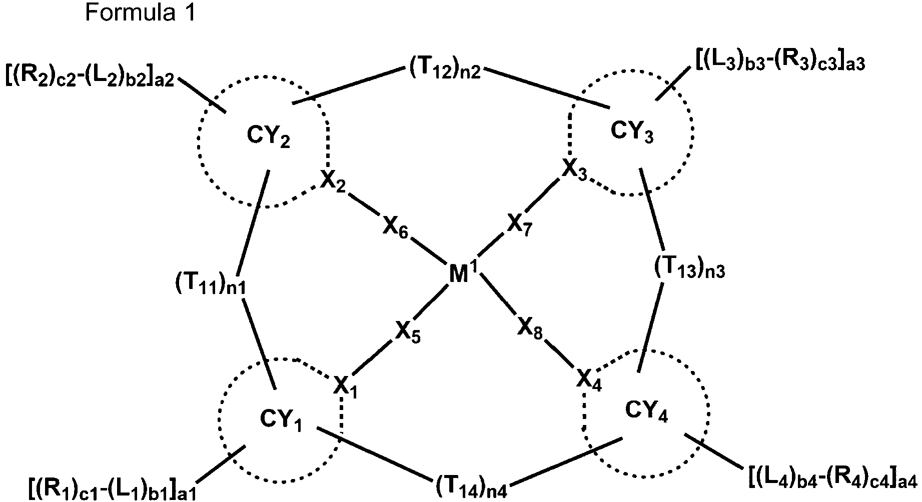

Formula 2A M²(L₁₁)₂(L₁₂)

Formula 2B M²(L₁₁)(L₁₂)₂

Formula 2C1 M²(L₁₁)₃

Formula 2C2 M²(L₁₂)₃

Formula 2D M²(L₁₃)₂(L₁₄)

wherein M¹ in Formula 1 is platinum (Pt), and M² in Formulae 2A, 2B, 2C1, 2C2 and 2D is iridium (Ir).
L₁₁ in Formulae 2A, 2B and 2C1 may be a ligand represented by Formula 2-1, L₁₂ in Formulae 2A, 2B and 2C2 may be a ligand represented by Formula 2-2, L₁₃ in Formula 2D may be a ligand represented by Formula 2-3, and L₁₄ in Formula 2D may be a ligand represented by Formula 2-4: 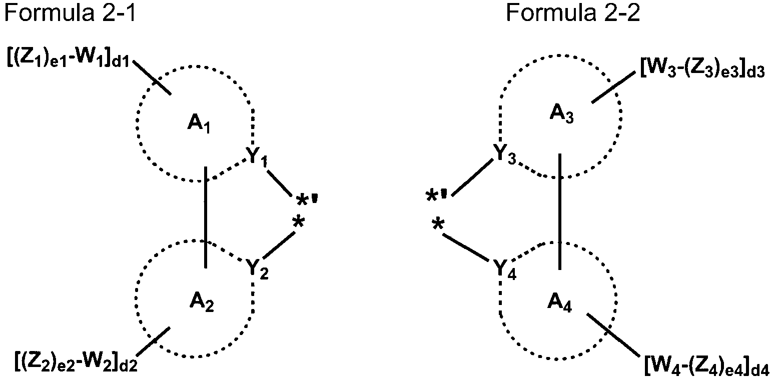 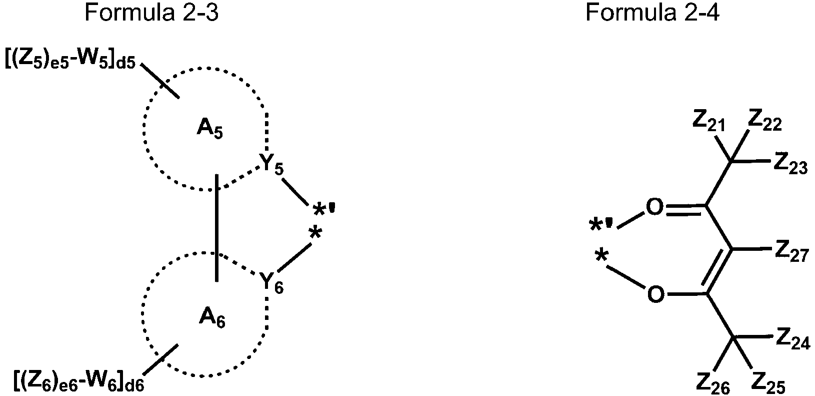 wherein Formulae 2-1 to 2-4 may be the same as described herein.

In Formulae 2A and 2B, L₁₁ and L₁₂ may be different from each other.

The organometallic compounds represented by Formulae 2A, 2B, and 2D may each be a heteroleptic complex.

The organometallic compounds represented by Formulae 2C1 and 2C2 may be a homoleptic complex.

In Formulae 1, 2-1, 2-2, and 2-3, X₁ to X₄ and Y₁ to Y₆ may each independently be C or N.

In one or more embodiments, at least one of X₁ to X₄ in Formula 1 may be C.

In one or more embodiments, X₁ in Formula 1 may be C.

In one or more embodiments, in Formula 1, i) X₁ and X₃ may each be C, and X₂ and X₄ may each be N, or ii) X₁ and X₄ may each be C, and X₂ and X₃ may each be N.

In one or more embodiments, in Formulae 2-1, 2-2, and 2-3, Y₁, Y₃, and Y₅ may each be N, and Y₂, Y₄, and Y₆ may each be C.

In Formula 1, X₅ to X₈ may each independently be a chemical bond, O, S, N(R'), C(R')(R"), or C(=O), wherein at least one of X₅ to X₈ may not be a chemical bond. R' and R" may each be the same as described herein.

In one or more embodiments, X₅ in Formula 1 may not be a chemical bond.

In one or more embodiments, X₅ in Formula 1 may be O or S.

In one or more embodiments, in Formula 1, X₅ may be O or S, and X₆ to X₈ may each be a chemical bond.

In Formula 1, two bonds of a bond between X₅ or X₁ and M¹, a bond between X₆ or X₂ and M¹, a bond between X₇ or X₃ and M¹, and a bond between X₈ or X₄ and M¹ may each be a coordinate bond, and the other two bonds may each be a covalent bond.

For example, in Formula 1, a bond between X₂ and M¹ may be a coordinate bond.

In one or more embodiments, in Formula 1, a bond between M¹ and either of X₅ and X₁ and a bond between M¹ and X₃ may each be a coordinate bond, and a bond between M¹ and X₂ and a bond between M¹ and X₄ may each be a covalent bond.

In one or more embodiments, in Formula 1, a bond between M¹ and either of X₅ and X₁ and a bond between M¹ and X₃ may each be a covalent bond, and a bond between M¹ and X₂ and a bond between M¹ and X₄ may each be a coordinate bond.

In Formulae 1, 2-1, 2-2, and 2-3, ring CY₁ to ring CY₄, and ring A₁ to ring A₆ may each independently be a C₅-C₃₀ carbocyclic group or a C₁-C₃₀ heterocyclic group.

For example, each of ring CY₁, ring CY₃, and ring CY₄ in Formula 1 may not be a benzimidazole group.

For example, in Formulae 1, 2-1, 2-2, and 2-3, ring CY₁ to ring CY₄ and ring A₁ to ring A₆ may each independently be i) a first cyclic group, ii) a second cyclic group, iii) a condensed cyclic group in which two or more first cyclic groups are condensed with each other, iv) a condensed cyclic group in which two or more second cyclic groups are condensed with each other, or v) a condensed cyclic group in which one or more first cyclic groups are condensed with one or more second cyclic groups,
wherein the first cyclic group may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second cyclic group may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, in Formulae 1, 2-1, 2-2, and 2-3, ring CY₁ to ring CY₄ and ring A₁ to ring A₆ may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthoxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenoxazole group, a phenanthrenoisoxazole group, a phenanthrenothiazole group, a phenanthrenoisothiazole group, a phenanthrenooxadiazole group, a phenanthrenothiadiazole group, a furopyridine group, a benzofuropyridine group, a thienopyridine group, a benzothienopyridine group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In one or more embodiments, ring CY₁ and ring CY₃ in Formula 1 may each independently be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each of which is condensed with a cyclohexane group, a cyclohexene group, a norbornane group, a piperidine group, or a combination thereof.

In one or more embodiments, ring CY₂ in Formula 1 may be:
an imidazole group, a benzimidazole group, a pyridine group, a pyrimidine group, a pyridazine group, a pyrazine group, a triazine group, a quinoline group, an isoquinoline group, a quinoxaline group, or a quinazoline group; or
an imidazole group, a benzimidazole group, a pyridine group, a pyrimidine group, a pyridazine group, a pyrazine group, a triazine group, a quinoline group, an isoquinoline group, a quinoxaline group, or a quinazoline group, each of which is condensed with a cyclohexane group, a cyclohexene group, a norbornane group, a benzene group, a pyridine group, a pyrimidine group, or a combination thereof.

In one or more embodiments, ring CY₄ in Formula 1 may be:
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group; or
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group, each of which is condensed with a cyclohexane group, a cyclohexene group, a norbornane group, a benzene group, a pyridine group, a pyrimidine group, or a combination thereof.

In Formulae 2-1 and 2-2, ring A₁ and ring A₃ may be different from each other.

In one or more embodiments, a Y₁-containing monocyclic group in ring A₁, a Y₂-containing monocyclic group in ring A₂, and Y₄-containing monocyclic group in ring A₄ may each be a 6-membered ring.

In one or more embodiments, a Y₃-containing monocyclic group in ring A₃ may be a 6-membered ring.

In one or more embodiments, a Y₃-containing monocyclic group in ring A₃ may be a 5-membered ring.

In one or more embodiments, a Y₁-containing monocyclic group in ring A₁ may be a 6-membered ring, and a Y₃-containing monocyclic group in ring A₃ may be a 5-membered ring.

In one or more embodiments, in Formulae 2-1 and 2-2, ring A₁ and ring A₃ may each independently be i) an A ring, ii) a polycyclic group in which two or more A rings are condensed with each other, or iii) a polycyclic group in which one or more A rings and one or more B rings are condensed with each other,
wherein the A ring may be a pyridine group, a pyrimidine group, a pyridazine group, a pyrazine group, or a triazine group, and
the B ring may be a cyclohexane group, a cyclohexene group, a norbornane group, a benzene group, a furan group, a thiophene group, a selenophene group, a pyrrole group, a cyclopentadiene group, or silole group.

In one or more embodiments, in Formula 2-2, ring A₃ may be i) a C ring, ii) a polycyclic group in which two or more C rings are condensed with each other, or iii) a polycyclic group in which one or more C rings and one or more D rings are condensed with each other,
wherein the C ring may be a pyrrole group, a pyrazole group, an imidazole group, a triazole group, an oxazole group, an isoxazole group, a thiazole group, or an isothiazole group, and
the D ring may be a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group. In one or more embodiments, ring A₁ in Formula 2-1 may be:
   a pyridine group, a pyrimidine group, a pyridazine group, or a pyrazine group; or
   pyridine group, a pyrimidine group, a pyridazine group, or a pyrazine group, each of which is condensed with a cyclohexane group, a norbornane group, a benzene group, or a combination thereof.

In one or more embodiments, ring A₃ in Formula 2-2 may be:
a pyridine group, a pyrimidine group, a pyridazine group, or a pyrazine group;
a pyridine group, a pyrimidine group, a pyridazine group, or a pyrazine group, each condensed with a cyclohexane group, a norbornane group, a benzene group, or a combination thereof; or
an imidazole group, a benzimidazole group, a naphthoimidazole group, a phenanthrenoimidazole group, a pyridoimidazole group, an oxazole group, a benzoxazole group, a naphthoxazole group, a phenanthrenoxazole group, a pyridooxazole group, a thiazole group, a benzothiazole group, a naphthothiazole group, a phenanthrenothiazole group, or a pyridothiazole group.

In one or more embodiments, ring A₂ and ring A₄ in Formulae 2-1 and 2-2 may be different from each other.

In one or more embodiments, in Formulae 2-1 and 2-2, ring A₂ and ring A₄ may each independently be i) an E ring, ii) a polycyclic group in which two or more E rings are condensed with each other, or iii) a polycyclic group in which one or more E rings and one or more F rings are condensed with each other,
wherein the E ring may be a benzene group, a pyridine group, a pyrimidine group, a pyridazine group, a pyrazine group, or a triazine group, and
the F ring may be a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In one or more embodiments, in Formula 2-1, ring A₂ may be a polycyclic group in which two or more E rings and one or more F ring are condensed with each other.

In one or more embodiments, in Formula 2-2, ring A₄ may be a polycyclic group in which two or more E rings and one or more F ring are condensed with each other.

In one or more embodiments, ring A₂ in Formula 2-1 may be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each of which is condensed with a cyclohexane group, a norbornane group, a benzene group, or a combination thereof.

In one or more embodiments, ring A₄ in Formula 2-2 may be:
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or an azadibenzosilole group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or an azadibenzosilole group, each of which is condensed with a benzene group, a naphthalene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof.

In one or more embodiments, in Formula 2-3, ring A₅ may include a quinoline group, an isoquinoline group, a benzoquinoline group, a benzoisoquinoline group, a naphthoquinoline group, a naphthoisoquinoline group, a thienopyridine group, a benzothienopyridine group, a thienopyrimidine group, a benzothienopyrimidine group, a furopyridine group, a benzofuropyridine group, a furopyrimidine group, or a benzofuropyrimidine group, and ring A₆ may include a benzene group, a naphthalene group, a benzofuran group, a benzothiophene group, a dibenzofuran group, a dibenzothiophene group, a carbazole group, or a fluorene group.

In Formula 1, T₁₁ to T₁₄ may each independently be a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(R₅ₐ)=*', *=C(R₅ₐ)-*', *-C(R₅ₐ)=C(R_{5b})-*', *-C(=S)-*', *-C≡C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

In one or more embodiments, T₁₁ and T₁₂ in Formula 1 may be a single bond, and T₁₃ may be a single bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', or *-O-*'.

In Formula 1, n1 to n4 indicate numbers of T₁₁ to T₁₄, respectively, and may each independently be 0 or 1, wherein three or more of n1 to n4 may each be 1. That is, an organometallic compound represented by Formula 1 may have a tetradentate ligand.

In Formula 1, when n1 is 0, T₁₁ does not exist (that is, ring CY₁ and ring CY₂ are not linked to each other), when n2 is 0, T₁₂ does not exist (that is, ring CY₂ and ring CY₃ are not linked to each other), when n3 is 0, T₁₃ does not exist (that is, ring CY₃ and ring CY₄ are not linked to each other), and when n4 is 0, T₁₄ does not exist (that is, ring CY₄ and ring CY₁ are not linked to each other).

In one or more embodiments, in Formula 1, n1 to n3 may each be 1, and n4 may be 0.

In Formulae 1, 2-1, 2-2, and 2-3, L₁ to L₄ and W₁ to W₆ may each independently be a single bond, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

For example, in Formulae 1, 2-1, 2-2, and 2-3, L₁ to L₄ and W₁ to W₆ may each independently be:
a single bond; or
a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In one or more embodiments, in Formulae 1, 2-1, 2-2, and 2-3, L₁ to L₄ and W₁ to W₆ may each independently be:
a single bond; or
a benzene group, a naphthalene group, a pyridine group, a fluorene group, a carbazole group, a dibenzofuran group, or a dibenzothiophene group, each unsubstituted or substituted with at least one R₁₀ₐ.

In one or more embodiments, in Formulae 1, 2-1, 2-2, and 2-3, L₁ to L₄ and W₁ to W₆ may each independently be:
a single bond; or
a benzene group, a naphthalene group, a dibenzofuran group, or a dibenzothiophene group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

In Formula 1, b1 to b4 indicate the number of L₁ to L₄, respectively, and may each independently be an integer from 1 to 10. When b1 is 2 or more, two or more of L₁ may be identical to or different from each other, when b2 is 2 or more, two or more of L₂ may be identical to or different from each other, when b3 is 2 or more, two or more of L₃ may be identical to or different from each other, and when b4 is 2 or more, two or more of L₄ may be identical to or different from each other. For example, b1 to b4 may each independently be 1, 2, or 3.

In Formulae 1, 2-1, 2-2, 2-3, and 2-4, R₁ to R₄, R₅ₐ, R_{5b}, R', R", Z₁ to Z₆, and Z₂₁ to Z₂₇ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂),-Si(Q₃)(Q₄)(Q₅), -Ge(Q₃)(Q₄)(Q₅), -B(Q₆)(Q₇), -P(=O)(Q₈)(Q₉), or -P(Q₈)(Q₉). Q₁ to Q₉ may each be the same as described herein.

For example, in Formulae 1, 2-1, 2-2, 2-3, and 2-4, R₁ to R₄, R₅ₐ, R_{5b}, R', R", Z₁ to Z₆, and Z₂₁ to Z₂₇ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₂-C₂₀ alkenyl group, a C₁-C₂₀ alkoxy group, or a C₁-C₂₀ alkylthio group;
a C₁-C₂₀ alkyl group, a C₂-C₂₀ alkenyl group, a C₁-C₂₀ alkoxy group, or a C₁-C₂₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group (or a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or azadibenzothiophenyl group, each unsubstituted or substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-N(Q₁)(Q₂), -Si(Q₃)(Q₄)(Q₅), -Ge(Q₃)(Q₄)(Q₅), -B(Q₆)(Q₇),-P(=O)(Q₈)(Q₉), or -P(Q₈)(Q₉), and
Q₁ to Q₉ may each independently be:
   deuterium, -F, -CH₃, -CD₃, -CD₂H, -CDH₂, -CH₂CH₃, -CH₂CD₃,-CH₂CD₂H, -CH₂CDH₂, -CHDCH₃, -CHDCD₂H, -CHDCDH₂, -CHDCD₃,-CD₂CD₃, -CD₂CD₂H, -CD₂CDH₂, -CF₃, -CF₂H, -CFH₂, -CH₂CF₃, -CH₂CF₂H,-CH₂CFH₂, -CHFCH₃, -CHFCF₂H, -CHFCFH₂, -CHFCF₃, -CF₂CF₃, -CF₂CF₂H, or -CF₂CFH₂; or
   an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a C₁-C₁₀ alkyl group, a phenyl group, or a combination thereof.

In one or more embodiments, in Formulae 1, 2-1, 2-2, 2-3, and 2-4, R₁ to R₄, R₅ₐ, R_{5b}, R', R", Z₁ to Z₆, and Z₂₁ to Z₂₇ may each independently be:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl, or a dibenzothiophenyl group, each unsubstituted or substituted with deuterium, -F, a cyano group, a C₁-C₂₀ alkyl group, a deuterated C₁-C₂₀ alkyl group, fluorinated C₁-C₂₀ alkyl group, a C₁-C₂₀ alkoxy group, a deuterated C₁-C₂₀ alkoxy group, a fluorinated C₁-C₂₀ alkoxy group, a C₁-C₂₀ alkylthio group, a deuterated C₁-C₂₀ alkylthio group, a fluorinated C₁-C₂₀ alkylthio group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or a combination thereof; or
-Si(Q₃)(Q₄)(Q₅) or -Ge(Q₃)(Q₄)(Q₅).

In one or more embodiments, Z₂₁ to Z₂₆ in Formula 2-4 may each independently be:
hydrogen, deuterium, or -F;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, or a combination thereof; or
a C₃-C₁₀ cycloalkyl group unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, or a combination thereof.

In one or more embodiments, Z₂₁ to Z₂₆ in Formula 2-4 may each independently be:
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, or a combination thereof; or
a C₃-C₁₀ cycloalkyl group unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, or a combination thereof.

In one or more embodiments, in Formula 2-4, at least one of Z₂₁ to Z₂₆ (e.g., at least one of Z₂₁ to Z₂₃ or at least one of Z₂₄ to Z₂₆) may each independently be:
a C₂-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, or a combination thereof; or
a C₃-C₁₀ cycloalkyl group unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, or a combination thereof.

In one or more embodiments, in Formula 2-1, each of e1 and d1 may not be 0, and at least one of a plurality of Z₁ may be a deuterated C₁-C₂₀ alkyl group, - Si(Q₃)(Q₄)(Q₅), or -Ge(Q₃)(Q₄)(Q₅). Q₃ to Q₅ may be the same as described herein.

For example, Q₃ to Q₅ may each independently be:
a C₁-C₆₀ alkyl group unsubstituted or substituted with deuterium, a C₁-C₆₀ alkyl group, a C₆-C₆₀ aryl group, or a combination thereof; or
a C₆-C₆₀ aryl group unsubstituted or substituted with deuterium, a C₁-C₆₀ alkyl group, a C₆-C₆₀ aryl group, or a combination thereof.

In one or more embodiments, Q₃ to Q₅ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or-CD₂CDH₂; or
an n-propyl group, an isopropyl group, an n-butyl group, a sec-butyl group, an isobutyl group, a tert-butyl group, an n-pentyl group, a tert-pentyl group, an neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or a combination thereof.

In one or more embodiments, Q₃ to Q₅ may be identical to each other.

In one or more embodiments, two or more of Q₃ to Q₅ may be different from each other.

In one or more embodiments, the organometallic compounds represented by Formulae 2A and 2B may satisfy at least one of Condition (1) to Condition (8), the organometallic compound represented by Formula 2C1 may satisfy at least one of Condition (1) to Condition (4), the organometallic compound represented by Formula 2C2 may satisfy at least one of Condition (5) to Condition (8), and the organometallic compound represented by Formula 2D may satisfy at least one of Condition (9) to Condition (12):
Condition (1)
   each of e1 and d1 in Formula 2-1 is not 0, and at least one Z₁ includes deuterium;
Condition (2)
   each of e2 and d2 in Formula 2-1 is not 0, and at least one Z₂ includes deuterium;
Condition (3)
   each of e1 and d1 in Formula 2-1 is not 0, and at least one Z₁ includes a fluoro group;
Condition (4)
   each of e2 and d2 in Formula 2-1 is not 0, and at least one Z₂ includes a fluoro group;
Condition (5)
   each of e3 and d3 in Formula 2-2 is not 0, and at least one Z₃ includes deuterium;
Condition (6)
   each of e4 and d4 in Formula 2-2 is not 0, and at least one Z₄ includes deuterium;
Condition (7)
   each of e3 and d3 in Formula 2-2 is not 0, and at least one Z₃ includes a fluoro group;
Condition (8)
   each of e4 and d4 in Formula 2-2 is not 0, and at least one Z₄ includes a fluoro group;
Condition (9)
   each of e5 and d5 in Formula 2-3 is not 0, and at least one Z₅ includes deuterium;
Condition (10)
   each of e6 and d6 in Formula 2-3 is not 0, and at least one Z₆ includes deuterium;
Condition (11)
   each of e5 and d5 in Formula 2-3 is not 0, and at least one Z₅ includes a fluoro group;
Condition (12)
   each of e6 and d6 in Formula 2-3 is not 0, and at least one Z₆ includes a fluoro group.

In Formulae 1, 2-1, 2-2, and 2-3, c1 to c4, a1 to a4, e1 to e6, and d1 to d6 indicate the number of R₁ to R₄, a group represented by *-[(L₁)_{b1}-(R₁)_{c1}], a group represented by *-[(L₂)_{b2}-(R₂)_{c2}], a group represented by *-[(L₃)_{b3}-(R₃)_{c3}], a group represented by *-[(L₄)_{b4}-(R₄)_{c4}], Z₁ to Z₆, a group represented by *-[W₁-(Z₁)ₑ₁], a group represented by *-[W₂-(Z₂)ₑ₂], a group represented by *-[W₃-(Z₃)ₑ₃], a group represented by *-[W₄-(Z₄)ₑ₄], a group represented by *-[W₅-(Z₅)ₑ₅], and a group represented by *-[W₆-(Z₆)ₑ₆], respectively, and may each independently be an integer from 0 to 20. When c1 is 2 or more, two or more of R₁ may be identical to or different from each other, when c2 is 2 or more, two or more of R₂ may be identical to or different from each other, when c3 is 2 or more, two or more of R₃ may be identical to or different from each other, when c4 is 2 or more, two or more of R₄ may be identical to or different from each other, when a1 is 2 or more, two or more of the group represented by *-[(L₁)_{b1}-(R₁)_{c1}] may be identical to or different from each other, when a2 is 2 or more, two or more of the group represented by *-[(L₂)_{b2}-(R₂)_{c2}] may be identical to or different from each other, when a3 is 2 or more, two or more of the group represented by *-[(L₃)_{b3}-(R₃)_{c3}] may be identical to or different from each other, when a4 is 2 or more, two or more of the group represented by *-[(L₄)_{b4}-(R₁)_{c4}] may be identical to or different from each other, when e1 is 2 or more, two or more of Z₁ may be identical to or different from each other, when e2 is 2 or more, two or more of Z₂ may be identical to or different from each other, when e3 is 2 or more, two or more of Z₃ may be identical to or different from each other, when e4 is 2 or more, two or more of Z₄ may be identical to or different from each other, when e5 is 2 or more, two or more of Z₅ may be identical to or different from each other, when e6 is 2 or more, two or more of Z₆ may be identical to or different from each other, when d1 is 2 or more, two or more of the group represented by *-[W₁-(Z₁)ₑ₁] may be identical to or different from each other, when d2 is 2 or more, two or more of the group represented by *-[W₂-(Z₂)ₑ₂] may be identical to or different from each other, when d3 is 2 or more, two or more of the group represented by *-[W₃-(Z₃)ₑ₃] may be identical to or different from each other, when d4 is 2 or more, two or more of the group represented by *-[W₄-(Z₄)ₑ₄] may be identical to or different from each other, when d5 is 2 or more, two or more of the group represented by *-[W₅-(Z₅)ₑ₅] may be identical to or different from each other, and when d6 is 2 or more, two or more of the group represented by *-[W₆-(Z₆)ₑ₆] may be identical to or different from each other. For example, in Formulae 1, 2-1, 2-2 and 2-3, c1 to c4, a1 to a4, e1 to e6, and d1 to d6 may each independently be an integer from 0 to 20, an integer from 0 to 15, an integer from 0 to 12, an integer from 0 to 11, an integer from 0 to 10, an integer from 0 to 9, an integer from 0 to 8, an integer from 0 to 7, an integer from 0 to 6, an integer from 0 to 5, or an integer from 0 to 4. For example, in Formulae 1, 2-1, 2-2, and 2-3, c1 to c4, a1 to a4, e1 to e6, and d1 to d6 may each independently be 0, 1, 2, or 3.

The sensitizer may not be tris[2-phenylpyridine]iridium.

In one or more embodiments, in Formula 2-1, one or more embodiments where Y₁ is N, ring A₁ is a pyridine group, Y₂ is C, ring A₂ is a benzene group, and each of d1 and d2 is 0, may be excluded.

In Formulae 1, 2-1, 2-2, and 2-3, each of i) two or more of a plurality of R₁, ii) two or more of a plurality of R₂, iii) two or more of a plurality of R₃, iv) two or more of a plurality of R₄, v) R₅ₐ and R_{5b}, vi) two or more of a plurality of Z₁, vii) two or more of a plurality of Z₂, viii) two or more of a plurality of Z₃, ix) two or more of a plurality of Z₄, x) two or more of a plurality of Z₅, xi) two or more of a plurality of Z₆, xii) two or more of R₁, R₂, R₃, R₄, R₅ₐ, and R_{5b}, and xiii) two or more of Z₁ to Z₆, may optionally be bonded together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

For example, in Formulae 1, 2-1, 2-2, and 2-3, i) two or more of a plurality of R₁ may optionally be bonded together to form a C₅-C₃₀ carbocyclic group unsubstituted or substituted with at least one R₁₀ₐ, or a C₁-C₃₀ heterocyclic group unsubstituted or substituted with at least one R₁₀ₐ, ii) two or more of a plurality of R₂ may optionally be bonded together to form a C₅-C₃₀ carbocyclic group unsubstituted or substituted with at least one R₁₀ₐ, or a C₁-C₃₀ heterocyclic group unsubstituted or substituted with at least one R₁₀ₐ, iii) two or more of a plurality of R₃ may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ, iv) two or more of a plurality of R₄ may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ, v) R₅ₐ and R_{5b} may optionally be bonded together to form a C₅-C₃₀ carbocyclic group unsubstituted or substituted with at least one R₁₀ₐ, or a C₁-C₃₀ heterocyclic group unsubstituted or substituted with at least one R₁₀ₐ, vi) two or more of a plurality of Z₁ may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ, vii) two or more of a plurality of Z₂ may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ, viii) two or more of a plurality of Z₃ may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ, ix) two or more of a plurality of Z₄ may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ, x) two or more of a plurality of Z₅ may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ, xi) two or more of a plurality of Z₆ may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ, xii) two or more of R₁, R₂, R₃, R₄, R₅ₐ, and R_{5b} may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ, and/or xiii) two or more of Z₁ to Z₆ may optionally be bonded to form a C₅-C₃₀ carbocyclic group unsubstituted or substituted with at least one R₁₀ₐ, or a C₁-C₃₀ heterocyclic group unsubstituted or substituted with at least one R₁₀ₐ.

R₁₀ₐ may be the same as described herein in connection with R₁.

As used herein, * and *' each indicate a binding site to a neighboring atom, unless otherwise stated.

In one or more embodiments, in Formula 1, n1 may not be 0, n4 may be 0, and a group represented by 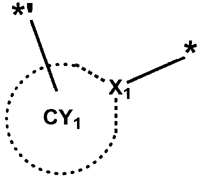 may be a group represented by one of Formulae CY1(1) to CY1(23): 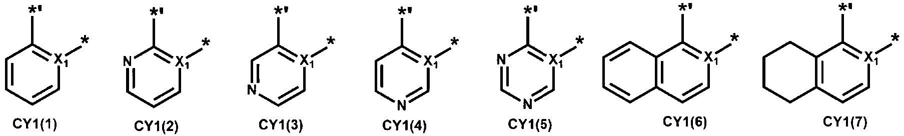 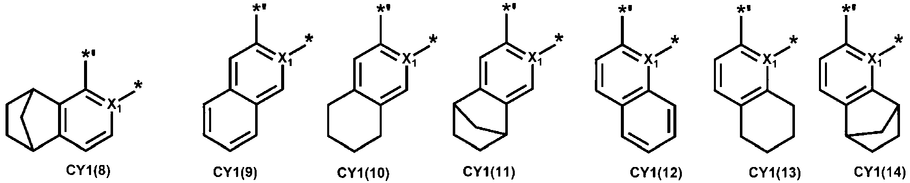 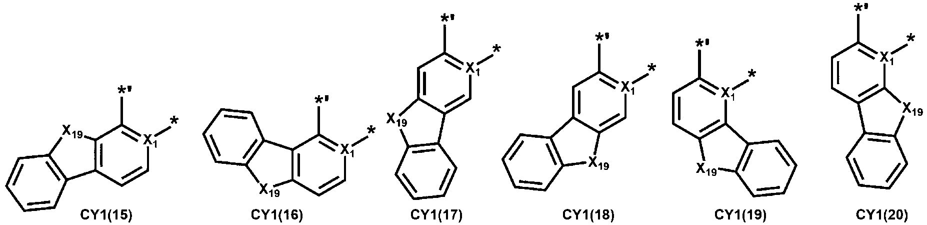 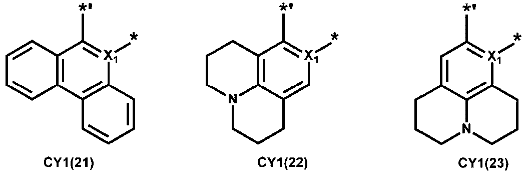 wherein, in Formulae CY1(1) to CY1(23),
X₁ may be the same as described herein,
X₁₉ may be O, S, Se, N(R₁₉ₐ), C(R₁₉ₐ)(R_{19b}), or Si(R₁₉ₐ)(R_{19b}),
R₁₉ₐ and R_{19b} may each be the same as described herein in connection with R₁,
* indicates a binding site to X₅ or M¹ in Formula 1, and
*' indicates a binding site to T₁₁ in Formula 1.

In one or more embodiments, in Formula 1, n1 may be 1, n4 may be 0, and a group represented by 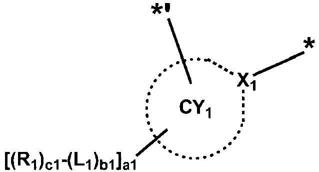 may be a group represented by one of Formulae CY1-1 to CY1-18: 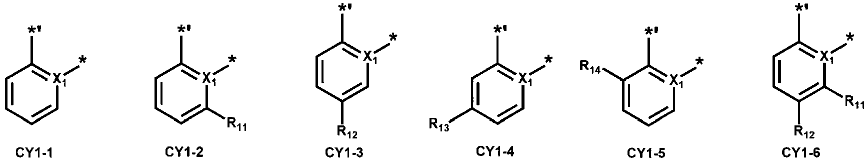 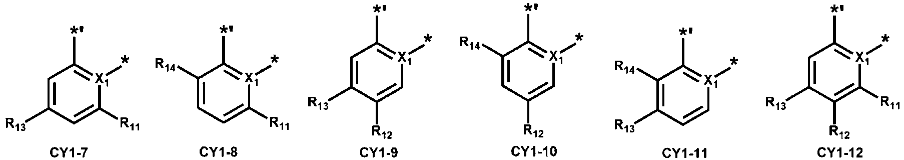 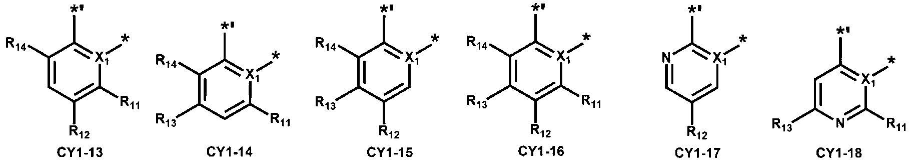 wherein, in Formulae CY1-1 to CY1-18,
X₁ may be the same as described herein,
R₁₁ to R₁₄ may each be the same as described herein in connection with R₁, and each of R₁₁ to R₁₄ may not be hydrogen,
* indicates a binding site to X₅ or M¹ in Formula 1, and
*' indicates a binding site to T₁₁ in Formula 1.

In one or more embodiments, in Formula 1, n1 and n2 may each be 1, and ring CY₂ may be a group represented by Formula CY2A or CY2B: 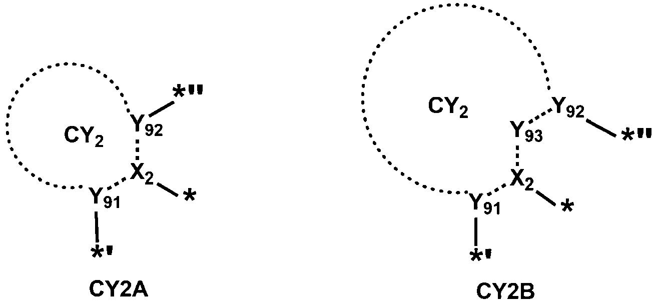 wherein, in Formulae CY2A and CY2B,
X₂ and ring CY₂ may each be the same as described herein,
Y₉₁ and Y₉₂ may each independently be N, C, or Si, and Y₉₃ may be O, S, N, C, or Si,
in Formulae CY2A and CY2B, a bond between X₂ and Y₉₁, a bond between X₂ and Y₉₂, a bond between X₂ and Y₉₃, and a bond between Y₉₂ and Y₉₃ may each be a chemical bond,
*' indicates a binding site to T₁₁ in Formula 1,
* indicates a binding site to X₆ or M¹ in Formula 1, and
*" indicates a binding site to T₁₂ in Formula 1.

In one or more embodiments, in Formula 1, each of n1 and n2 may not be 0, and a group represented by 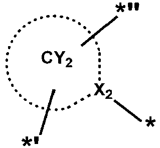 may be a group represented by one of Formulae CY2(1) to CY2(21): 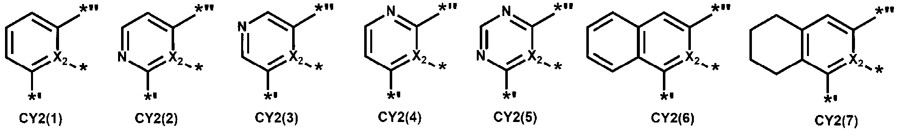 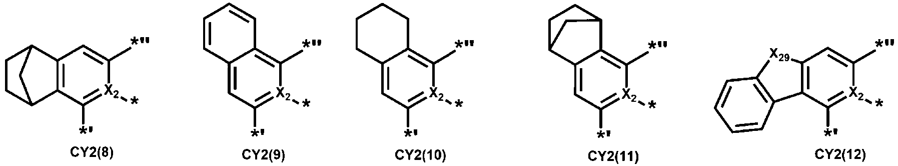 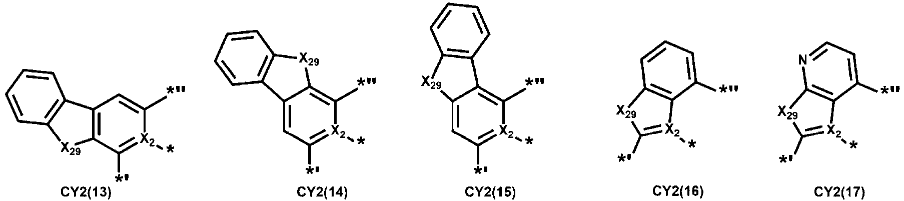 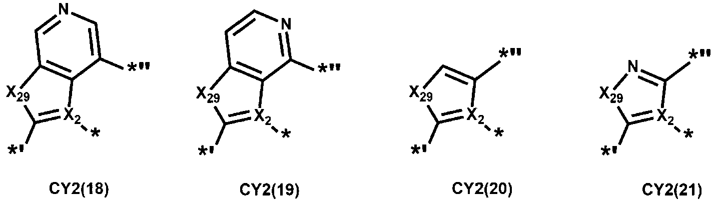 wherein, in Formulae CY2(1) to CY2(21),
X₂ may be the same as described herein,
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may each be the same as described herein,
R₂₉ₐ and R_{29b} may each be the same as described herein in connection with R₂,
*' indicates a binding site to T₁₁ in Formula 1,
* indicates a binding site to X₆ or M¹ in Formula 1, and
*" indicates a binding site to T₁₂ in Formula 1.

In one or more embodiments, in Formula 1, each of n1 and n2 may be 1, and a group represented by 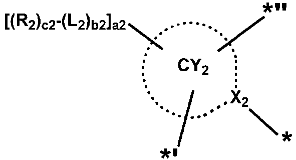 may be a group represented by one of Formulae CY2-1 to CY2-16: 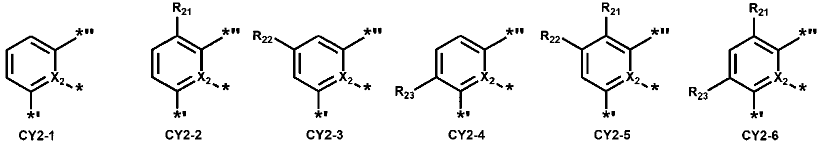 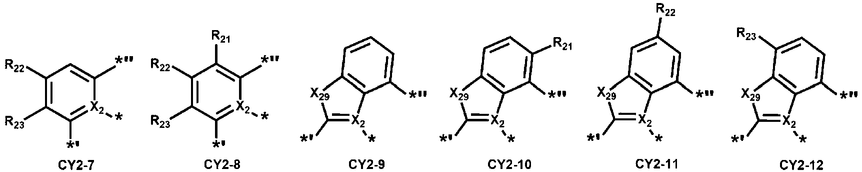 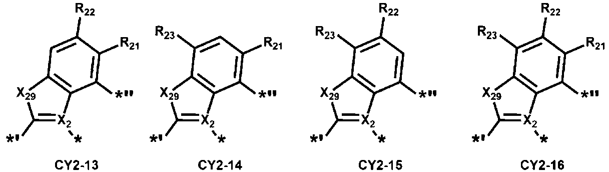 wherein, in Formulae CY2-1 to CY2-16,
X₂ may be the same as described herein,
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may each be the same as described herein,
R₂₁ to R₂₃, R₂₉ₐ, and R_{29b} may each be the same as described herein in connection with R₂, wherein each of R₂₁ to R₂₃ may not be hydrogen,
*' indicates a binding site to T₁₁ in Formula 1,
* indicates a binding site to X₆ or M¹ in Formula 1, and
*" indicates a binding site to T₁₂ in Formula 1.

In one or more embodiments, in Formula 1,
each of n1 and n2 may be 1,
a group represented by 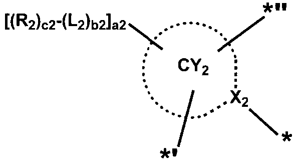 may be a group represented by one of Formulae CY2-9 to CY2-16,
X₂₉ in Formulae CY2-9 to CY2-16 may be N-[(L₂)_{b2}-(R₂)_{c2}],
L₂ may be a benzene group unsubstituted or substituted with at least one R₁₀ₐ,
b2 may be 1 or 2,
c2 may be 1 or 2, and
i) when c2 is 1, R₂ may be a phenyl group unsubstituted or substituted with deuterium, a C₁-C₂₀ alkyl group, a phenyl group, a deuterated phenyl group, a (C₁-C₂₀ alkyl)phenyl group, or a combination thereof, and ii) when c2 is 2, iia) one of two R₂(s) may be a phenyl group unsubstituted or substituted with deuterium, a C₁-C₂₀ alkyl group, a phenyl group, a deuterated phenyl group, a (C₁-C₂₀ alkyl)phenyl group, or a combination thereof, and iib) the other of R₂ may be a C₄-C₂₀ alkyl group that is unsubstituted or substituted with a C₃-C₁₀ cycloalkyl group or a deuterated C₁-C₂₀ alkyl group that is unsubstituted or substituted with a C₃-C₁₀ cycloalkyl group.

In one or more embodiments, in Formula 1, each of n2 and n3 may not be 0, and a group represented by 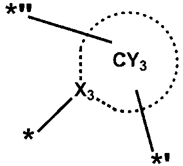 may be a group represented by one of Formulae CY3(1) to CY3(15): 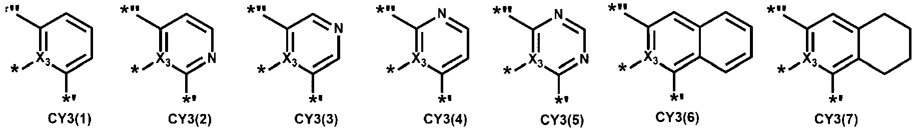 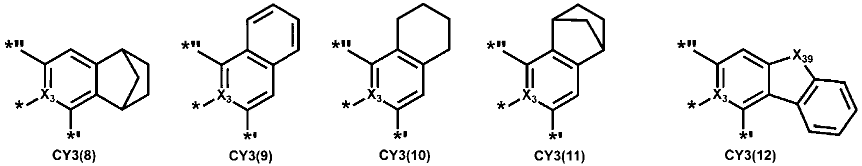 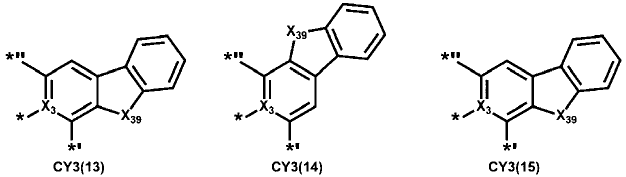 wherein, in Formulae CY3(1) to CY3(15),
X₃ may be the same as described herein,
X₃₉ may be O, S, N(Z₃₉ₐ), C(R₃₉ₐ)(R_{39b}), or Si(R₃₉ₐ)(R_{39b}),
R₃₉ₐ and R_{39b} may each be the same as described herein in connection with R₃,
*" indicates a binding site to T₁₂ in Formula 1,
* indicates a binding site to X₇ or M¹ in Formula 1, and
*' indicates a binding site to T₁₃ in Formula 1.

In one or more embodiments, in Formula 1, each of n2 and n3 may be 1, and a group represented by 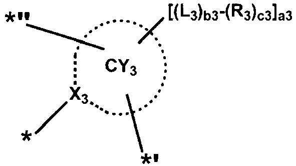 may be a group represented by one of Formulae CY3-1 to CY3-13: 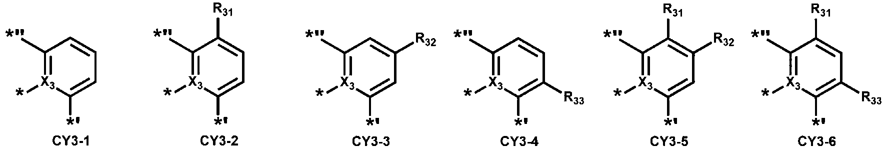 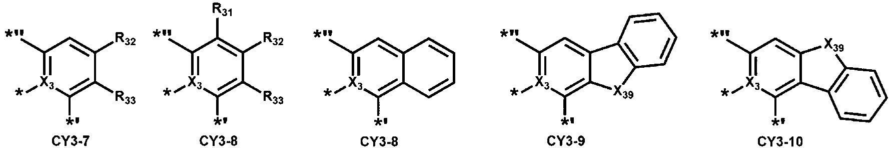 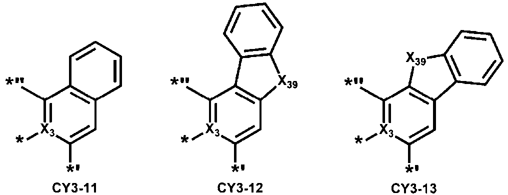 wherein, in Formulae CY3-1 to CY3-13,
X₃ may be the same as described herein,
X₃₉ may be O, S, N-[(L₃)_{b3}-(R₃)_{c3}], C(R₃₉ₐ)(R_{39b}), or Si(R₃₉ₐ)(R_{39b}),
L₃, b3, R₃, and c3 may each be the same as described herein,
R₃₁ to R₃₃, R₃₉ₐ, and R_{39b} may each be the same as described herein in connection with R₃, wherein each of R₃₁ to R₃₃ may not be hydrogen,
*" indicates a binding site to T₁₂ in Formula 1,
* indicates a binding site to X₇ or M¹ in Formula 1, and
*' indicates a binding site to T₁₃ in Formula 1.

In one or more embodiments, in Formula 1, n3 may not be 0, n4 may be 0, and a group represented by 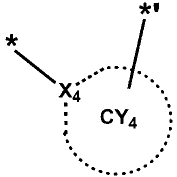 may be a group represented by one of Formulae CY4(1) to CY4(20): 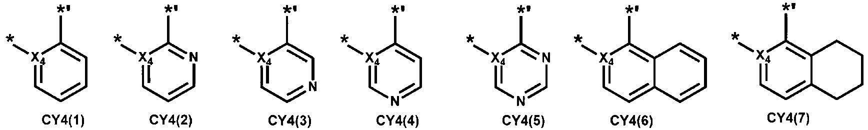 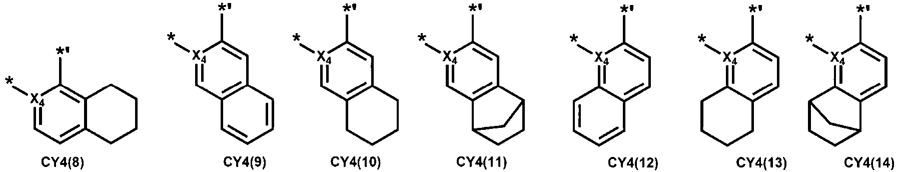 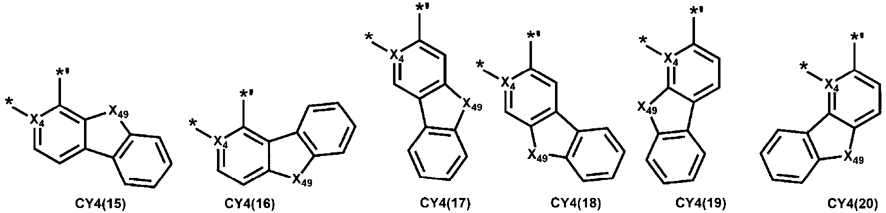 wherein, in Formulae CY4(1) to CY4(20),
X₄ may be the same as described herein,
X₄₉ may be O, S, N(R₄₉ₐ), C(R₄₉ₐ)(R_{49b}), or Si(R₄₉ₐ)(R_{49b}),
R₄₉ₐ and R_{49b} may each be the same as described herein in connection with R₄,
*' indicates a binding site to T₁₃ in Formula 1, and
* indicates a binding site to X₈ or M¹ in Formula 1.

In one or more embodiments, in Formula 1, n3 may be 1, n4 may be 0, and a group represented by 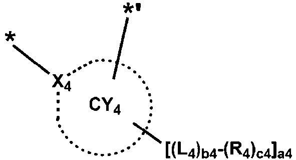 may be a group represented by one of Formulae CY4-1 to CY4-16: 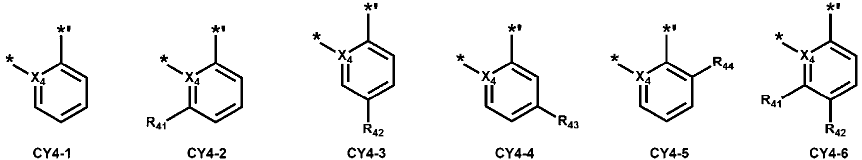 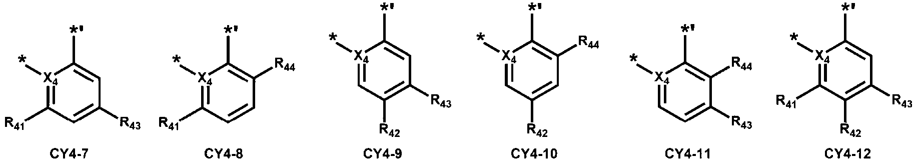 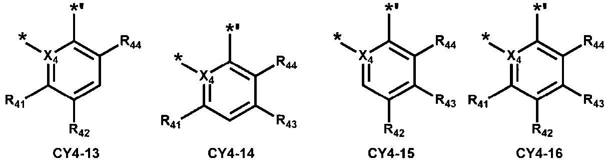 wherein, in Formulae CY4-1 to CY4-16,
X₄ may be the same as described herein,
R₄₁ to R₄₄ may each be the same as described herein in connection with R₄, wherein each of R₄₁ to R₄₄ may not be hydrogen,
*' indicates a binding site to T₁₃ in Formula 1, and
* indicates a binding site to X₈ or M¹ in Formula 1.

In one or more embodiments, the organometallic compound represented by Formula 1 may be a compound represented by one of Formulae 1-1 to 1-3: 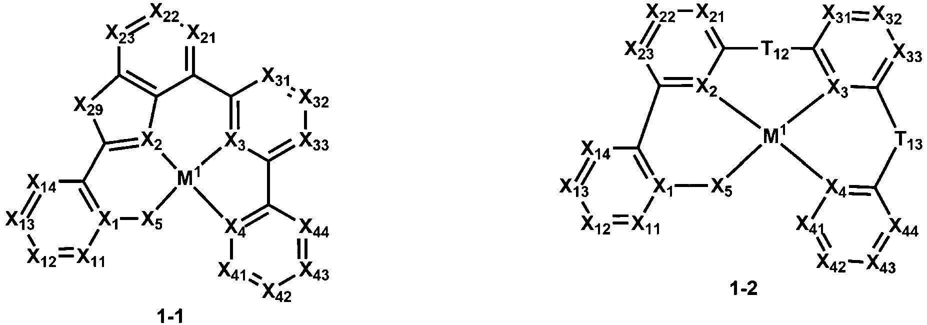 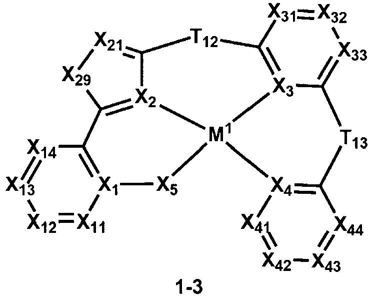 wherein, in Formulae 1-1 to 1-3,
M¹, X₁ to X₅, T₁₂, and T₁₃ may each be the same as described herein,
X₁₁ may be N or C(R₁₁), X₁₂ may be N or C(R₁₂), X₁₃ may be N or C(R₁₃), and X₁₄ may be N or C(R₁₄),
R₁₁ to R₁₄ may each be the same as described herein in connection with R₁,
two or more of R₁₁ to R₁₄ may optionally be linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
X₂₁ may be N or C(R₂₁), X₂₂ may be N or C(R₂₂), and X₂₃ may be N or C(R₂₃),
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may each be the same as described herein,
R₂₁ to R₂₃, R₂₉ₐ, and R_{29b} may each be the same as described herein in connection with R₂,
two or more of R₂₁ to R₂₃ may optionally be linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
X₃₁ may be N or C(R₃₁), X₃₂ may be N or C(R₃₂), and X₃₃ may be N or C(R₃₃),
R₃₁ to R₃₃ may each be the same as described herein in connection with R₃,
two or more of R₃₁ to R₃₃ may optionally be linked to each other to form a C₅-C₃₀ carbocyclic group unsubstituted or substituted with at least one R₁₀ₐ, or a C₁-C₃₀ heterocyclic group unsubstituted or substituted with at least one R₁₀ₐ,
X₄₁ may be N or C(R₄₁), X₄₂ may be N or C(R₄₂), X₄₃ may be N or C(R₄₃), and X₄₄ may be N or C(R₄₄),
R₄₁ to R₄₄ may each be the same as described herein in connection with R₄, and
two or more of R₄₁ to R₄₄ may optionally be linked to each other to form a C₅-C₃₀ carbocyclic group unsubstituted or substituted with at least one R₁₀ₐ or a C₁-C₃₀ heterocyclic group unsubstituted or substituted with at least one R10a.

In one or more embodiments,
Y₁ in Formula 2-1 may be N, and
a group represented by 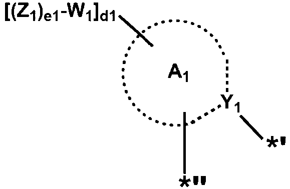 in Formula 2-1 may be a group represented by one of Formulae A1-1 to A1-3: 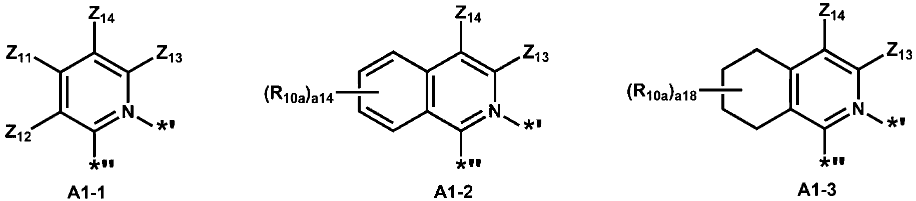 wherein, in Formulae A1-1 to A1-3,
   Z₁₁ to Z₁₄ may each be the same as described herein in connection with Z₁,
   R₁₀ₐ may be the same as described herein,
   a14 may be an integer from 0 to 4,
   a18 may be an integer from 0 to 8,
   *' indicates a binding site to M² in Formulae 2A, 2B and 2C1, and
   *" indicates a binding site to ring A₂.

For example, at least one of Z₁₁, Z₁₂, or Z₁₄ (for example, Z₁₄) in Formulae A1-1 to A1-3 may be:
a C₁-C₂₀ alkyl group that is unsubstituted or substituted with deuterium, -F, a phenyl group, or a combination thereof;
-Si(Q₃)(Q₄)(Q₅); or
-Ge(Q₃)(Q₄)(Q₅).

In one or more embodiments,
Y₃ in Formula 2-2 may be N, and
a group represented by 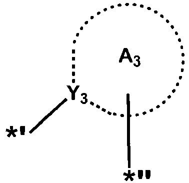 in Formula 2-2 may be a group represented by one of Formulae NR1 to NR48, and
a group represented by 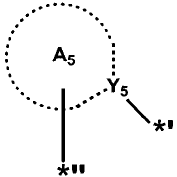 in Formula 2-3 may be a group represented by one of Formulae NR11 to NR28: 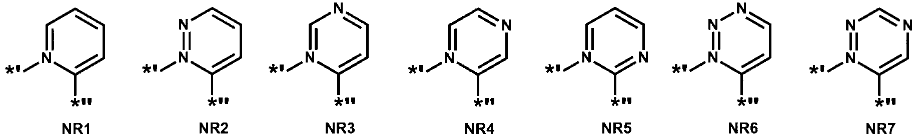 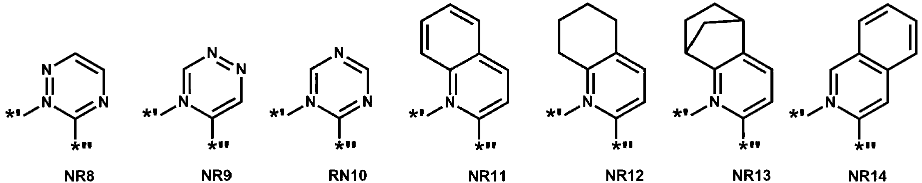 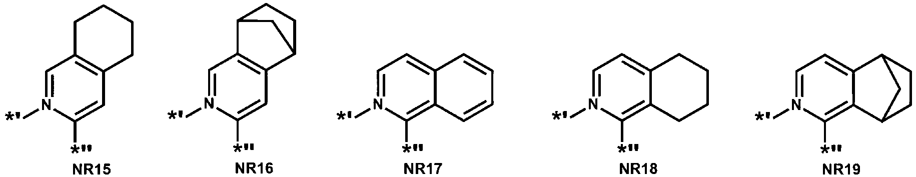 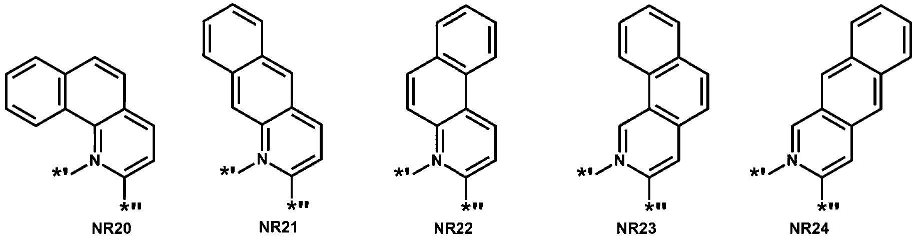 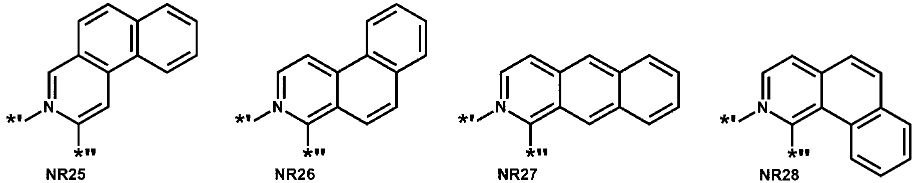 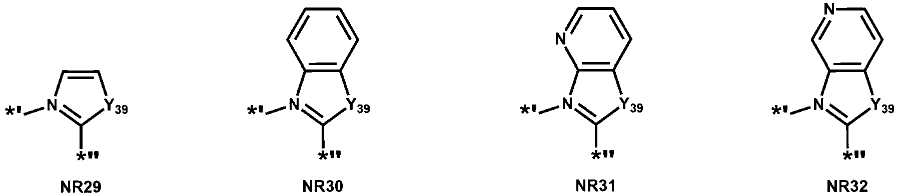 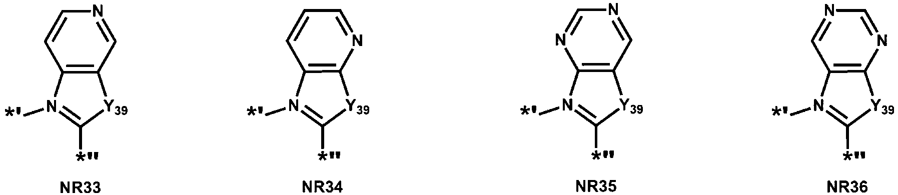 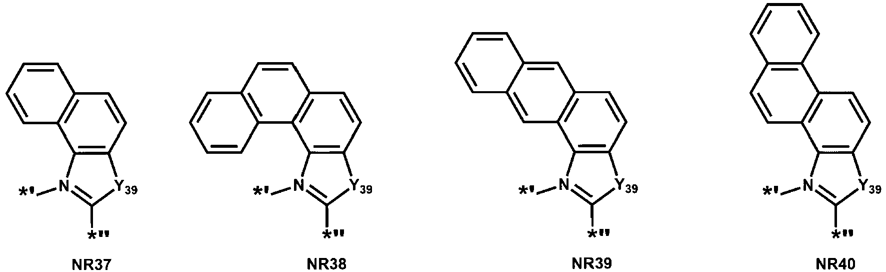 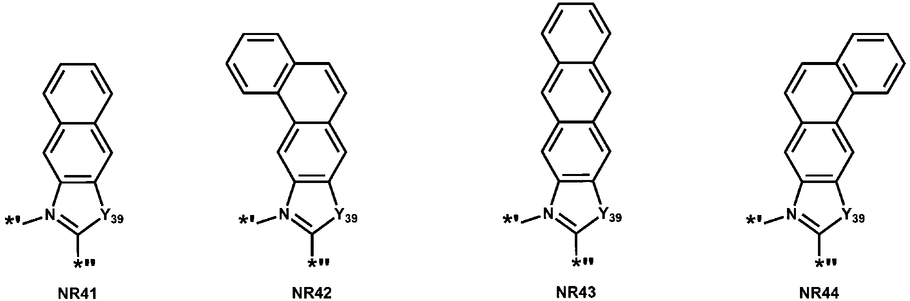 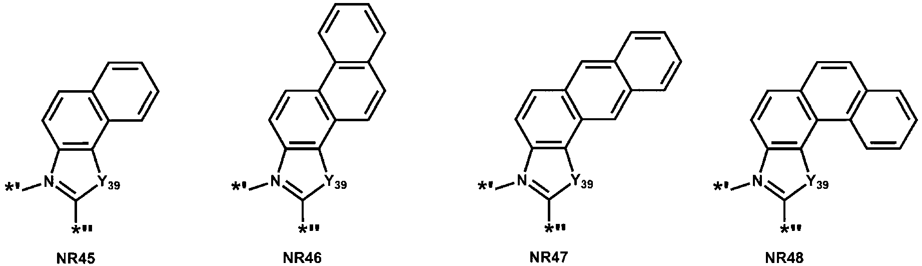 wherein, in Formulae NR1 to NR48,
   Y₃₉ may be O, S, Se, N-[W₃-(Z₃)ₑ₃], C(Z₃₉ₐ)(Z_{39b}), or Si(Z₃₉ₐ)(Z_{39b}),
   W₃, Z₃, and e3 may each be the same as described herein,
   Z₃₉ₐ and Z_{39b} may each be the same as described herein in connection with Z₃,
   *' indicates a binding site to M² in Formulae 2A, 2B, 2C2 and 2D, and
   *" indicates a binding site to ring A₄ or ring A₆.

In one or more embodiments,
in Formulae 2-1, 2-2, and 2-3, each of Y₂, Y₄, and Y₆ may be C, and
a group represented by 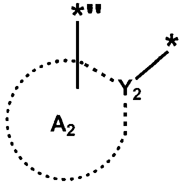 in Formula 2-1, a group represented by 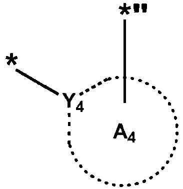 in Formula 2-2, and a group represented by 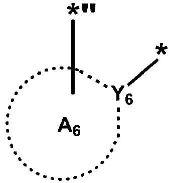 in Formula 2-3 may each independently be a group represented by one of Formulae CR1 to CR29: 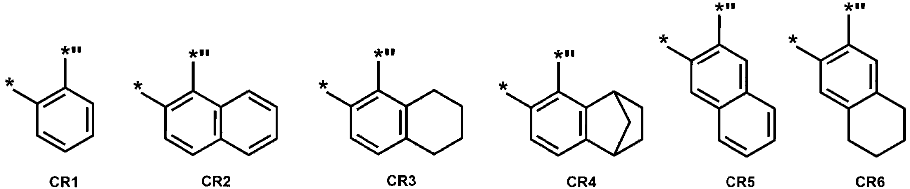 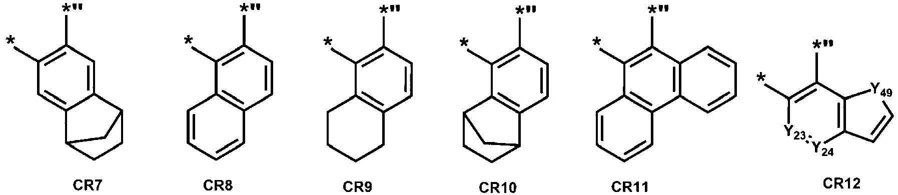 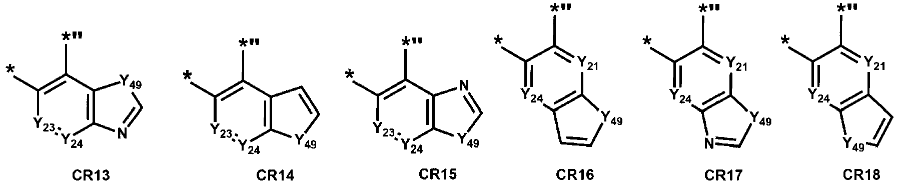 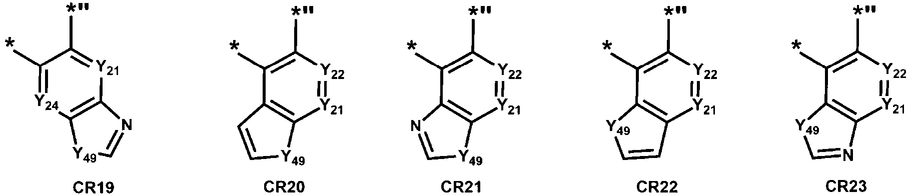 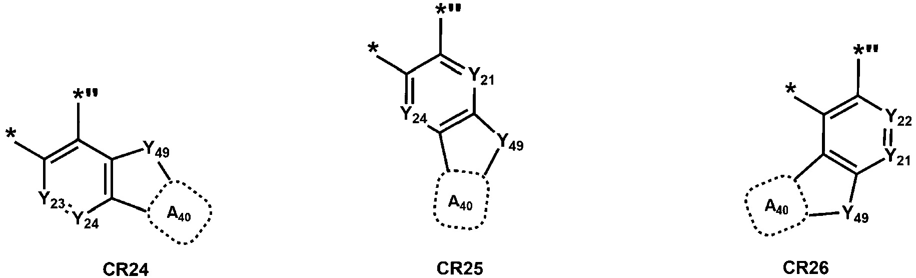 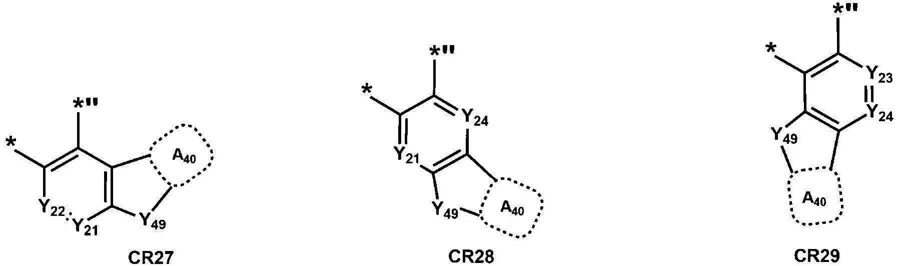 wherein, in Formulae CR1 to CR29,
   Y₄₉ may be O, S, Se, N-[W₂-(Z₂)ₑ₂], N-[W₄-(Z₄)ₑ₄], C(Z₂₉ₐ)(Z_{29b}), C(Z₄₉ₐ)(Z_{49b}), Si(Z₂₉ₐ)(Z_{29b}), or Si(Z₄₉ₐ)(Z_{49b}),
   W₂, W₄, Z₂, Z₄, e2, and e4 may each be the same as described herein,
   Z₂₉ₐ and Z_{29b} may each be the same as described herein in connection with Z₂,
   Z₄₉ₐ and Z_{49b} may each be the same as described herein in connection with Z₄,
   Y₂₁ to Y₂₄ may each independently be N or C,
   ring A₄₀ may be a C₅-C₃₀ carbocyclic group or a C₁-C₃₀ heterocyclic group (e.g., a benzene group, a naphthalene group, an anthracene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or a benzoquinazoline group),
   * indicates a binding site to M² in Formulae 2A, 2B, 2C1, 2C2 and 2D, and
   *" indicates a binding site to ring A₁, ring A₃, or ring A₅.

In one or more embodiments, a group represented by 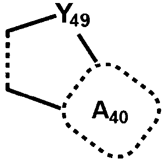 in Formulae CR24 to CR29 may be a group represented by one of Formulae CR(1) to CR(13): 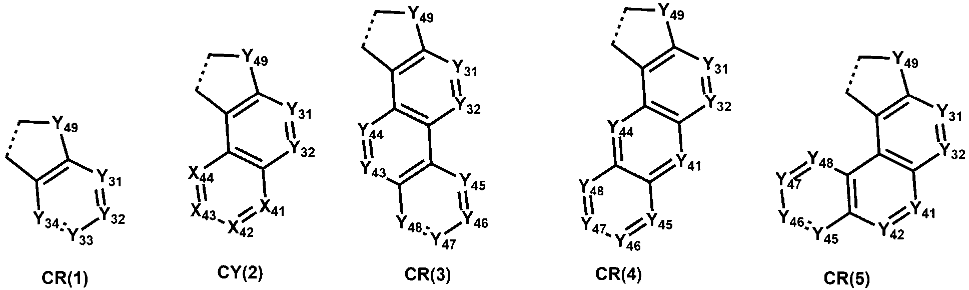 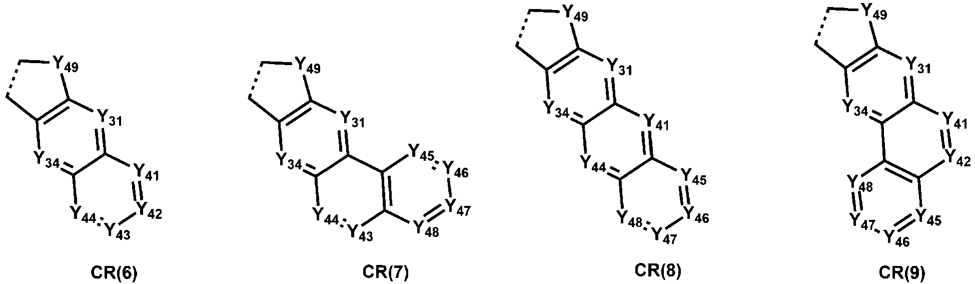 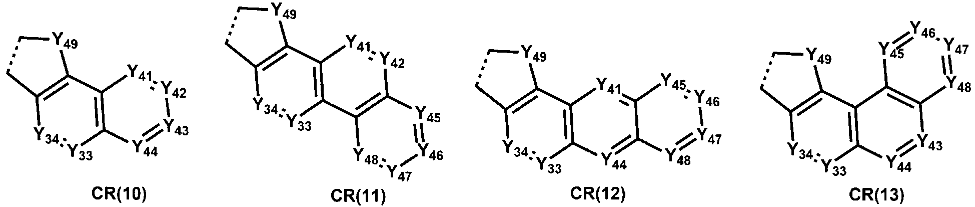 wherein, in Formulae CR(1) to CR(13),
Y₄₉ may be the same as described herein, and
Y₃₁ to Y₃₄ and Y₄₁ to Y₄₈ may each independently be C or N.

In one or more embodiments, each of the platinum-containing organometallic compound and the iridium-containing organometallic compound may include at least one deuterium.

For example, in one or more embodiments, the platinum-containing organometallic compound may be a compound represented by Formula 1-1(1) or a compound represented by Formula 1-2(1): 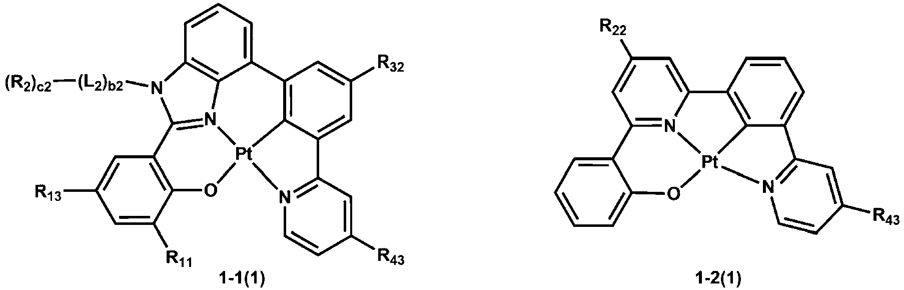 wherein, in Formulae 1-1(1) and 1-2(1),
R₁₁ and R₁₃ may each independently be a C₁-C₁₀ alkyl group unsubstituted or substituted with deuterium,
L₂ may be a benzene group unsubstituted or substituted with deuterium, a C₁-C₁₀ alkyl group, a C₃-C₁₀ cycloalkyl group, a phenyl group, a biphenyl group, or a combination thereof,
b2 may be 1 or 2,
c2 may be 0, 1, or 2,
R₂ and R₃₂ may each independently be:
   a C₁-C₁₀ alkyl group unsubstituted or substituted with deuterium, a C₃-C₁₀ cycloalkyl group, or a combination thereof; or
   a phenyl group unsubstituted or substituted with deuterium, a C₁-C₁₀ alkyl group, a C₃-C₁₀ cycloalkyl group, a phenyl group, a biphenyl group, or a combination thereof, and
   R₂₂ and R₄₃ may each independently be a phenyl group unsubstituted or substituted with deuterium, a C₁-C₁₀ alkyl group, a C₃-C₁₀ cycloalkyl group, a phenyl group, a biphenyl group, or a combination thereof.

In one or more embodiments, the iridium-containing organometallic compound may be the organometallic compound represented by Formula 2A or the organometallic compound represented by Formula 2B.

The group represented by 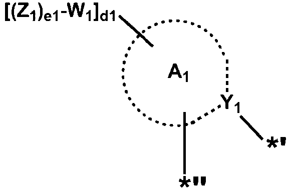
in Formula 2-1 may be a group represented by Formula A1-1, the group represented by 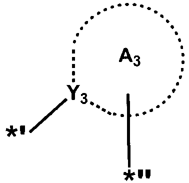
in Formula 2-2 may be a group represented by one of Formulae NR1, NR29, NR30, or NR37 to NR48,
   the group represented by 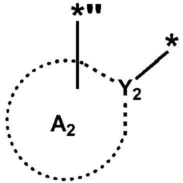
in Formula 2-1 may be a group represented by one of Formulae CR1, CR2, CR5, CR8, or CR24 to CR29,
   the group represented by 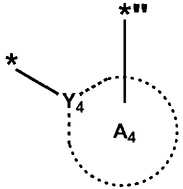
in Formula 2-2 may be a group represented by one of Formulae CR24 to CR29, W₂ to W₄ in Formulae 2A and 2B may each independently be:
   a single bond; or
   a benzene group unsubstituted or substituted with deuterium, -F, a C₁-C₁₀ alkyl group, a C₃-C₁₀ cycloalkyl group, a phenyl group, a biphenyl group, or a combination thereof,
   Z₁₁ to Z₁₄ in Formula A1-1 and Z₂ to Z₄ in Formula 2A may each independently be:
      hydrogen, deuterium, or -F;
      a C₁-C₁₀ alkyl group unsubstituted or substituted with deuterium, -F, a phenyl group, or a combination thereof;
      a phenyl group unsubstituted or substituted with deuterium, -F, a C₁-C₁₀ alkyl group, a phenyl group, or a combination thereof;
      -Si(Q₃)(Q₄)(Q₅); or
      -Ge(Q₃)(Q₄)(Q₅),
      Q₃ to Q₅ may each independently be a C₁-C₁₀ alkyl group or a deuterated C₁-C₁₀ alkyl group, and
      e2 to e4 and d2 to d4 may each independently be 0, 1, 2, or 3.

The C₁-C₁₀ alkyl group may include, for example, a methyl group, ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like.

The C₃-C₁₀ cycloalkyl group may include a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, a bicyclo[2.2.2]octyl group, or the like.

In one or more embodiments, each of the platinum-containing organometallic compound and the iridium-containing organometallic compound may include deuterium, a fluoro group, Si, Ge, or a combination thereof. For example, each of the platinum-containing organometallic compound and the iridium-containing organometallic compound may include deuterium, a fluoro group, a deuterated C₁-C₂₀ alkyl group, a fluorinated C₁-C₂₀ alkyl group, -Si(Q₃)(Q₄)(Q₅), -Ge(Q₃)(Q₄)(Q₅), or a combination thereof, and Q₃ to Q₅ may each independently be a C₁-C₂₀ alkyl group or a phenyl group.

In one or more embodiments, the platinum-containing organometallic compound may be a compound of [Group 1-1] to [Group 1-4], and the iridium-containing organometallic compound may be a compound of [Group 2-1] to [Group 2-8] or Compound SE2:

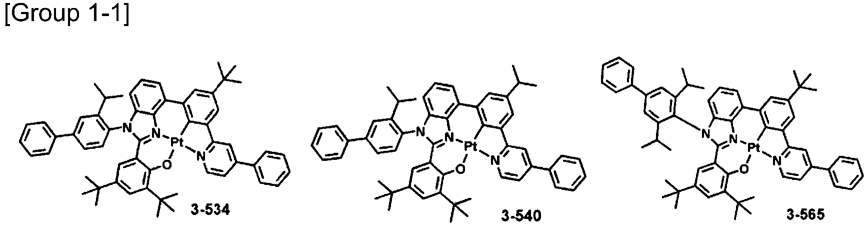

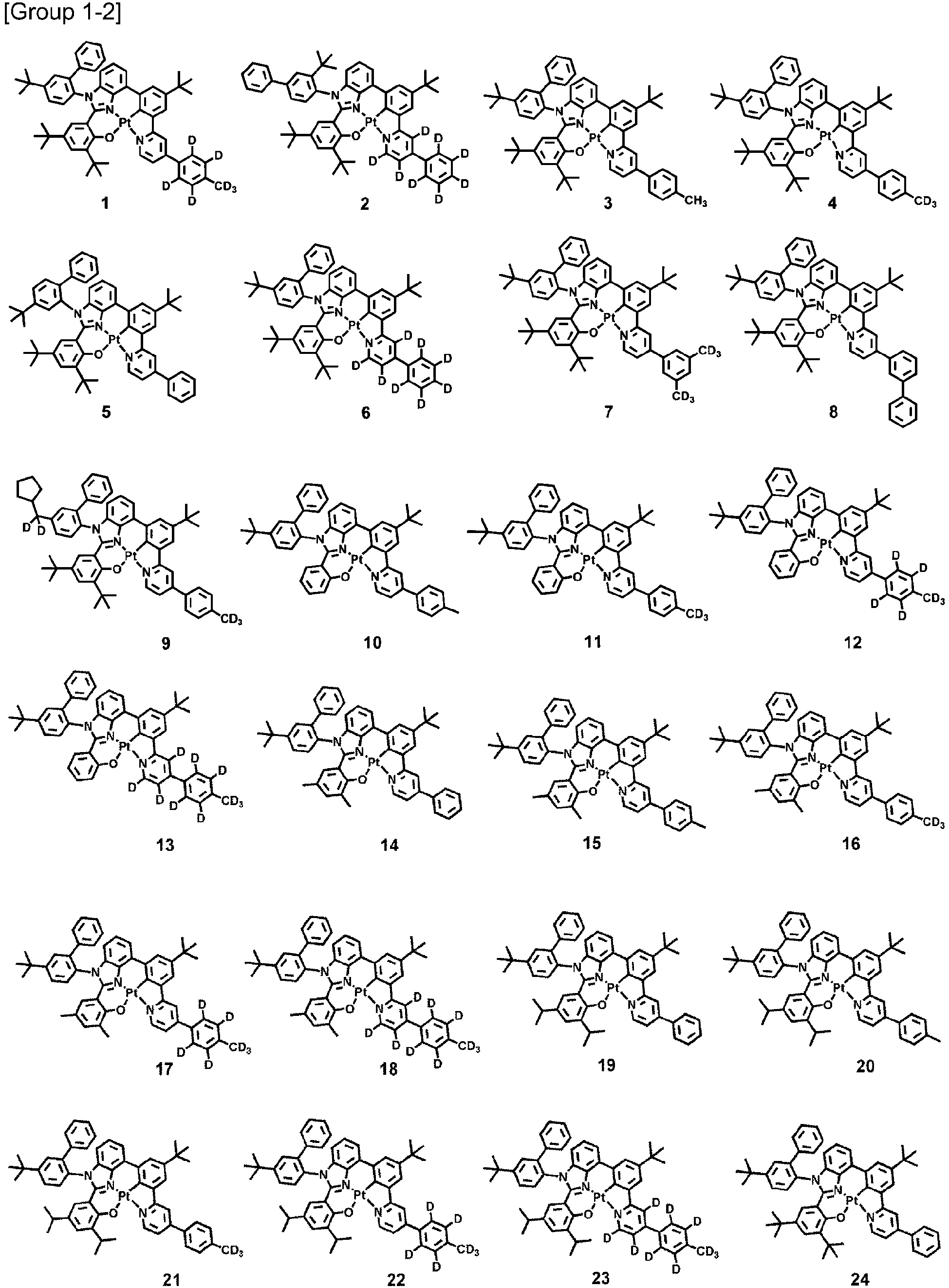

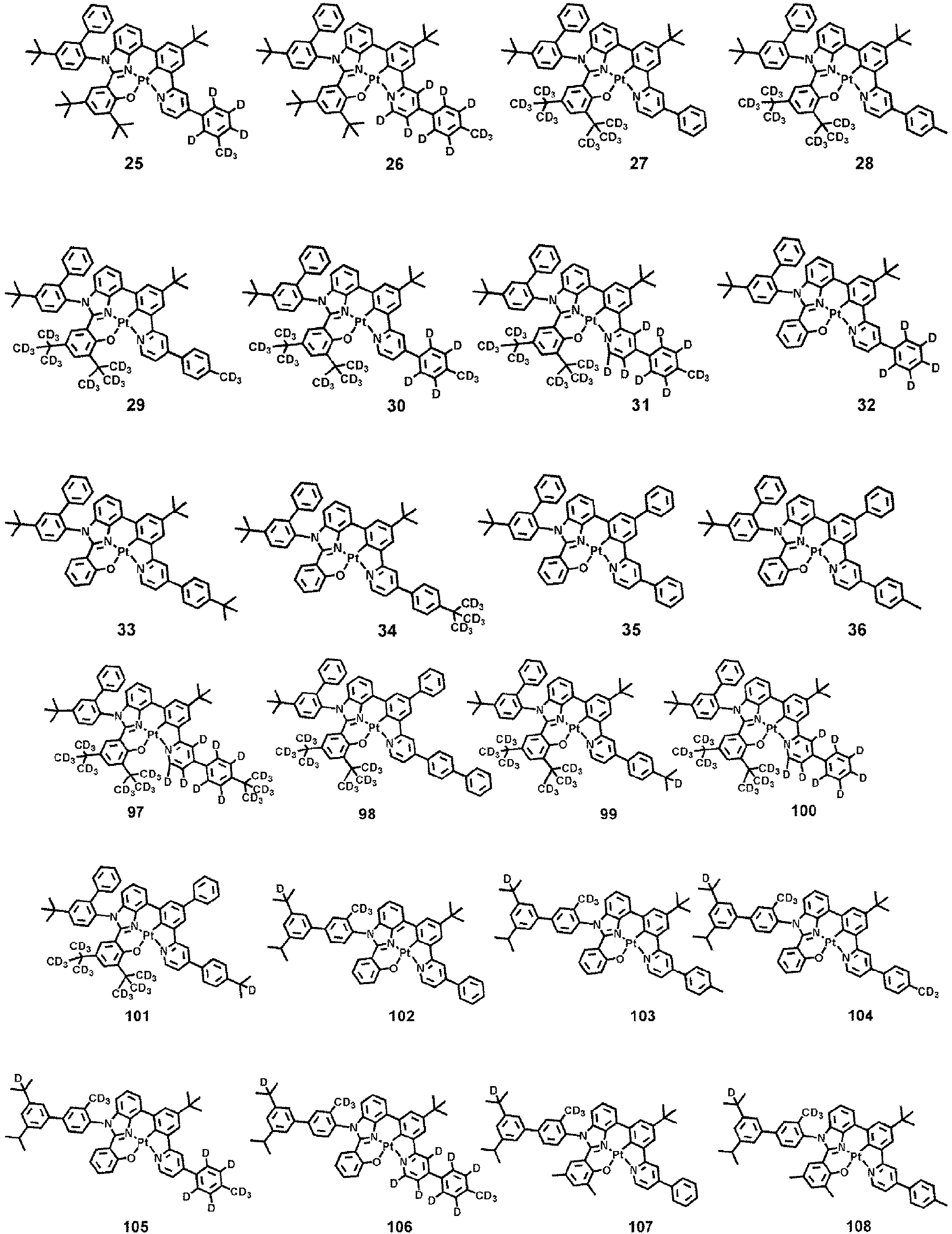

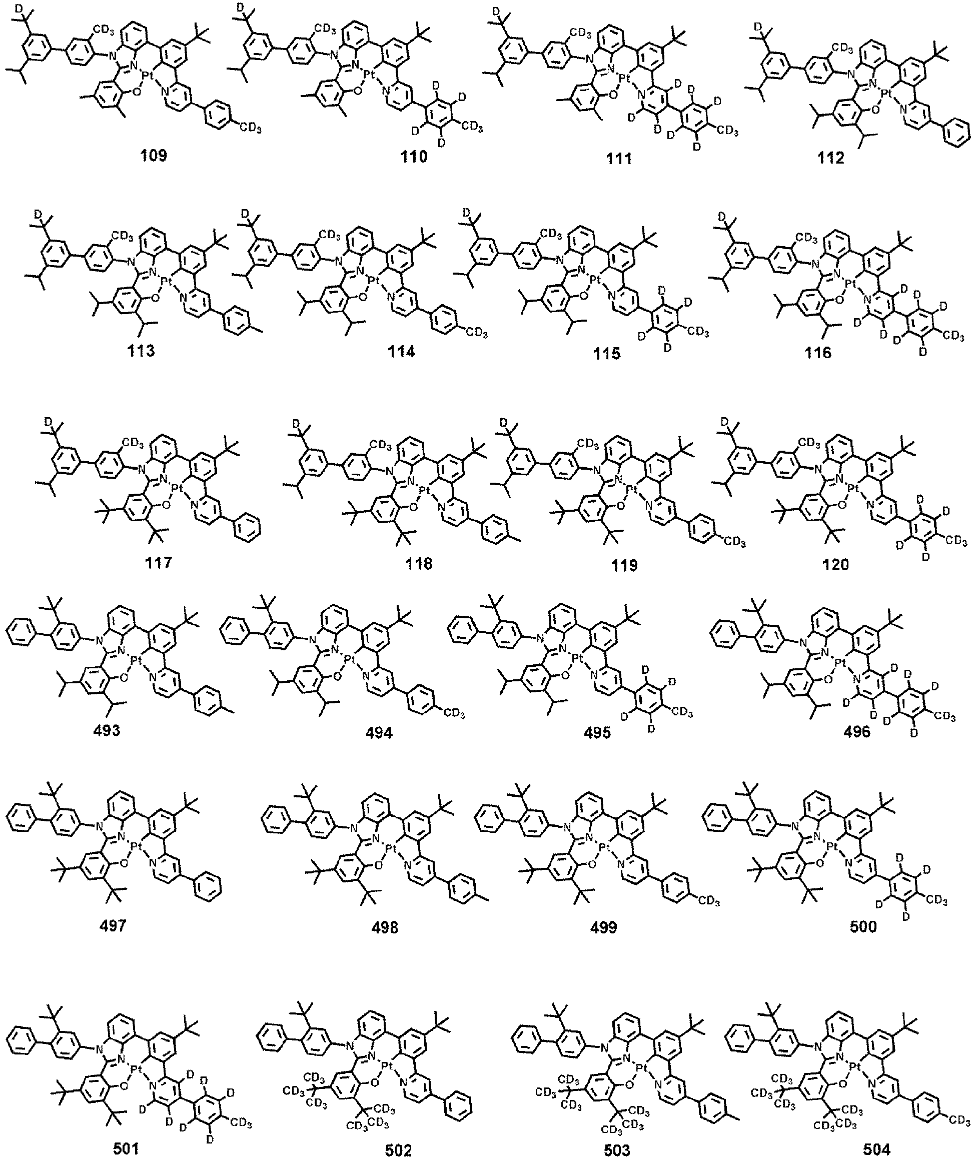

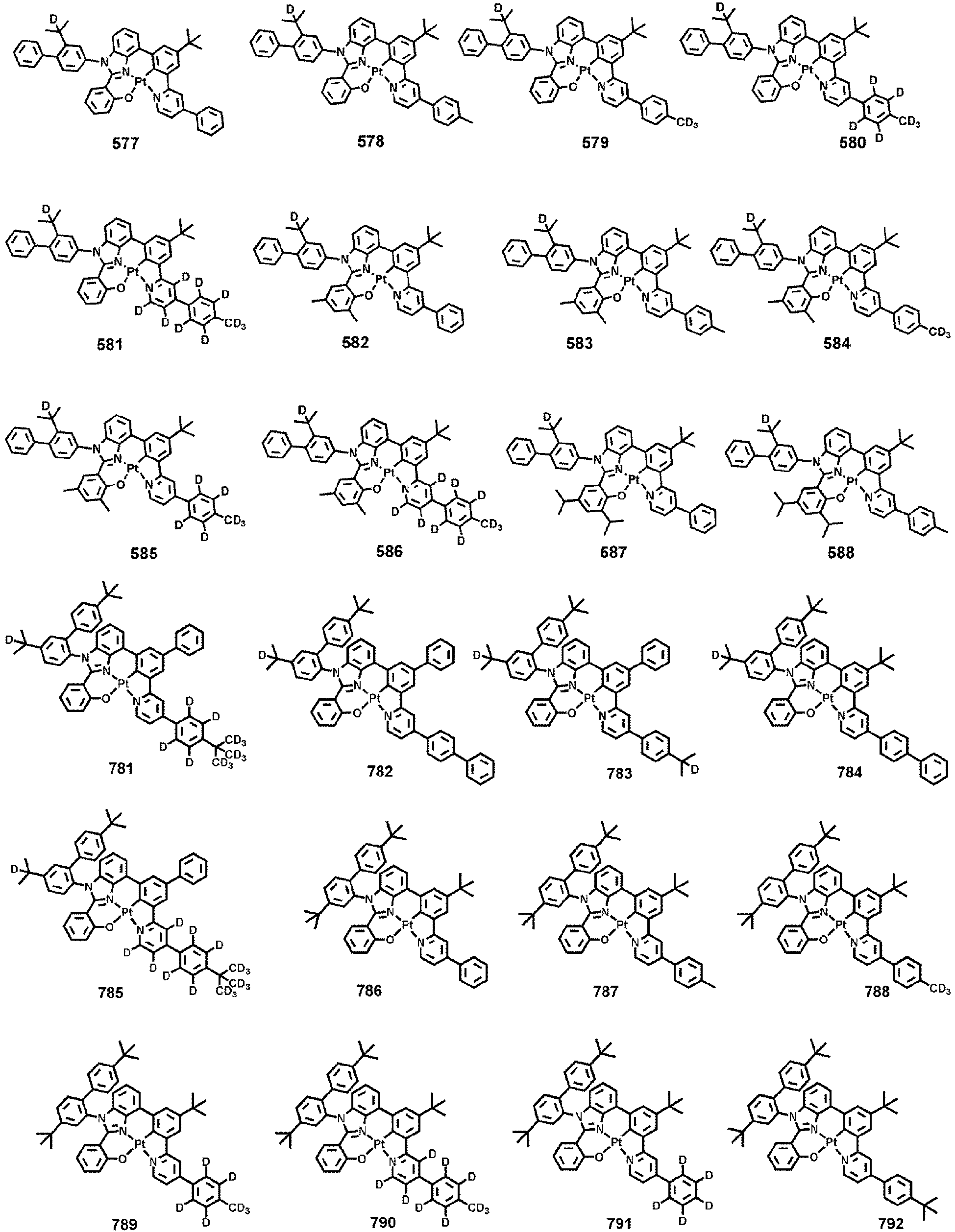

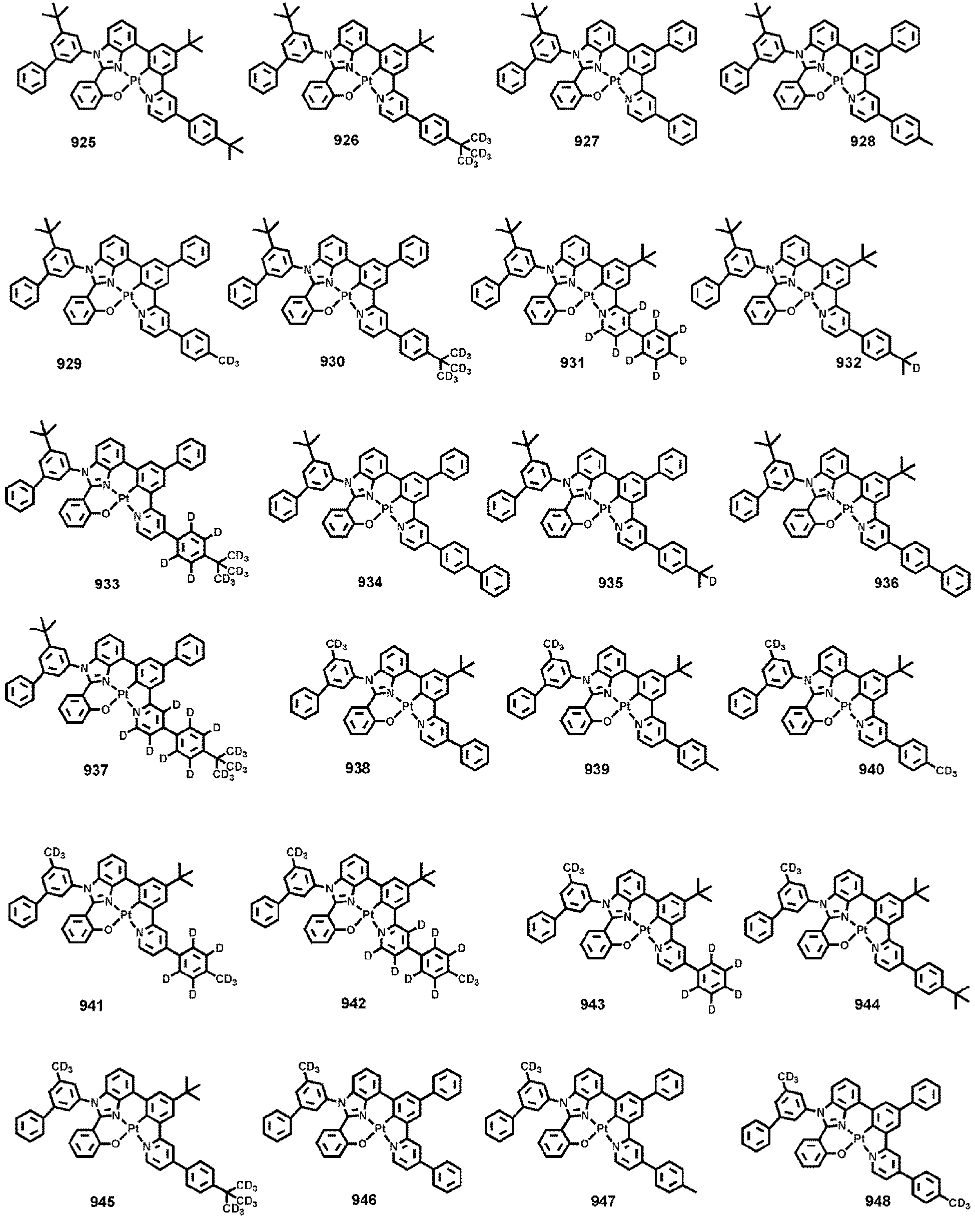

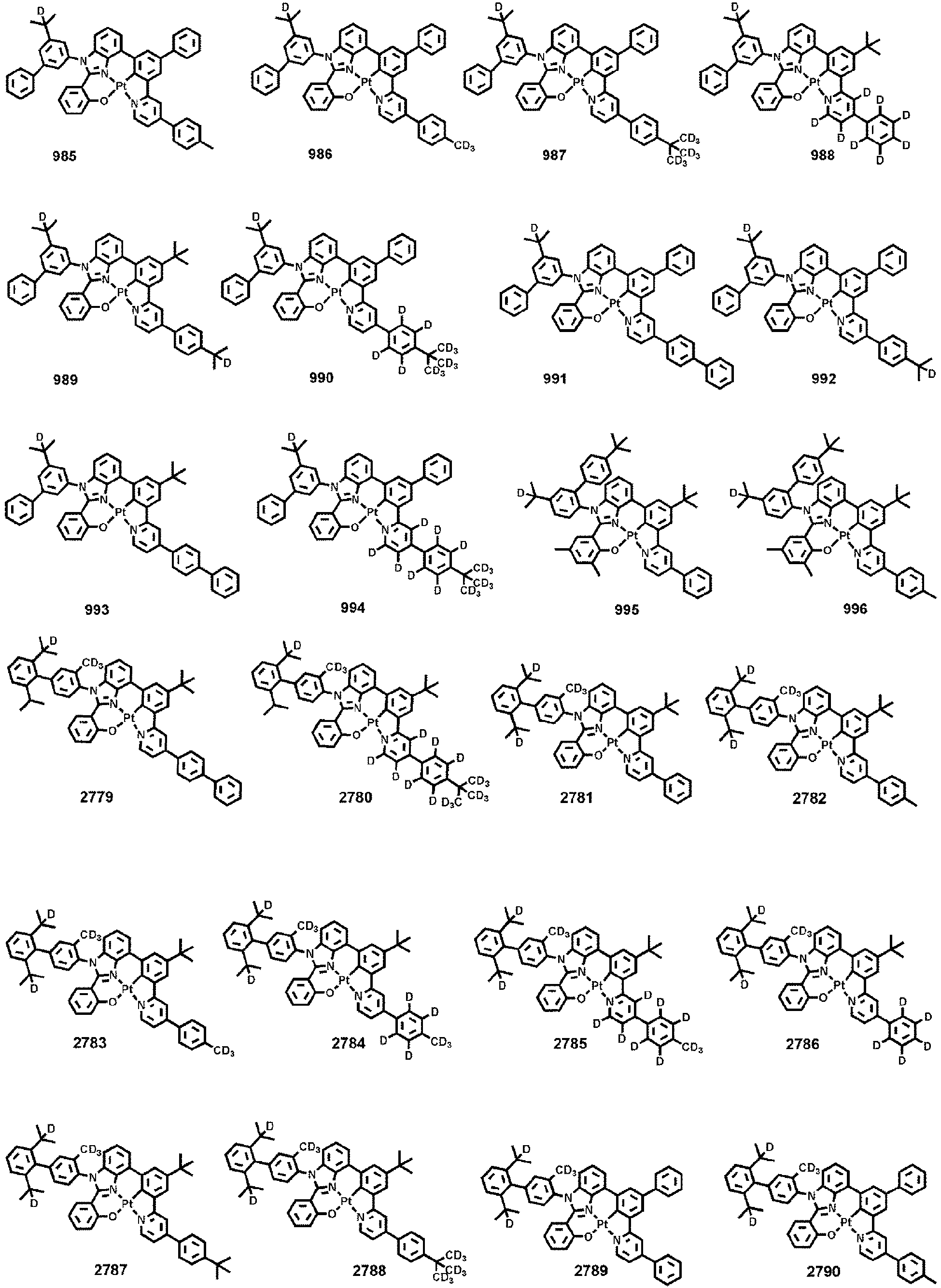

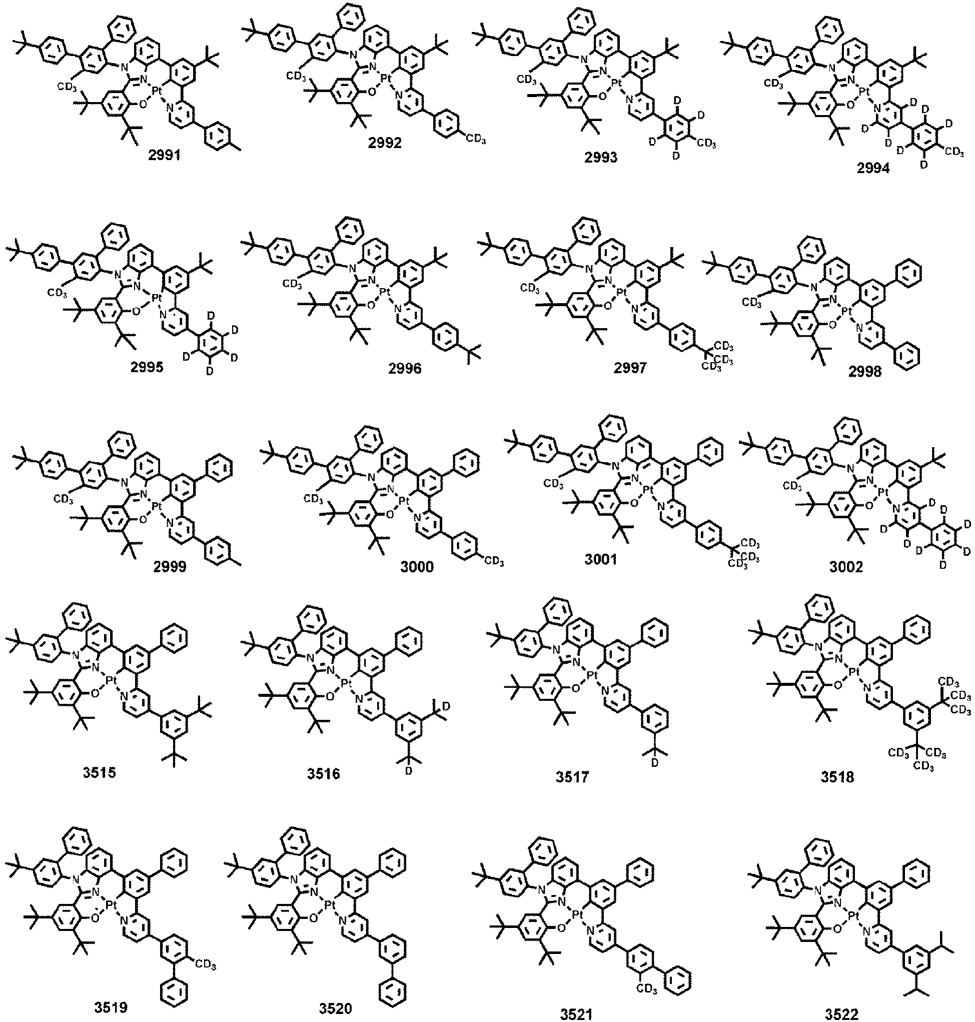

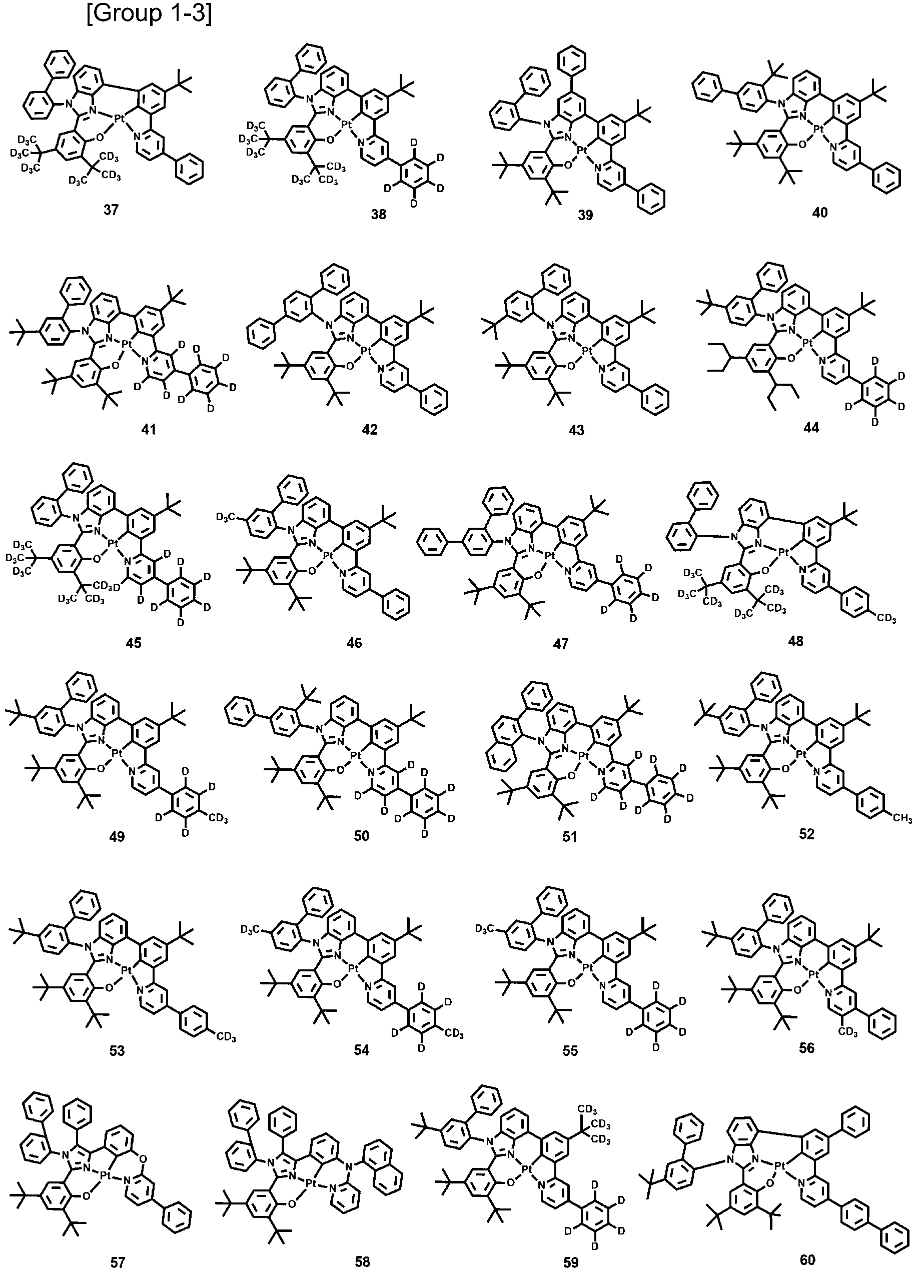

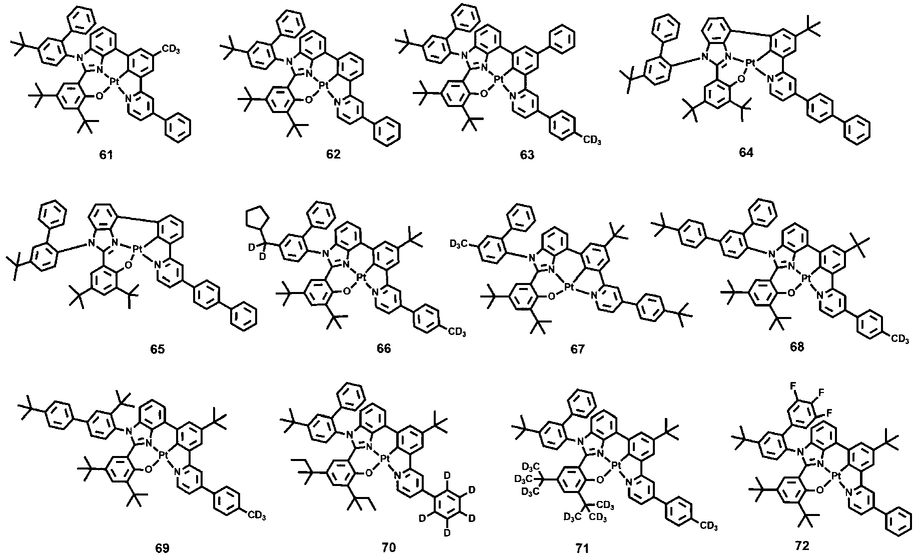

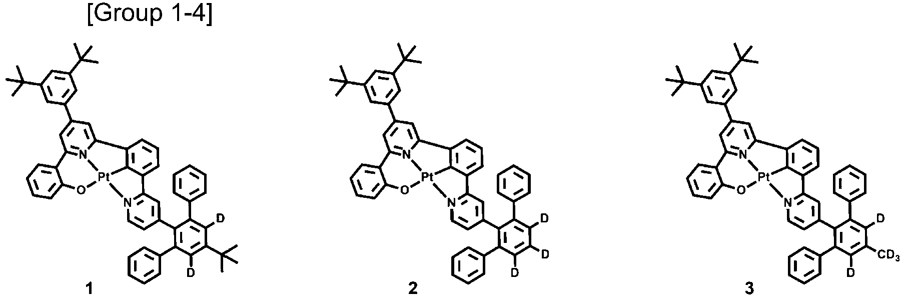

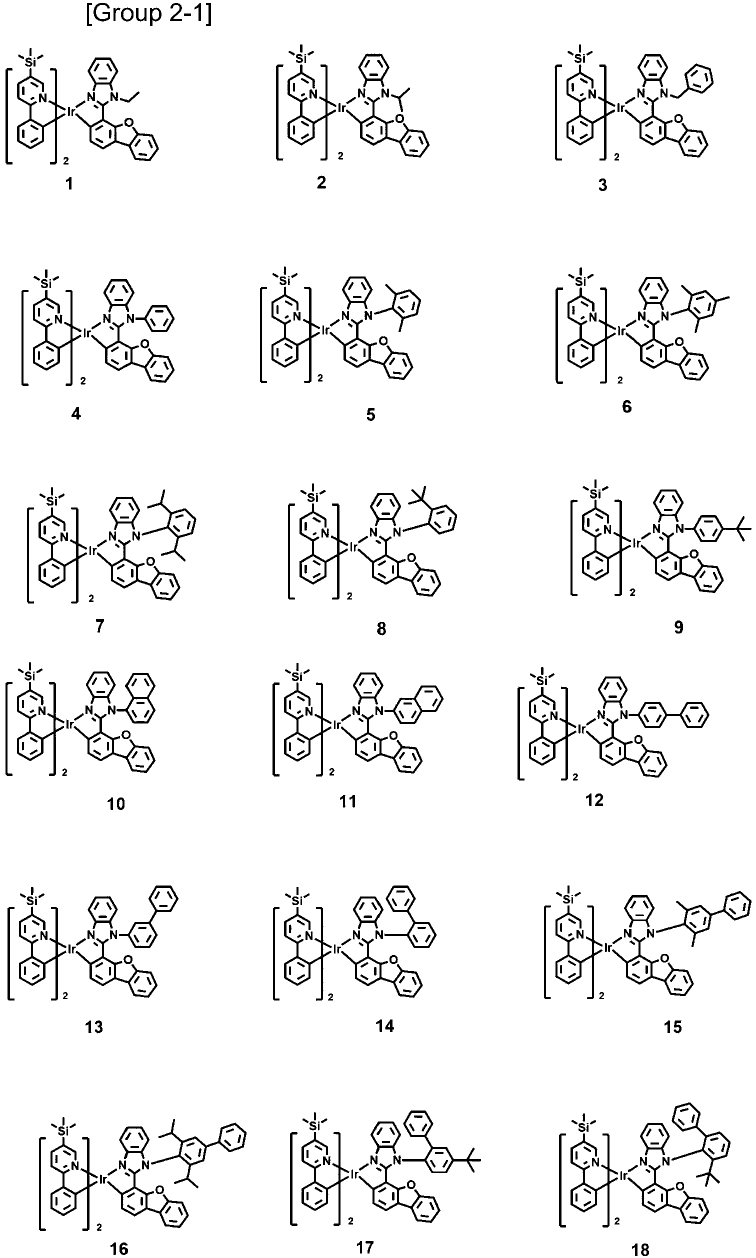

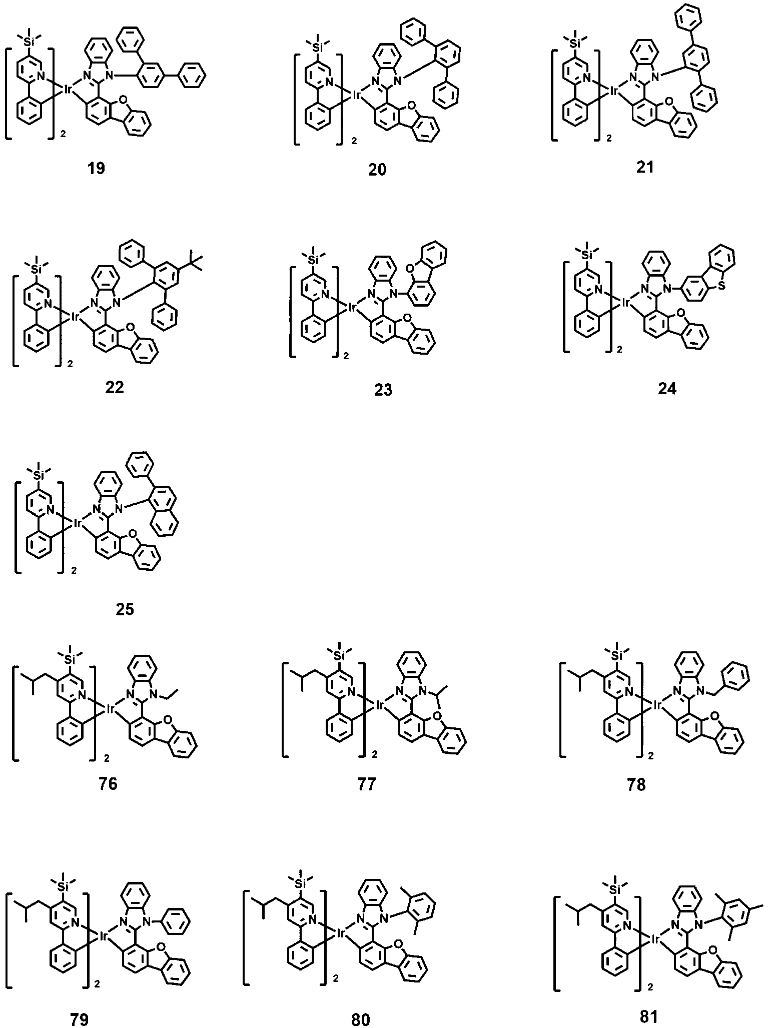

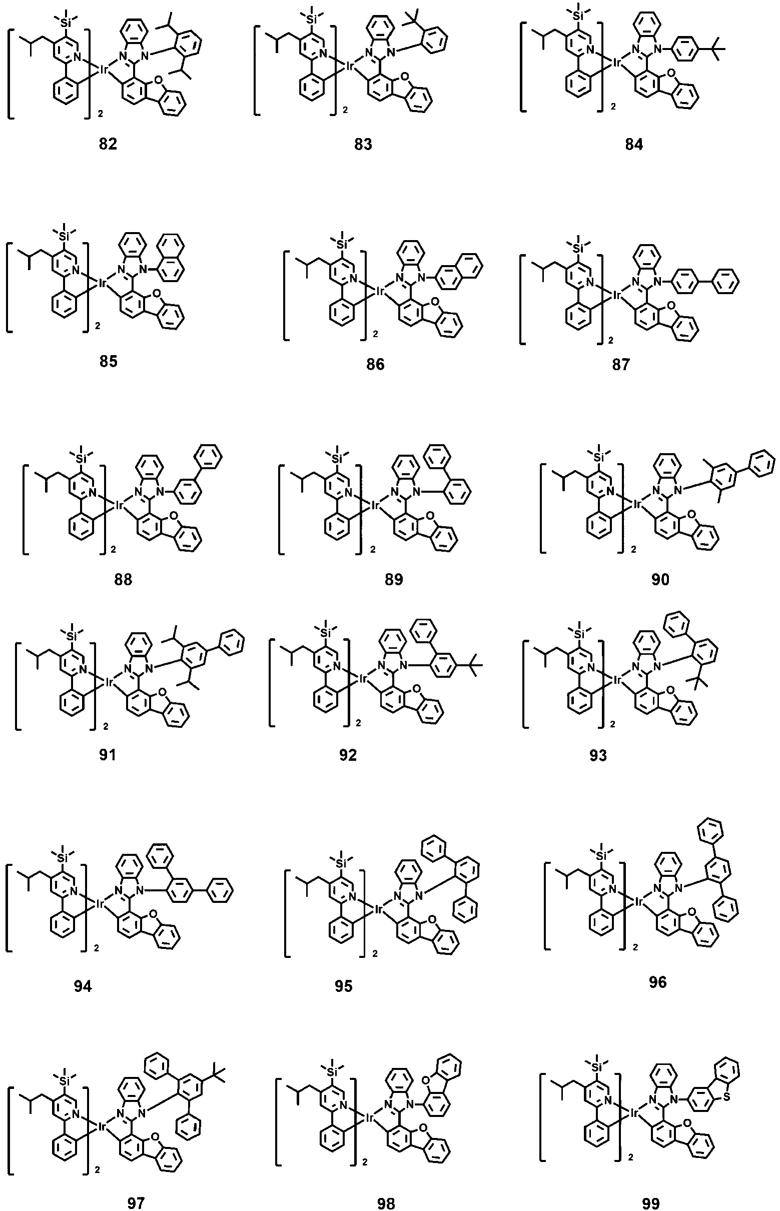

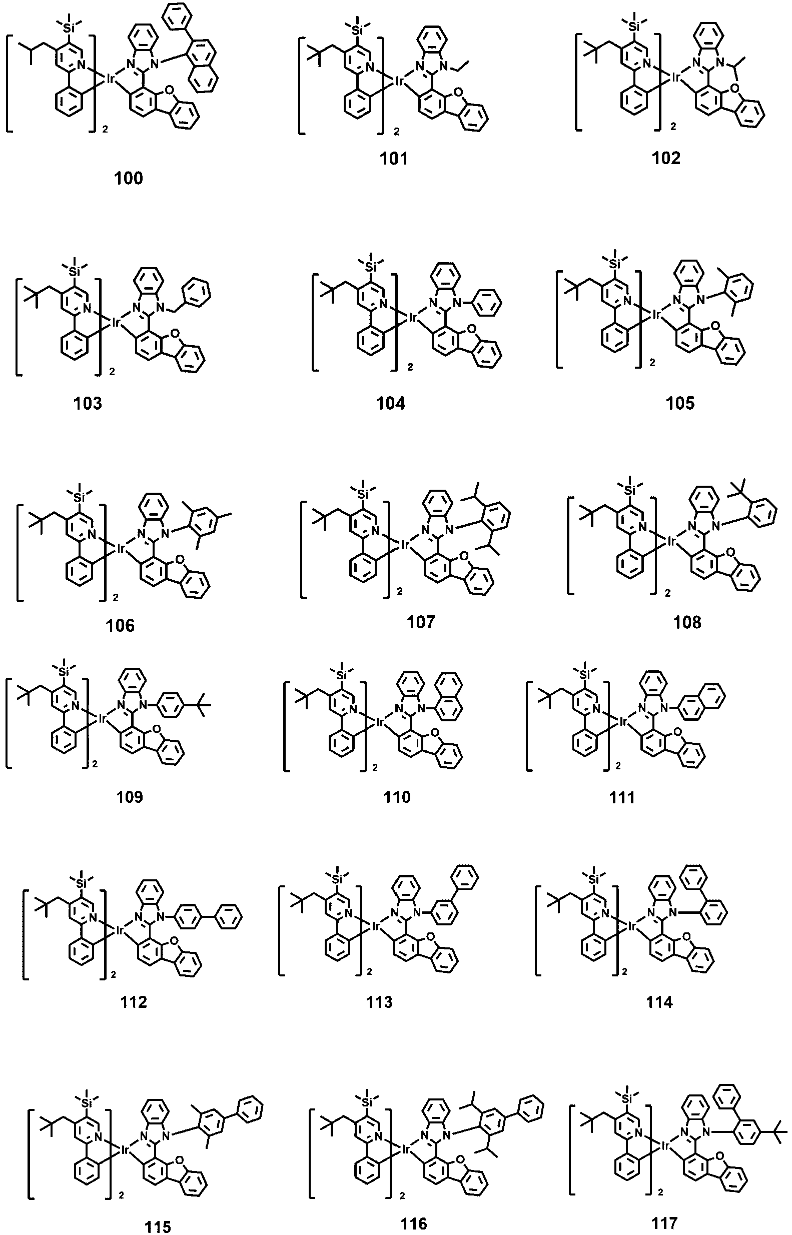

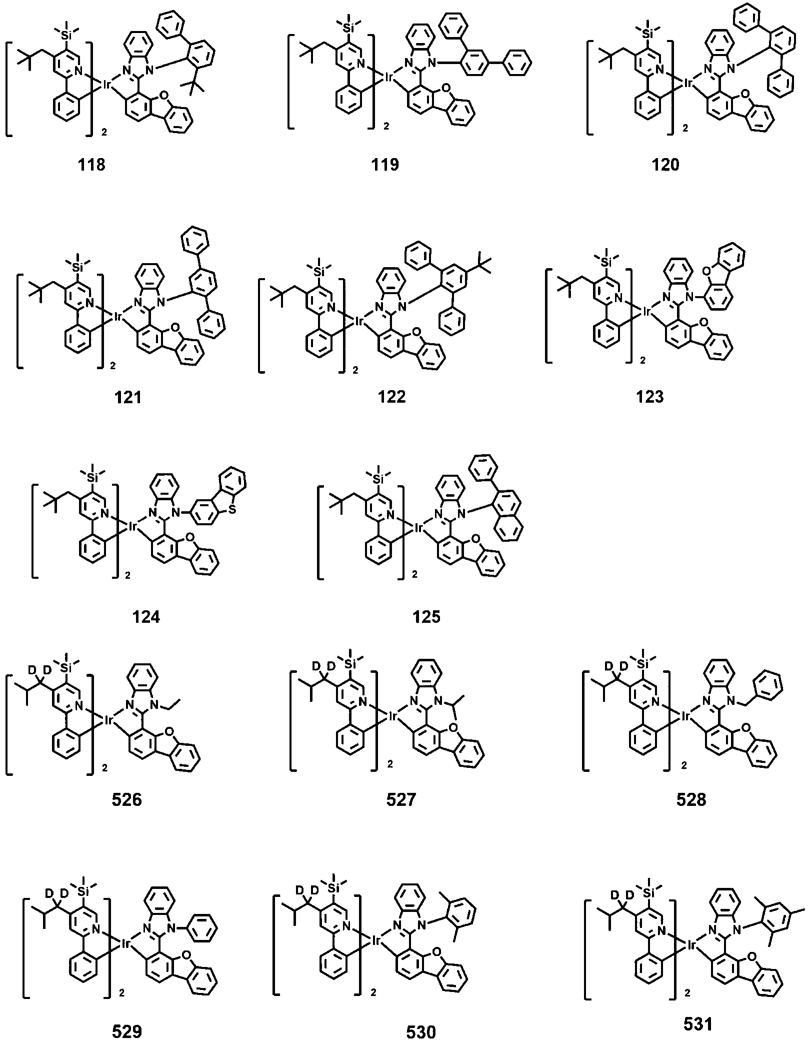

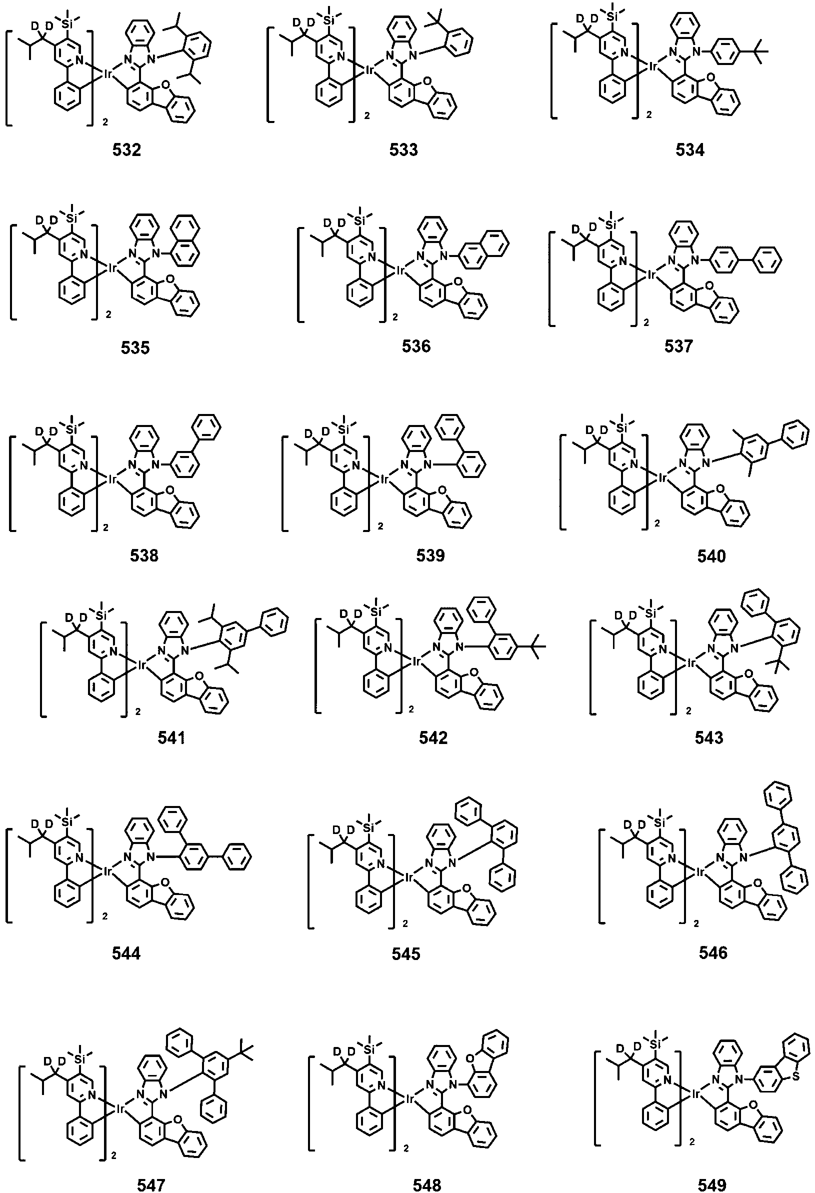

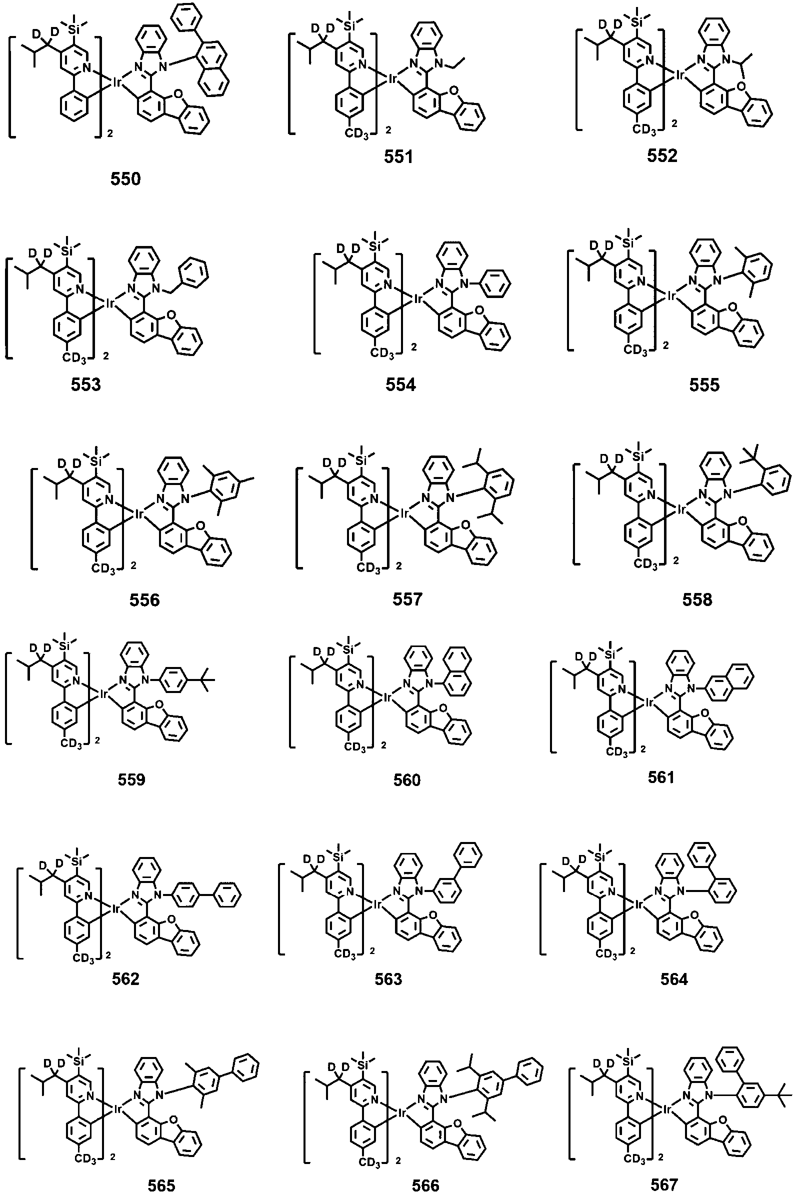

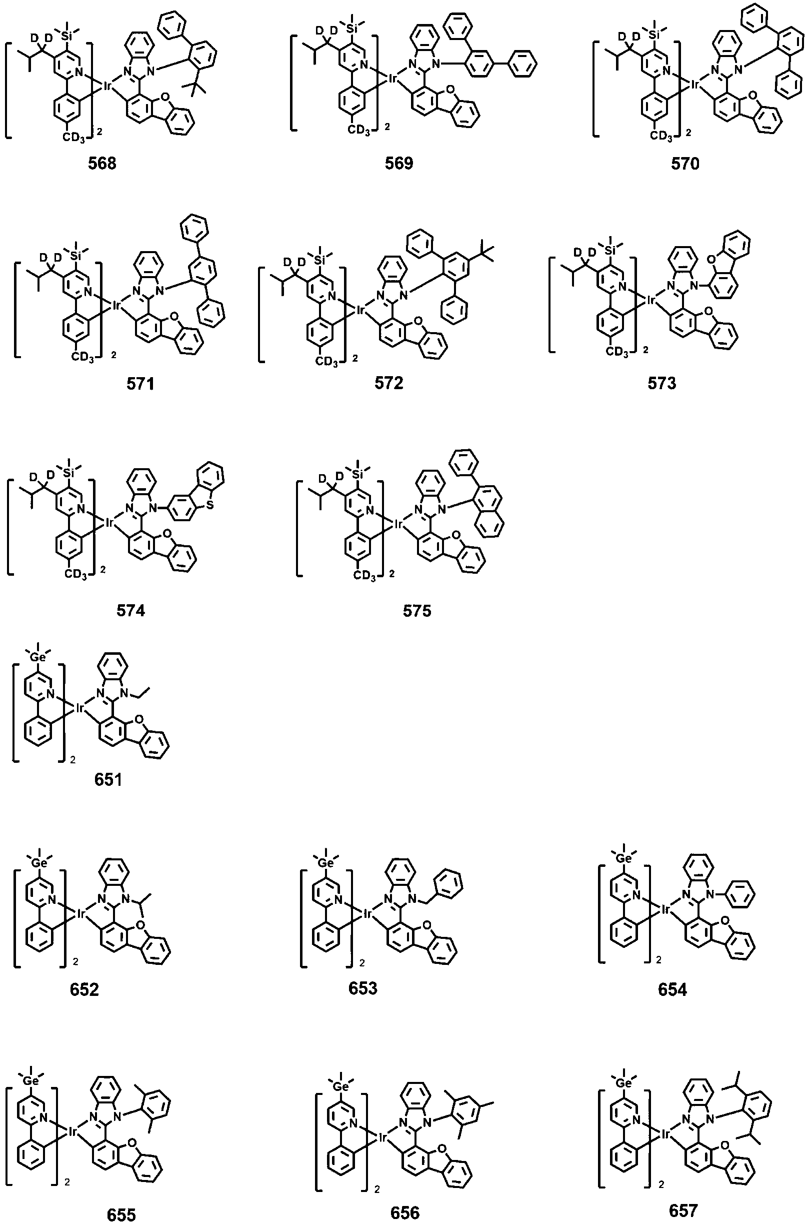

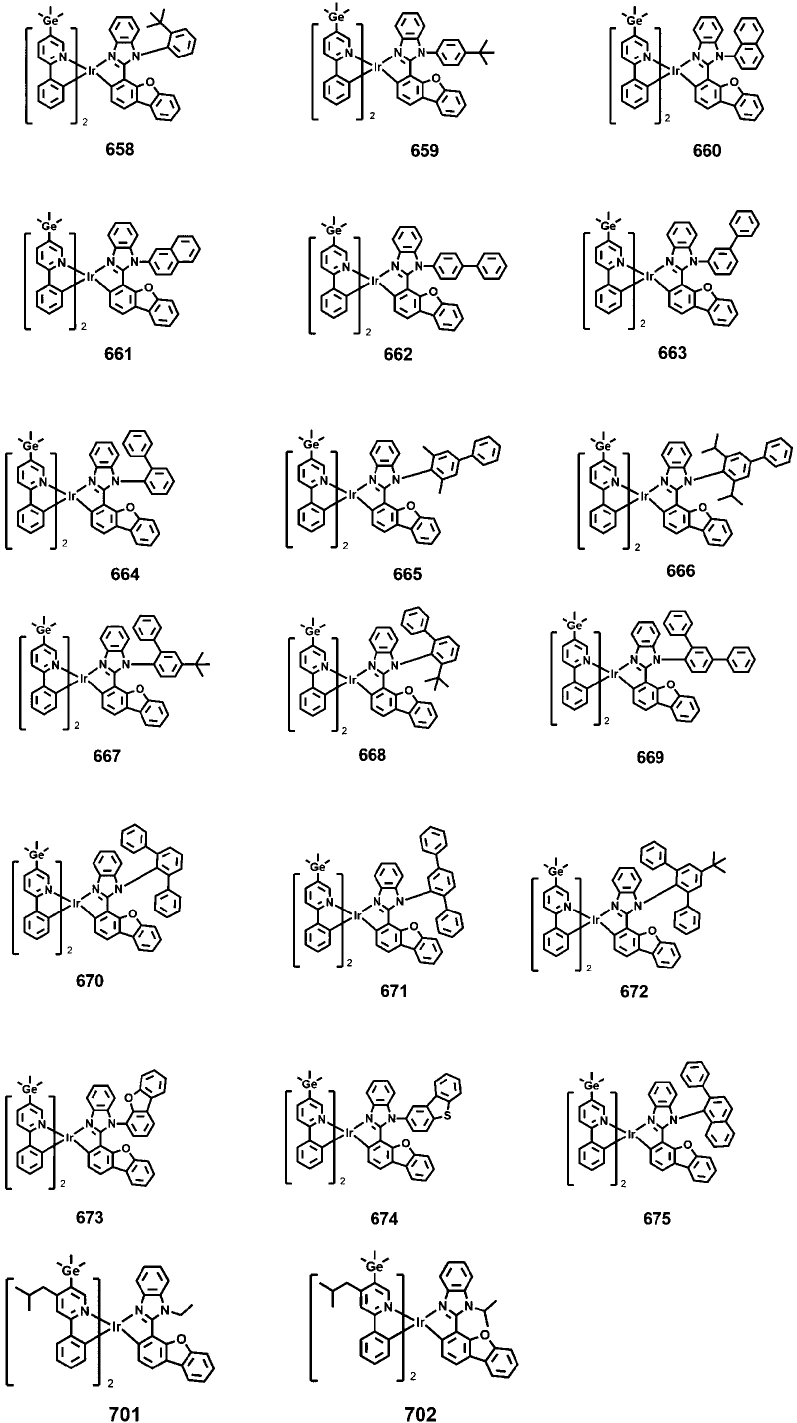

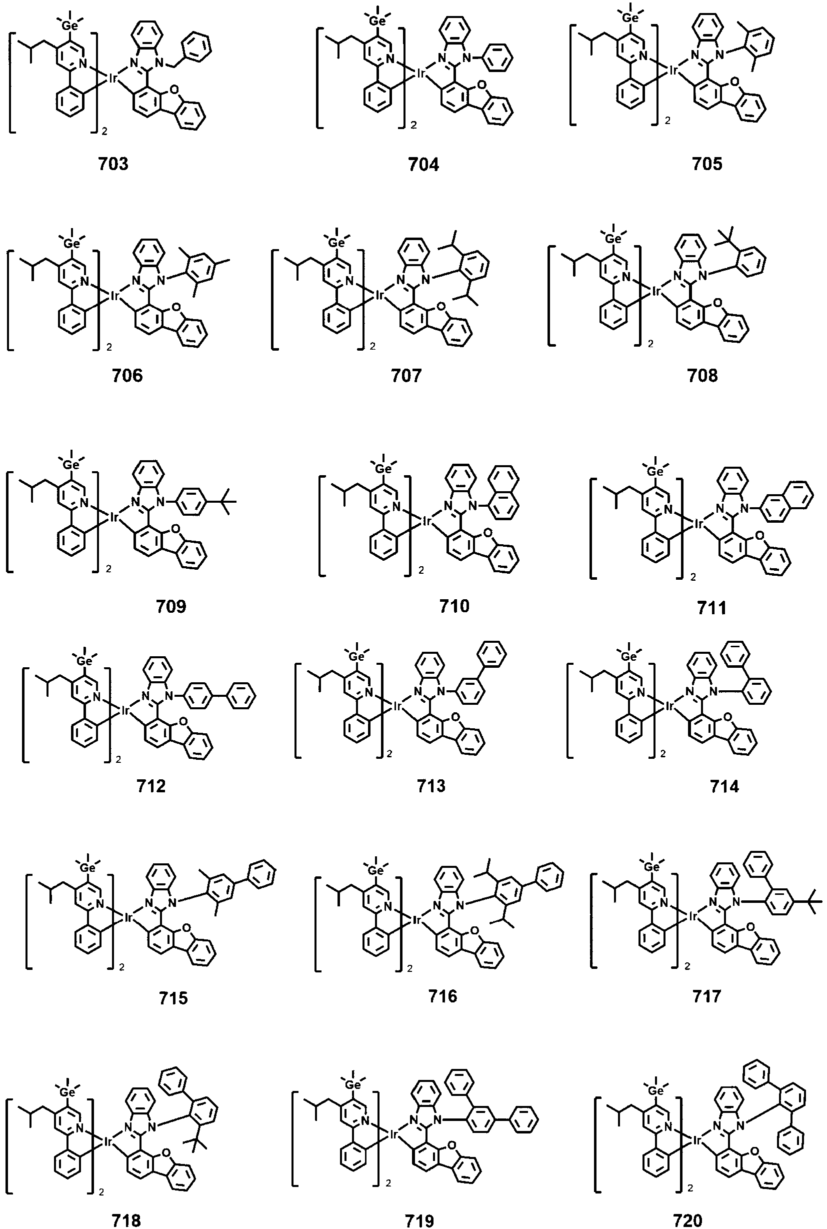

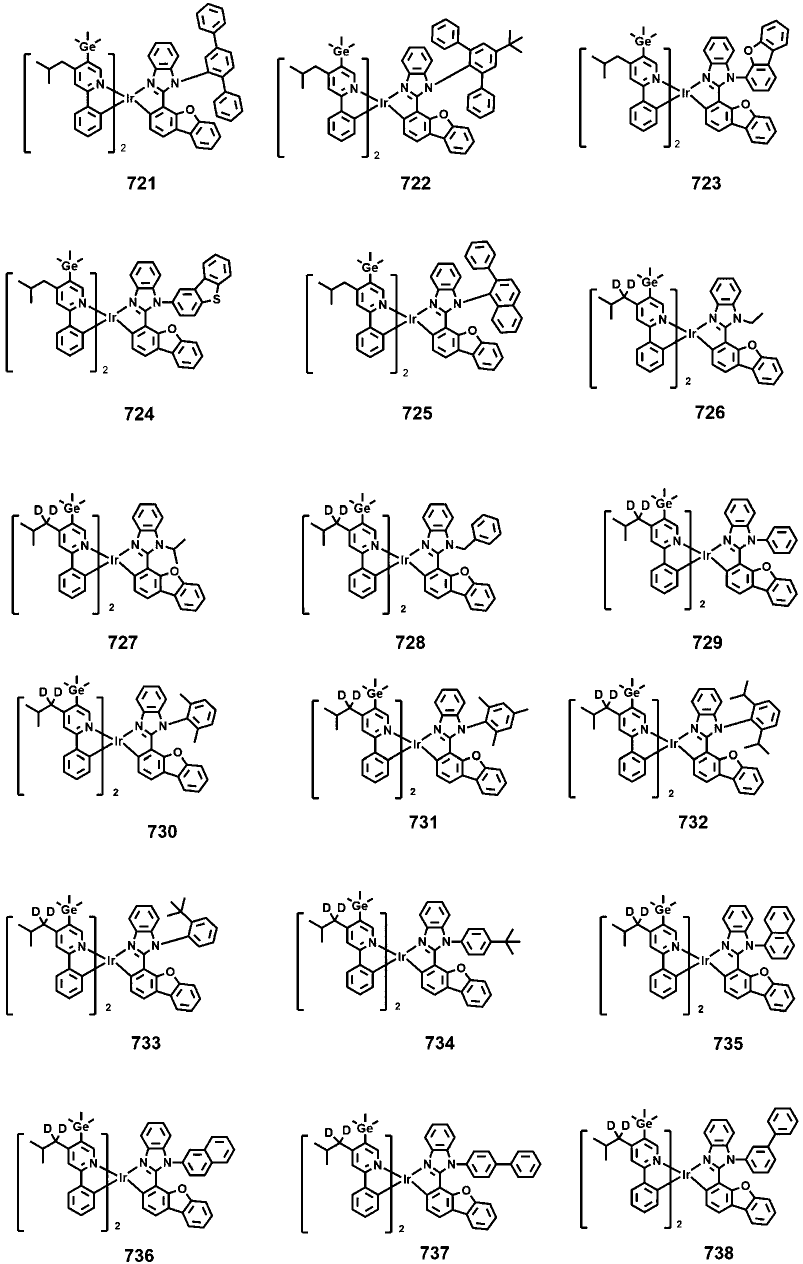

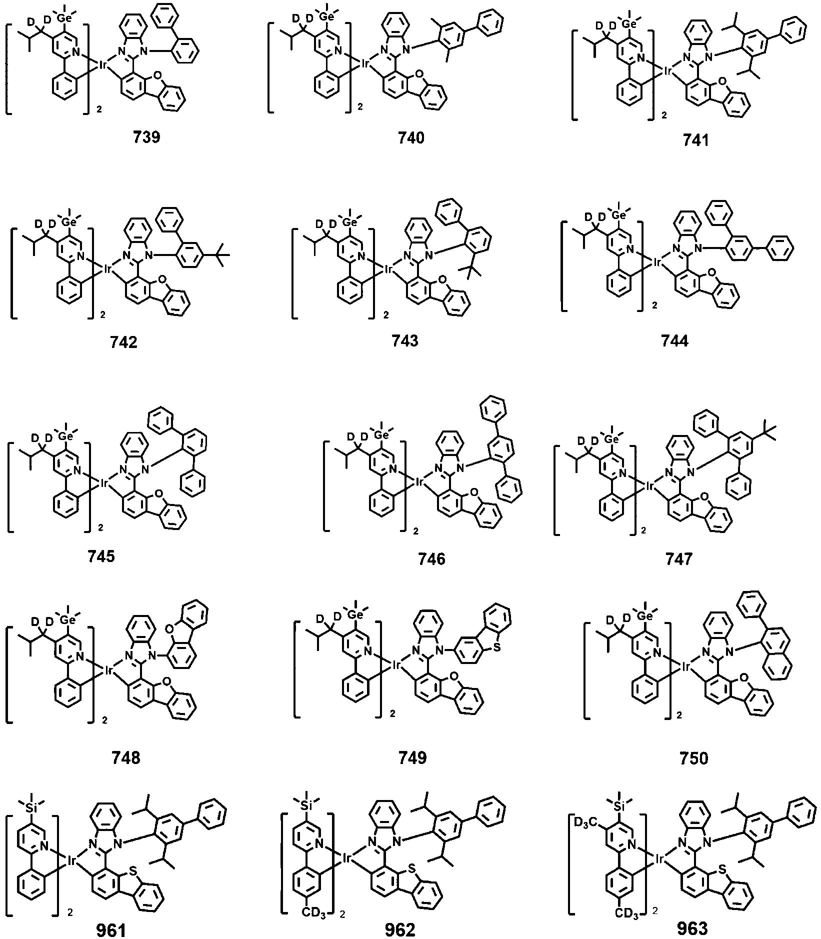

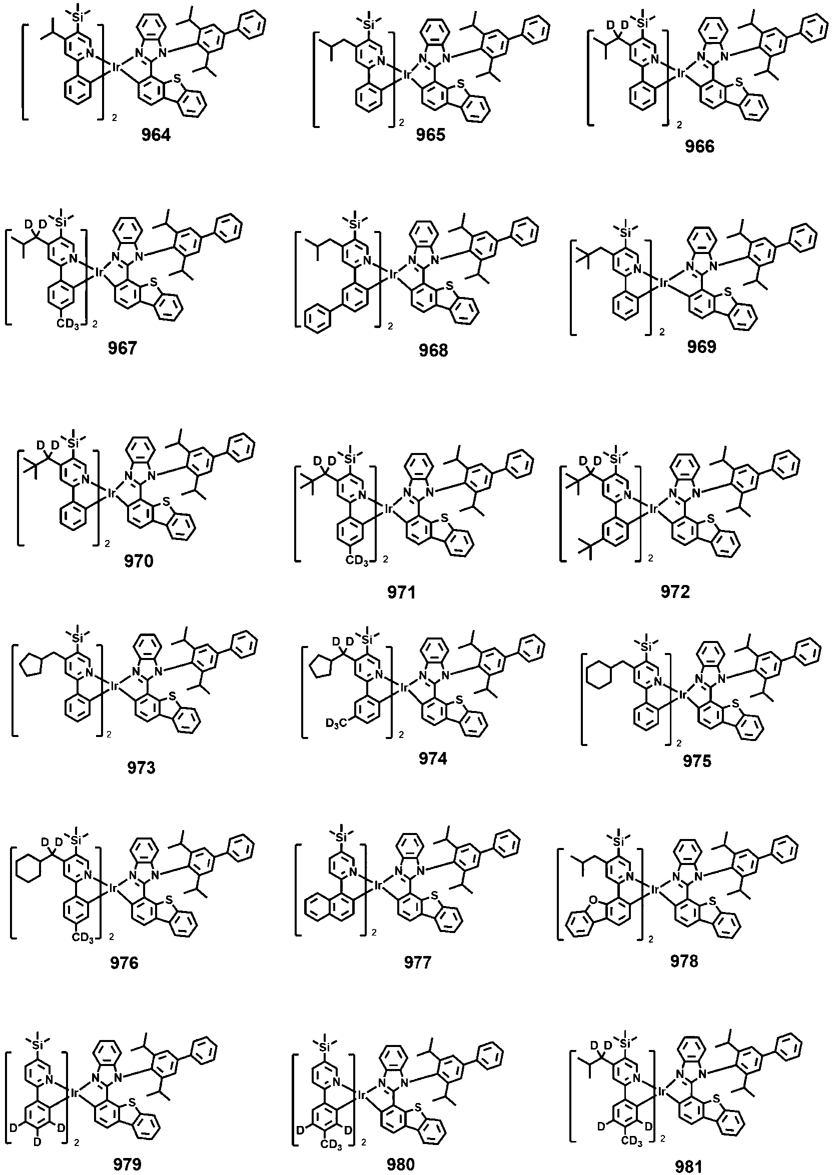

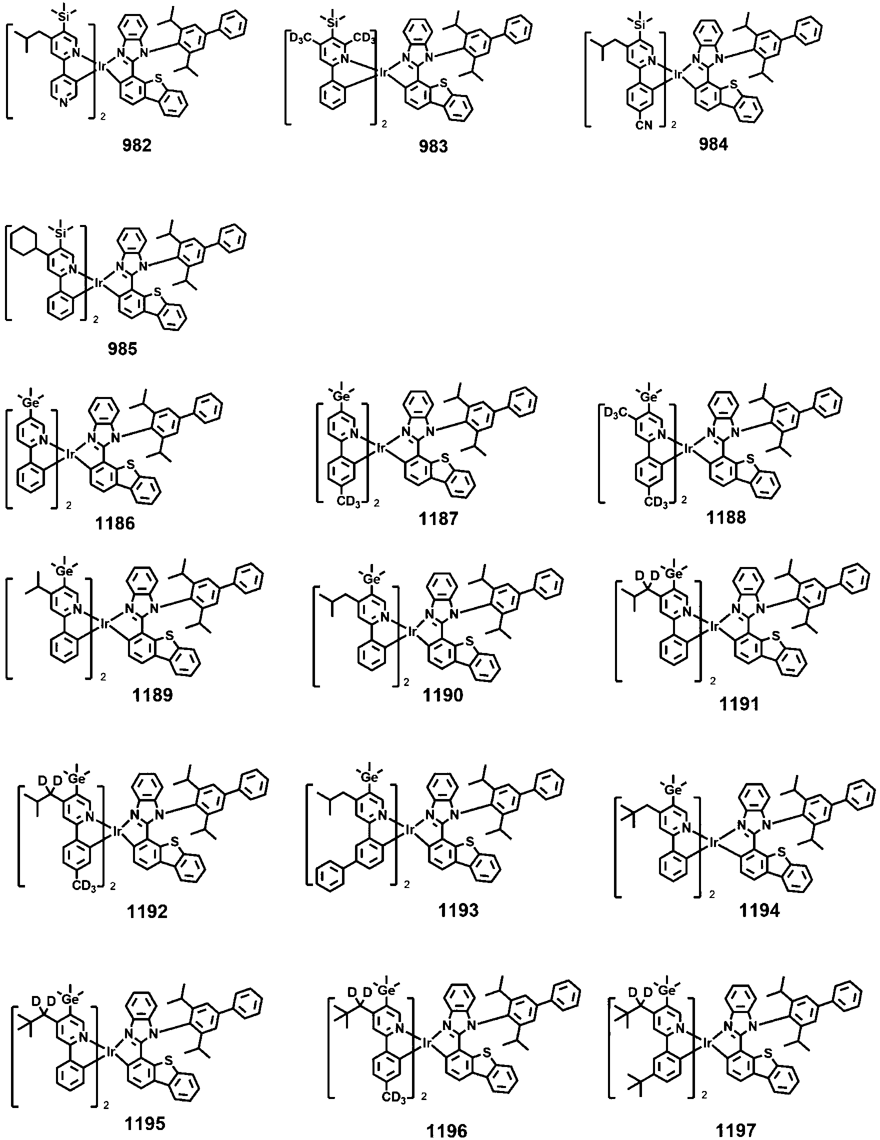

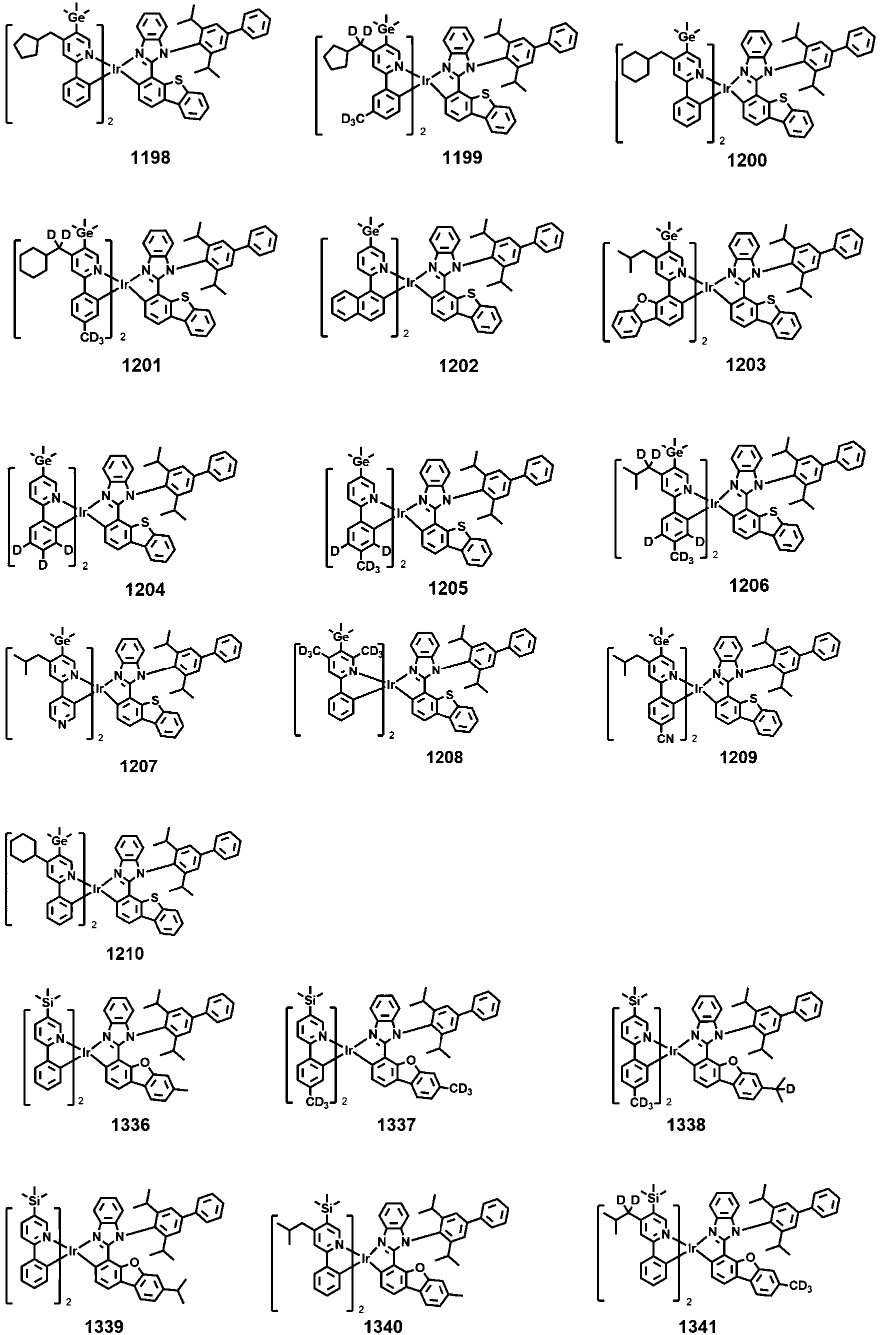

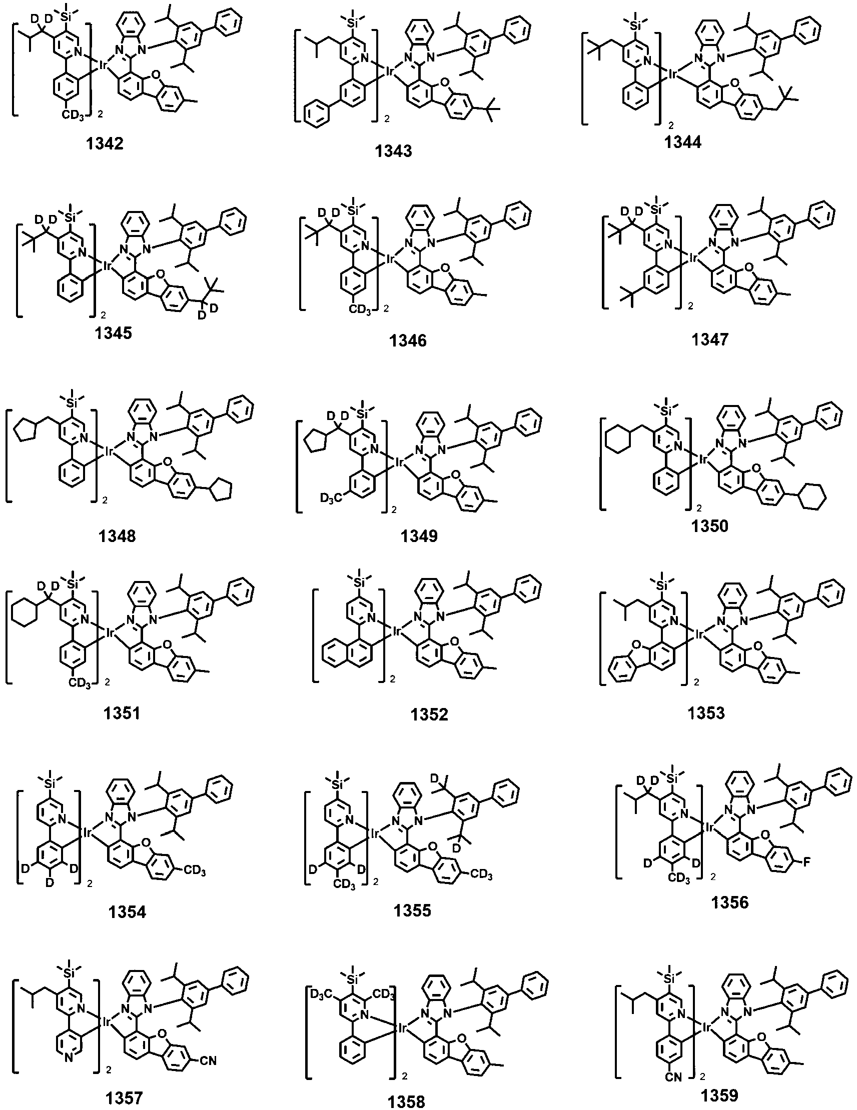

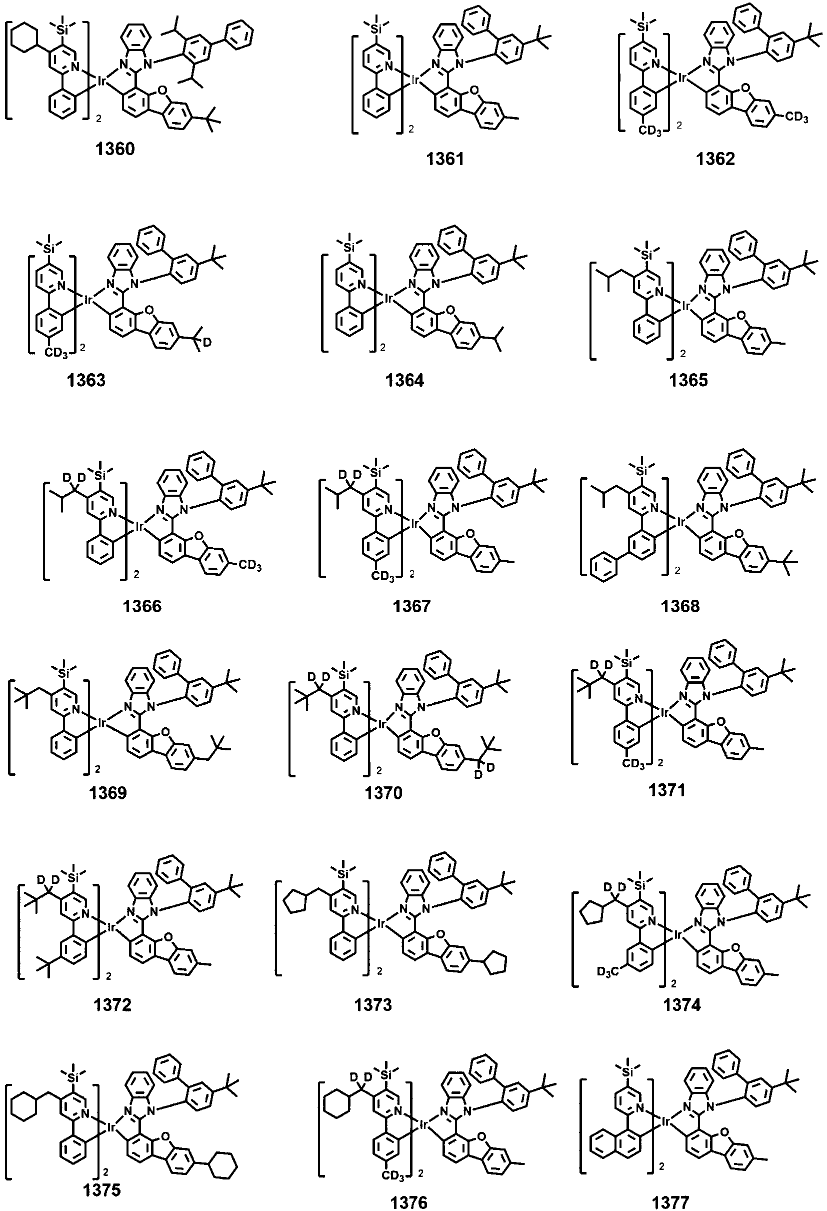

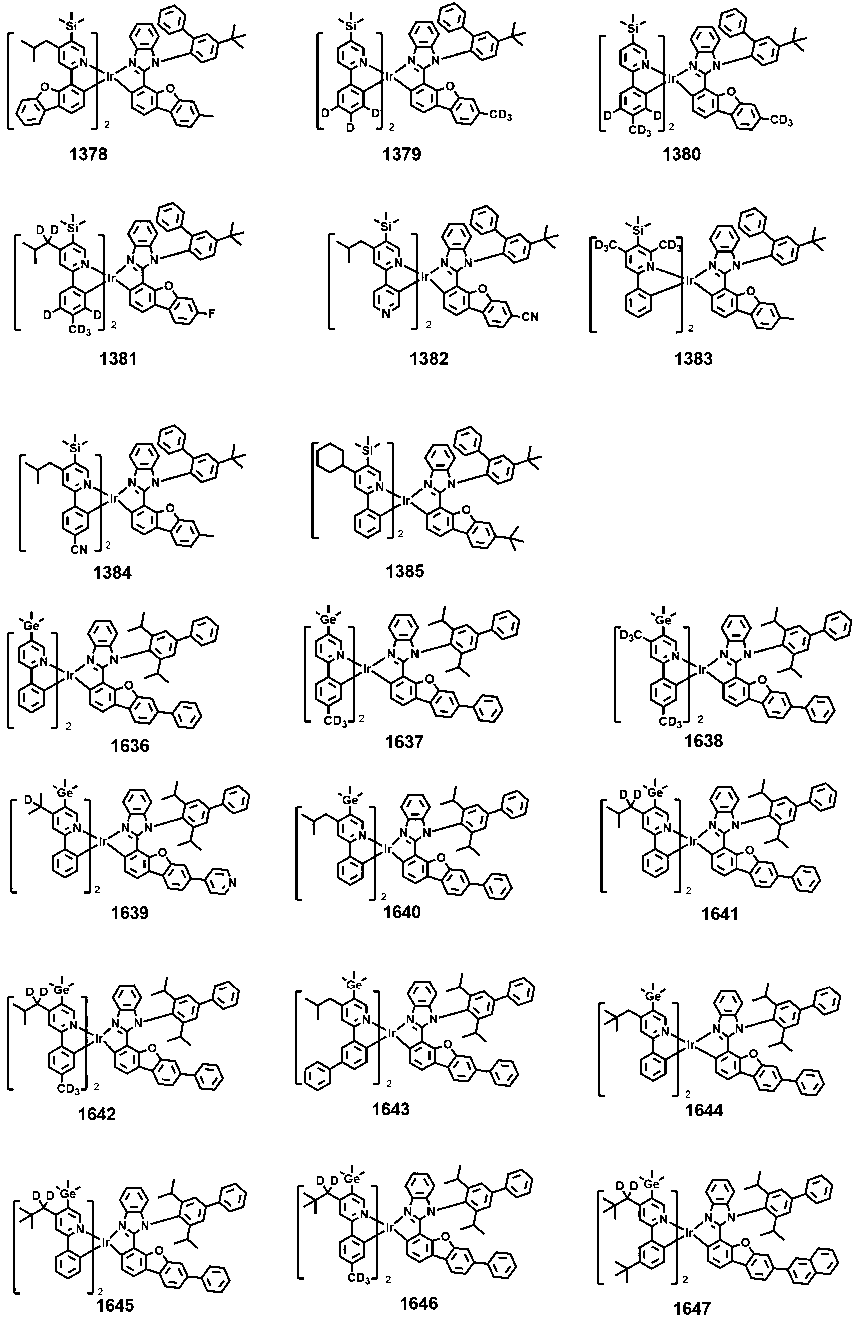

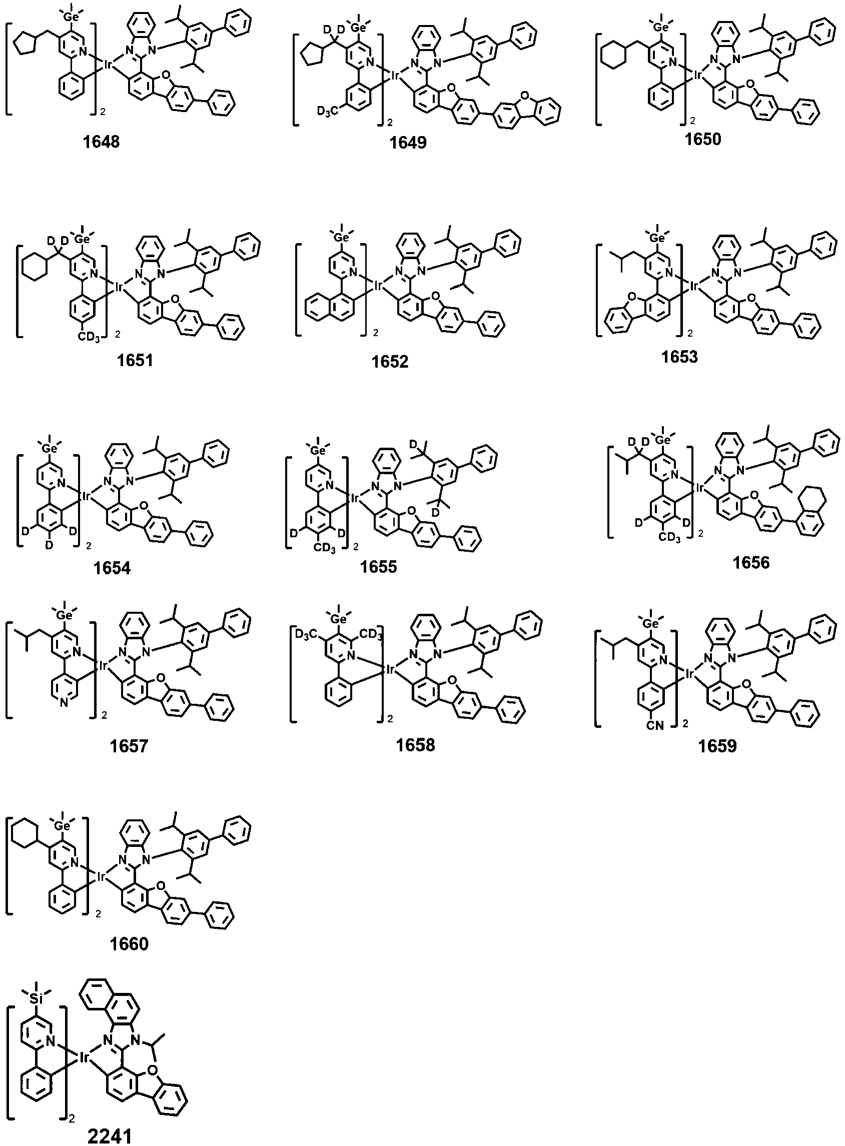

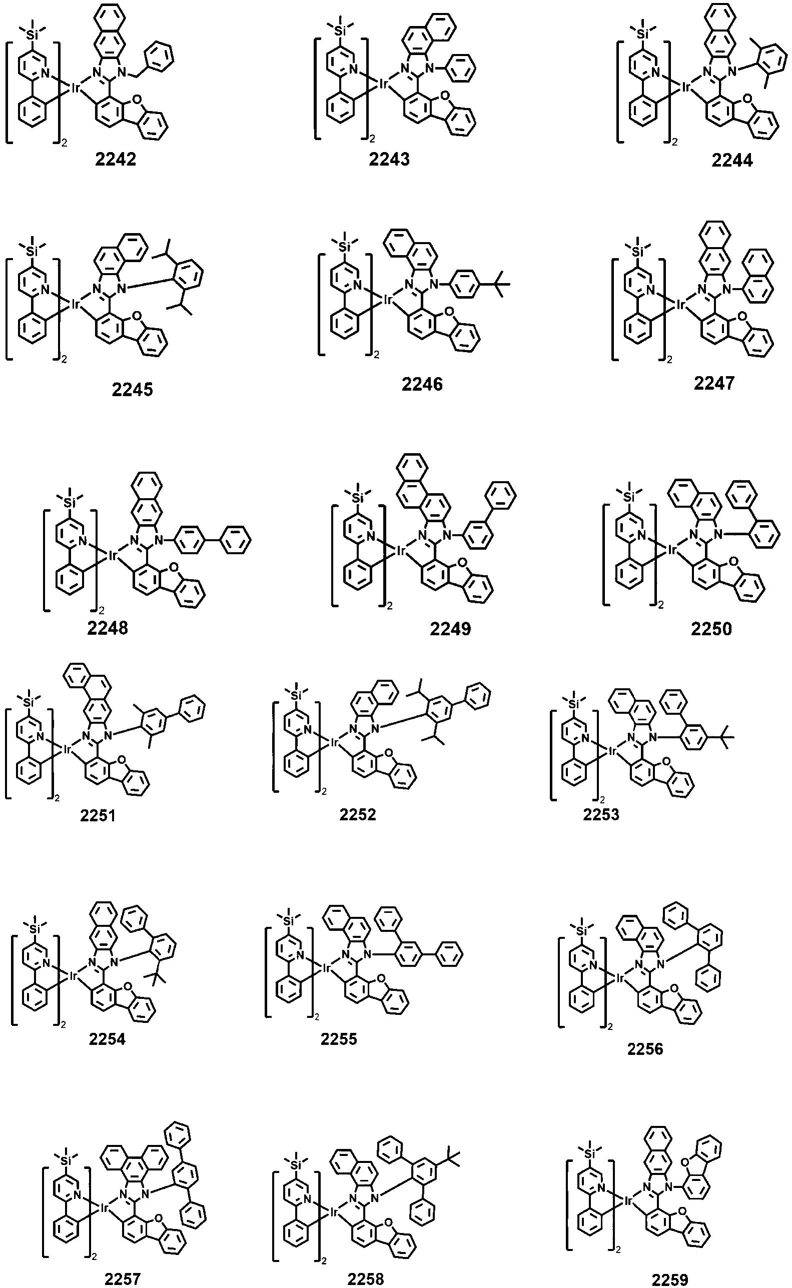

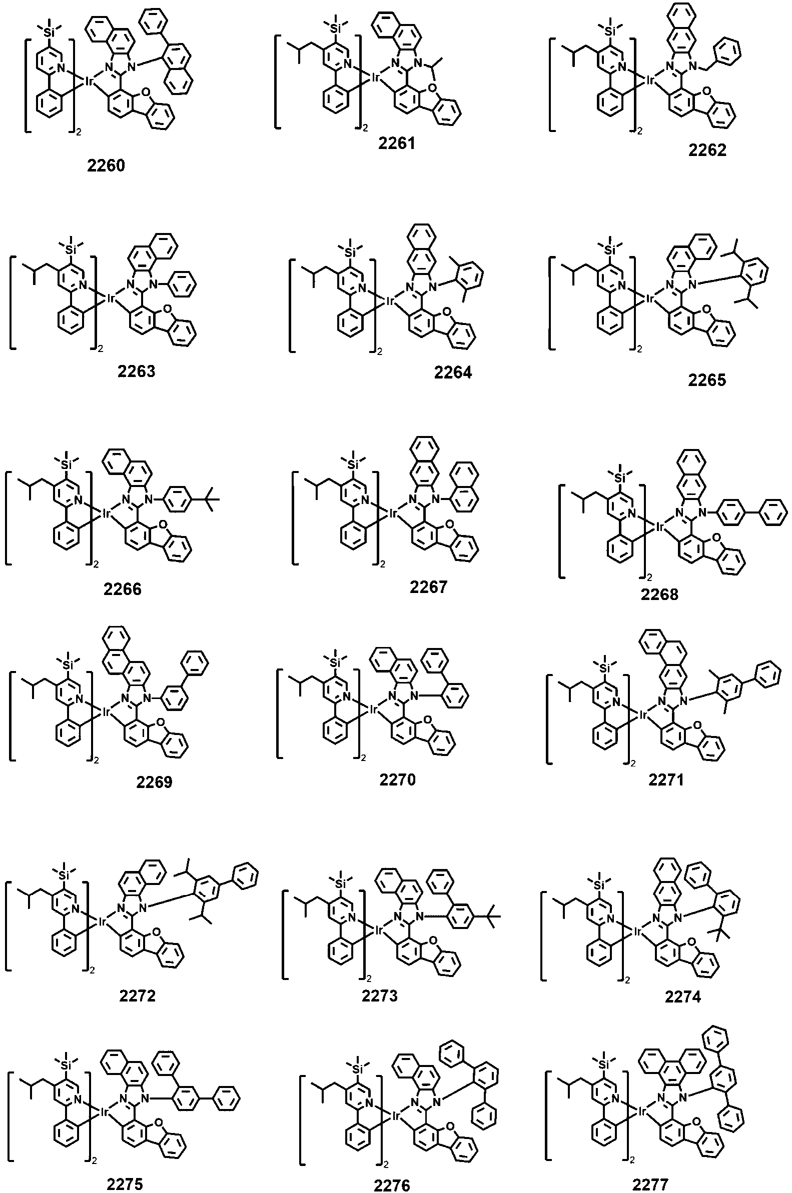

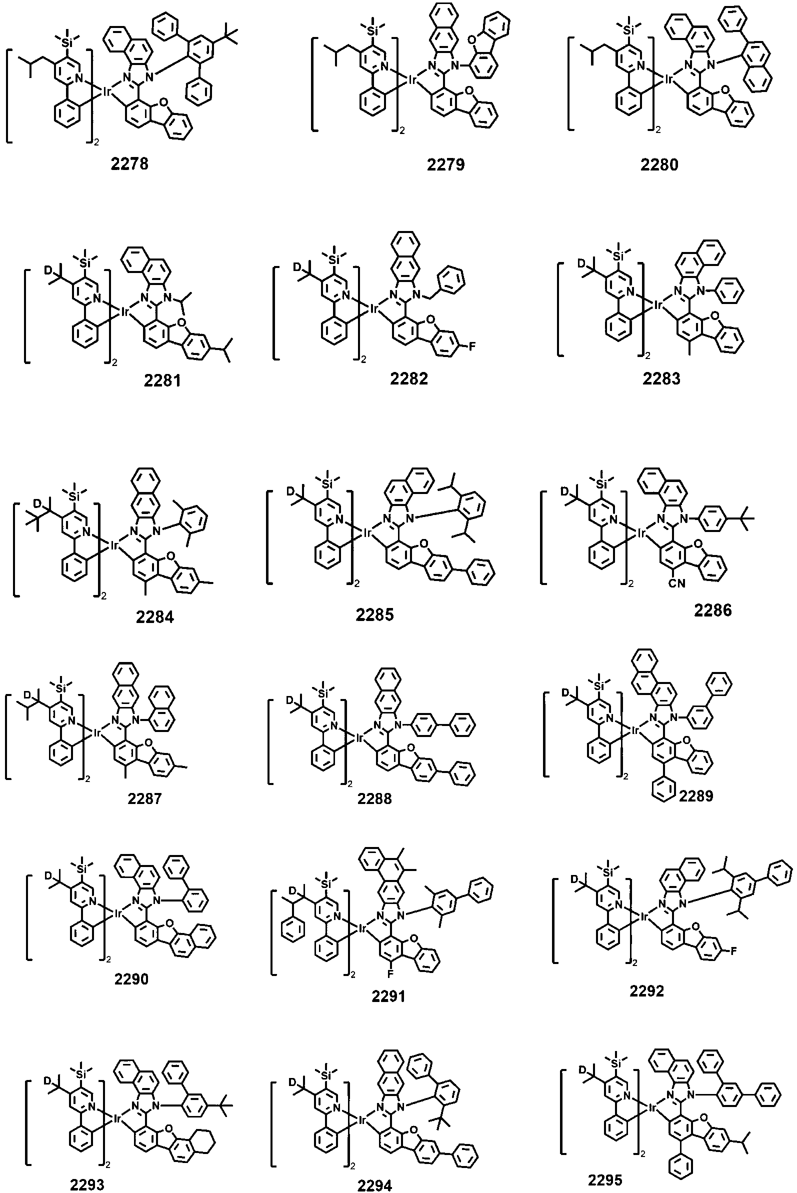

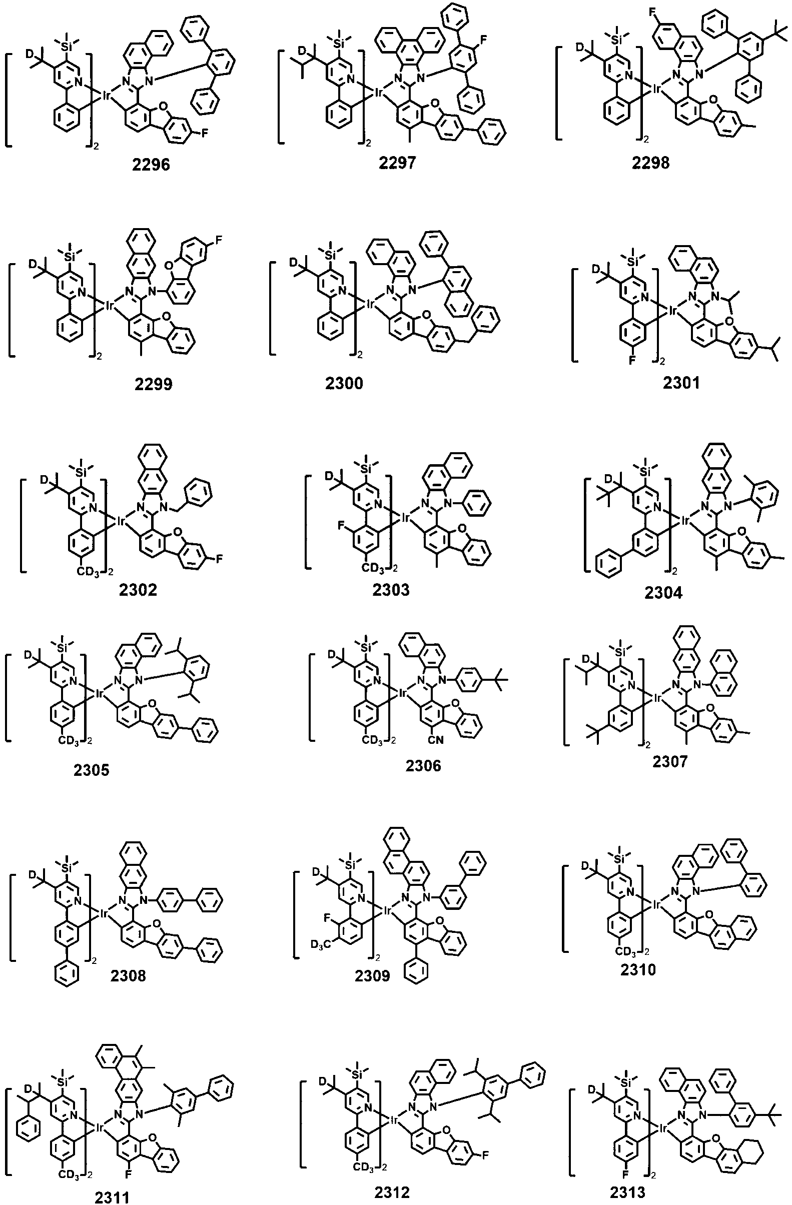

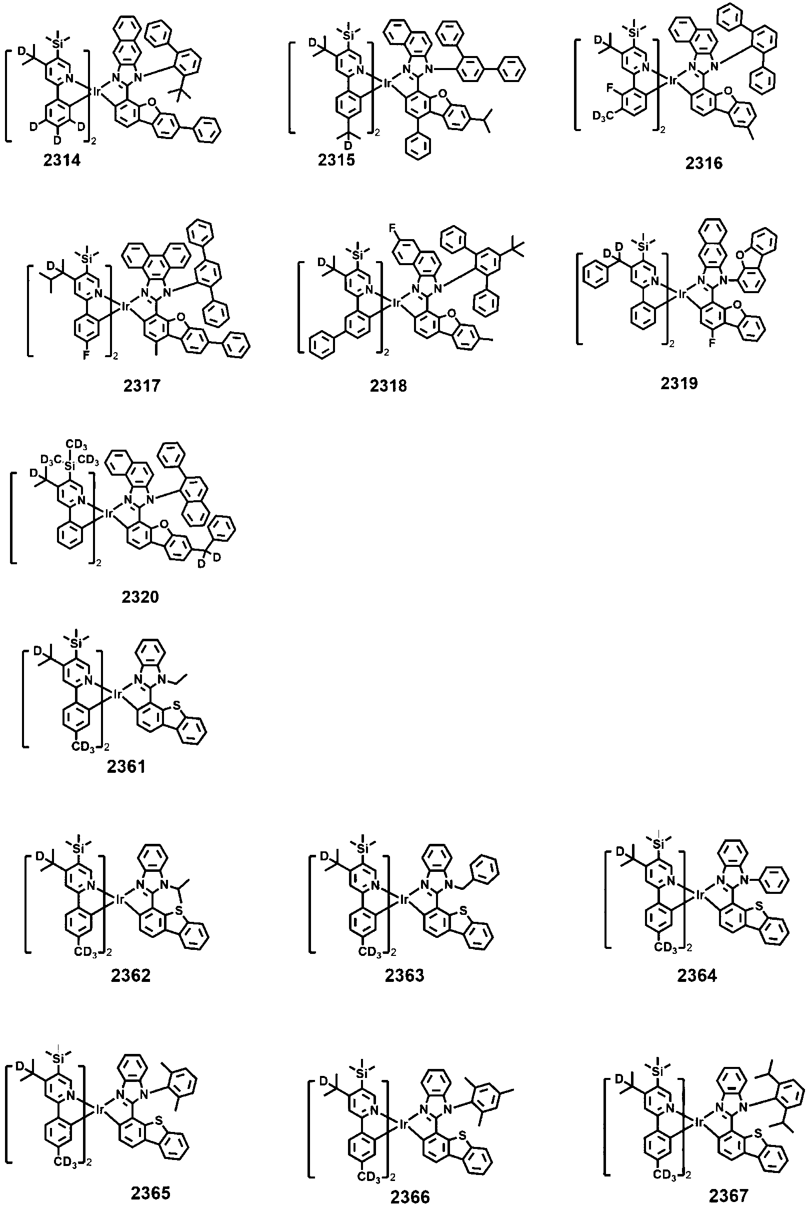

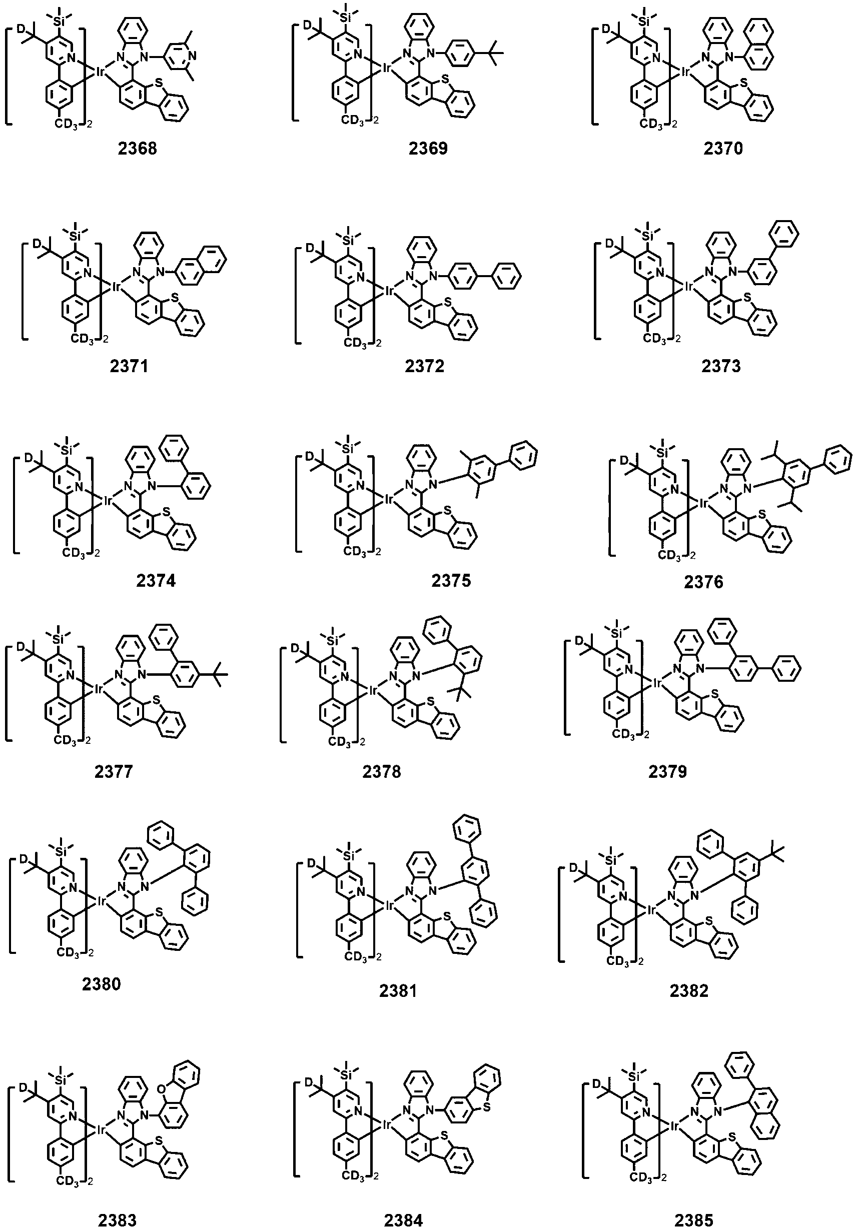

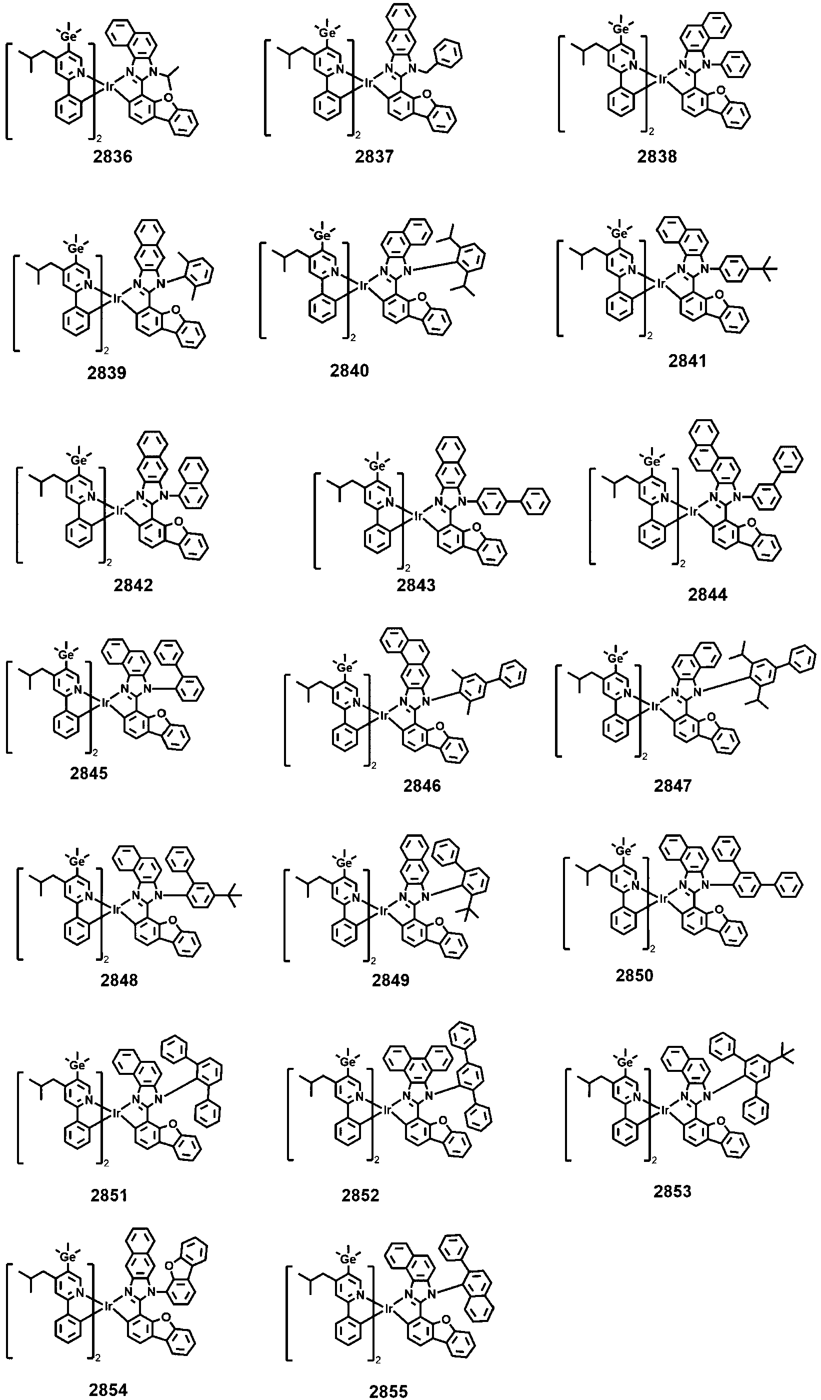

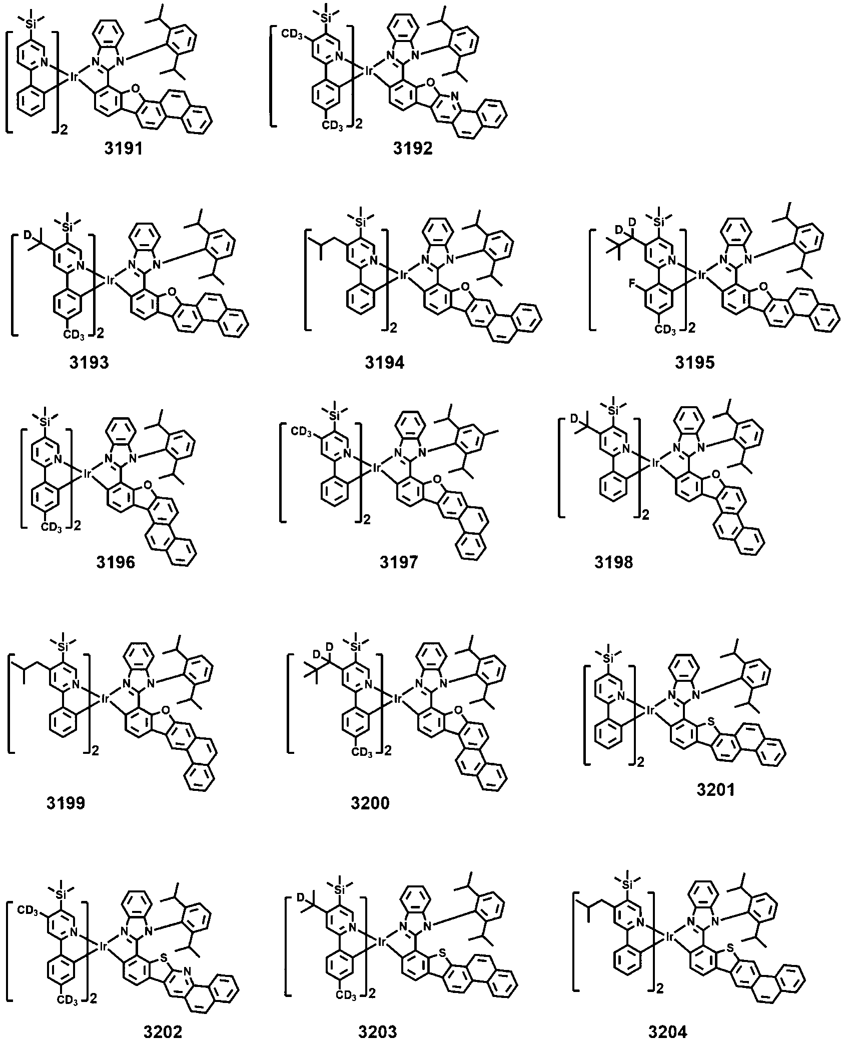

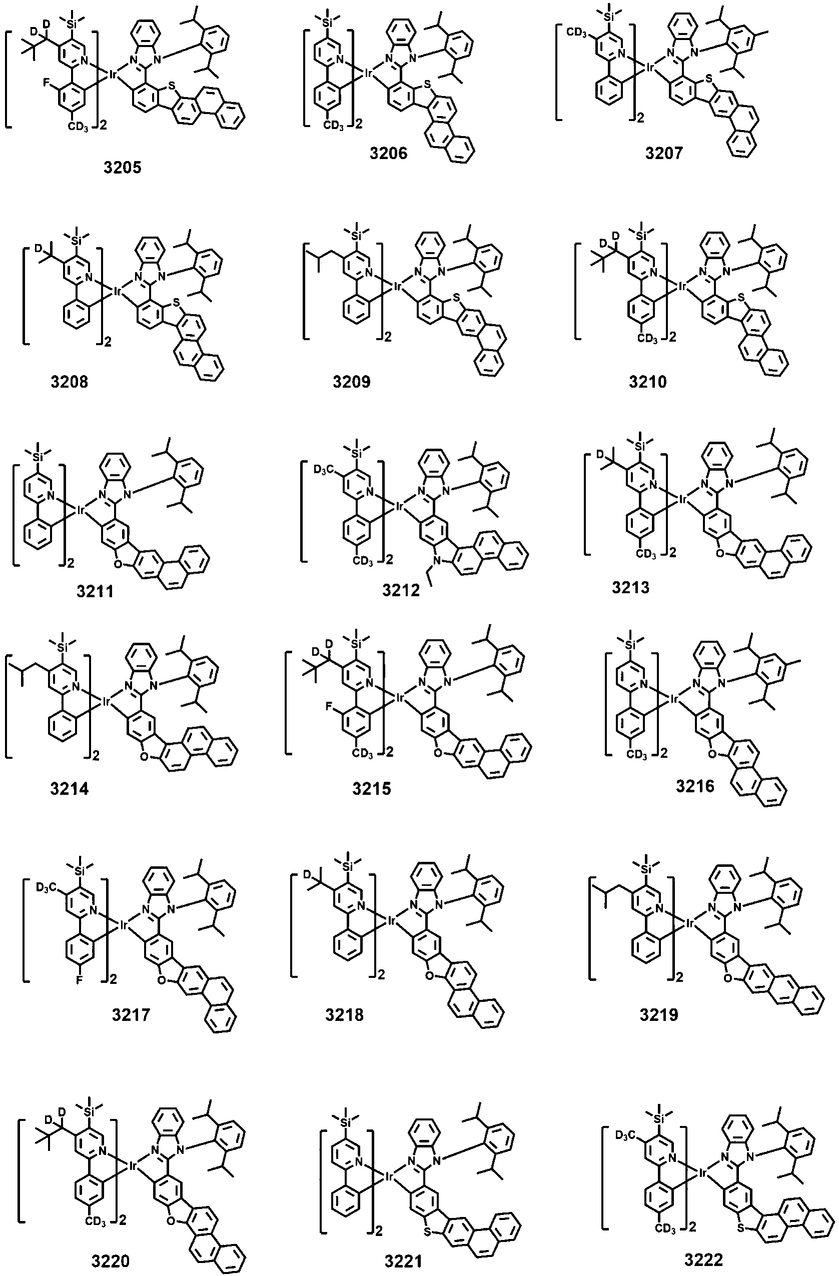

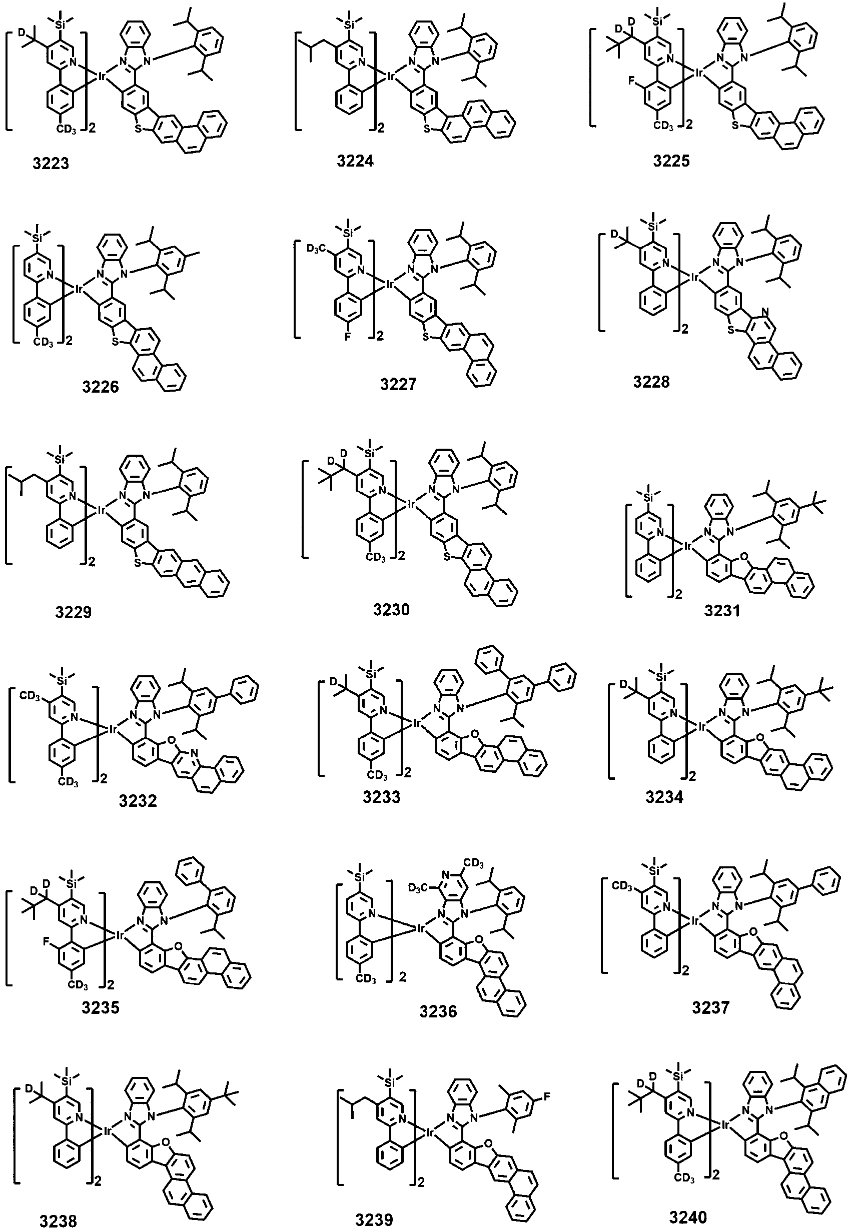

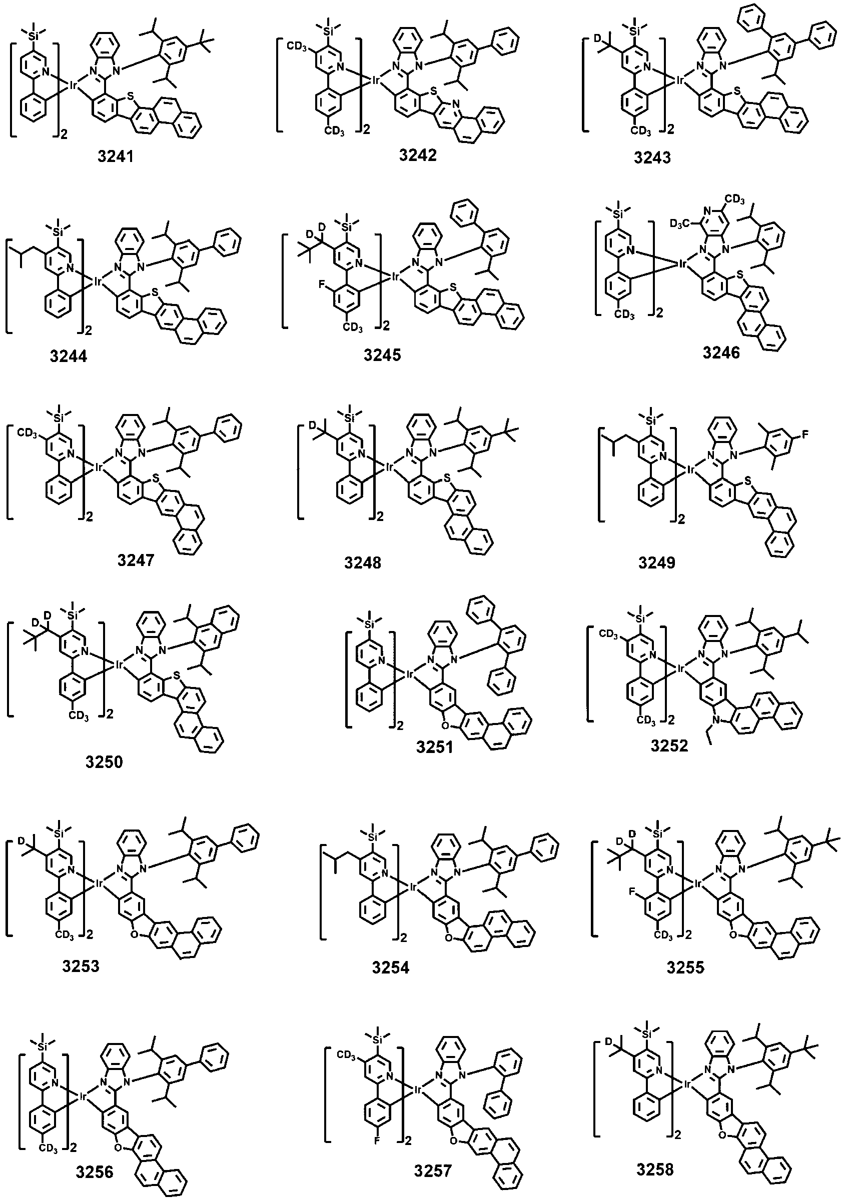

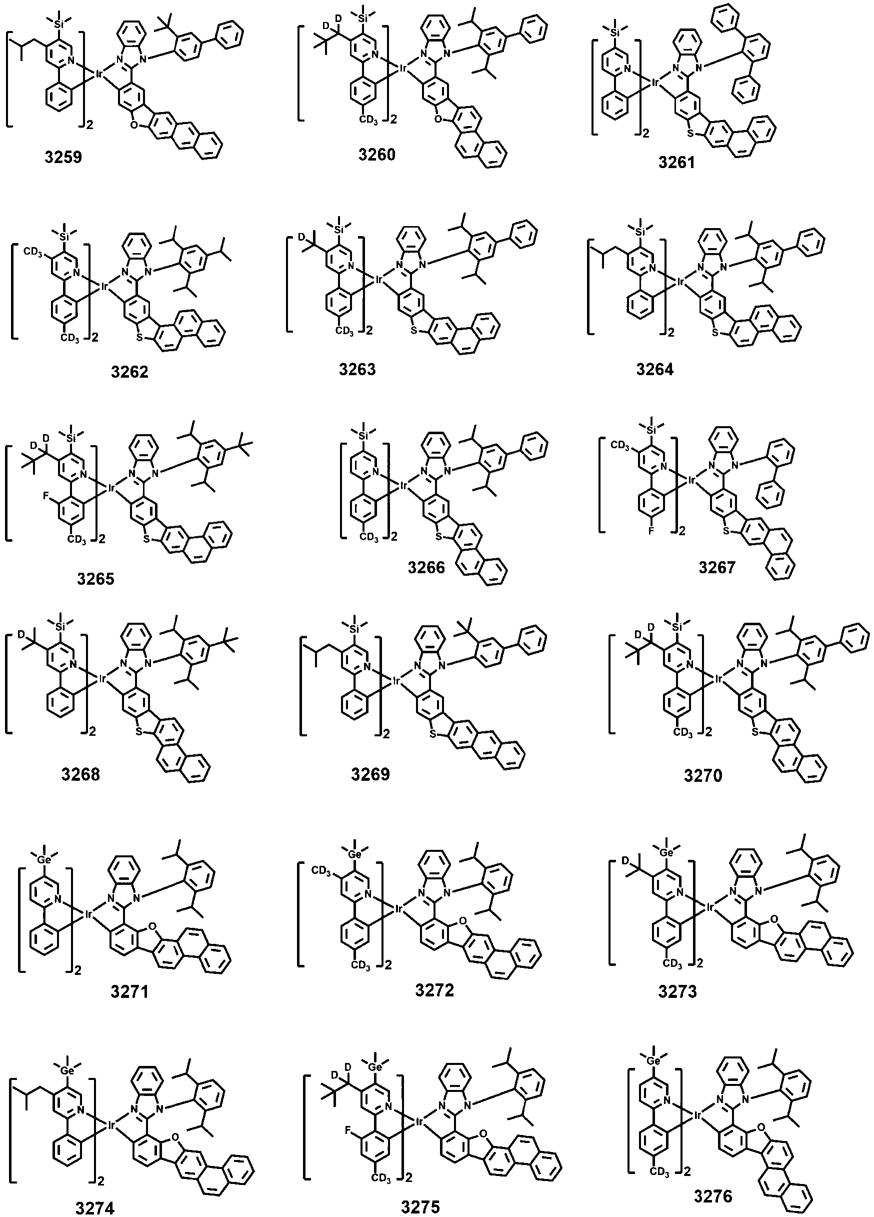

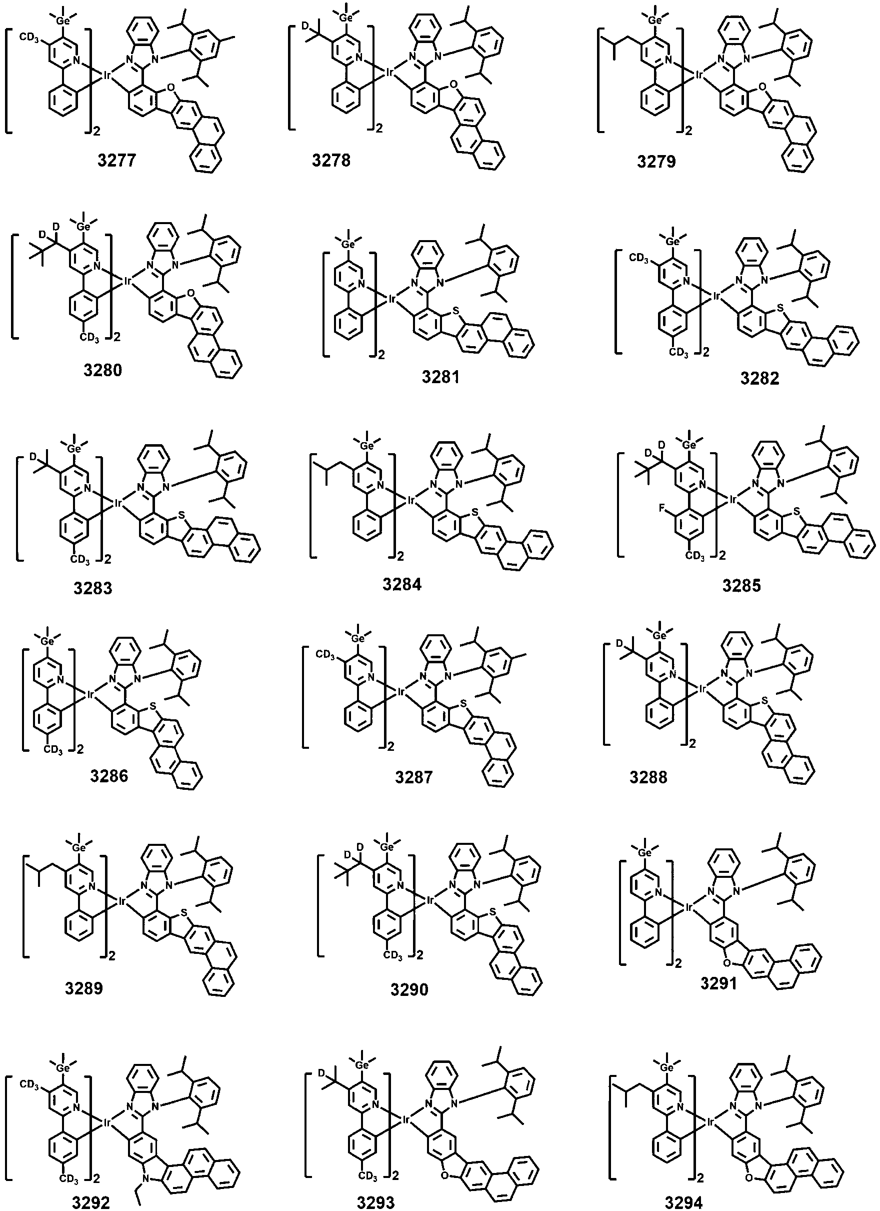

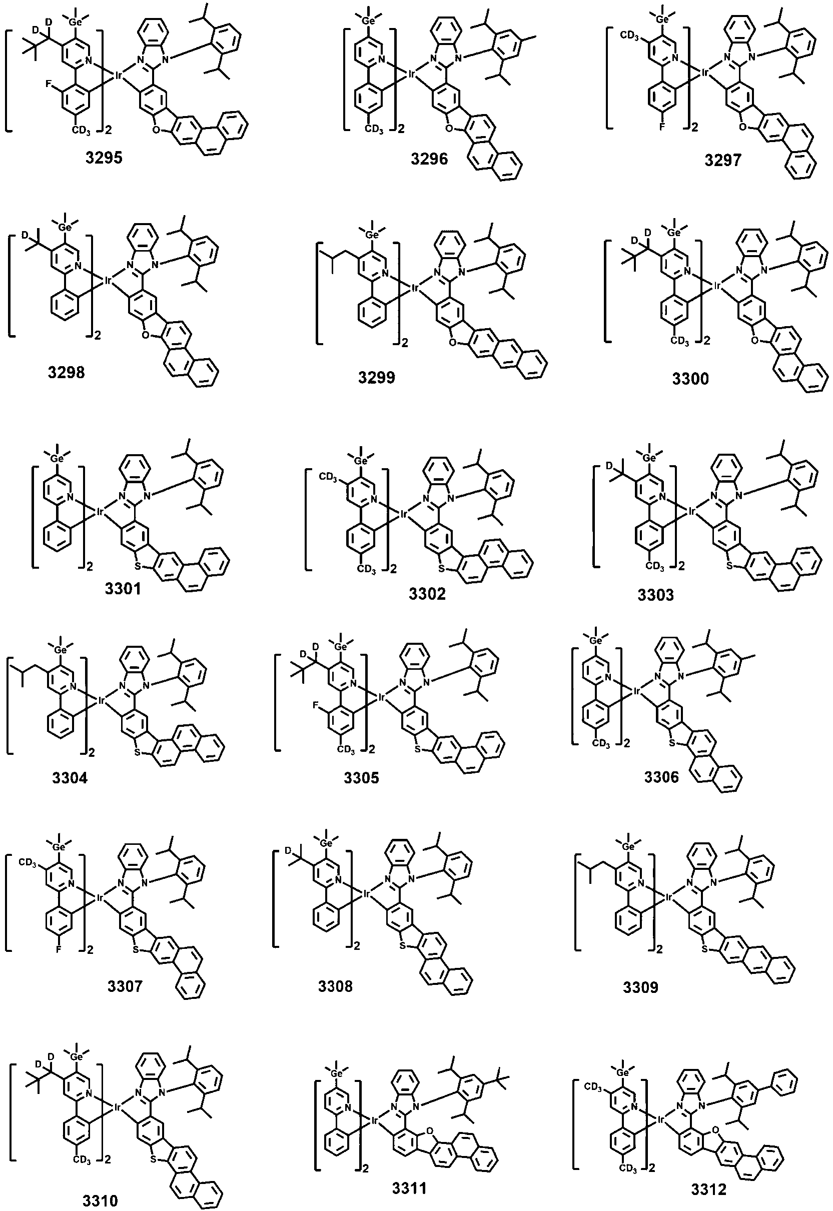

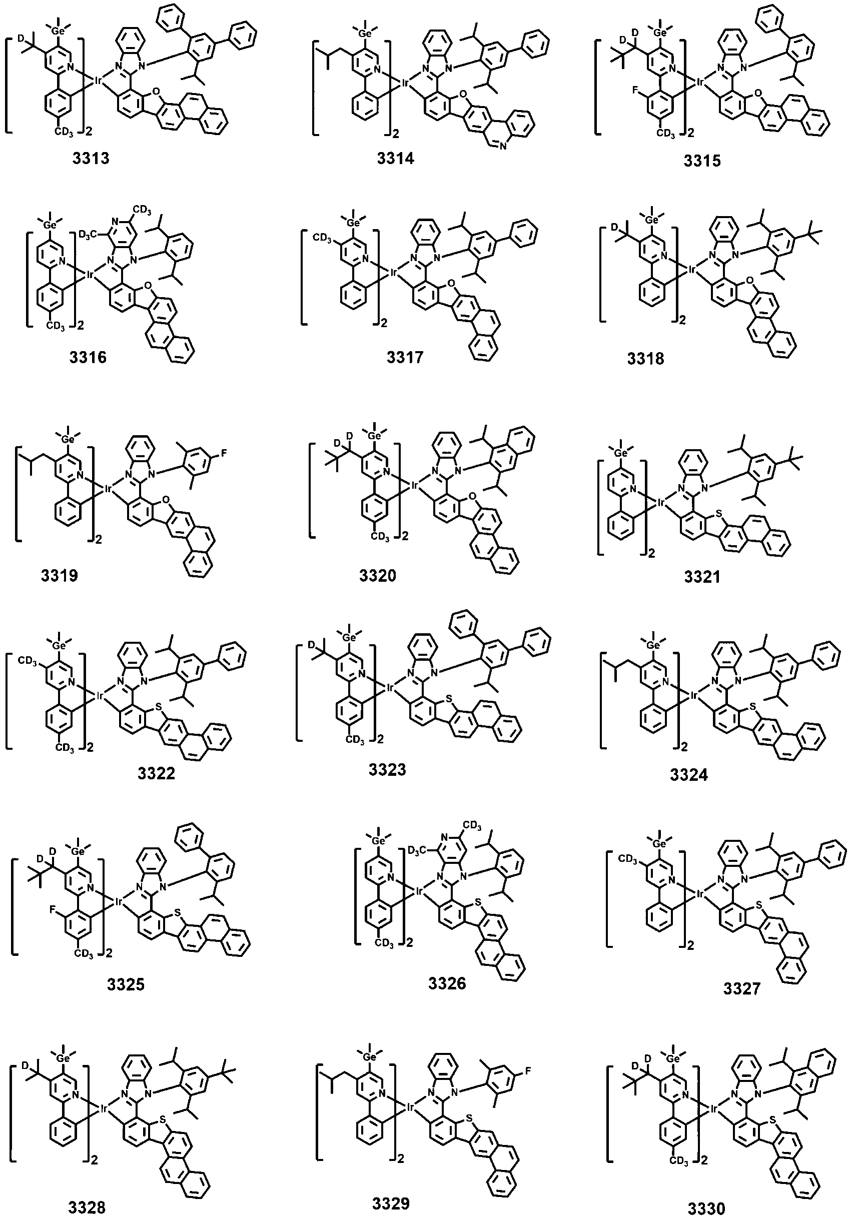

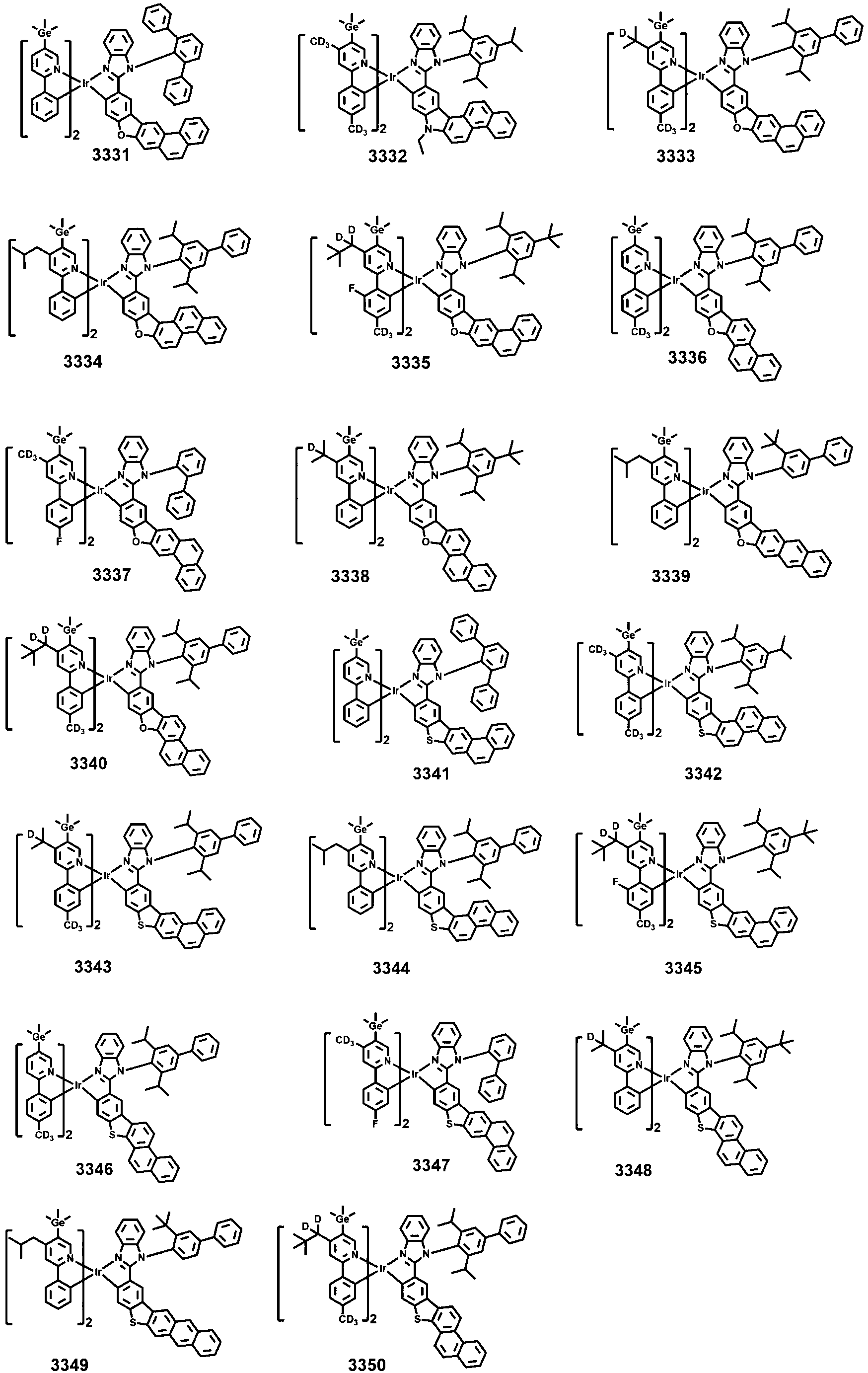

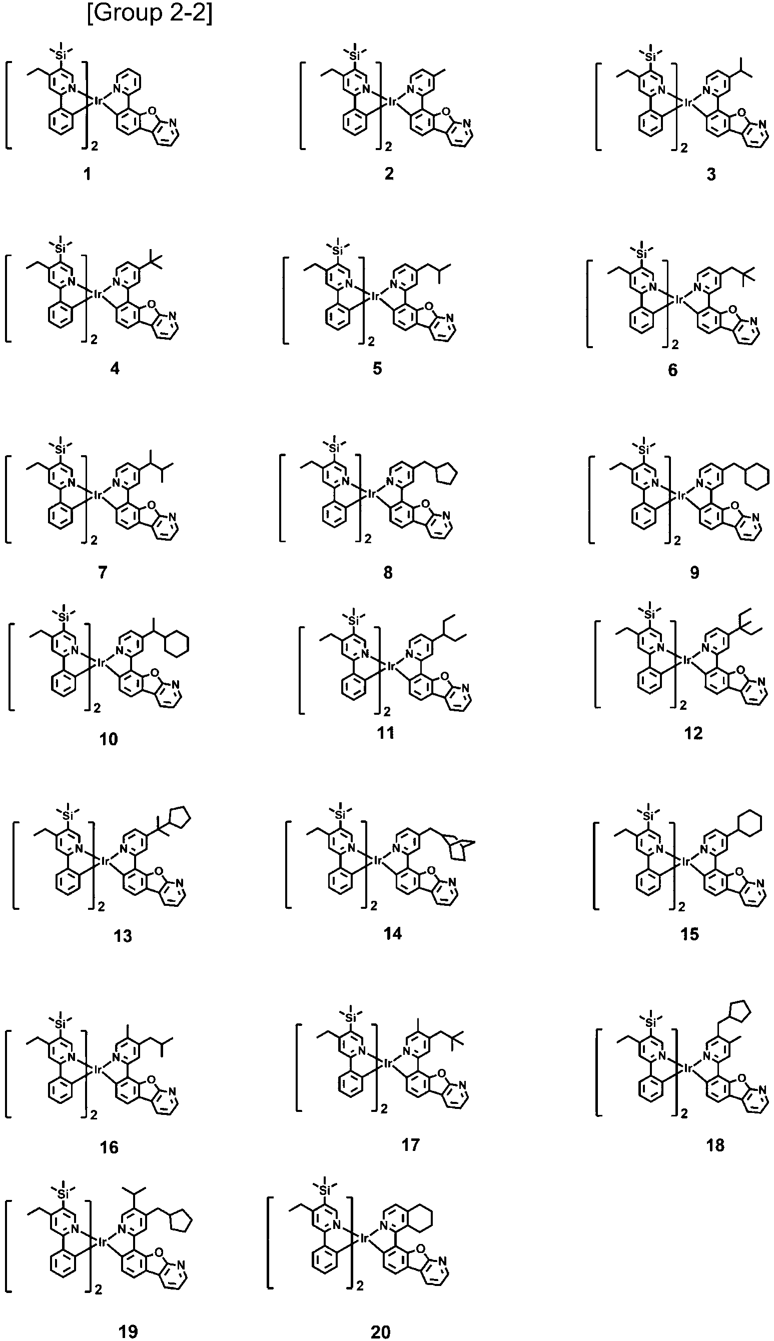

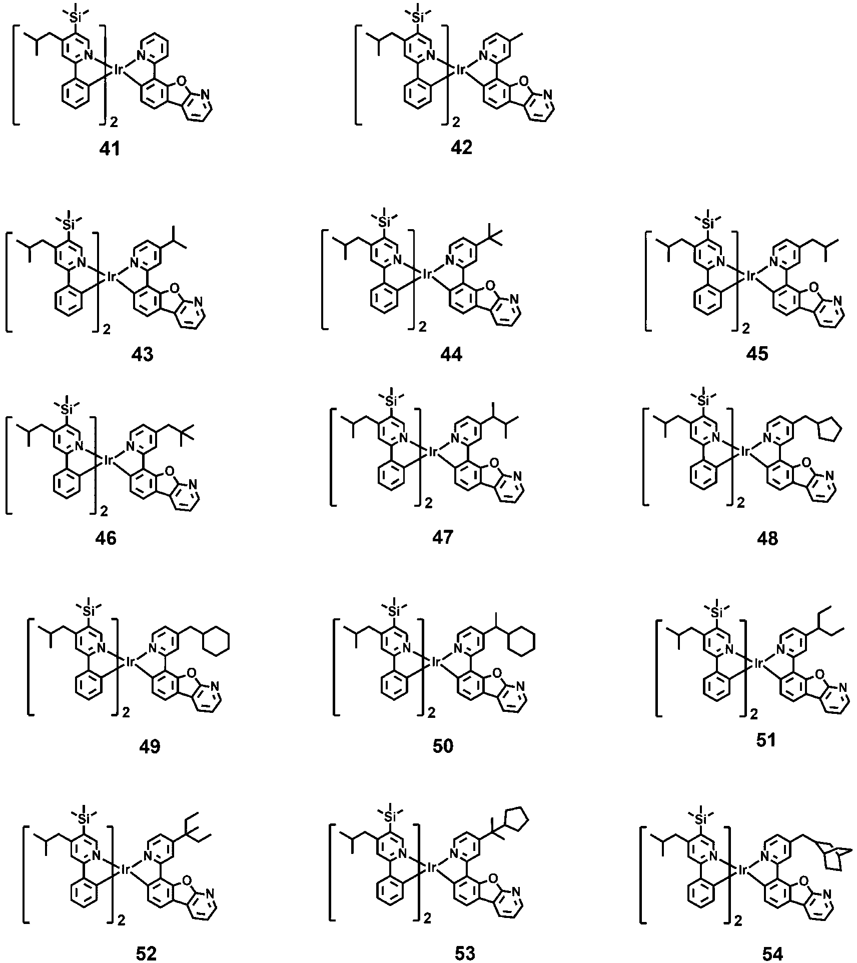

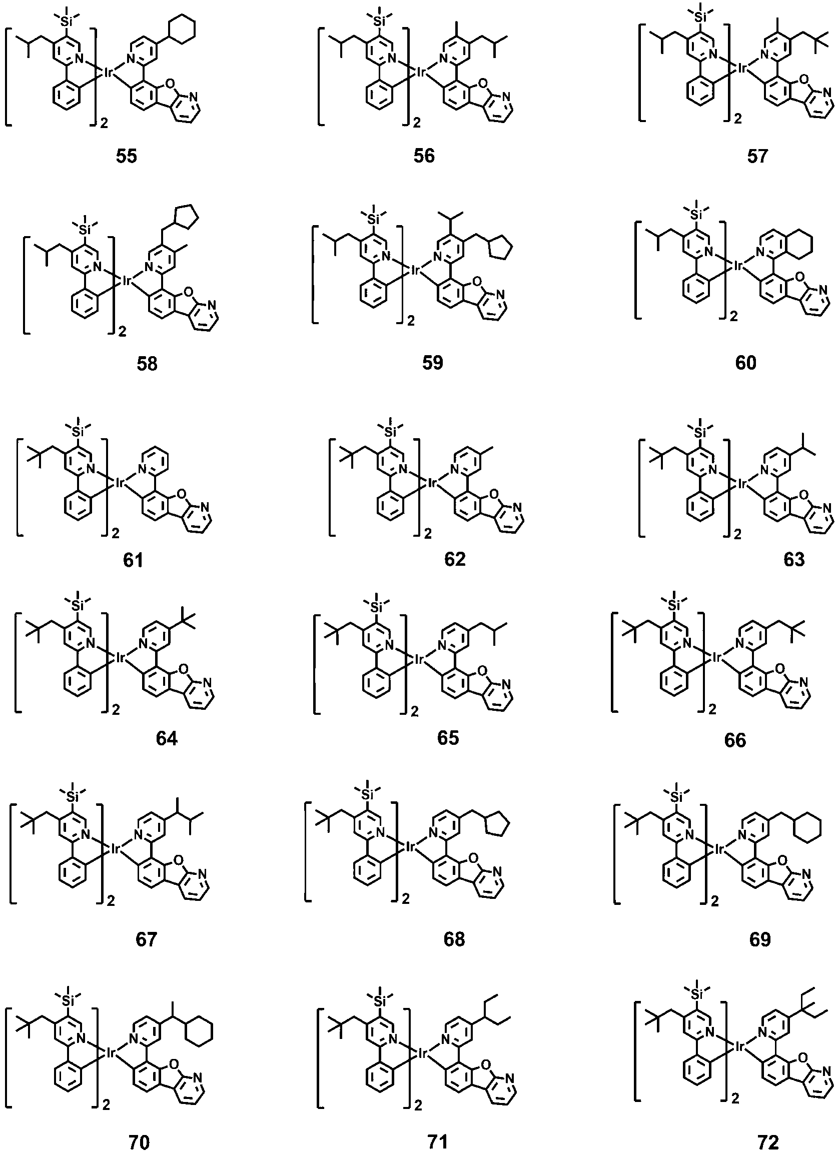

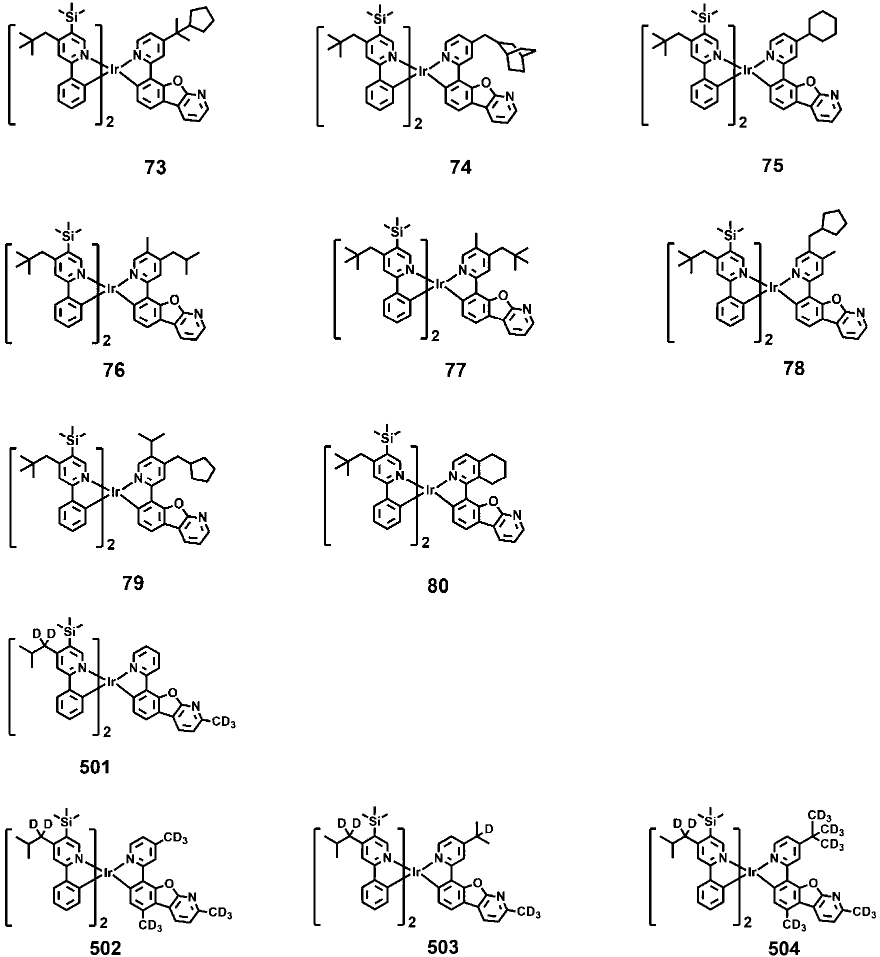

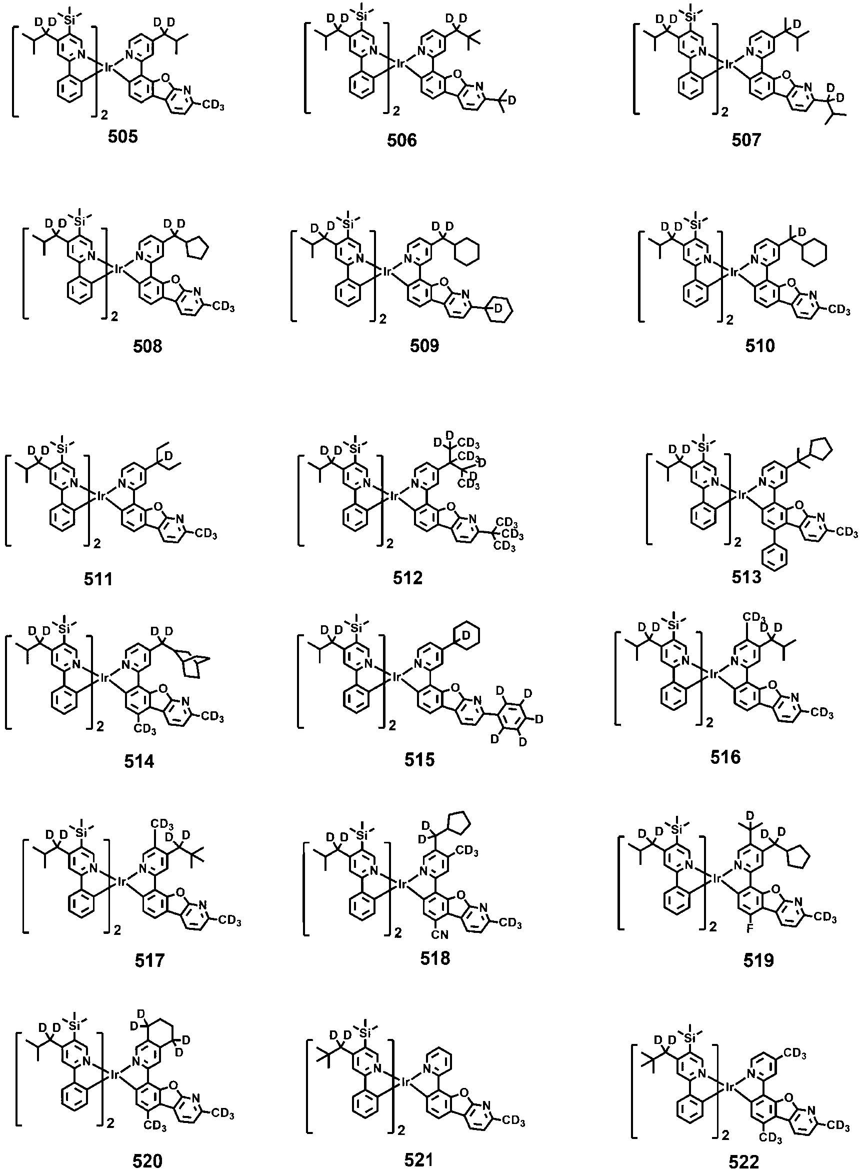

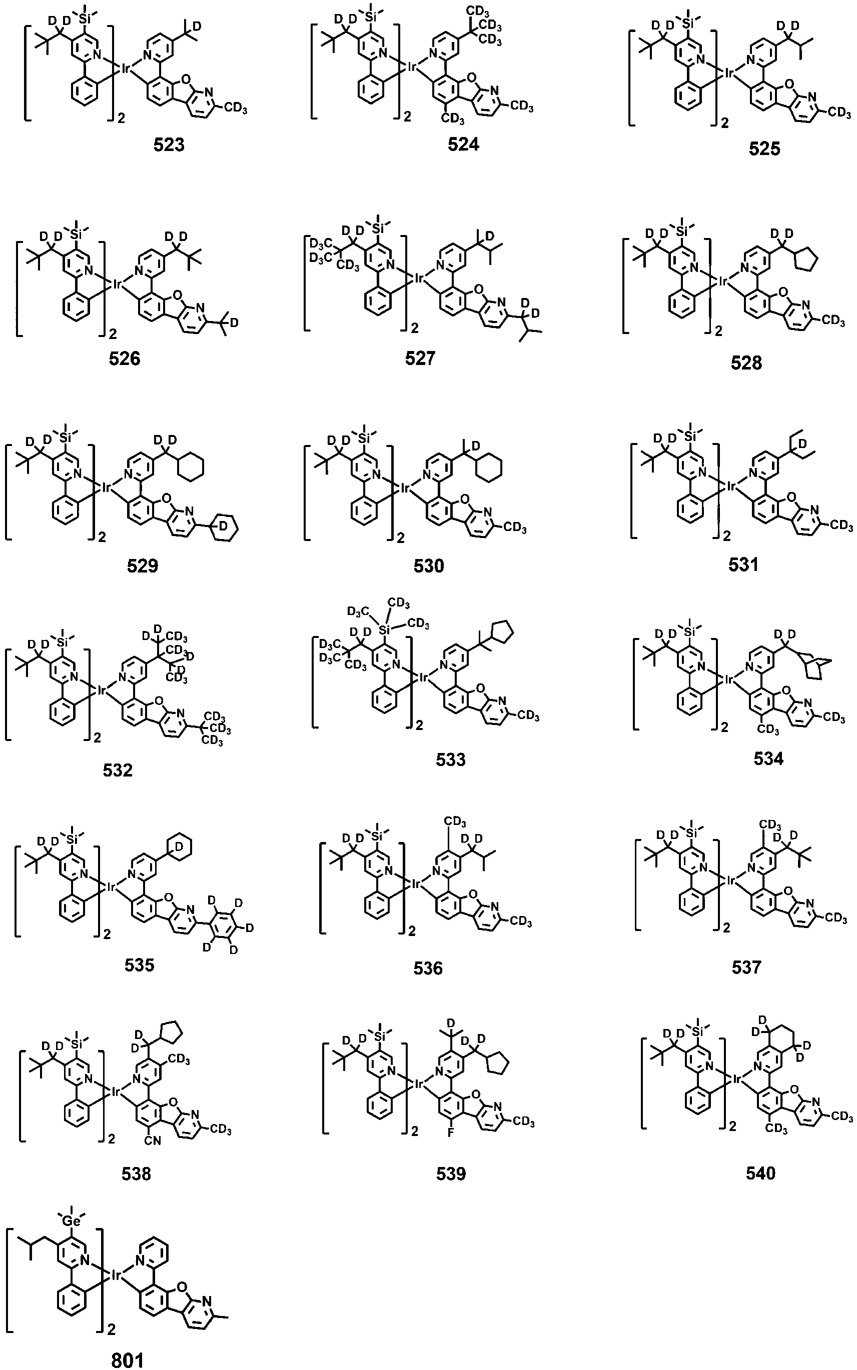

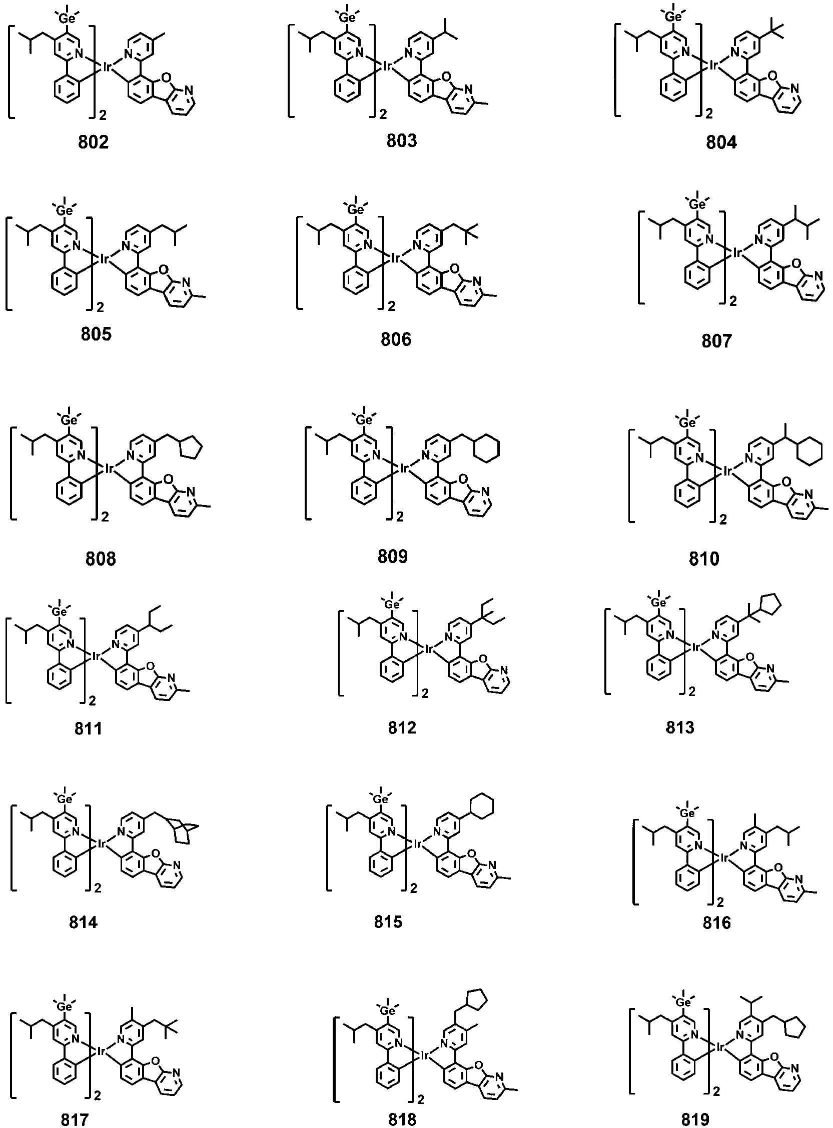

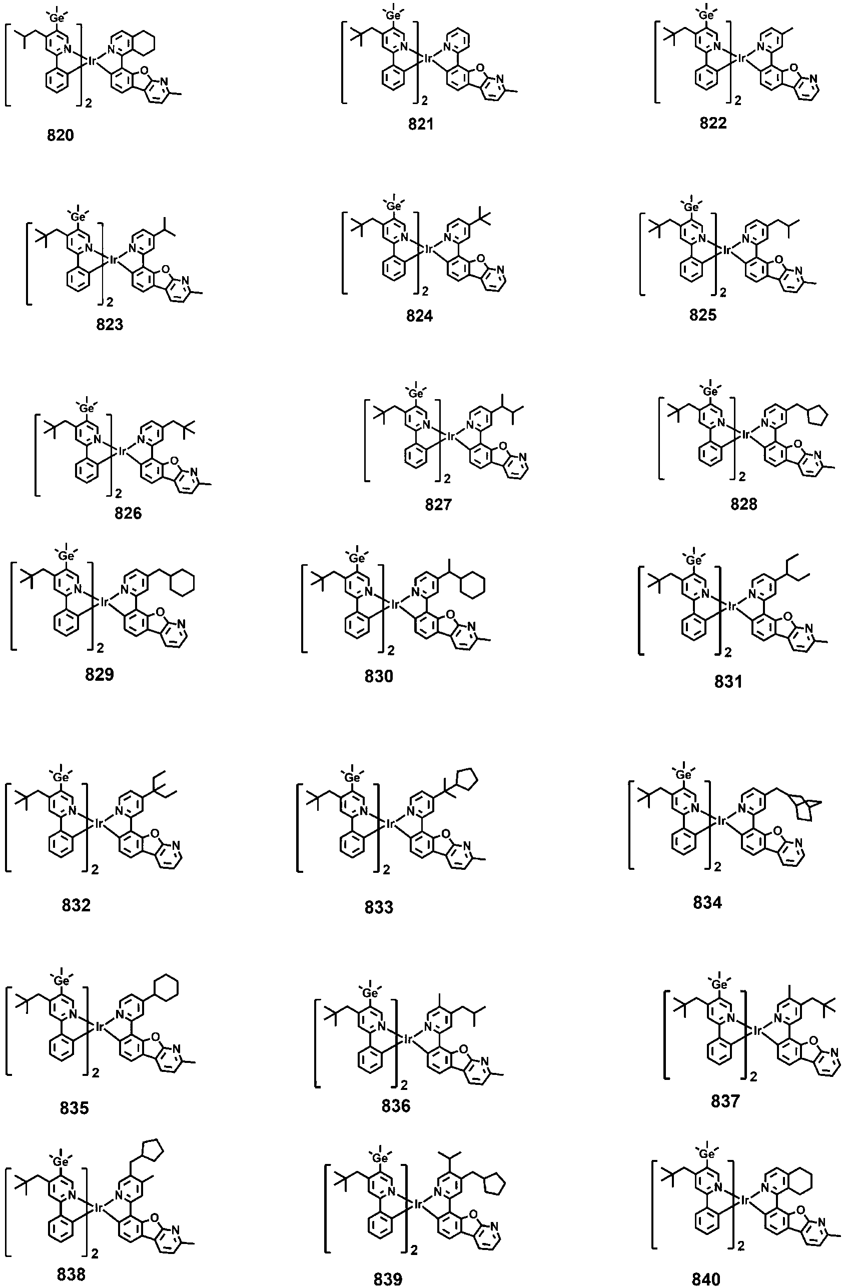

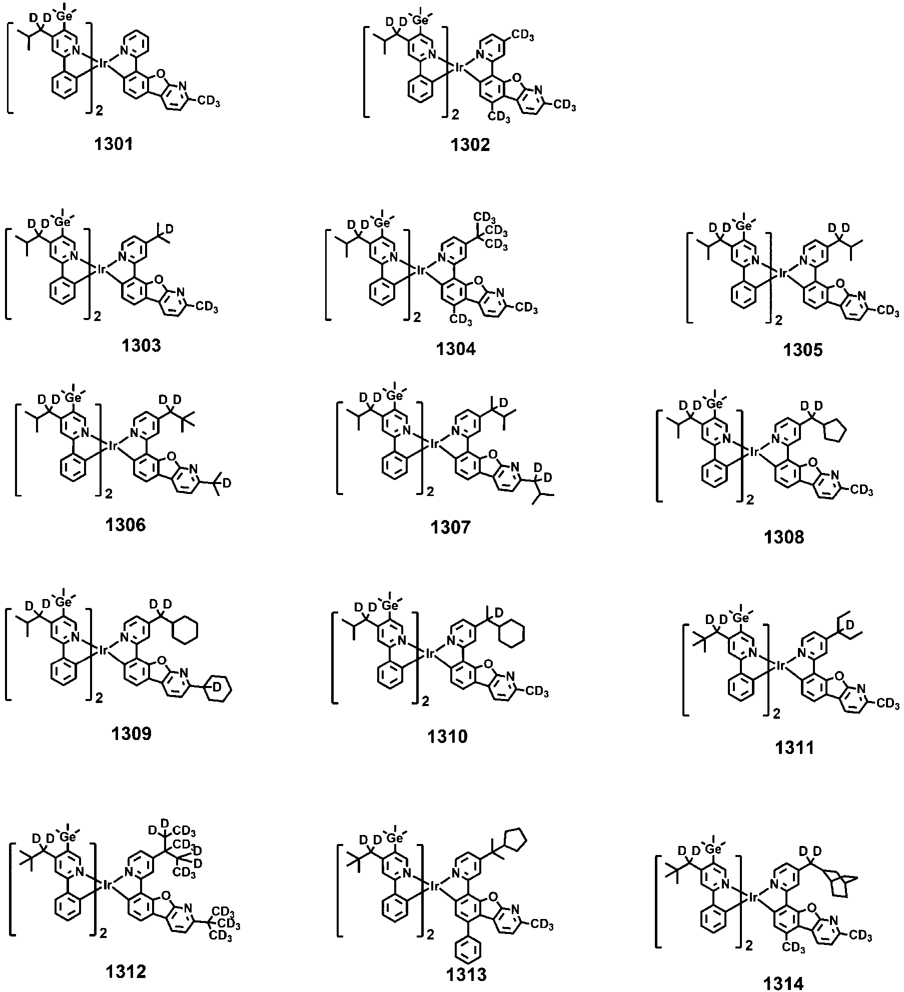

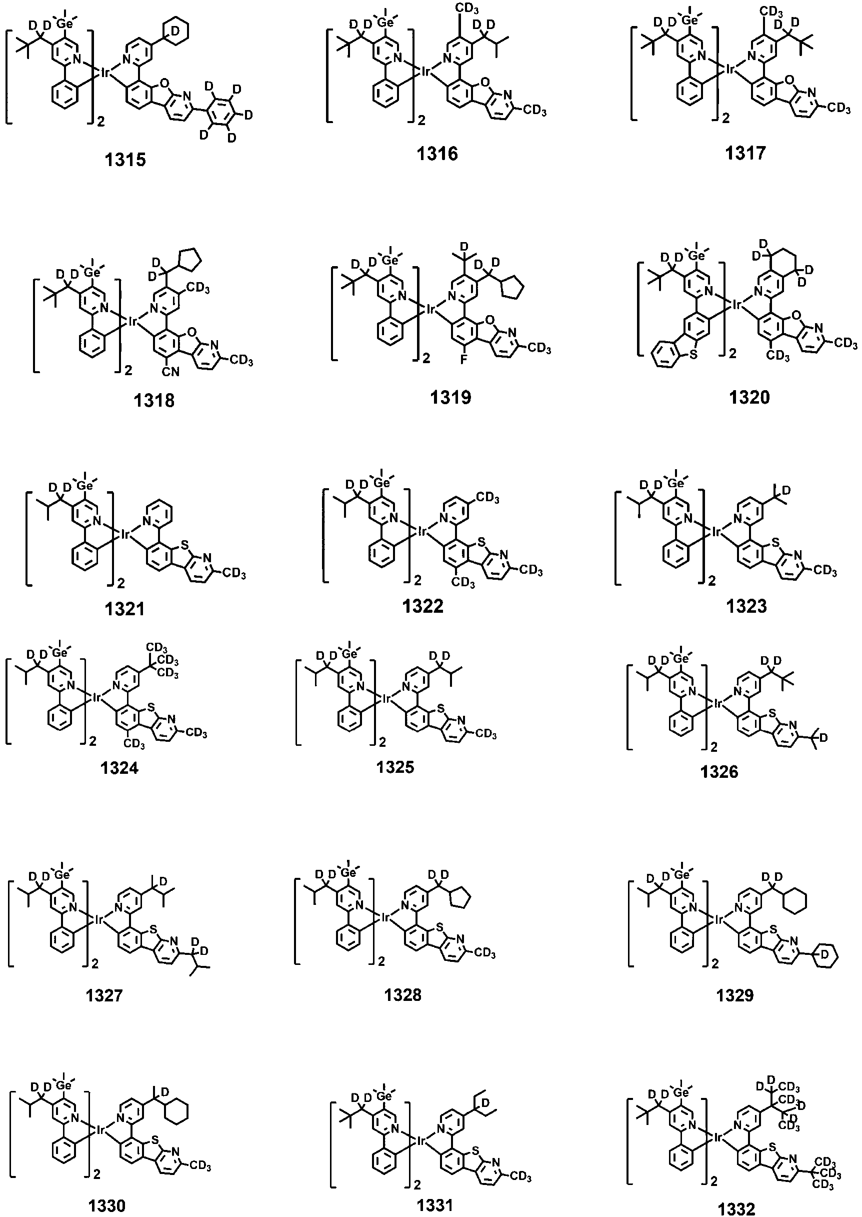

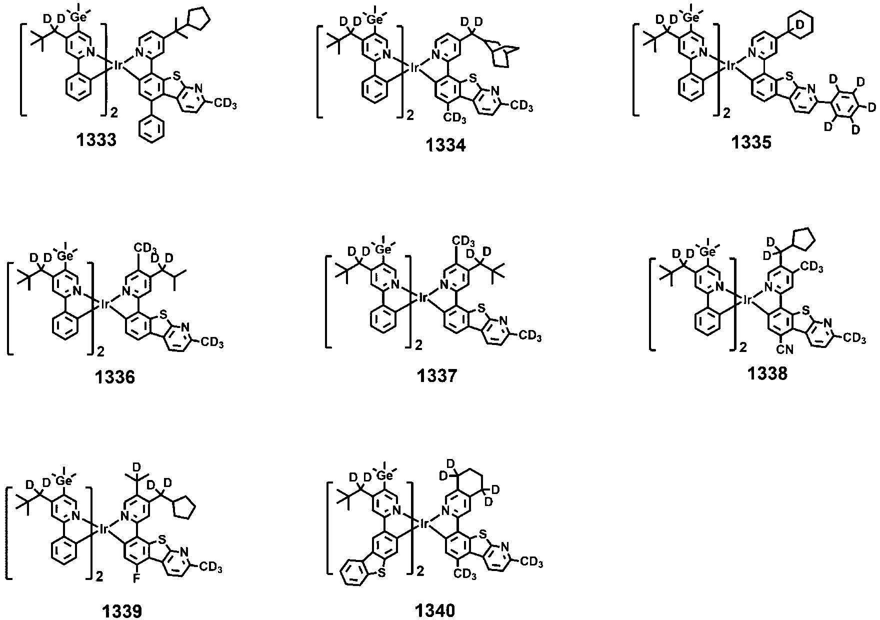

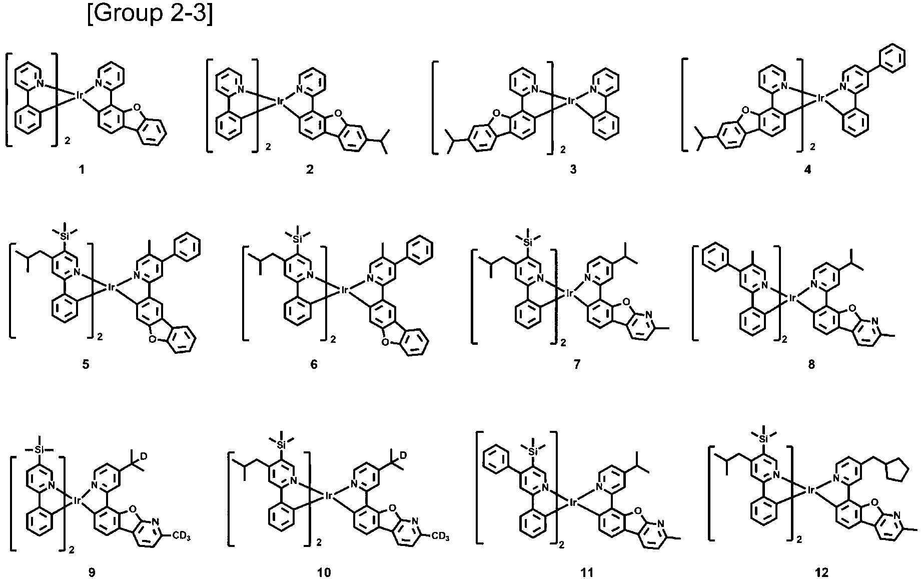

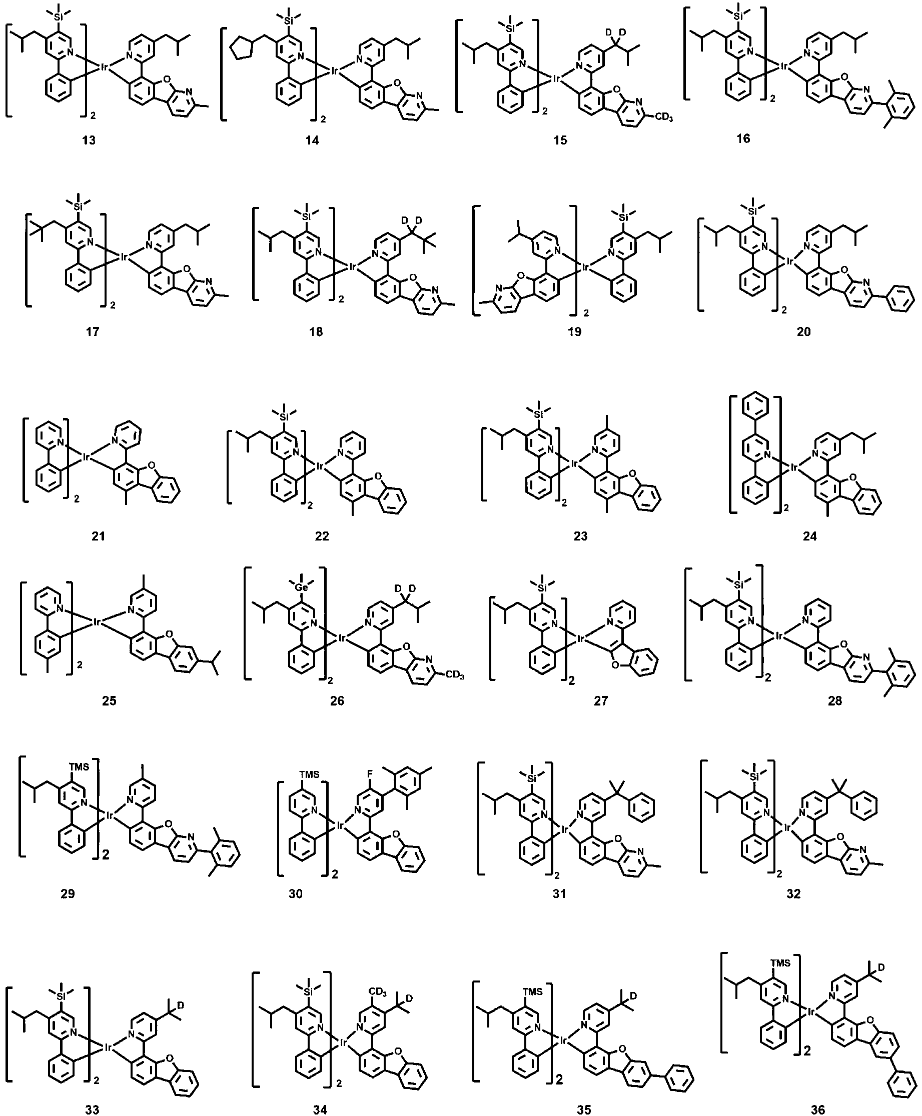

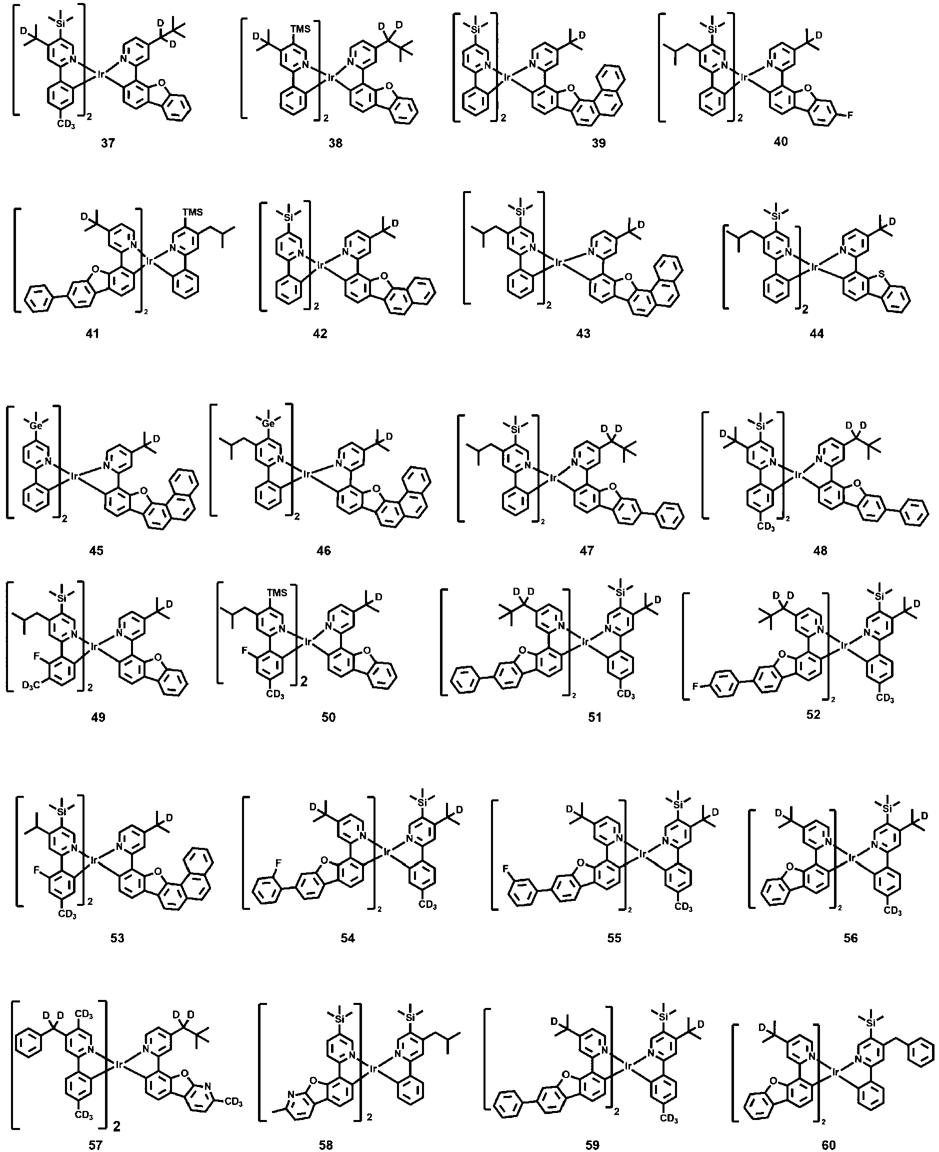

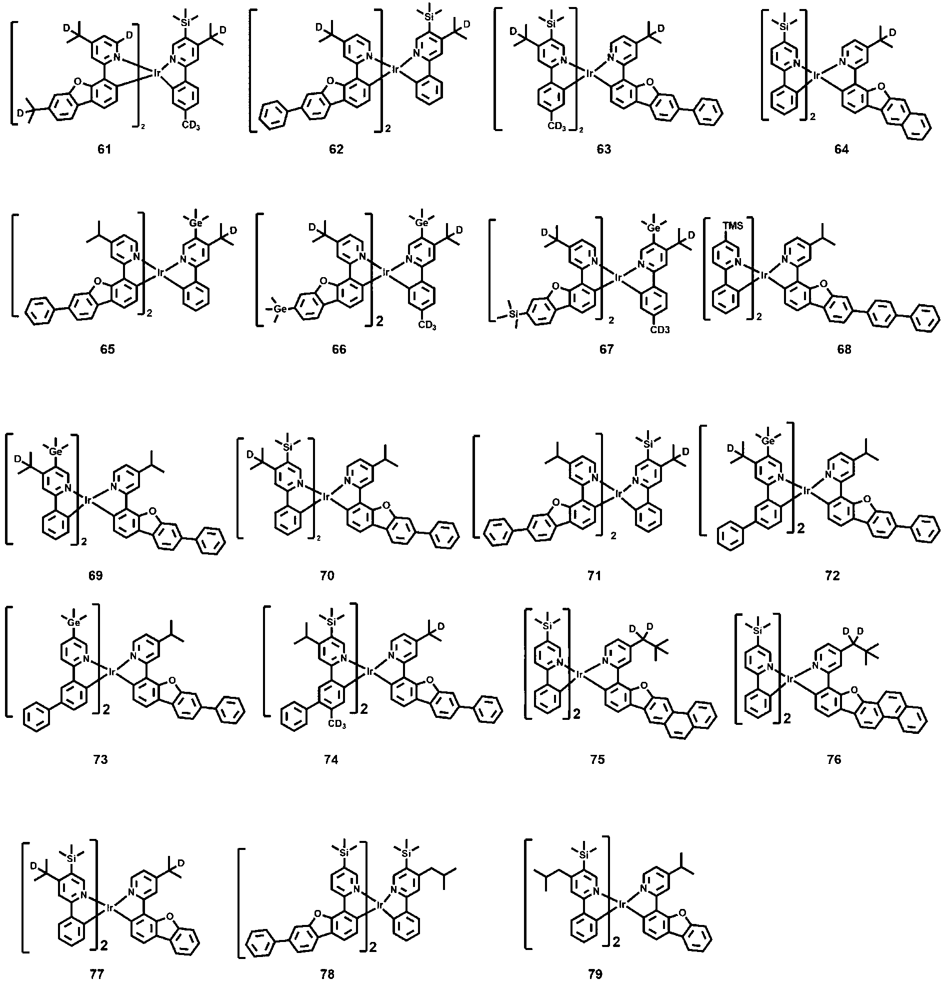

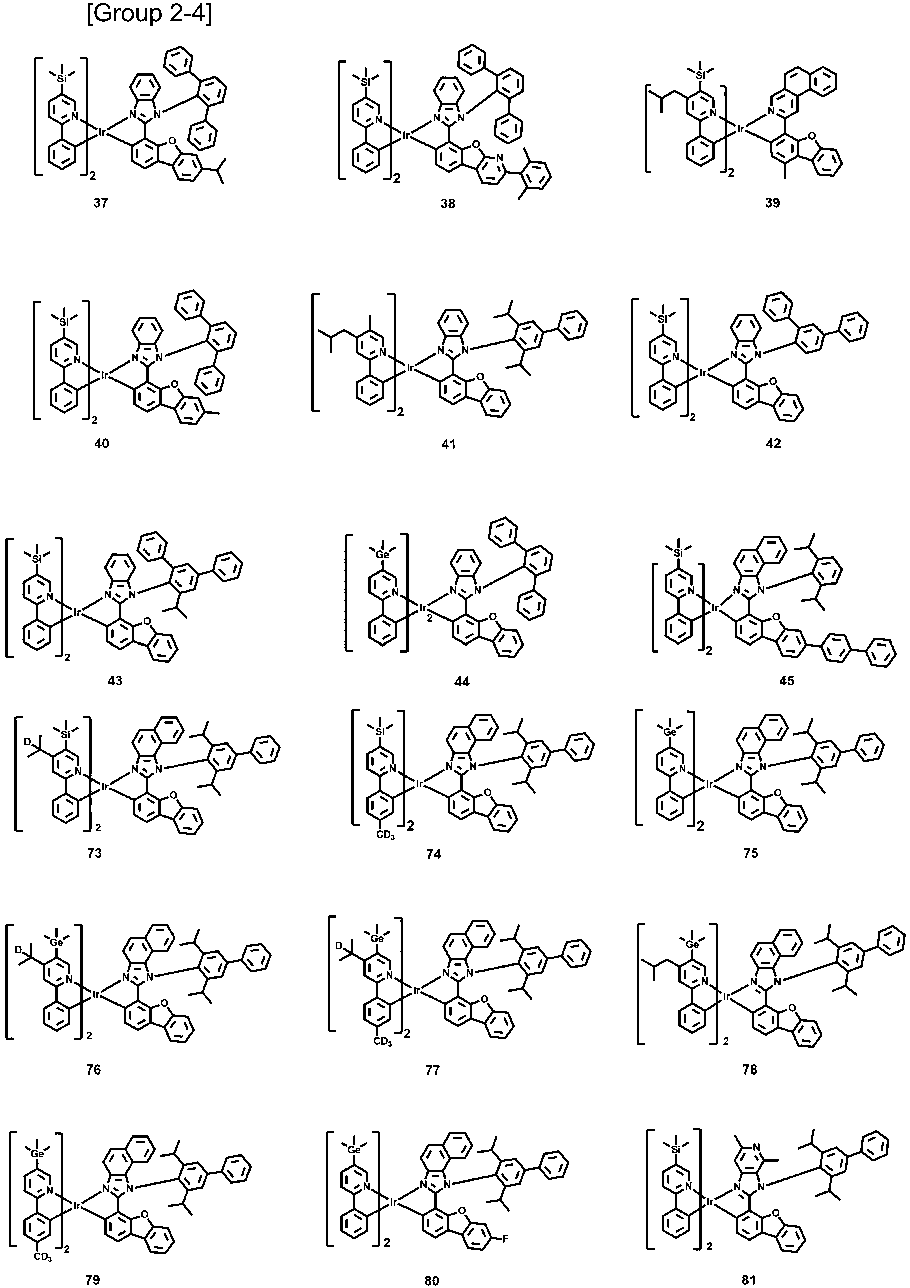

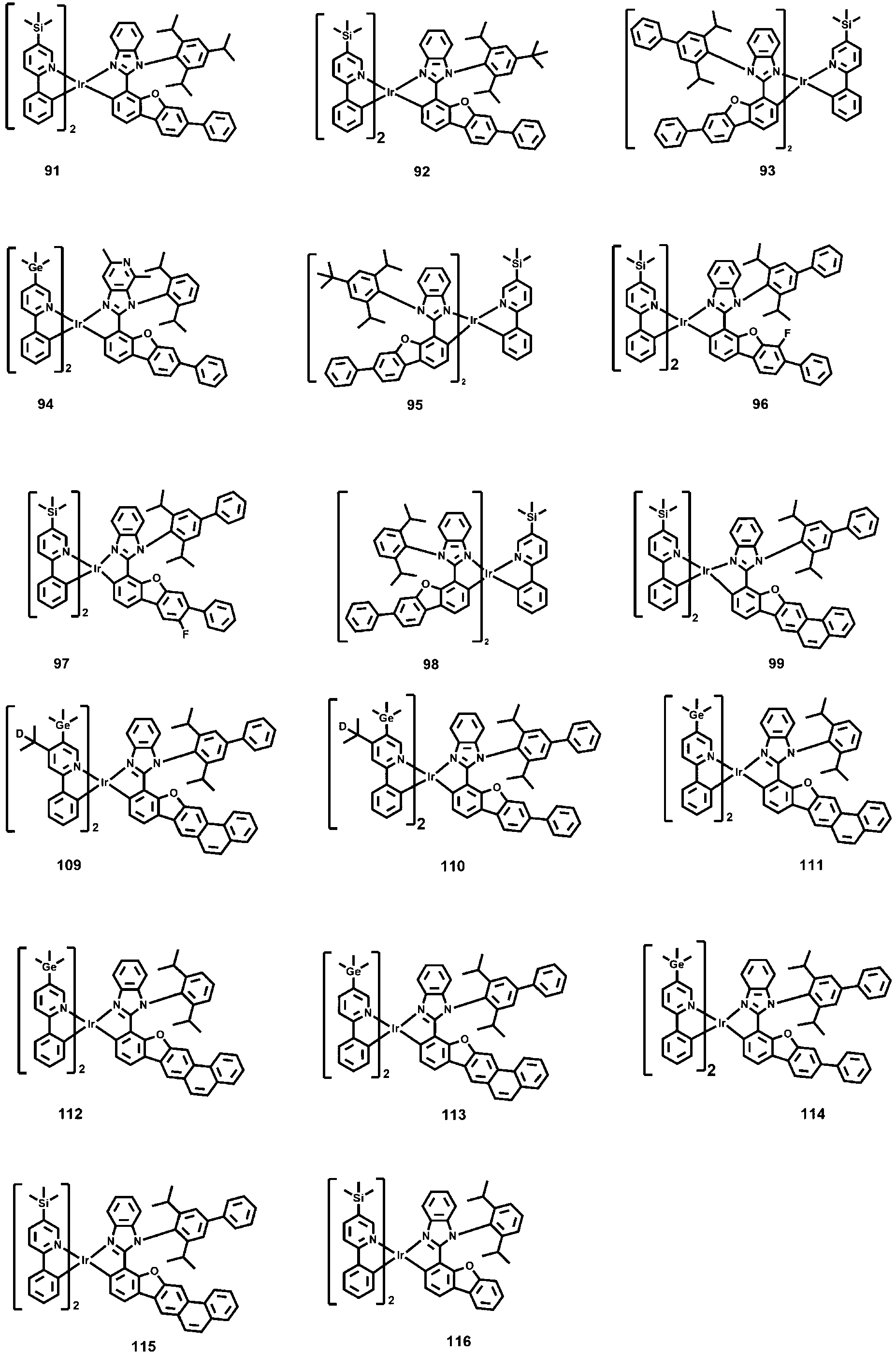

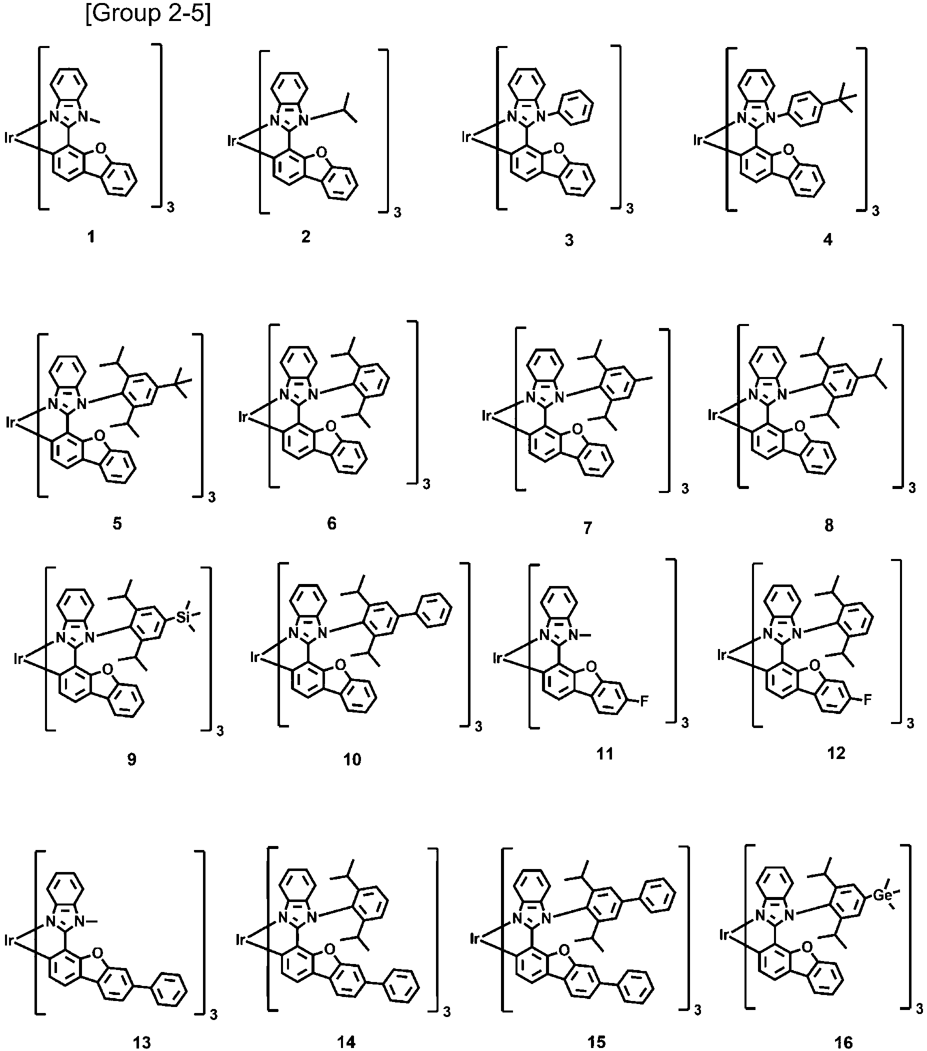

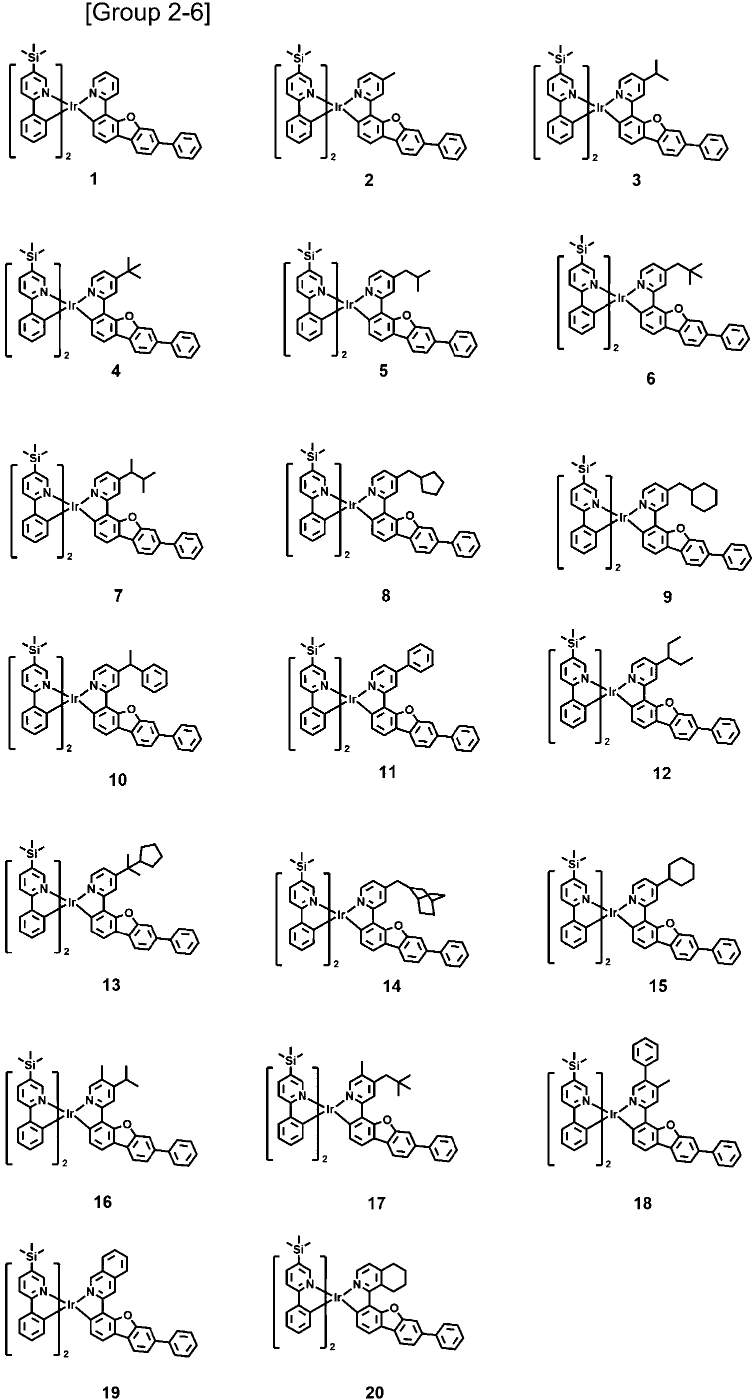

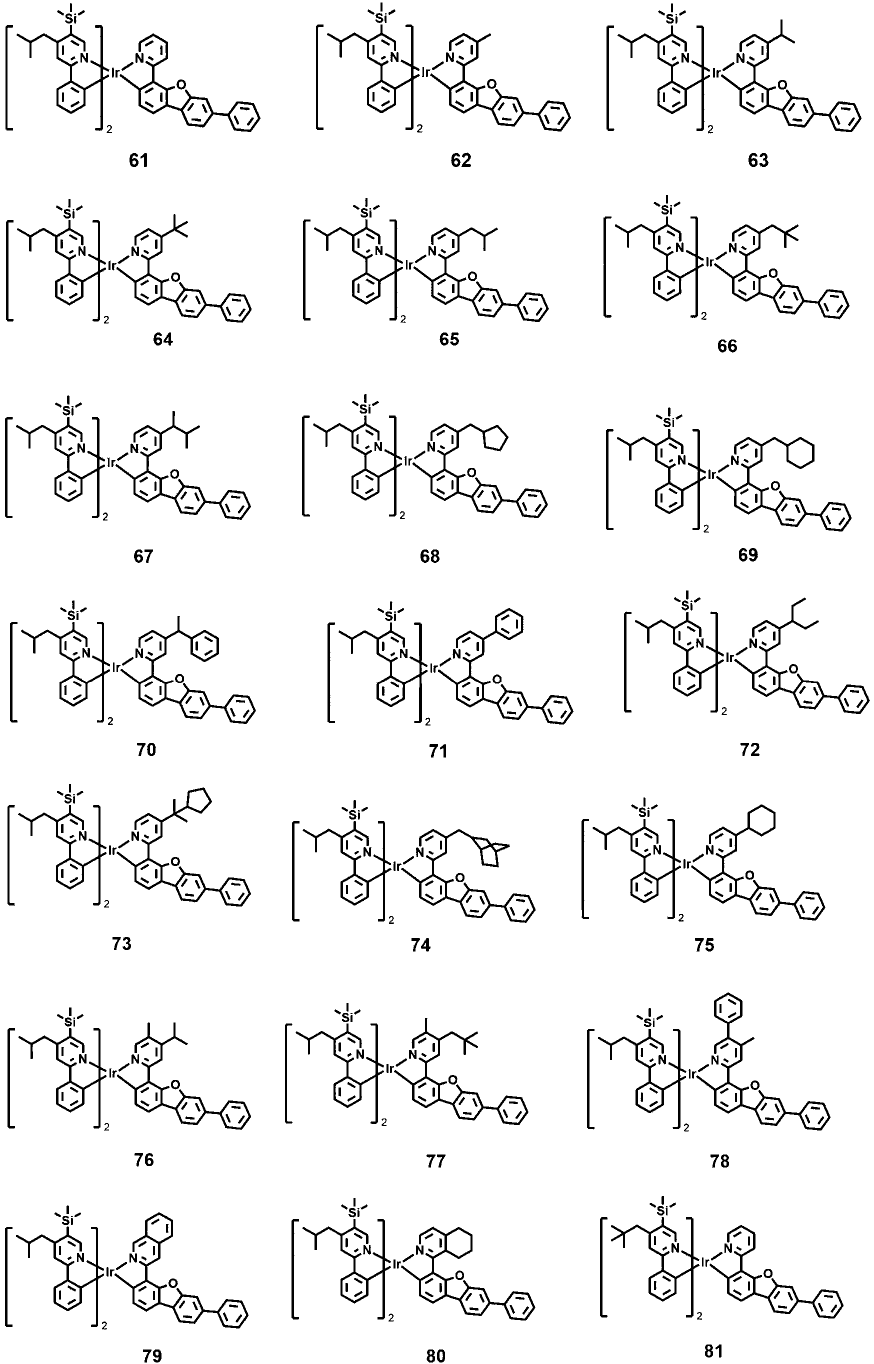

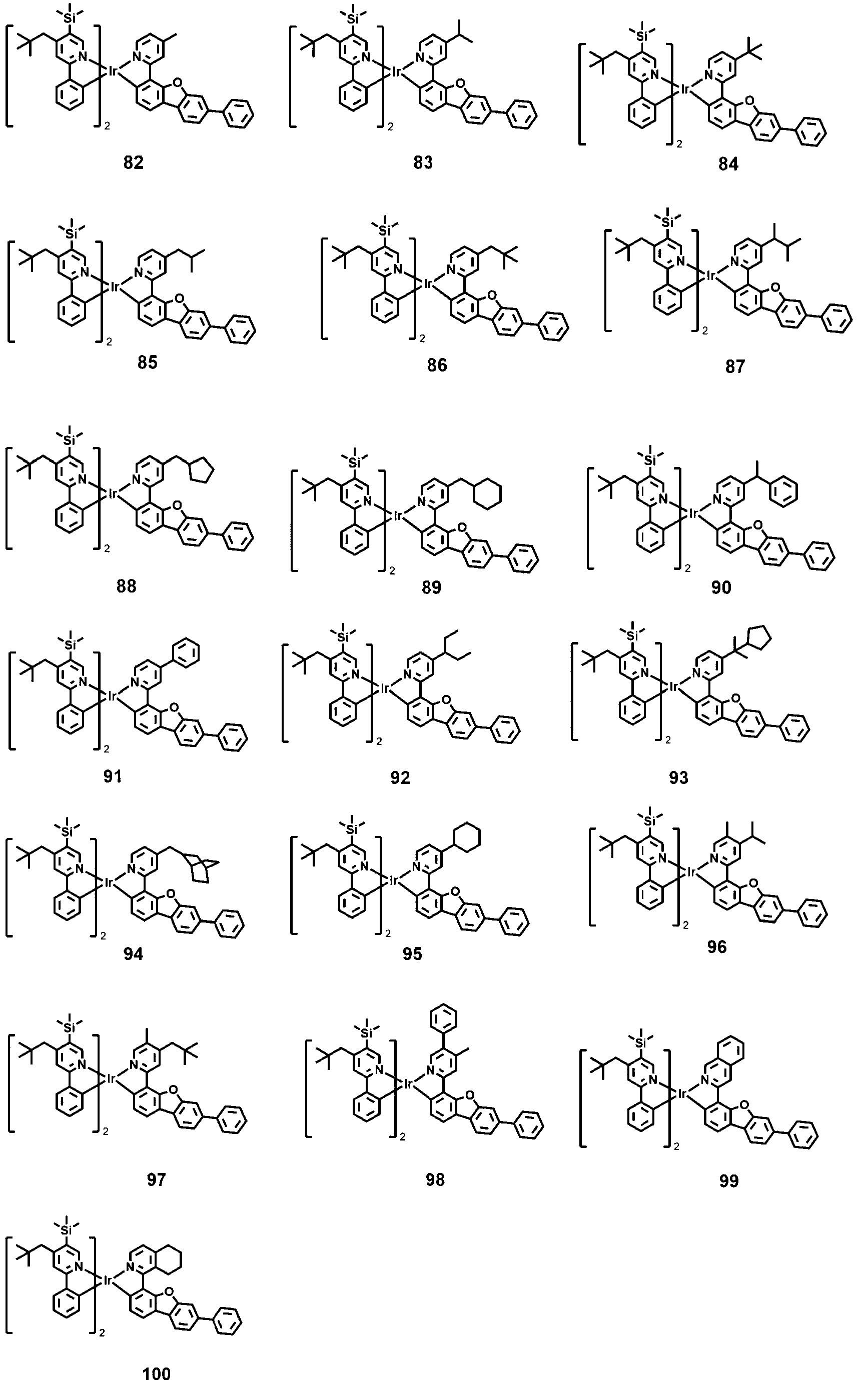

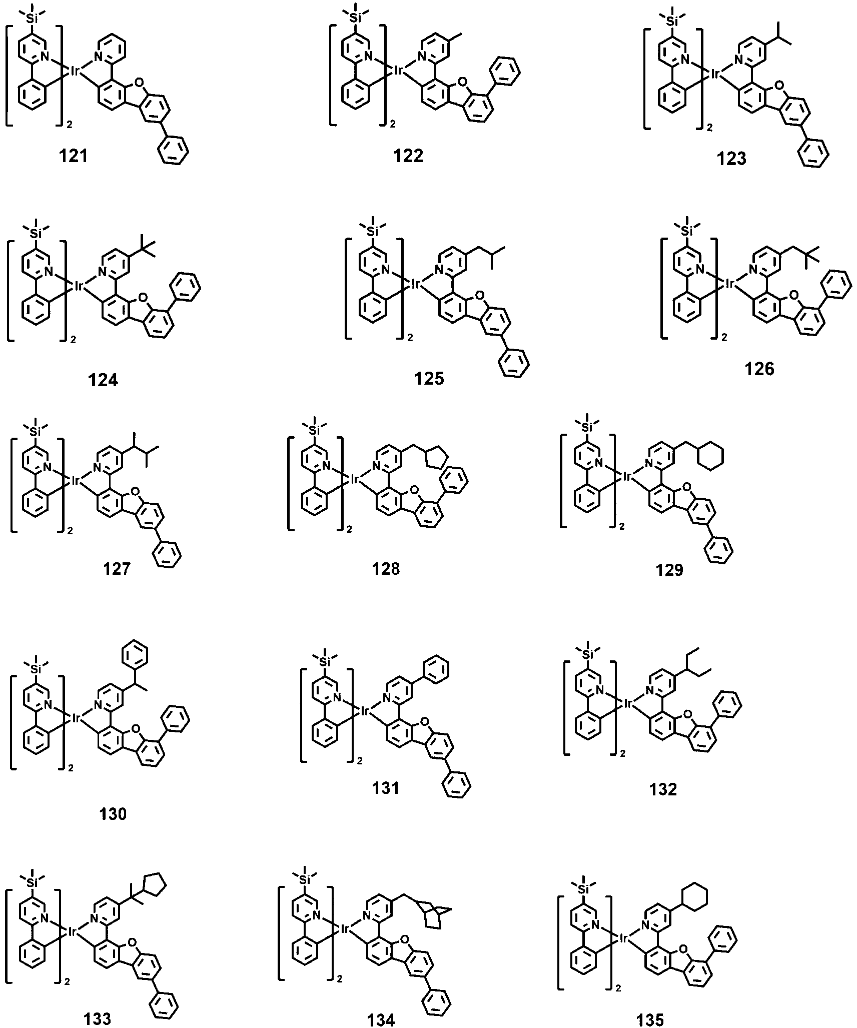

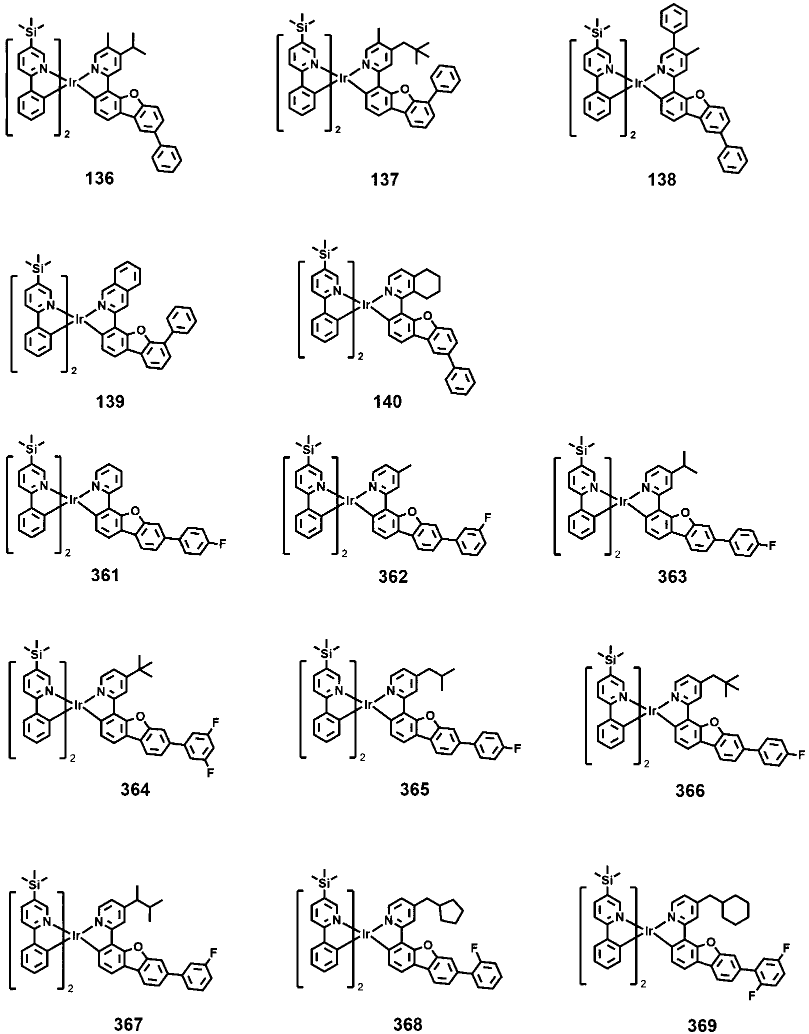

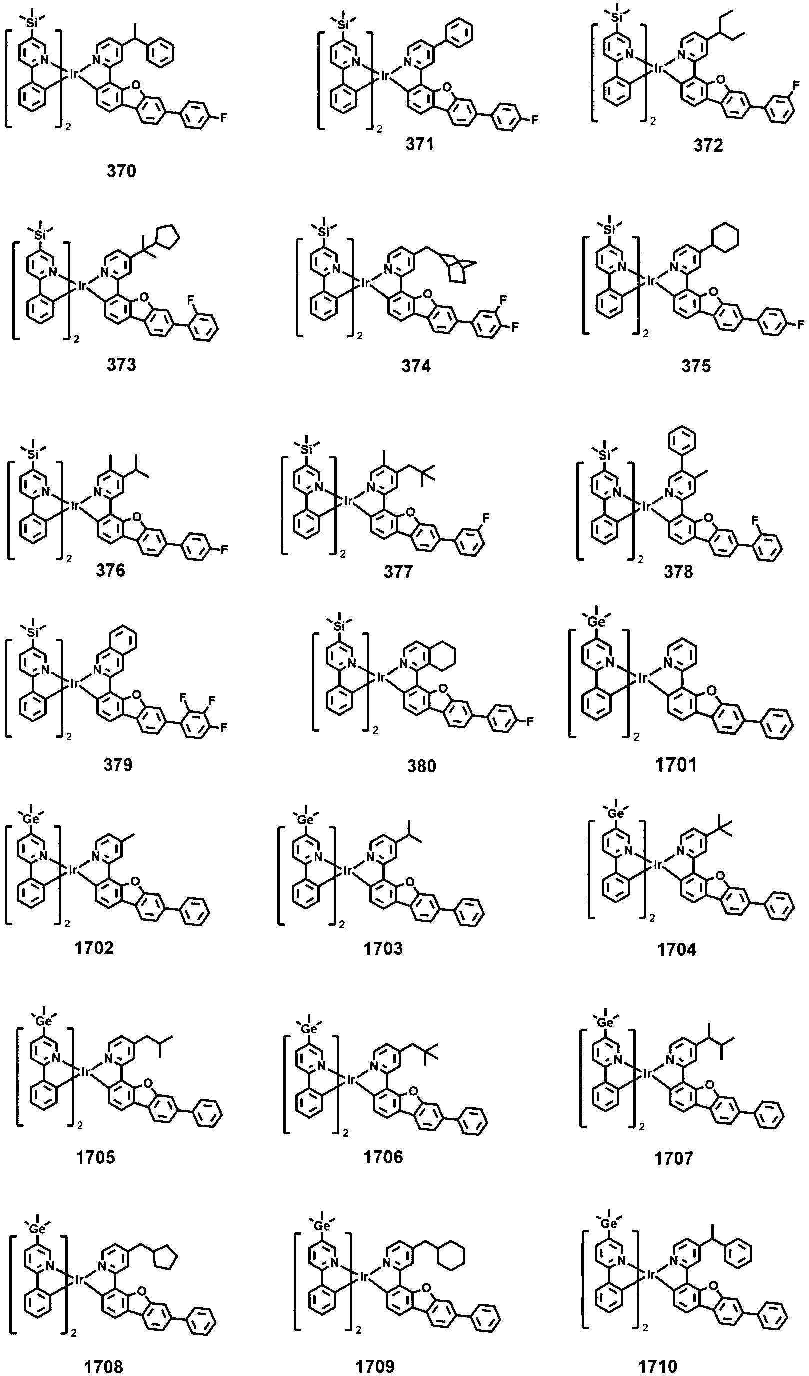

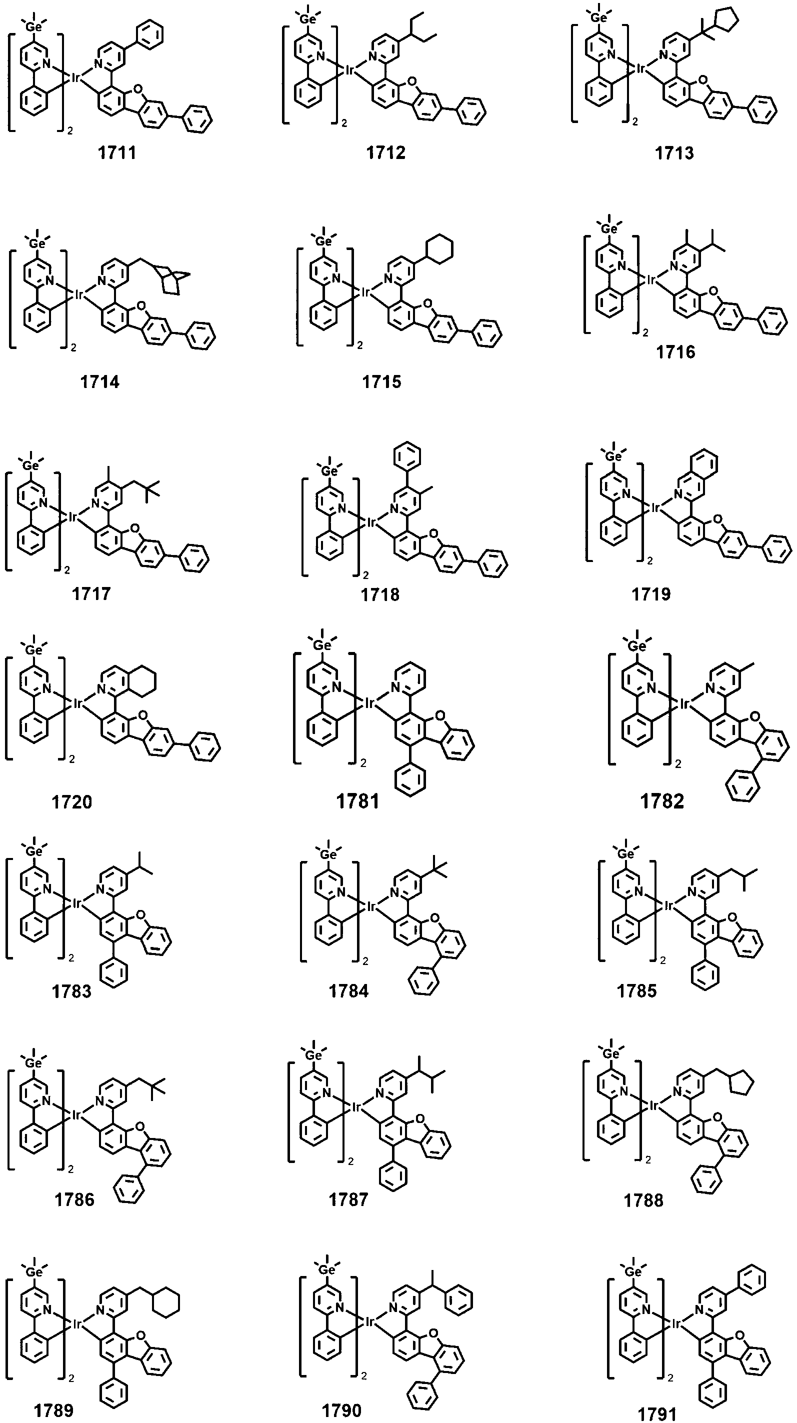

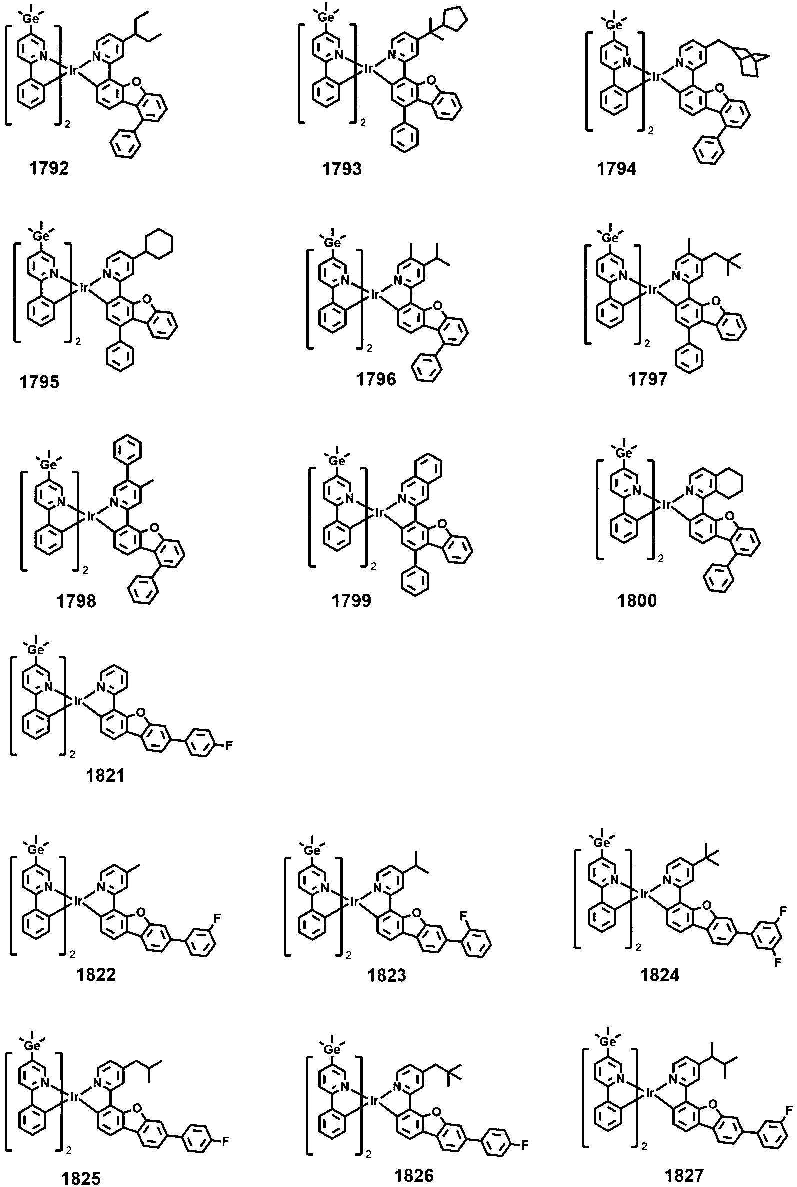

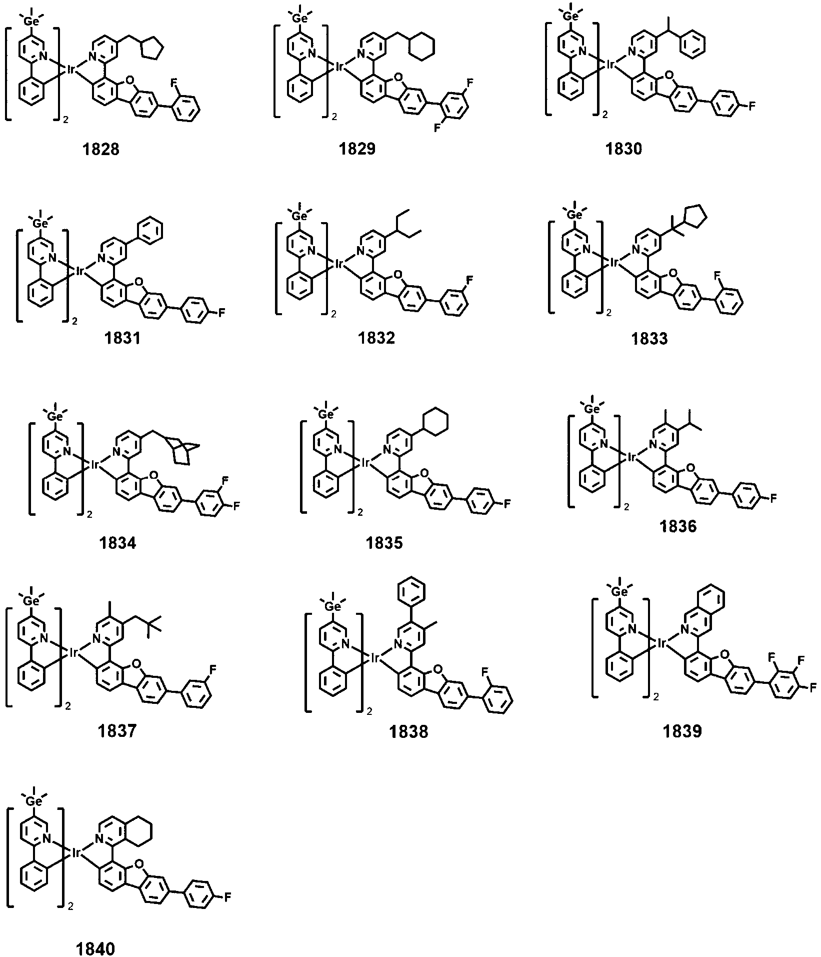

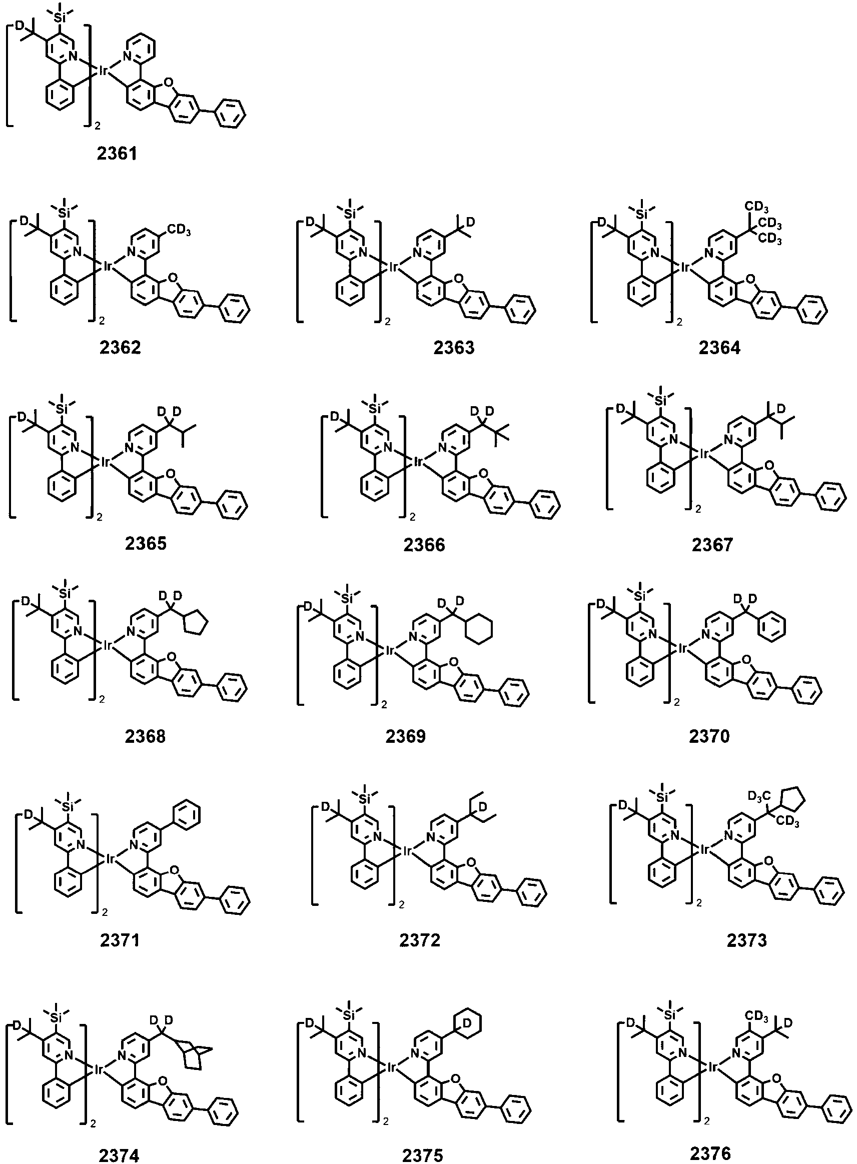

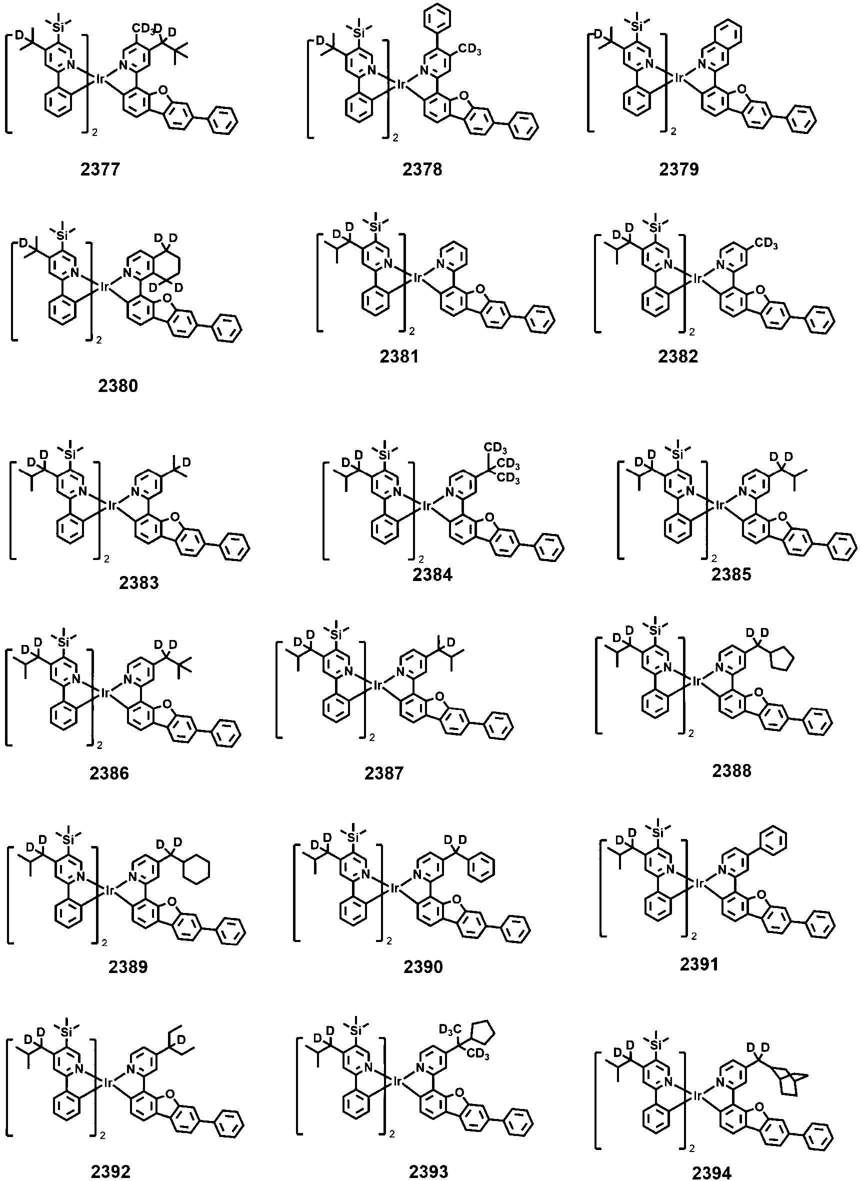

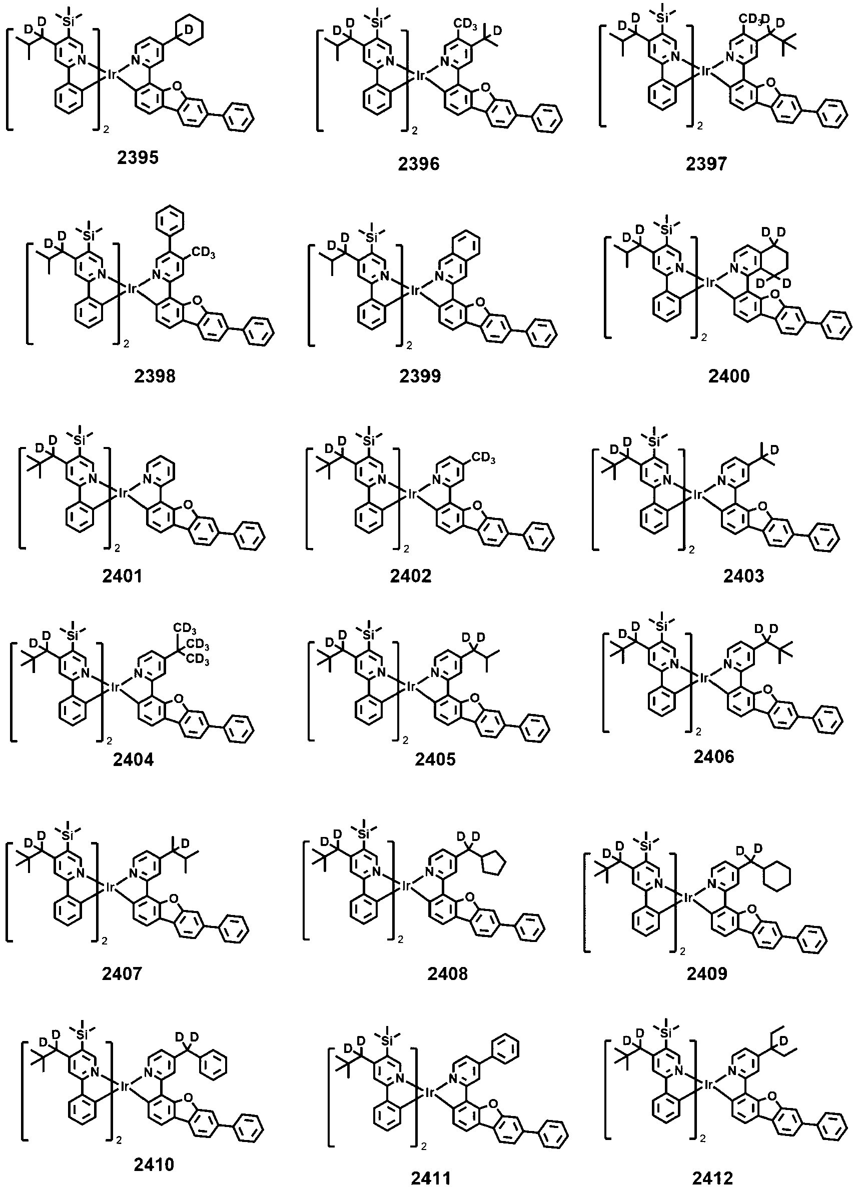

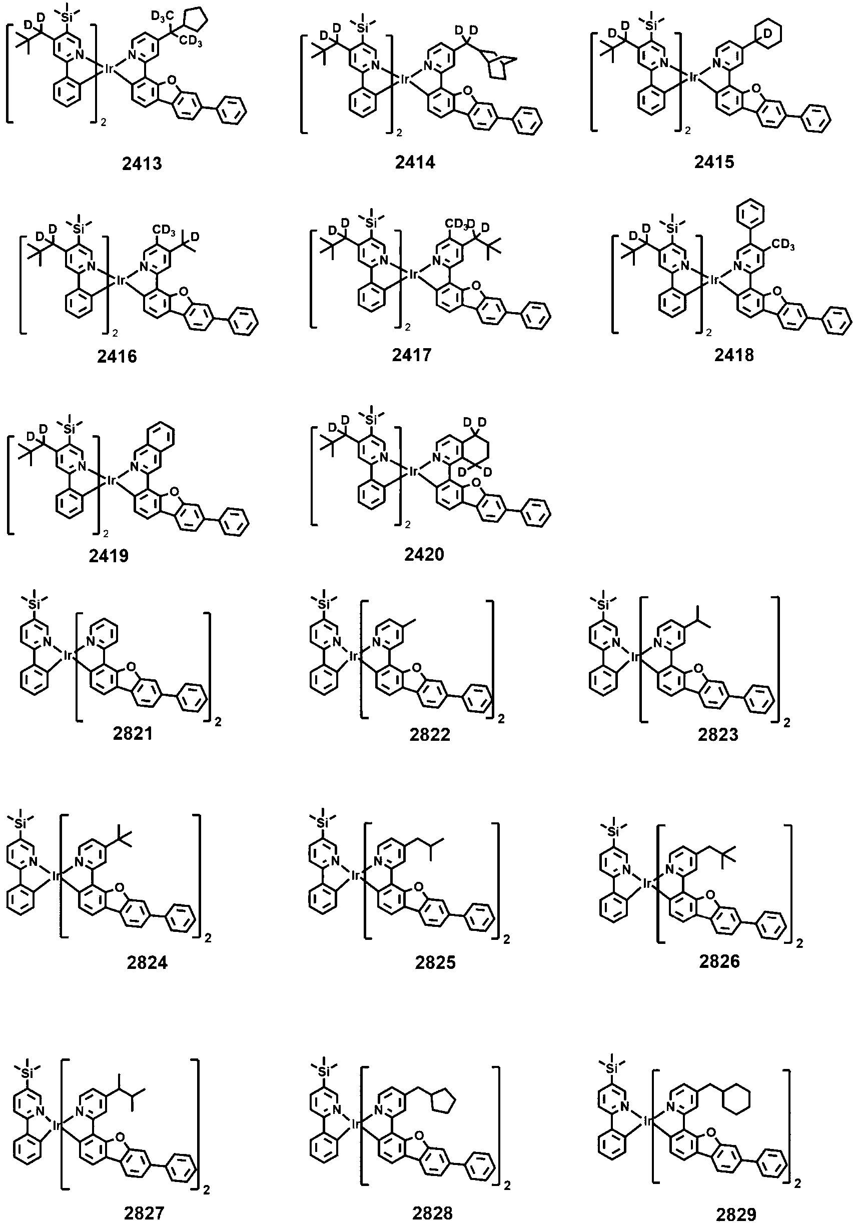

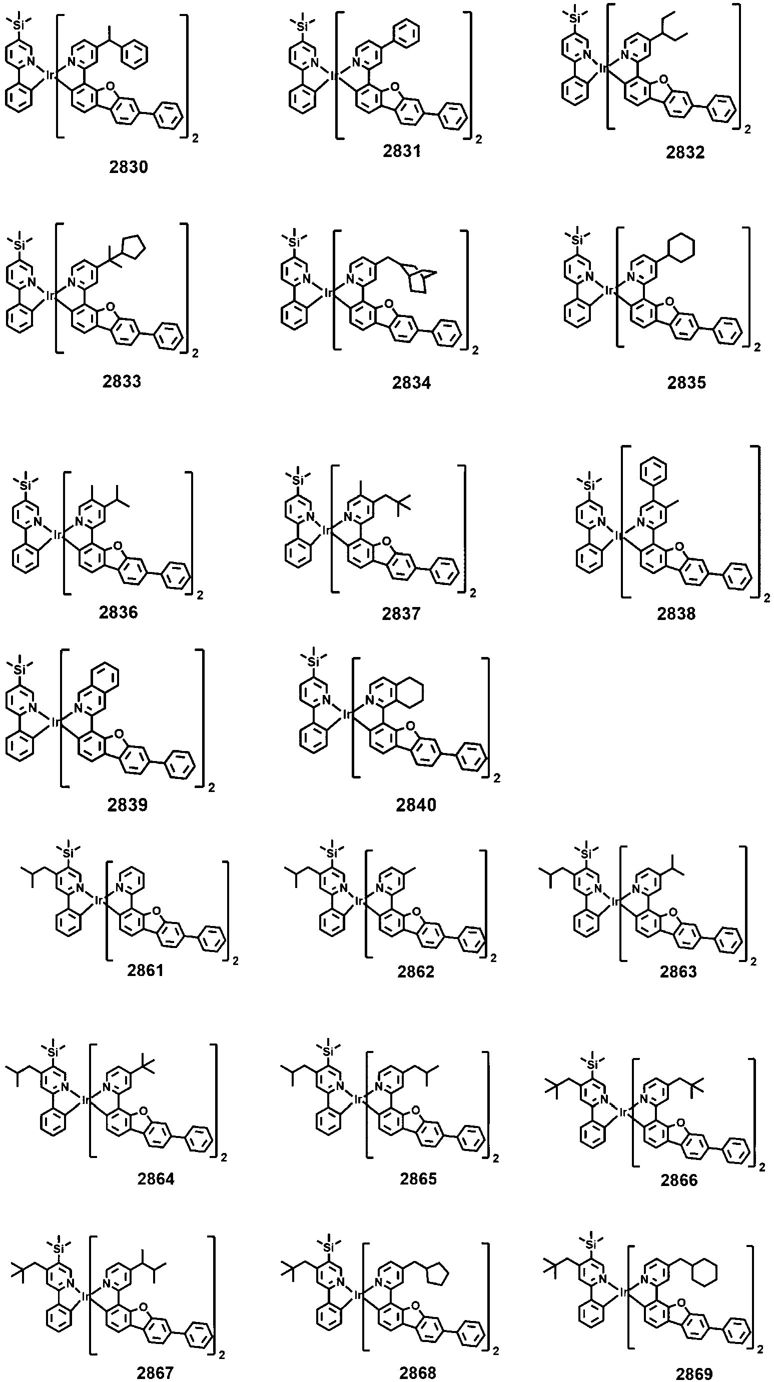

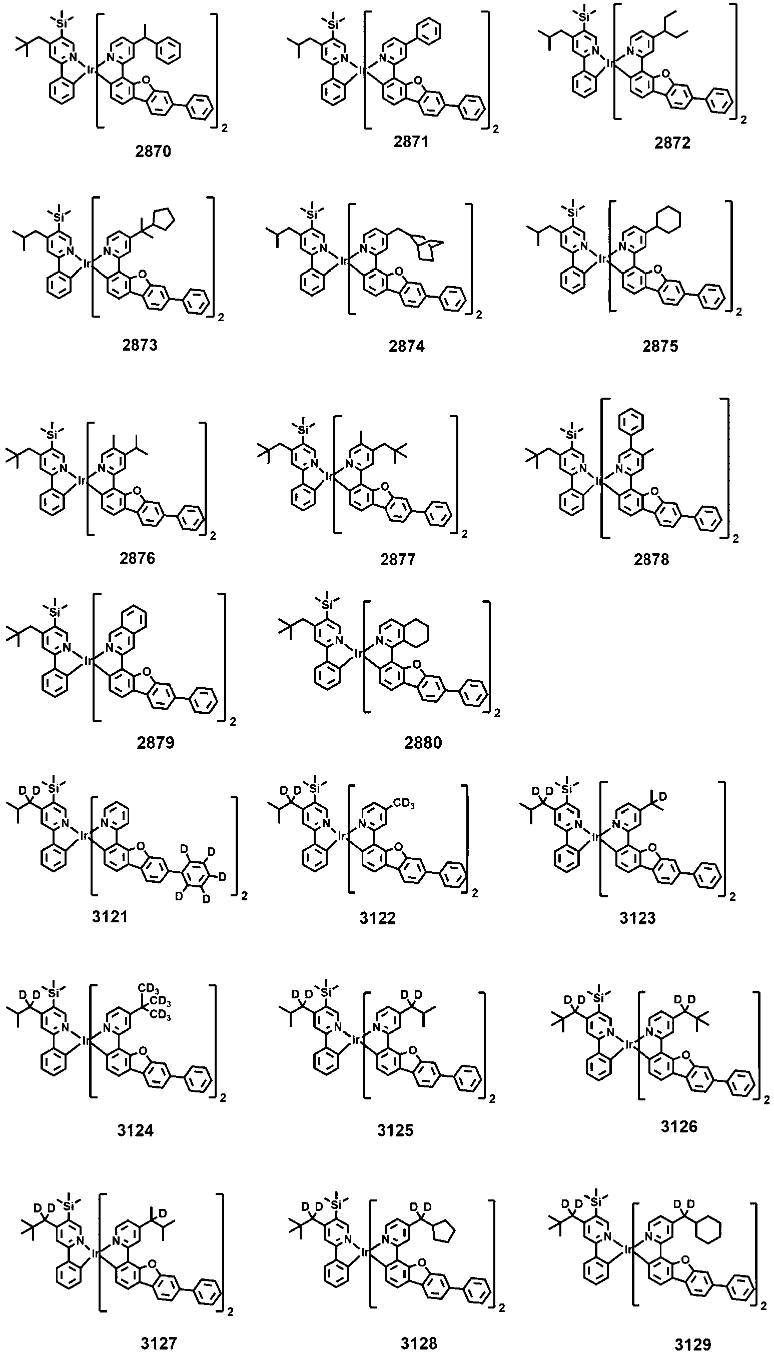

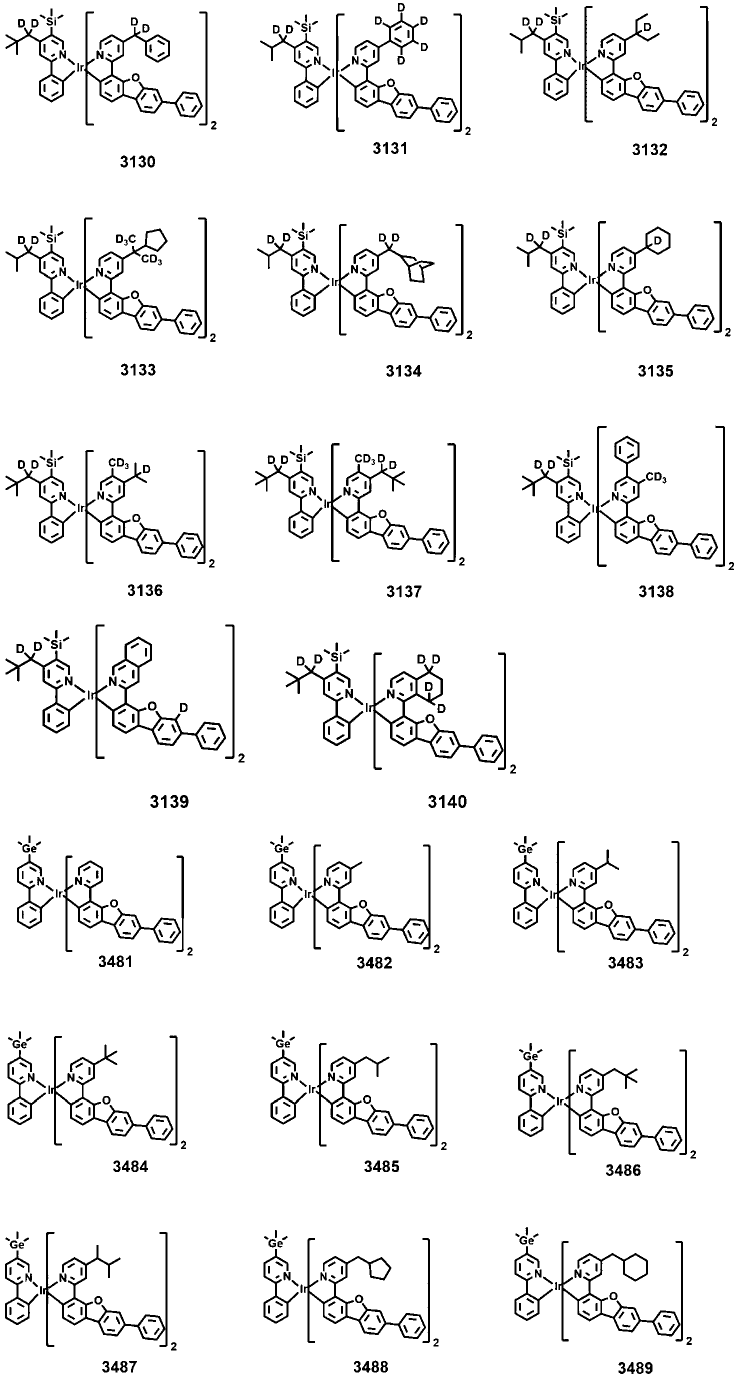

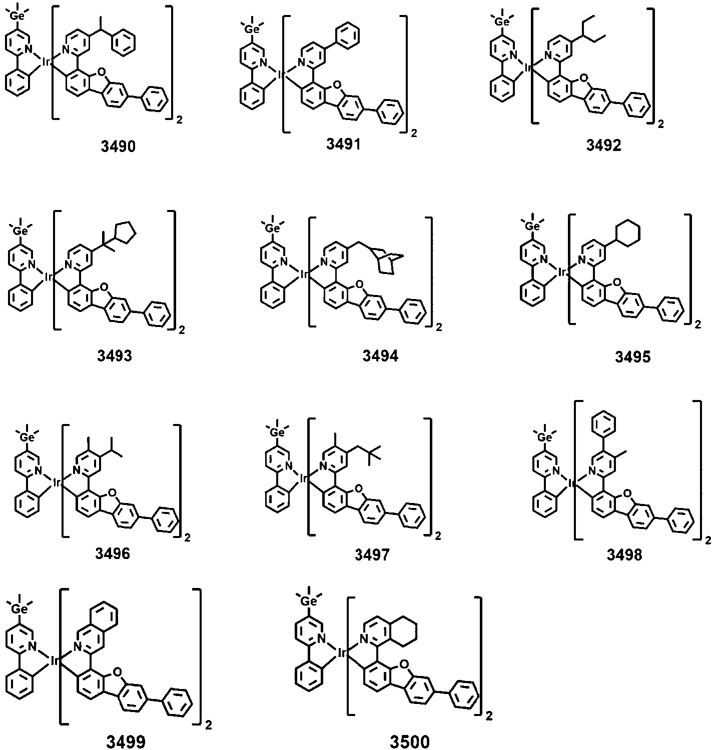

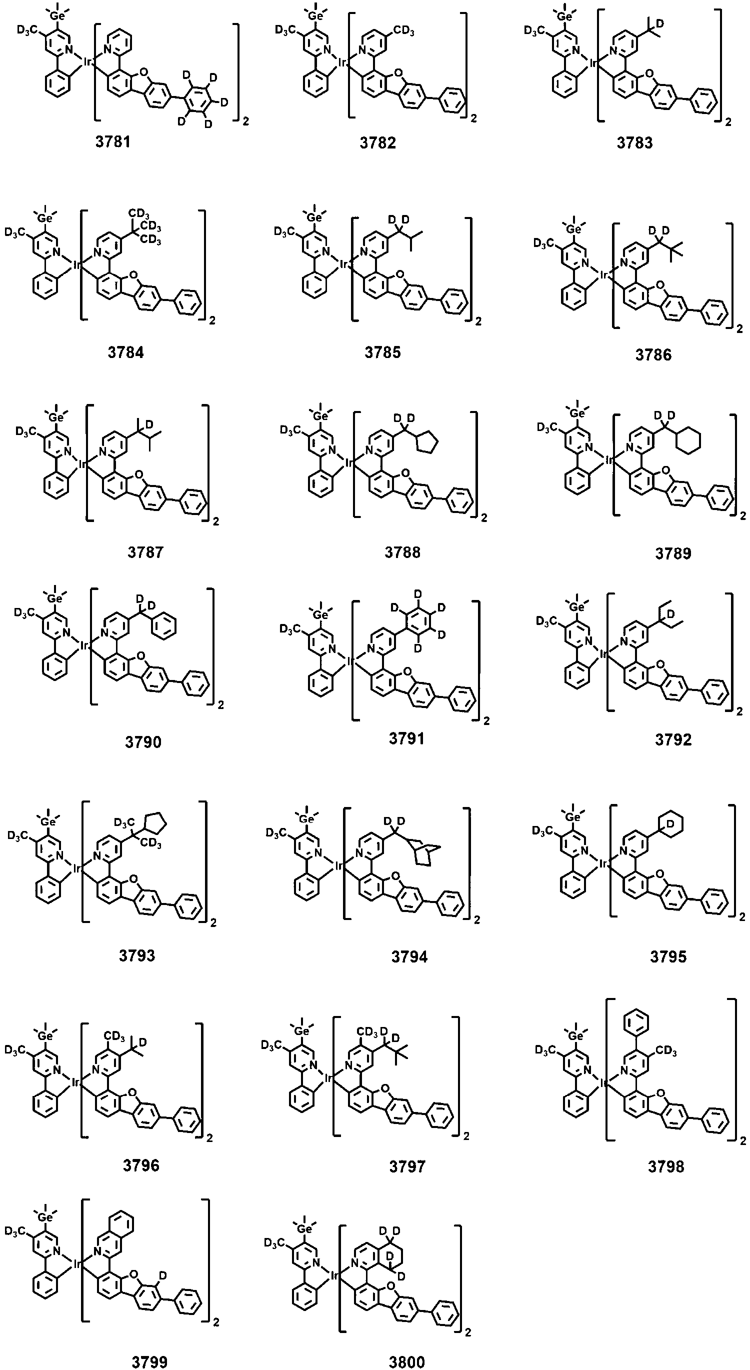

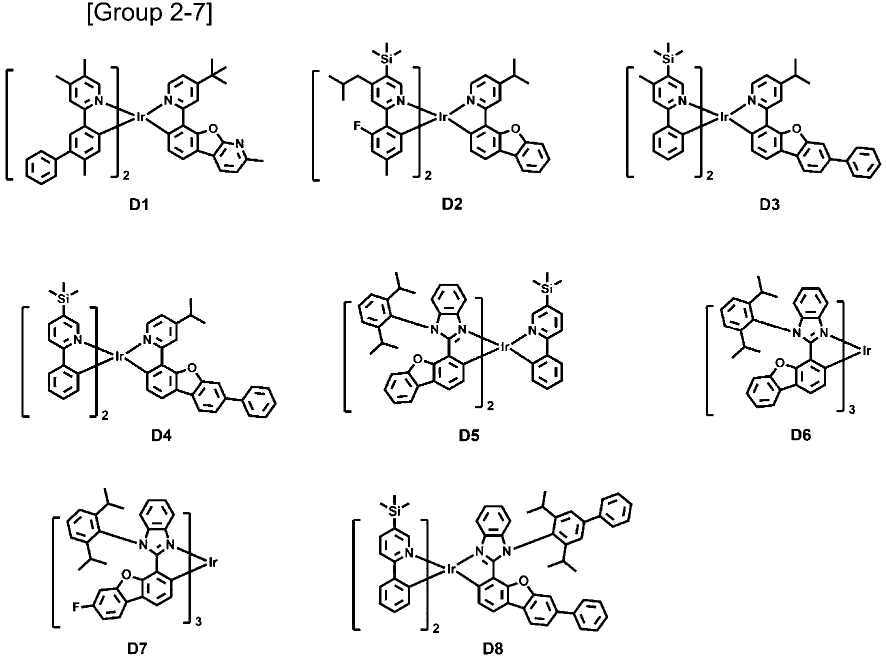

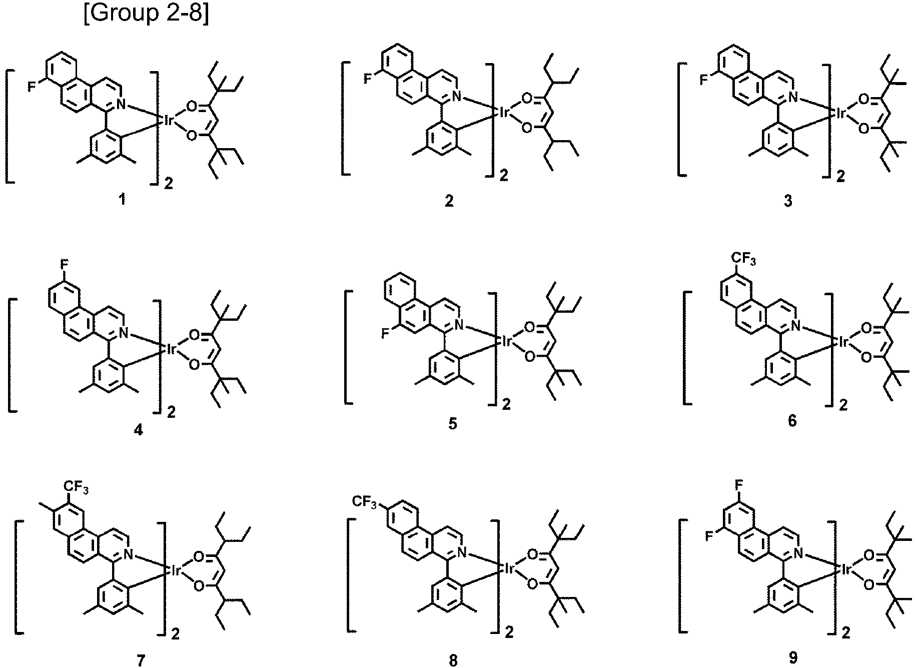

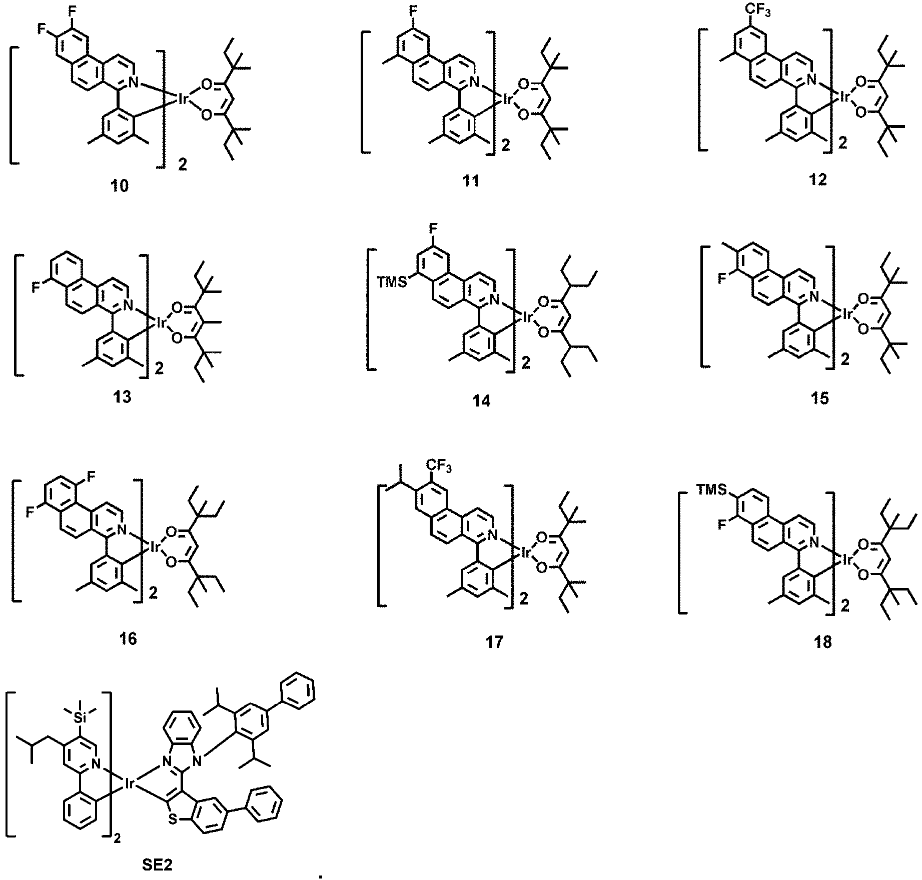

As used herein, "Ome" is a methoxy group, "TMS" is a trimethylsilyl group, and "TMG" is a trimethylgermyl group.

### Description of fluorescent emitter

The fluorescent emitter does not include a metal (i.e., the fluorescent emitter is metal-free), for example, a transition metal.

In one or more embodiments, the fluorescent emitter may include a thermal activated delayed fluorescent emitter.

In one or more embodiments, the fluorescent emitter may include:
a) a first ring;
b) a second ring; and
c) a third ring, a fifth ring, or a combination thereof,

wherein each of the first ring and the second ring may be a 6-membered ring including one boron atom, one nitrogen atom, and four carbon atoms,
the third ring may be i) a 6-membered ring including one nitrogen atom and five carbon atoms, or ii) a 6-membered ring including one nitrogen atom, four carbon atoms, and one silicon atom,
the fifth ring may be a condensed ring in which at least one thiophene or at least one furan is condensed with at least one 6-membered ring,
the first ring and the second ring may be condensed with each other while sharing a boron atom,
if present, the third ring may be condensed with the second ring while sharing a nitrogen atom, and
if present, the fifth ring i) may be condensed with the first ring but may not be condensed with the second ring, or ii) may be condensed with the second ring but may not be condensed with the first ring.

In one or more embodiments, the fluorescent emitter may further include, in addition to the first ring, the second ring, the third ring, and/or the fifth ring, a fourth ring. The fourth ring may be i) a 6-membered ring including one nitrogen atom and five carbon atoms, or ii) a 6-membered ring including one nitrogen atom, four carbon atoms, and one silicon atom, and the fourth ring may be condensed with the first ring while sharing a nitrogen atom.

In one or more embodiments, the fluorescent emitter may further include, in addition to the first ring, the second ring, the third ring, and/or the fifth ring, a sixth ring. The sixth ring may be a condensed ring in which at least one thiophene or at least one furan is condensed with at least one 6-membered ring. The sixth ring may be condensed with the first ring to which the fifth ring is not condensed or the second ring to which the fifth ring is not condensed.

For example, the fifth ring and the sixth ring may each independently be a benzothiophene group, or a benzofuran group.

In one or more embodiments, the fluorescent emitter may include the fifth ring, and thiophene of the benzothiophene group or furan of the benzofuran group may directly be condensed with the first ring or the second ring (e.g., the first ring).

In one or more embodiments, the fluorescent emitter may include the sixth ring, and thiophene of the benzothiophene group or furan of the benzofuran group may be directly condensed with the first ring or the second ring (e.g., the second ring).

In one or more embodiments, the fluorescent emitter may include the first ring, the second ring, and the third ring.

In one or more embodiments, the fluorescent emitter may include the first ring, the second ring, the third ring, and the fourth ring.

In one or more embodiments, the fluorescent emitter may include the first ring, the second ring, and the fifth ring.

In one or more embodiments, the fluorescent emitter may include the first ring, the second ring, the third ring, and the fifth ring.

In one or more embodiments, the fluorescent emitter may include the first ring, the second ring, the third ring, the fourth ring, and the fifth ring.

In one or more embodiments, the fluorescent emitter may include the first ring, the second ring, the fifth ring, and the sixth ring.

In one or more embodiments, the fluorescent emitter may include the first ring, the second ring, the third ring, the fifth ring, and the sixth ring.

In one or more embodiments, the fluorescent emitter may include the first ring, the second ring, the third ring, the fourth ring, the fifth ring, and the sixth ring.

In one or more embodiments, the fluorescent emitter may include a compound represented by Formula 3: 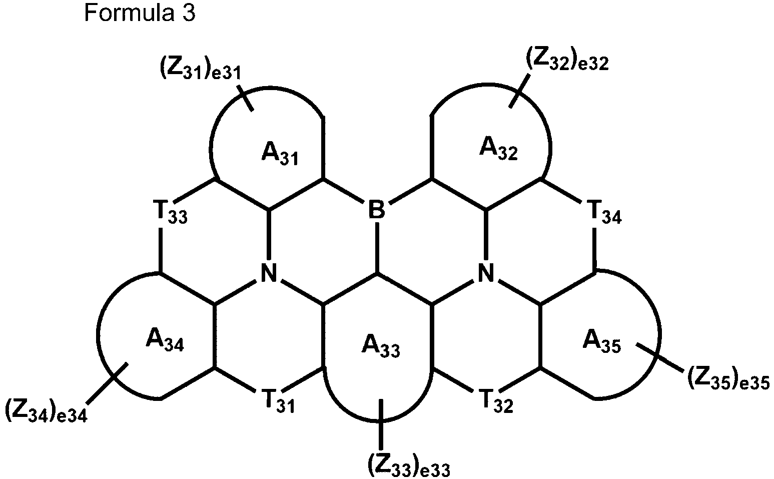 wherein, in Formula 3,
ring A₃₁ to ring A₃₅ may each independently be a C₅-C₆₀ carbocyclic group or a C₃-C₆₀ heterocyclic group,
T₃₁ may not be present, or may be a single bond, O, S, N(R₉₁), C(R₉₁)(R₉₂), or Si(R₉₁)(R₉₂),
T₃₂ may not be present, or may be a single bond, O, S, N(R₉₃), C(R₉₃)(R₉₄), or Si(R₉₃)(R₉₄),
T₃₃ may not be present, or may be a single bond, O, S, N(R₉₅), C(R₉₅)(R₉₆), or Si(R₉₅)(R₉₆),
T₃₄ may not be present, or may be a single bond, O, S, N(R₉₇), C(R₉₇)(R₉₈), or Si(R₉₇)(R₉₈),
Z₃₁ to Z₃₅ and R₉₁ to R₉₈ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q₆)(Q₇), -P(=O)(Q₈)(Q₉), or -P(Q₈)(Q₉),
e31 to e35 may each independently be an integer from 0 to 10,
at least two of Z₃₁, Z₃₂, Z₃₃, Z₃₄, Z₃₅, R₉₁, R₉₂, R₉₃, R₉₄, R₉₅, R₉₆, R₉₇ and R₉₈ may optionally be linked together to form a substituted or unsubstituted C₅-C₃₀ carbocyclic group or a substituted or unsubstituted C₁-C₃₀ heterocyclic group,
substituents of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may each independently be:
   deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
   a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), - P(=O)(Q₁₈)(Q₁₉), -P(Q₁₈)(Q₁₉), or a combination thereof;
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), - P(=O)(Q₂₈)(Q₂₉), -P(Q₂₈)(Q₂₉), or a combination thereof;
   -N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
   a combination thereof, and
   Q₁ to Q₉, Q₁₁ to Q₁₉, Q₂₁ to Q₂₉, and Q₃₁ to Q₃₉ may each independently be a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, a cyano group, a C₁-C₆₀ alkyl group, a C₆-C₆₀ aryl group, or a combination thereof,

Formula 3 may satisfy at least one of Condition 3a or Condition 3b:
Condition 3a
   in Formula 3, T₃₂ is C(R₉₃)(R₉₄) or Si(R₉₃)(R₉₄)
Condition 3b
   in Formula 3, at least one of ring A₃₁ or ring A₃₂ is each independently a condensed ring in which at least one thiophene or at least one furan is condensed with at least one 6-membered ring.

In one or more embodiments, in Formula 3 and 3, ring A₃₁ to ring A₃₅ may each independently be a benzene group, a naphthalene group, a phenanthrene group, a pyridine group, a pyrimidine group, a pyridazine group, a pyrazine group, a quinoline group, an isoquinoline group, a benzofuran group, a benzothiophene group, a dibenzofuran group, a dibenzothiophene group, a carbazole group, a fluorene group, a dibenzosilole group, an azadibenzofuran group, an azadibenzothiophene group, an azacarbazole group, an azafluorene group, or an azadibenzosilole group.

In one or more embodiments, in Formula 3, Z₃₁ to Z₃₅ and R₉₁ to R₉₈ may each independently be:
hydrogen, deuterium, -F, or a cyano group;
a C₁-C₂₀ alkyl group, a phenyl group, a biphenyl group, a dibenzofuranyl group, a dibenzothiophenyl group, a carbazolyl group (e.g., an N-carbazolyl group), a fluorenyl group, or a dibenzosilolyl group, each unsubstituted or substituted with deuterium, -F, a cyano group, a C₁-C₂₀ alkyl group, a phenyl group, a dibenzofuranyl group, a dibenzothiophenyl group, a carbazolyl group (e.g., an N-carbazolyl group or the like), a fluorenyl group, a dibenzosilolyl group, or a combination thereof; or
-N(Q₁)(Q₂), and
Q₁ and Q₂ may each independently be a C₁-C₂₀ alkyl group, a phenyl group, a biphenyl group, a dibenzofuranyl group, a dibenzothiophenyl group, a carbazolyl group, a fluorenyl group, or a dibenzosilolyl group, each unsubstituted or substituted with deuterium, -F, a cyano group, a C₁-C₂₀ alkyl group, a phenyl group, a dibenzofuranyl group, a dibenzothiophenyl group, a carbazolyl group, a fluorenyl group, a dibenzosilolyl group, or a combination thereof.

In one or more embodiments, Formula 3-1 may satisfy Condition 3a, and
i) each of R₉₃ and R₉₄ may be a substituted or unsubstituted C₁-C₆₀ alkyl group (e.g., a substituted or unsubstituted C₁-C₂₀ alkyl group or a substituted or unsubstituted C₁-C₁₀ alkyl group), or
ii) R₉₃ and R₉₄ may each independently be a substituted or unsubstituted C₆-C₆₀ aryl group (e.g., a substituted or unsubstituted phenyl group or a substituted or unsubstituted naphthyl group), a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and R₉₃ and R₉₄ may optionally be linked to each other via a single bond, a di(C₁-C₁₀ alkyl)methylene group, a di(C₆-C₁₀ aryl)methylene group, O, or S, wherein at least one hydrogen in the di(C₁-C₁₀ alkyl)methylene group and the di(C₆-C₁₀ aryl)methylene group may optionally be substituted with deuterium.

In one or more embodiments, Formula 3 may satisfy Condition 3b, and at least one of ring A₃₁ or ring A₃₂ may be a benzothiophene group, or a benzofuran group. For example, when at least one of ring A₃₁ or ring A₃₂ is a benzothiophene group or a benzofuran group, thiophene of the benzothiophene group and furan of the benzofuran group may directly be condensed with a 6-membered ring including a boron atom and a nitrogen atom in Formula 3.

In one or more embodiments, T₃₁ in Formula 3 may be C(R₉₁)(R₉₂), or Si(R₉₁)(R₉₂).

In one or more embodiments, T₃₁ in Formula 3 may be C(R₉₁)(R₉₂), or Si(R₉₁)(R₉₂), and
i) each of R₉₁ and R₉₂ may be a substituted or unsubstituted C₁-C₆₀ alkyl group (e.g., a substituted or unsubstituted C₁-C₂₀ alkyl group or a substituted or unsubstituted C₁-C₁₀ alkyl group), or
ii) R₉₁ and R₉₂ may each independently be a substituted or unsubstituted C₆-C₆₀ aryl group (e.g., a substituted or unsubstituted phenyl group or a substituted or unsubstituted naphthyl group), a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and R₉₃ and R₉₄ may optionally be linked to each other via a single bond, a di(C₁-C₁₀ alkyl)methylene group, a di(C₆-C₁₀ aryl)methylene group, O, or S, wherein at least one hydrogen in the di(C₁-C₁₀ alkyl)methylene group and the di(C₆-C₁₀ aryl)methylene group may optionally be substituted with deuterium.

In one or more embodiments, the fluorescent emitter may be a compound represented by one of Formulae 3(1) to 3(5): 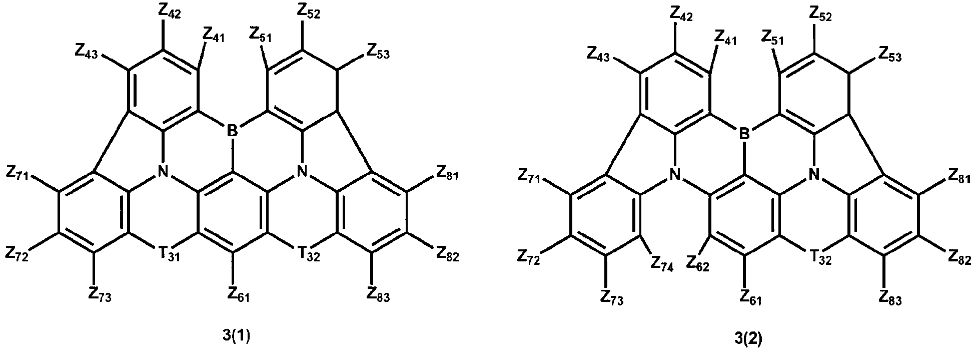 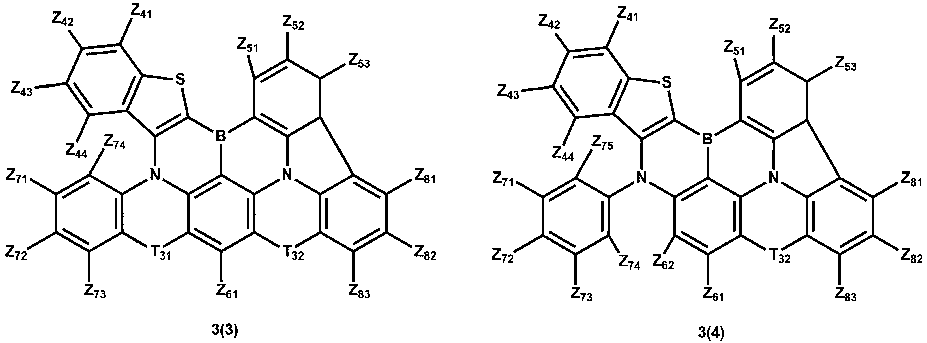 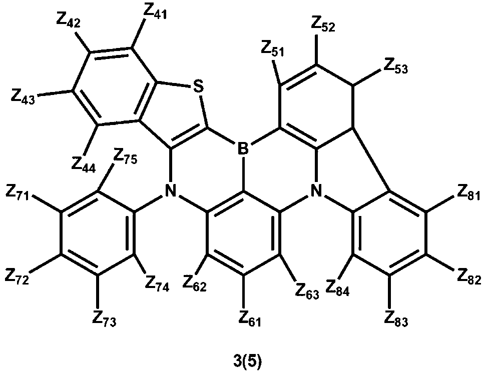 wherein, in Formulae 3(1) to 3(5),
T₃₁ may be a single bond, O, S, N(R₉₁), C(R₉₁)(R₉₂), or Si(R₉₁)(R₉₂),
T₃₂ may be C(R₉₃)(R₉₄) or Si(R₉₃)(R₉₄),
Z₄₁ to Z₄₄ may each be the same as described herein in connection with Z31,
Z₅₁ to Z₅₃ may each be the same as described herein in connection with Z32,
Z₆₁ to Z₆₃ may each be the same as described herein in connection with Z33,
Z₇₁ to Z₇₅ may each be the same as described herein in connection with Z34,
Z₈₁ to Z₈₄ may each be the same as described herein in connection with Z35,
R₉₁ to R₉₄ may each be the same as described herein,
Z₆₂ and Z₇₄ in Formulae 3(2), 3(4), and 3(5) may not be linked to each other, and
Z₆₃ and Z₈₄ in Formulae 3(5) may not be linked to each other.

For example, in Formulae 3(1) to 3(5),
i) each of R₉₃ and R₉₄ may be a substituted or unsubstituted C₁-C₆₀ alkyl group (e.g., a substituted or unsubstituted C₁-C₂₀ alkyl group or a substituted or unsubstituted C₁-C₁₀ alkyl group), or
ii) R₉₃ and R₉₄ may each independently be a substituted or unsubstituted C₆-C₆₀ aryl group (e.g., a substituted or unsubstituted phenyl group or a substituted or unsubstituted naphthyl group), a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and R₉₃ and R₉₄ may optionally be linked to each other via a single bond, a di(C₁-C₁₀ alkyl)methylene group, a di(C₆-C₁₀ aryl)methylene group, O, or S, wherein at least one hydrogen in the di(C₁-C₁₀ alkyl)methylene group and the di(C₆-C₁₀ aryl)methylene group may optionally be substituted with deuterium.

In one or more embodiments, T₃₁ in Formulae 3(1) and 3(3) may be C(R₉₁)(R₉₂), or Si(R₉₁)(R₉₂).

In one or more embodiments, T₃₁ in Formulae 3(1) and 3(3) may be C(R₉₁)(R₉₂), or Si(R₉₁)(R₉₂), and
i) each of R₉₁ and R₉₂ may be a substituted or unsubstituted C₁-C₆₀ alkyl group (e.g., a substituted or unsubstituted C₁-C₂₀ alkyl group or a substituted or unsubstituted C₁-C₁₀ alkyl group), or
ii) R₉₁ and R₉₂ may each independently be a substituted or unsubstituted C₆-C₆₀ aryl group (e.g., a substituted or unsubstituted phenyl group or a substituted or unsubstituted naphthyl group), a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and R₉₃ and R₉₄ may optionally be linked to each other via a single bond, a di(C₁-C₁₀ alkyl)methylene group, a di(C₆-C₁₀ aryl)methylene group, O, or S, wherein at least one hydrogen in the di(C₁-C₁₀ alkyl)methylene group and the di(C₆-C₁₀ aryl)methylene group may optionally be substituted with deuterium.

For example, the fluorescent emitter may be one of Compounds FE1, FE2, FE3, FE10, or FE11:

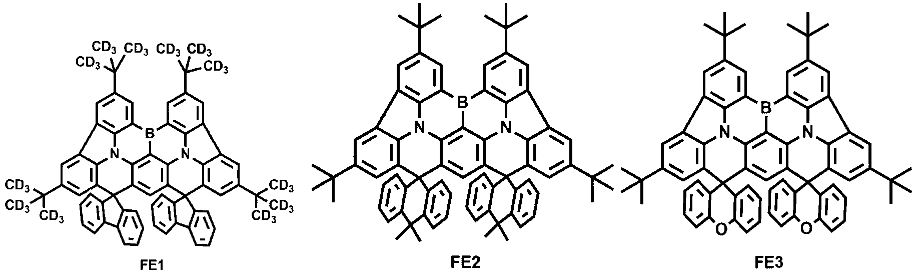

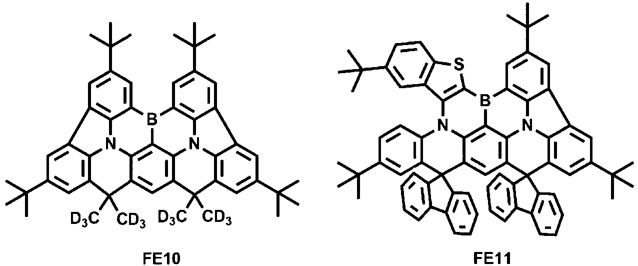

For example, the first ring, the second ring, the third ring, the fourth ring, and/or the fifth ring included in Compounds FE1, and FE11 may each be indicated by "1", "2", "3", "4", and "5", as shown below:

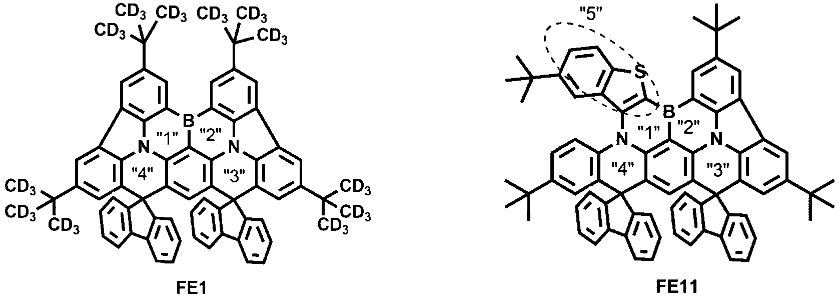

An amount of the sensitizer in the emission layer may be about 1 part by weight to about 30 parts by weight, for example, about 5 part by weight to about 20 parts by weight, or about 8 part by weight to about 15 parts by weight based on 100 parts by weight of the host in the emission layer. An amount of the fluorescent emitter in the emission layer may be about 0.005 parts by weight to about 15 parts by weight, for example, about 0.01 parts by weight to about 15 parts by weight, about 0.01 parts by weight to about 10 parts by weight, or about 0.5 parts by weight to about 5 parts by weight based on 100 parts by weight of the emission layer. When the amounts of the sensitizer and the fluorescent emitter are within the ranges above, the emission layer may exhibit excellent characteristics without concentration quenching.

In one or more embodiments, the emission layer may not include compounds of [Group A]:

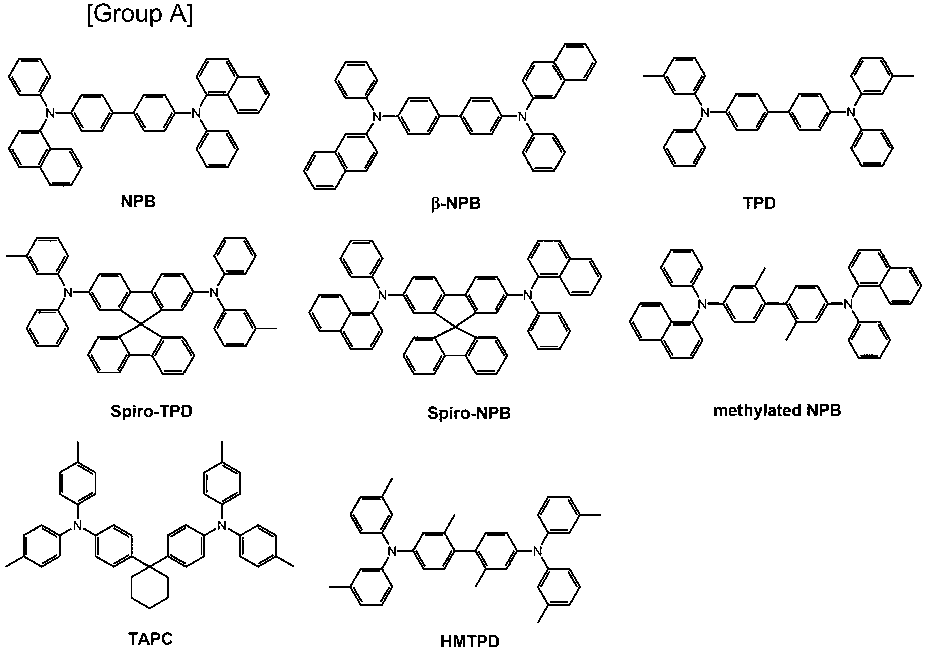

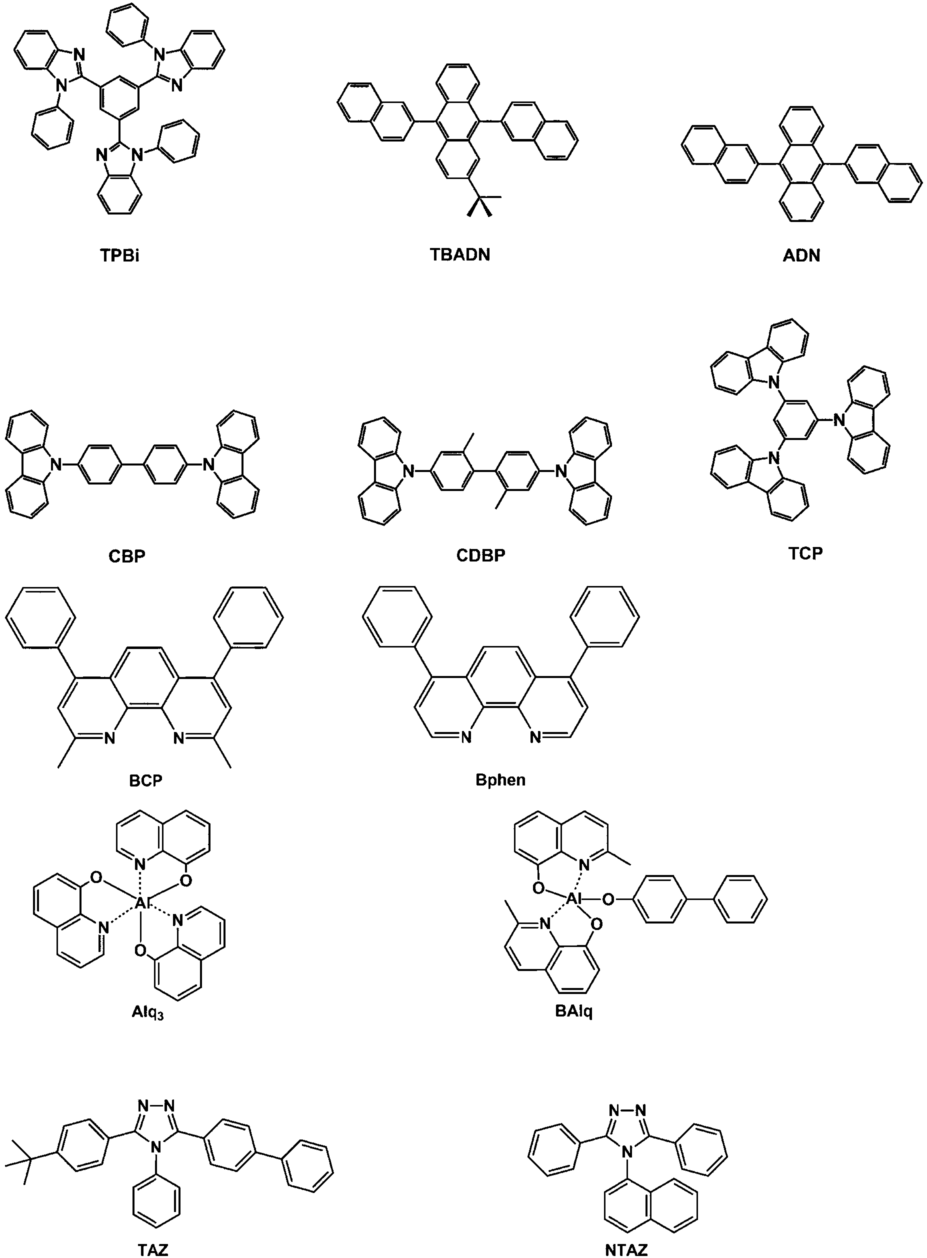

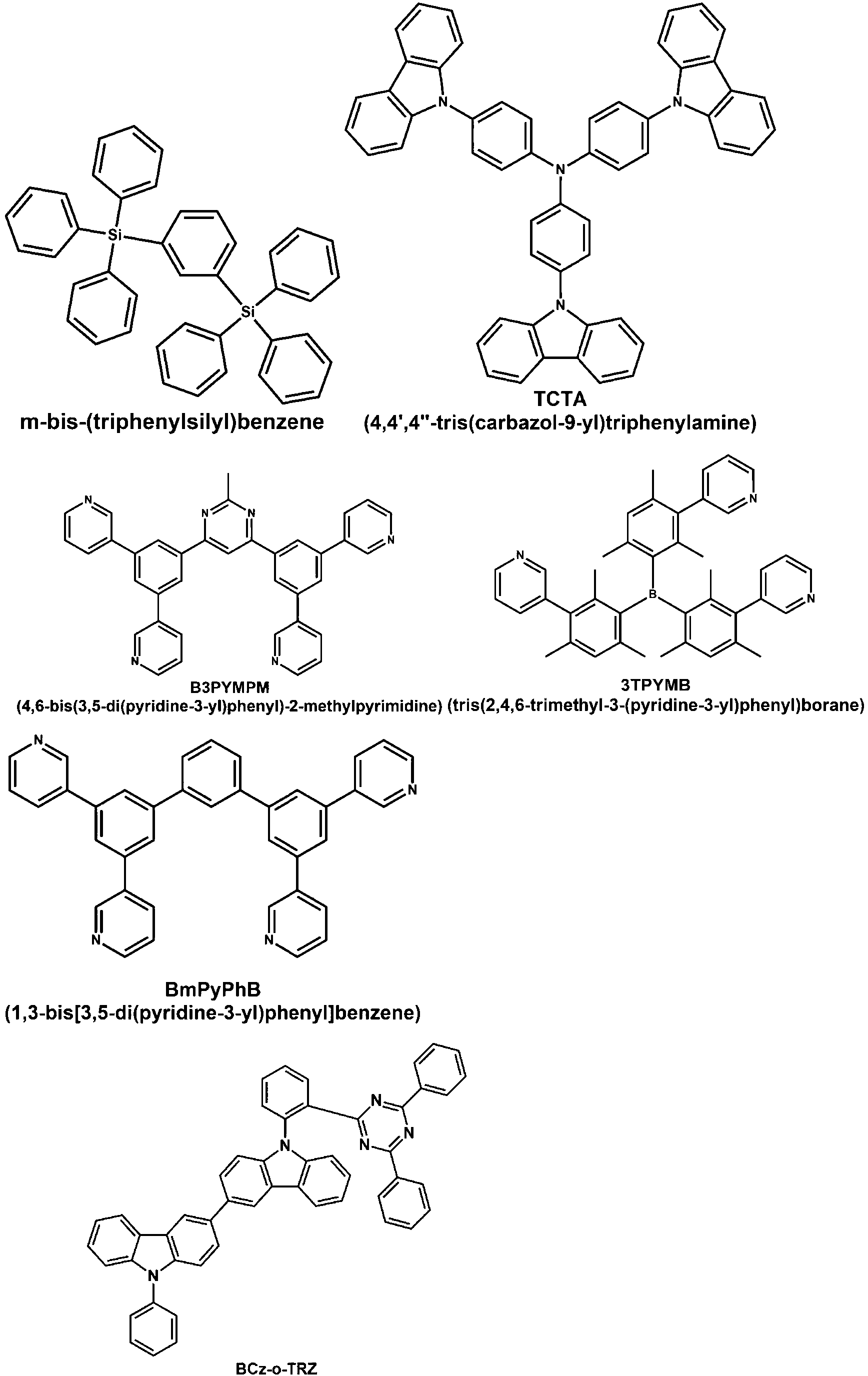

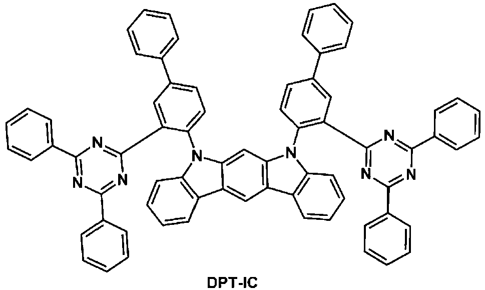

In one or more embodiments, the interlayer of the light-emitting device may further include a hole transport region arranged between the first electrode and the emission layer, and an electron transport region arranged between the emission layer and the second electrode.

The hole transport region may include a hole injection layer, a hole transport layer, an electron-blocking layer, a buffer layer, or a combination thereof, and the electron transport region may include a hole-blocking layer, an electron transport layer, an electron injection layer, or a combination thereof.

The term "interlayer" as used herein refers to a single layer and/or a plurality of layers arranged between the first electrode and the second electrode of the light-emitting device. The "interlayer" may include, in addition to an organic compound, an organometallic complex including a metal or the like.

In one or more embodiments, the interlayer of the light-emitting device may include:
light-emitting units in the number of m that include at least one emission layer; and
charge generation layers in the number of m-1 arranged between every two neighboring light-emitting units of the light-emitting units in the number of m. It will be understood that there may be one charge generation layer between every two neighboring light-emitting units. Since the number of the light-emitting units is m, the total number of the charge generation layer may be m-1. Here, m may be an integer of 2 or more.

That is, the light-emitting device may be a tandem light-emitting device.

For example, m may be 2, 3, 4, 5, 6, 7, 8, 9, or 10. In one or more embodiments, m may be 2, 3, 4, 5, or 6.

In one or more embodiments, one of the light-emitting units in the number of m may include the emission layer described herein.

In one or more embodiments, at least one of the light-emitting units in the number of m may emit a blue light.

According to another aspect, an electronic apparatus includes the light-emitting device. Therefore, an electronic apparatus including the light-emitting device is provided. The electronic apparatus may include, for example, a display, a lighting, a sensor, or the like.

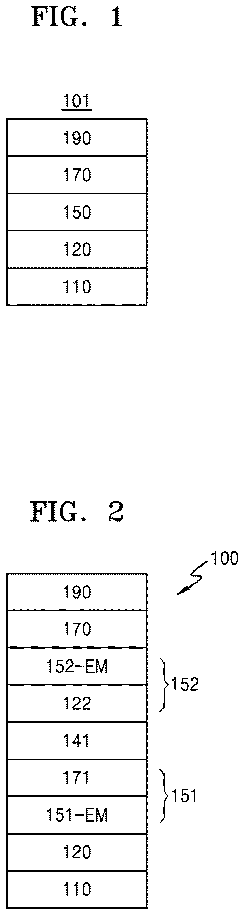

### Description of FIG. 1

FIG. 1 schematically illustrates a cross-sectional view of an organic light-emitting device 101, which is a light-emitting device according to one or more embodiments. Hereinafter, the structure and manufacturing method of the organic light-emitting device 10 according to one or more embodiments will be described in further detail with reference to FIG. 1.

The organic light-emitting device 101 of FIG. 1 includes a first electrode 110, a second electrode 190, and an interlayer (not shown) arranged between the first electrode 110 and the second electrode 190, wherein the interlayer includes a hole transport region 120, an emission layer 150, and an electron transport region 170.

A substrate may be additionally arranged under the first electrode 110 or above the second electrode 190. The substrate may be a substrate commonly used in organic light-emitting devices, e.g., a glass substrate or a transparent plastic substrate, which have excellent mechanical strength, thermal stability, transparency, surface smoothness, ease of handling, and/or water repellency.

The first electrode 110 may be formed by providing, on the substrate, a material for forming the first electrode 110, by using a deposition or sputtering method. The first electrode 110 may be an anode. The material for forming the first electrode 110 may include materials with a high work function to facilitate hole injection. The first electrode 110 may be a reflective electrode. The material for forming the first electrode 110 may be indium tin oxide (ITO), indium zinc oxide (IZO), tin oxide (SnO₂), or zinc oxide (ZnO). In one or more embodiments, the material for forming the first electrode 110 may be metal or an alloy, such as magnesium (Mg), aluminum (Al), silver (Ag), aluminum-lithium (Al-Li), calcium (Ca), magnesium-indium (Mg-In), or magnesium-silver (Mg-Ag).

The first electrode 110 may have a single-layered structure or a multi-layered structure including two or more layers. In one or more embodiments, the first electrode 110 may have a three-layer structure of ITO/Ag/ITO.

The hole transport region 120 may be arranged between the first electrode 110 and the emission layer 150.

The hole transport region 120 may include a hole injection layer, a hole transport layer, an electron-blocking layer, a buffer layer, or a combination thereof.

The hole transport region 120 may include only a hole injection layer or only a hole transport layer. In one or more embodiments, the hole transport region 120 may have a hole injection layer/hole transport layer structure or a hole injection layer/hole transport layer/electron-blocking layer structure, which are sequentially stacked in this stated order from the first electrode 110.

When the hole transport region 120 includes a hole injection layer, the hole injection layer may be formed on the first electrode 110 by using one or more suitable methods, for example, a vacuum deposition method, a spin coating method, a casting method, a Langmuir-Blodgett (LB) method, and/or an ink-jet printing method, but embodiments are not limited thereto.

When the hole injection layer is formed by a vacuum deposition method, deposition conditions may vary depending on a compound used as a material for forming the hole injection layer, a structure and thermal characteristics of the desired hole injection layer, or the like. For example, a deposition temperature may be about 100 °C to about 500 °C, a vacuum degree may be about 10⁻⁸ torr to about 10⁻³ torr, and a deposition rate may be about 0.01 angstroms per second (Å/sec) to about 100 Å/sec, but embodiments are not limited thereto.

When the hole injection layer is formed by a spin coating method, coating conditions may vary depending on a compound that is used as a material for forming the hole injection layer, a structure and thermal characteristics of the desired hole injection layer, and the like. For example, a coating rate may be about 2,000 revolutions per minute (rpm) to about 5,000 rpm, and a temperature at which heat treatment is performed to remove a solvent after coating may be about 80 °C to about 200 °C, but embodiments are not limited thereto.

In this regard, conditions for forming the hole transport layer and the electron-blocking layer may be understood by referring to the conditions for forming the hole injection layer.

The hole transport region 120 may include, for example, at least one of m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, or a compound represented by Formula 202, but embodiments are not limited thereto:

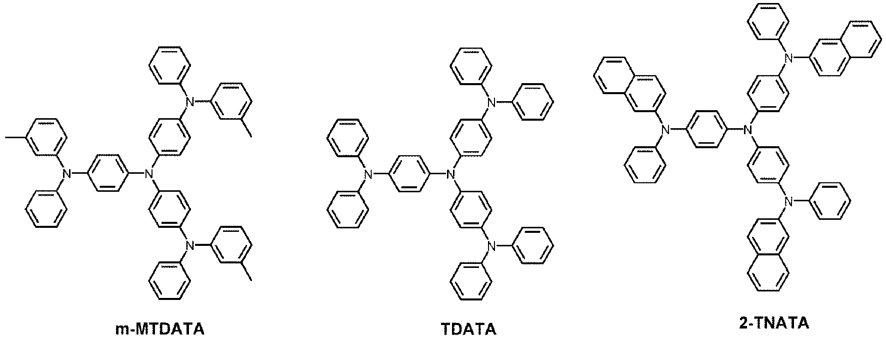

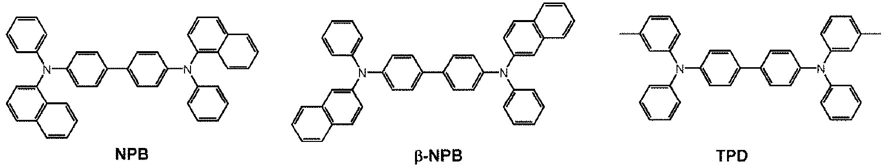

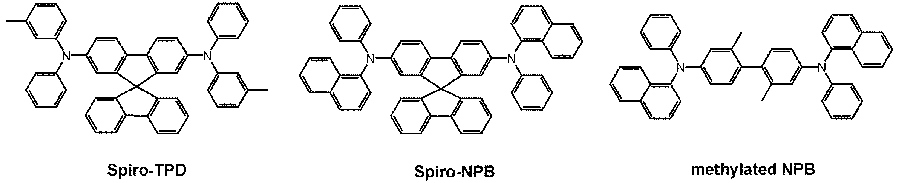

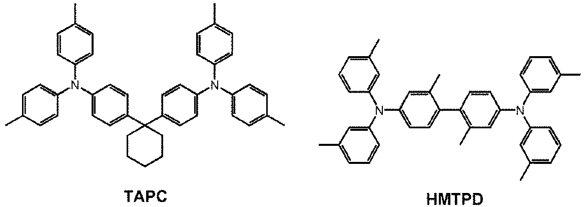

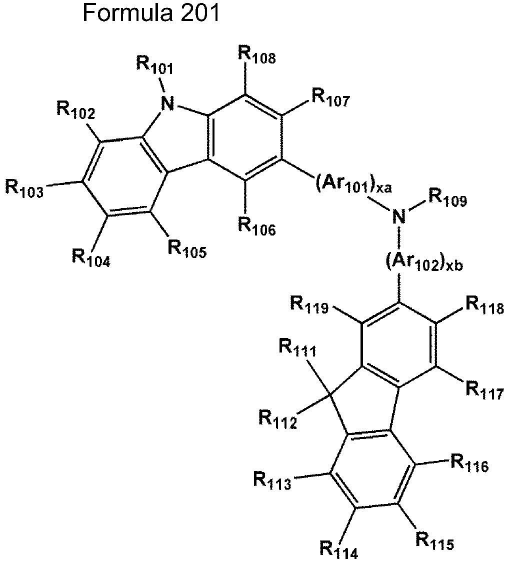

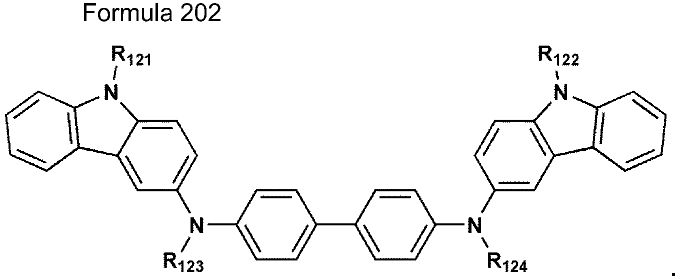

In Formula 201, Ar₁₀₁ and Ar₁₀₂ may each independently be a phenylene group, a pentalenylene group, an indenylene group, a naphthylene group, an azulenylene group, a heptalenylene group, an acenaphthenylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

In Formula 201, xa and xb may each independently be an integer from 0 to 5, or may each independently be 0, 1, or 2. For example, xa may be 1 and xb may be 0.

In Formulae 201 and 202, R₁₀₁ to R₁₀₈, R₁₁₁ to R₁₁₉, and R₁₂₁ to R₁₂₄ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (e.g., a methyl group, an ethyl group, a propyl group, a butyl group, a pentyl group, a hexyl group, or the like), a C₁-C₁₀ alkoxy group (e.g., a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each unsubstituted or substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with deuterium, - F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

In Formula 201, R₁₀₉ may be a phenyl group, a naphthyl group, an anthracenyl group, or a pyridinyl group, each unsubstituted or substituted with deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A:

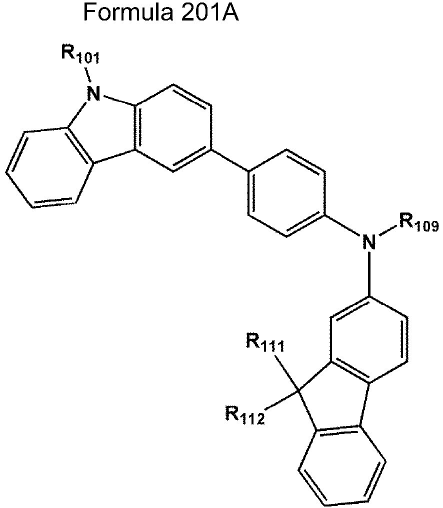

In Formula 201A, R₁₀₁, R₁₁₁, R₁₁₂, and R₁₀₉ may each be the same as described herein.

For example, the hole transport region 120 may include one of Compounds HT1 to HT20, or a combination thereof:

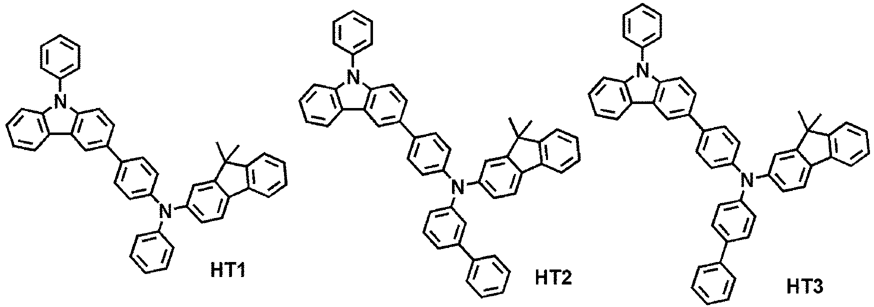

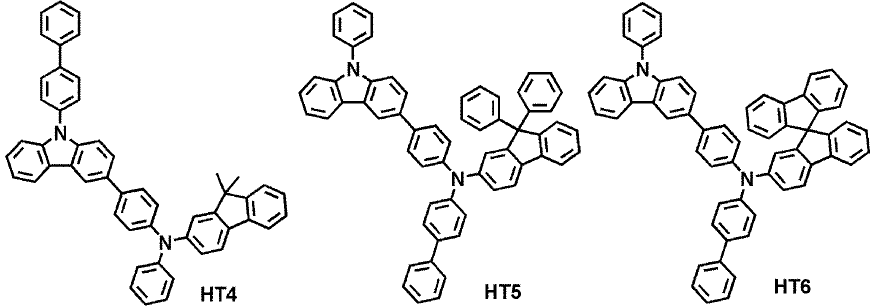

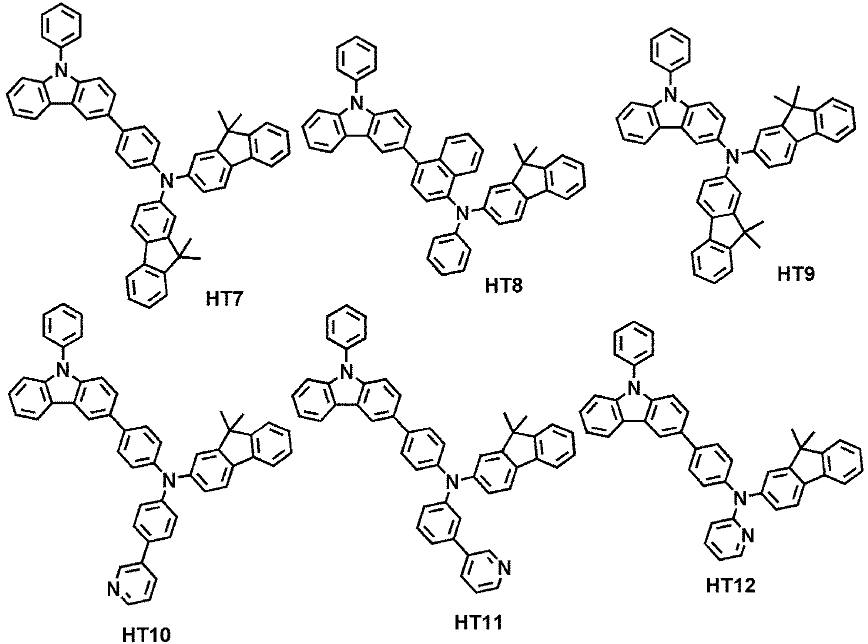

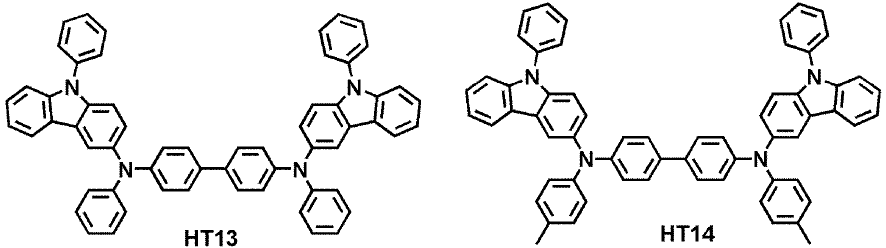

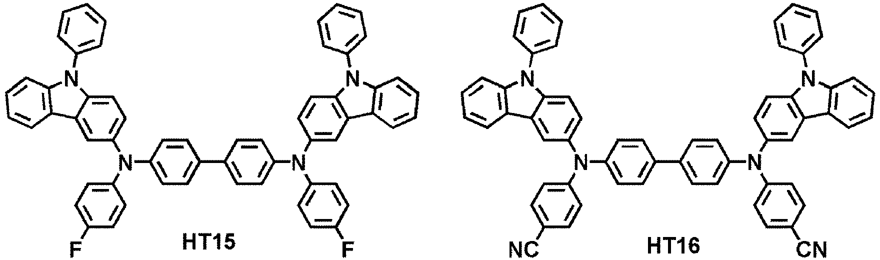

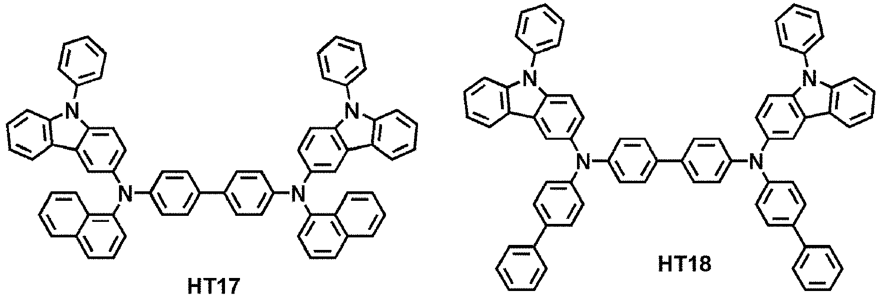

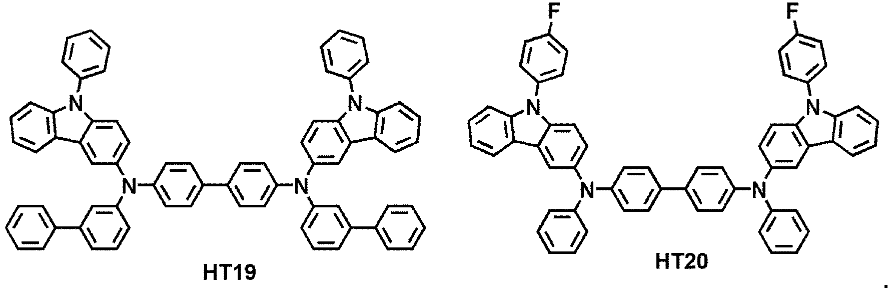

A thickness of the hole transport region 120 may be about 50 Å to about 10,000 Å, for example, about 100 Å to about 1,000 Å. When the hole transport region 120 includes a hole injection layer, a hole-transporting layer, an electron-blocking layer, or a combination thereof, the thickness of the hole injection layer may be about 100 Å to about 10,000 Å, for example, about 100 Å to about 1,000 Å, and a thickness of the hole-transporting layer may be about 50 Å to about 2,000 Å, for example, about 100 Å to about 1,500 Å. When the thicknesses of the hole transport region 120, the hole injection layer, and the hole transport layer are within these ranges, satisfactory hole transporting characteristics may be obtained without a substantial increase in driving voltage.

In addition to the above-described materials, the hole transport region 120 may further include a charge-generation material to improve conductivity. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or a combination thereof. For example, the p-dopant may include a quinone derivative, such as tetracyanoquinonedimethane (TCNQ), 2,3,5,6-tetrafluoro-tetracyano-1,4-benzoquinonedimethane (F4-TCNQ), F6-TCNNQ, or the like; a metal oxide, such as a tungsten oxide, a molybdenum oxide, or the like; a cyano group-containing compound, such as Compound HT-D1, HT-D2, or the like; or a combination thereof:

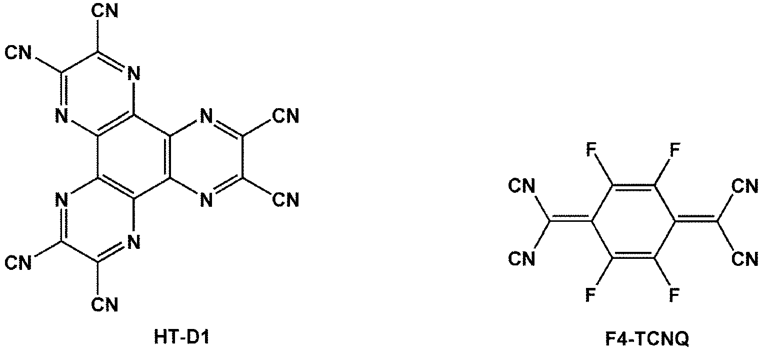

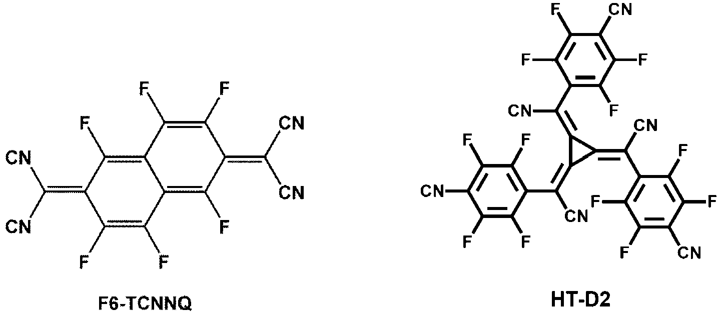

The hole transport region 120 may further include a buffer layer.

The buffer layer may compensate for an optical resonance distance according to a wavelength of light emitted from the emission layer 150, and thus, efficiency of a formed organic light-emitting device may be improved.

Meanwhile, when the hole transport region 120 includes an electron-blocking layer, the material for the electron-blocking layer may include a material that may be used in the hole transport region 120 as described above, a host material, or a combination thereof. For example, when the hole transport region 120 includes an electron-blocking layer, mCP, Compound HTH1, or the like may be used as a material for forming the electron-blocking layer.

The emission layer 150 may be formed on the hole transport region 120 by using, for example, a vacuum deposition method, a spin coating method, a cast method, an LB method, and/or an ink-jet printing method, but embodiments are not limited thereto. When the emission layer 150 is formed by vacuum deposition or spin coating, the deposition or coating conditions may be similar to those applied in forming the hole injection layer although the deposition or coating conditions may vary depending on a material that is used to form the hole-transporting layer.

The emission layer 150 may be the same as described herein.

A thickness of the emission layer 150 may be about 100 Å to about 1,000 Å, for example, about 200 Å to about 600 Å. When the thickness of the emission layer 150 is within these ranges, excellent light-emission characteristics may be obtained without a substantial increase in driving voltage.

When the light-emitting device 101 is a full-color light-emitting device, the emission layer 150 may be patterned into a red emission layer, a green emission layer, and/or a blue emission layer.

Next, the electron transport region 170 may be arranged on the emission layer 150.

The electron transport region 170 may include a hole-blocking layer, an electron transport layer, an electron injection layer, or a combination thereof.

For example, the electron transport region 170 may have a hole-blocking layer/electron transport layer/electron injection layer structure, a hole-blocking layer/electron transport layer structure, or an electron transport layer/electron injection layer structure. The electron transport layer may have a single-layered structure or a multi-layered structure including two or more different materials.

The conditions for the forming the hole-blocking layer, the electron transport layer, and the electron injection layer in the electron transport region 170 may be the same as the conditions for the forming the hole injection layer.

When the electron transport region 170 includes a hole-blocking layer, the hole-blocking layer may include, for example, BCP, Bphen, BAIq, or a combination thereof, but embodiments are not limited thereto:

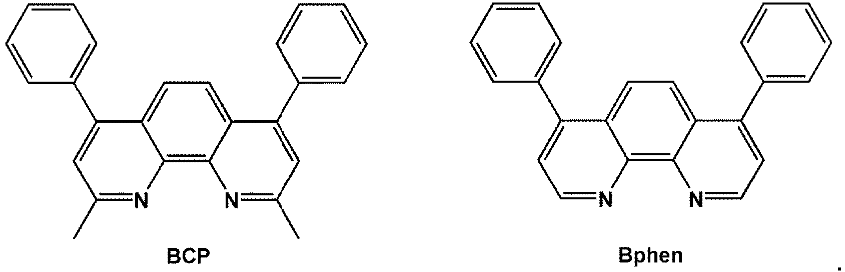

In one or more embodiments, the hole-blocking layer may include any host material, and a material for an electron-transporting layer, a material for an electron injection layer, or a combination thereof, which will be described herein.

A thickness of the hole-blocking layer may be about 20 Å to about 1,000 Å, for example, about 30 Å to about 600 Å. When the thickness of the hole-blocking layer is within these ranges, excellent hole blocking characteristics may be obtained without a substantial increase in driving voltage.

The electron transport layer may include BCP, Bphen, TPBi, Alq₃, BAIq, TAZ, NTAZ, or a combination thereof, but embodiments are not limited thereto:

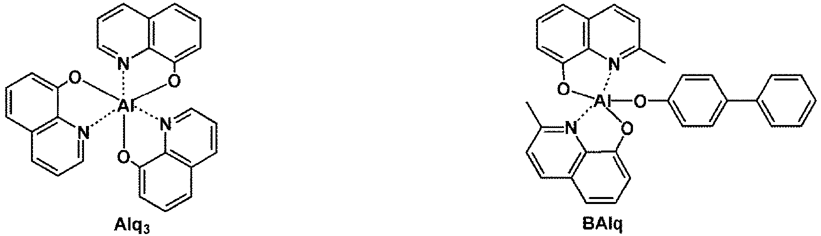

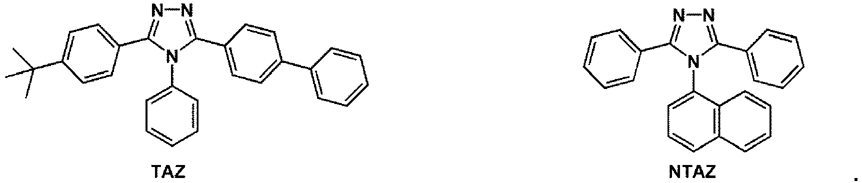

In one or more embodiments, the electron transport layer may include one of Compounds ET1 to ET25, or a combination thereof:

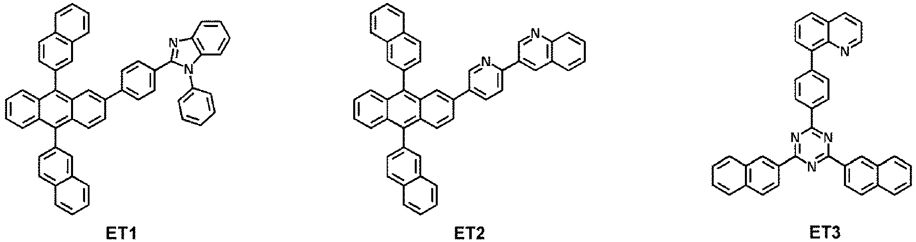

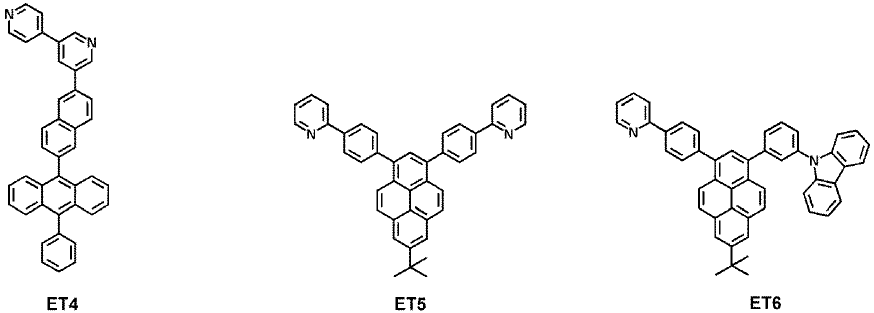

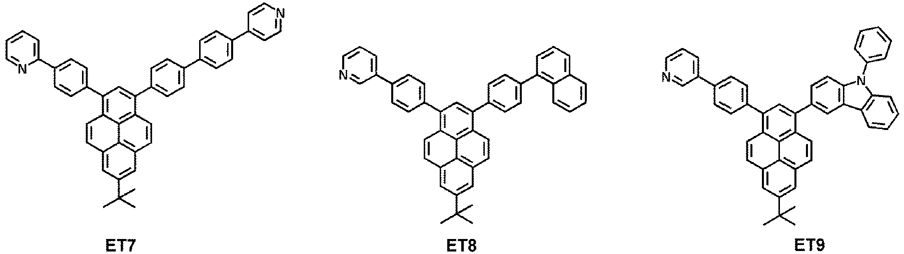

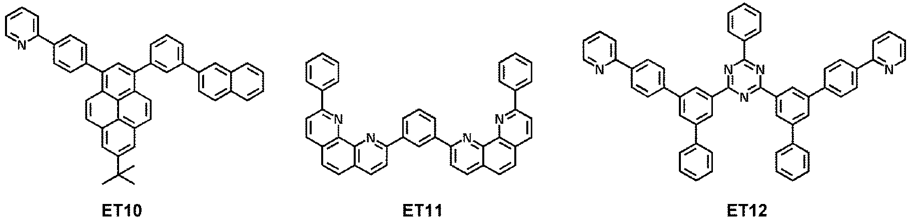

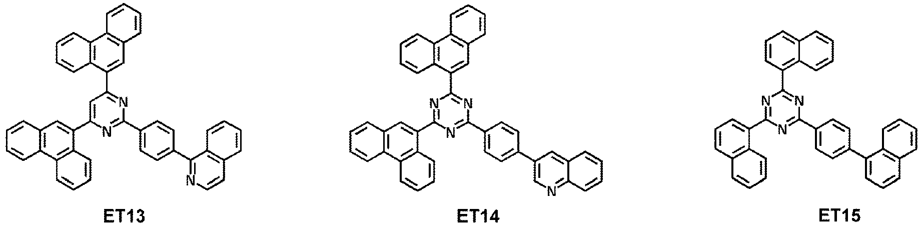

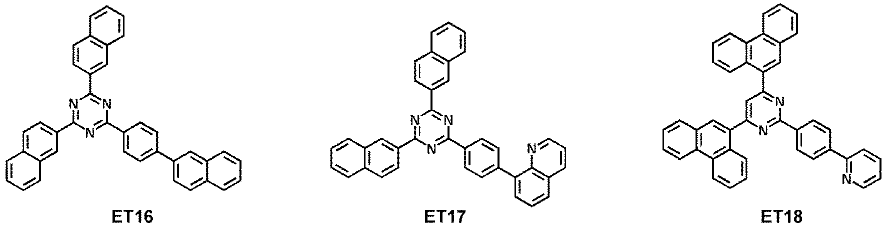

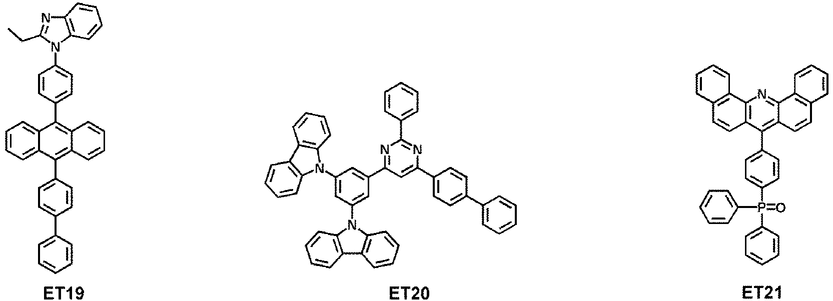

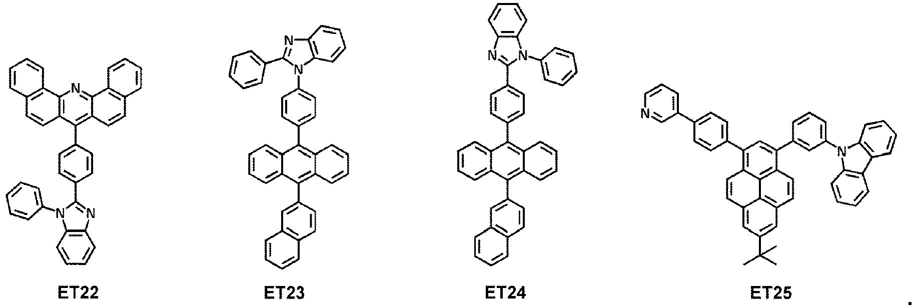

The thickness of the electron transport layer may be about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may further include a metal-containing material, in addition to the material as described herein.

The metal-containing material may include a Li complex. The Li complex may include, for example, Compound ET-D1 or ET-D2, but embodiments are not limited thereto:

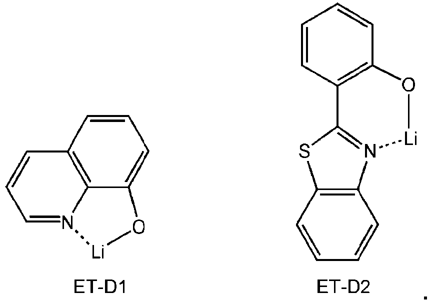

In one or more embodiments, the electron transport region 170 may include an electron injection layer that facilitates injection of electrons from the second electrode 190.

The electron injection layer may include LiF, NaCl, CsF, Li₂O, BaO, Yb, Compound ET-D1, Compound ET-D2, or a combination thereof.

A thickness of the electron injection layer may be about 1 Å to about 100 Å, for example, about 3 Å to about 90 Å. When the thickness of the electron injection layer is within the range as described above, satisfactory electron injection characteristics may be obtained without a substantial increase in driving voltage.

The second electrode 190 may be arranged on the electron transport region 170. The second electrode 190 may be a cathode. A material for forming the second electrode 190 may be metal, an alloy, an electrically conductive compound, or a combination thereof, which have a relatively low work function. For example, the material for forming the second electrode 190 may include lithium (Li), magnesium (Mg), aluminum (Al), silver (Ag), aluminum-lithium (Al-Li), calcium (Ca), magnesium-indium (Mg-In), magnesium-silver (Mg-Ag), or the like. In one or more embodiments, to manufacture a top-emission type light-emitting device, a transparent or semitransparent electrode formed using ITO or IZO may be used as the second electrode 190.

### Description of FIG. 2

FIG. 2 is a schematic view of an organic light-emitting device 100 according to one or more embodiments.

The organic light-emitting device 100 of FIG. 2 may include a first electrode 110, a second electrode 190 facing the first electrode 110, and a first light-emitting unit 151 and a second light-emitting unit 152 which are stacked between the first electrode 110 and the second electrode 190. A charge generation layer 141 is arranged between the first light-emitting unit 151 and the second light-emitting unit 152. The charge generation layer 141 may include an n-type charge generation layer, a p-type charge generation layer, or a combination thereof. The charge generation layer 141 is a layer that generates charge and supplies the charge to neighboring light-emitting units, and any known material may be used therefor.

The first light-emitting unit 151 may include a first emission layer 151-EM, and the second light-emitting unit 152 may include a second emission layer 152-EM.

In one or more embodiments, the first emission layer 151-EM may include the emission layer as described herein.

In one or more embodiments, the second emission layer 152-EM may include the emission layer as described herein.

A hole transport region 120 may be arranged between the first light-emitting unit 151 and the first electrode 110, and the second light-emitting unit 152 may include a second hole transport region 122 arranged on the side of the first electrode 110.

An electron transport region 170 may be arranged between the second light-emitting unit 152 and the second electrode 190, and the first light-emitting unit 151 may include a first electron transport region 171 arranged between the charge generation layer 141 and the first emission layer 151-EM.

The first electrode 110 and the second electrode 190 shown in FIG. 2 may be the same as described in connection with the first electrode 110 and the second electrode 190 shown in FIG. 1, respectively.

The hole transport region 120 and the second hole transport region 122 shown in FIG. 2 may each be the same as described in connection with the hole transport region 120 shown in FIG. 1.

The electron transport region 170 and the first electron transport region 171 shown in FIG. 2 may be each the same as described in connection with the electron transport region 170 shown in FIG. 1.

Hereinbefore, an example of a tandem light-emitting device has been described with reference to FIG. 2. However, the tandem light-emitting device may have various other forms. For example, the tandem light-emitting device may include three or more light-emitting units.

### Explanation of terms

As used herein, the term "C₁-C₆₀ alkyl group" refers to a linear or branched saturated aliphatic hydrocarbon monovalent group having 1 to 60 carbon atoms, and the term "C₁-C₆₀ alkylene group" refers to a divalent group having the same structure as the C₁-C₆₀ alkyl group.

As used herein, non-limiting examples of the C₁-C₆₀ alkyl group, the C₁-C₂₀ alkyl group, and/or the C₁-C₁₀ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof.

As used herein, the term "C₁-C₆₀ alkoxy group" refers to a monovalent group represented by -OA₁₀₁ (wherein A₁₀₁ is the C₁-C₆₀ alkyl group), and non-limiting examples thereof may include a methoxy group, an ethoxy group, a propoxy group, a butoxy group, a pentoxy group, or the like.

As used herein, the term "C₁-C₆₀ alkylthio group" refers to a monovalent group represented by -SA₁₀₁ (wherein A₁₀₁ is the C₁-C₆₀ alkyl group).

As used herein, the term "C₂-C₆₀ alkenyl group" refers to a hydrocarbon group formed by substituting at least one carbon-carbon double bond in the middle or at the terminus of the C₂-C₆₀ alkyl group, and non-limiting examples thereof may include an ethenyl group, a propenyl group, a butenyl group, or the like. As used herein, the term "C₂-C₆₀ alkenylene group" refers to a divalent group having the same structure as the C₂-C₆₀ alkenyl group.

As used herein, the term "C₂-C₆₀ alkynyl group" refers to a hydrocarbon group formed by substituting at least one carbon-carbon triple bond in the middle or at the terminus of the C₂-C₆₀ alkyl group, and non-limiting examples thereof may include an ethynyl group, a propynyl group, or the like. As used herein, the term "C₂-C₆₀ alkynylene group" refers to a divalent group having the same structure as the C₂-C₆₀ alkynyl group.

As used herein, the term "C₃-C₁₀ cycloalkyl group" refers to a monovalent saturated hydrocarbon cyclic group having 3 to 10 carbon atoms as ring-forming atoms, and the term "C₃-C₁₀ cycloalkylene group" refers to a divalent group having the same structure as the C₃-C₁₀ cycloalkyl group.

As used herein, non-limiting examples of the C₃-C₁₀ cycloalkyl group may include a cyclopropyl group, a cyclobutyl group, a cyclopentyl group, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, a bicyclo[2.2.2]octyl group, or the like.

As used herein, the term "C₁-C₁₀ heterocycloalkyl group" refers to a saturated monovalent cyclic group that includes at least one heteroatom selected from N, O, P, Si, S, Se, Ge, and B as a ring-forming atom and 1 to 10 carbon atoms as ring-forming atom(s), and the term "C₁-C₁₀ heterocycloalkylene group" refers to a divalent group having the same structure as the C₁-C₁₀ heterocycloalkyl group.

As used herein, non-limiting examples of the C₁-C₁₀ heterocycloalkyl group may include a silolanyl group, a silinanyl group, tetrahydrofuranyl group, a tetrahydro-2H-pyranyl group, a tetrahydrothiophenyl group, or the like.

As used herein, the term "C₃-C₁₀ cycloalkenyl group" refers to a monovalent hydrocarbon ring group that has 3 to 10 carbon atoms, and at least one carbon-carbon double bond in the ring thereof, and no aromaticity, and non-limiting examples thereof may include a cyclopentenyl group, a cyclohexenyl group, a cycloheptenyl group, or the like. As used herein, the term "C₃-C₁₀ cycloalkenylene group" refers to a divalent group having the same structure as the C₃-C₁₀ cycloalkenyl group.

As used herein, the term "C₁-C₁₀ heterocycloalkenyl group" refers to a monovalent group that has at least one heteroatom selected from N, O, P, Si, S, Se, Ge, and B as a ring-forming atom, 1 to 10 carbon atoms as ring-forming atom(s), and at least one carbon-carbon double bond in the ring thereof. Non-limiting examples of the C₁-C₁₀ heterocycloalkenyl group may include a 2,3-dihydrofuranyl group, a 2,3-dihydrothiophenyl group, or the like. As used herein, the term "C₁-C₁₀ heterocycloalkenylene group" refers to a divalent group having the same structure as the C₁-C₁₀ heterocycloalkenyl group.

As used herein, the term "C₆-C₆₀ aryl group" refers to a monovalent group having a carbocyclic aromatic system having 6 to 60 carbon atoms as ring-forming atoms, and the term "C₆-C₆₀ arylene group" refers to a divalent group having a carbocyclic aromatic system having 6 to 60 carbon atoms as ring-forming atoms. Non-limiting examples of the C₆-C₆₀ aryl group may include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused with each other.

As used herein, the term "C₇-C₆₀ alkyl aryl group" refers to a C₆-C₆₀ aryl group substituted with at least one C₁-C₆₀ alkyl group. As used herein, the term "C₇-C₆₀ aryl alkyl group" refers to a C₁-C₆₀ alkyl group substituted with at least one C₆-C₆₀ aryl group.

As used herein, the term "C₁-C₆₀ heteroaryl group" refers to a monovalent group that includes a heterocyclic aromatic system having at least one heteroatom selected from N, O, P, Si, S, Se, Ge, and B as a ring-forming atom and 1 to 60 carbon atoms as ring-forming atom(s), and the term "C₁-C₆₀ heteroarylene group" refers to a divalent group that includes a heterocyclic aromatic system having at least one heteroatom selected from N, O, P, Si, S, Se, Ge, and B as a ring-forming atom 1 to 60 carbon atoms as ring-forming atom(s). Non-limiting examples of the C₁-C₆₀ heteroaryl group may include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused with each other.

As used herein, the term "C₂-C₆₀ alkyl heteroaryl group" refers to a C₁-C₆₀ heteroaryl group substituted with at least one C₁-C₆₀ alkyl group. As used herein, the term "C₂-C₆₀ heteroaryl alkyl group" refers to a C₁-C₆₀ alkyl group substituted with at least one C₁-C₆₀ heteroaryl group.

As used herein, the term "C₆-C₆₀ aryloxy group" indicates -OA₁₀₂ (wherein A₁₀₂ indicates the C₆-C₆₀ aryl group), and the term "C₆-C₆₀ arylthio group" indicates -SA₁₀₃ (wherein A₁₀₃ indicates the C₆-C₆₀ aryl group).

As used herein, the term "C₁-C₆₀ heteroaryloxy group" indicates -OA_{102'} (wherein A_{102'} indicates the C₁-C₆₀ heteroaryl group), and the term "C₁-C₆₀ heteroarylthio group" indicates -SA_{103'} (wherein A_{103'} indicates the C₁-C₆₀ heteroaryl group).

As used herein, the term "monovalent non-aromatic condensed polycyclic group" refers to a monovalent group (e.g., a group having 8 to 60 carbon atoms) having two or more rings condensed with each other, only carbon atoms as ring-forming atoms, and no aromaticity in its entire molecular structure. Non-limiting examples of the monovalent non-aromatic condensed polycyclic group may include a fluorenyl group or the like. As used herein, the term "divalent non-aromatic condensed polycyclic group" refers to a divalent group having the same structure as the monovalent non-aromatic condensed polycyclic group.

As used herein, the term "monovalent non-aromatic condensed heteropolycyclic group" refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Non-limiting examples of the monovalent non-aromatic condensed heteropolycyclic group may include a carbazolyl group or the like. As used herein, the term "divalent non-aromatic condensed heteropolycyclic group" refers to a divalent group having the same structure as the monovalent non-aromatic condensed heteropolycyclic group.

As used herein, the term "C₅-C₃₀ carbocyclic group" refers to a saturated or unsaturated cyclic group having, as a ring-forming atom, 5 to 30 carbon atoms only. The C₅-C₃₀ carbocyclic group may be a monocyclic group or a polycyclic group. As used herein, non-limiting examples of the "C₅-C₃₀ carbocyclic group (unsubstituted or substituted with at least one R₁₀ₐ)" may include an adamantane group, a norbornene group, a bicyclo[1.1.1]pentane group, a bicyclo[2.1.1]hexane group, a bicyclo[2.2.1]heptane group (or a norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one R₁₀ₐ).

As used herein, the term "C₁-C₃₀ heterocyclic group" refers to a saturated or unsaturated cyclic group having, as a ring-forming atom, at least one heteroatom selected from N, O, P, Si, S, Se, Ge, and B other than 1 to 30 carbon atoms. The C₁-C₃₀ heterocyclic group may be a monocyclic group or a polycyclic group. The "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

As used herein, non-limiting examples of the "C₆-C₃₆ carbocyclic group" and "C₁-C₃₀ heterocyclic group" may include i) a first ring, ii) a second ring, iii) a condensed ring group in which two or more first rings are condensed with each other, iv) a condensed ring group in which two or more second rings are condensed with each other, or v) a condensed ring group in which at least one first ring is condensed with at least one second ring,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

As used herein, the terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" refer to a C₁-C₆₀ alkyl group (or a C₁-C₂₀ alkyl group or the like), a C₃-C₁₀ cycloalkyl group, a C₁-C₁₀ heterocycloalkyl group, and a phenyl group, respectively, each substituted with at least one fluoro group (-F). For example, the term "fluorinated C₁ alkyl group (i.e., a fluorinated methyl group)" includes -CF₃, -CF₂H, and -CFH₂. The terms "fluorinated C₁-C₆₀ alkyl group (or a fluorinated C₁-C₂₀ alkyl group, or the like)", "the fluorinated C₃-C₁₀ cycloalkyl group", "the fluorinated C₁-C₁₀ heterocycloalkyl group", or "the fluorinated a phenyl group" may be i) a fully fluorinated C₁-C₆₀ alkyl group (or a fully fluorinated C₁-C₂₀ alkyl group or the like), a fully fluorinated C₃-C₁₀ cycloalkyl group, a fully fluorinated C₁-C₁₀ heterocycloalkyl group, or a fully fluorinated phenyl group, wherein all hydrogen atoms included in each group are substituted with a fluoro group, or ii) a partially fluorinated C₁-C₆₀ alkyl group (or a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein all hydrogen atoms included in each group are not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" each refer to a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the term "deuterated C₁ alkyl group (e.g., the deuterated methyl group)" may include -CD₃, - CD₂H, and -CDH₂. The terms "deuterated C₁-C₆₀ alkyl group (or the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which all hydrogen atoms included in each group are substituted with deuterium, or ii) a partially deuterated C₁-C₆₀ alkyl group (or a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which all hydrogen atoms included in each group are not substituted with deuterium.

As used herein, the term "(C₁-C₂₀ alkyl) 'X' group" refers to a 'X' group that is substituted with at least one C₁-C₂₀ alkyl group. For example, as used herein, the term "(C₁-C₂₀ alkyl)C₃-C₁₀ cycloalkyl group" refers to a C₃-C₁₀ cycloalkyl group substituted with at least one C₁-C₂₀ alkyl group, and the term "(C₁-C₂₀ alkyl)phenyl group" refers to a phenyl group substituted with at least one C₁-C₂₀ alkyl group. An example of a (C₁ alkyl) phenyl group may include a tolyl group.

As used herein, the terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refer to a heterocyclic group having the same backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," wherein at least one ring-forming carbon is substituted with nitrogen.

Substituents of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), - P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₆ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), - P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof.

As used herein, Q₁ to Q₉, Q₁₁ to Q₁₉, Q₂₁ to Q₂₉, and Q₃₁ to Q₃₉ may each independently be a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₆ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, a C₁-C₆₀ alkyl group, a C₆-C₆₀ aryl group, or a combination thereof.

For example, Q₁ to Q₉, Q₁₁ to Q₁₉, Q₂₁ to Q₂₉, and Q₃₁ to Q₃₉ as described herein may each independently be:
- CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, an neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or a combination thereof.

Hereinafter, a light-emitting device according to exemplary embodiments will be described in further detail with reference to Examples. However, the disclosure is not limited to the following examples.

### EXAMPLES

### Evaluation Example 1

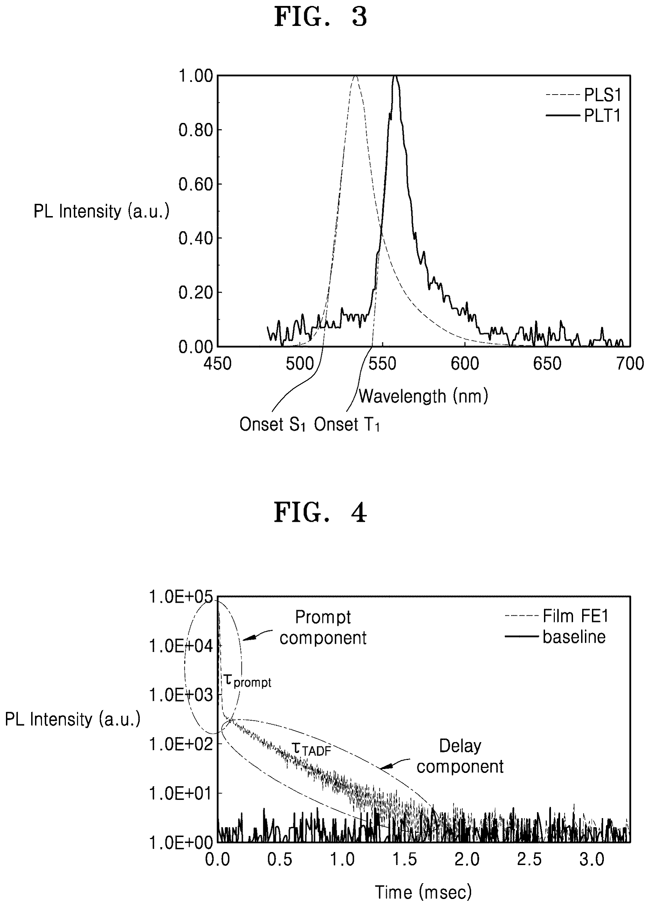

Regarding each compound shown in Table 2, methods described in Table 1 were used to evaluate a peak wavelength (PLₘₐₓ) of a peak having maximum emission intensity in a photoluminescence (PL) spectrum in solution and full width at half maximum (FWHM) of a peak having maximum emission intensity, a lowest excited singlet (S₁) energy level, and/or a lowest excited triplet (T₁) energy level, and the results are shown in Table 2. Regarding Compound FE1, a PL spectrum in solution (see "PLS1") and a PL spectrum (see "PLT1") for T₁ energy level evaluation may each be referred to FIG. 3.

**Table 1**

| | |
|---|---|
| Evaluation method of PLₘₐₓ and FWHM | Each compound was diluted in toluene at a concentration of 1x10⁻⁵ M, and a PL spectrum for each compound was measured at room temperature by using a fluorescence spectrophotometer F-7000 equipped with a xenon lamp, and then, PLₘₐₓ and FWHM were evaluated from the PL spectrum. |
| Evaluation method of S₁ energy level for fluorescent emitter, first host, and second host | Onset S₁ energy level of the PL spectrum was evaluated as shown in FIG. 3, and is converted into a unit of eV according to the following equation: |
| | S₁ (eV) = 1240 / onset S₁ (nm) |
| Evaluation method of T₁ energy level for fluorescent emitter, first host, and second host | For each compound, excitation was made in a 77 K liquid N₂ atmosphere, delay time was adjusted from excitation light irradiation to initiation of measurement at a chopping speed of 40 Hz, a PL spectrum was measured after 1 ms, and an onset T₁ energy level of the PL spectrum was evaluated as shown in FIG. 3 and then converted into a unit of eV according to the following equation: |
| | T₁ (eV) = 1240 / onset T₁ (nm) |
| Evaluation method for T₁ energy level in sensitizer | Each compound was diluted in toluene at a concentration of 1x10⁻⁵ M, and a PL spectrum for each compound was measured at room temperature by using a fluorescence spectrophotometer F-7000 equipped with a xenon lamp, and an onset T₁ energy level was evaluated from the PL spectrum and then converted into a unit of eV according to the following equation: |
| | T₁ (eV) = 1240 / onset T₁ (nm) |

**Table 2**

| | Compound No. | PLₘₐₓ (nm) | FWHM (nm) | S₁ (eV) | T₁ (eV) |
|---|---|---|---|---|---|
| Fluorescent emitter | FE1 | 533 | 24 | 2.40 | 2.28 |
| | FE2 | 535 | 23 | 2.40 | 2.27 |
| | FE3 | 526 | 22 | 2.43 | 2.29 |
| | FE4 | 522 | 26 | 2.46 | 2.27 |
| | FE5 | 517 | 16 | 2.46 | 2.33 |
| | FE6 | 522 | 21 | 2.46 | 2.25 |
| | FE7 | 527 | 22 | 2.41 | 2.20 |
| | FE8 | 527 | 24 | 2.44 | 2.24 |
| | FE9 | 527 | 24 | 2.44 | 2.14 |
| | FE10 | 539 | 24 | 2.38 | 2.27 |
| | FE11 | - | - | 2.45 | 2.21 |
| Sensitizer | SE1 (Compound 99 of [Group 2-4]) | 525 | 25 | - | 2.44 |
| | SE2 | 515 | 45 | - | 2.53 |
| | SE3 (Compound 24 of [Group 1-2]) | 523 | 47 | - | 2.49 |
| First host | HTH3 | 404 | 43 | 3.36 | 2.85 |
| Second host | ETH8 | 524 | 97 | 2.82 | 2.77 |

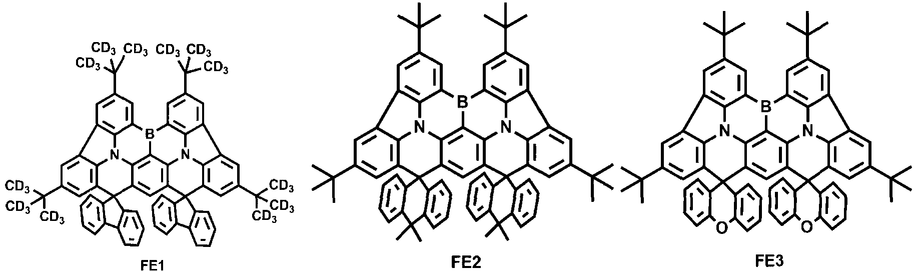

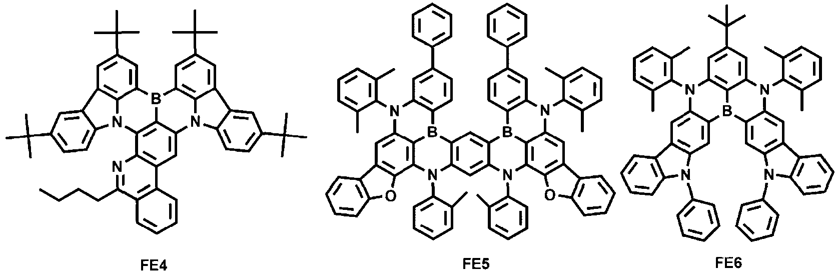

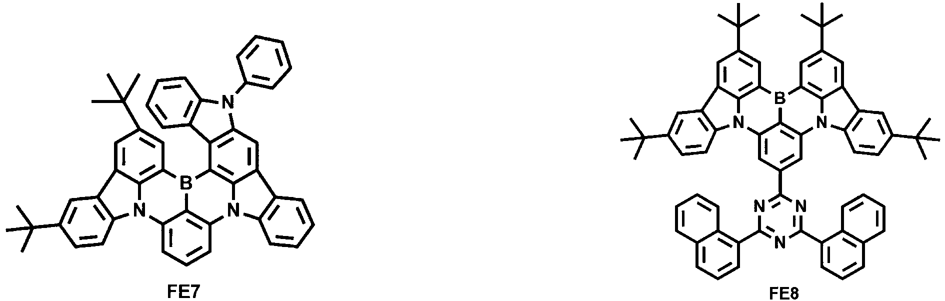

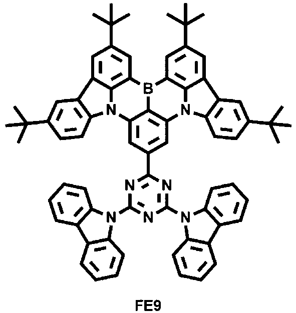

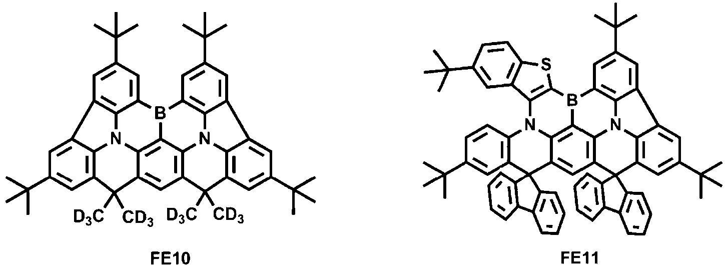

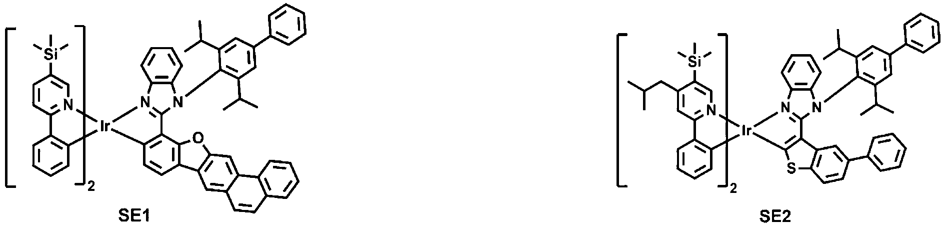

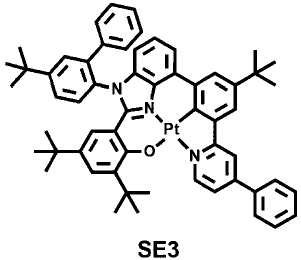

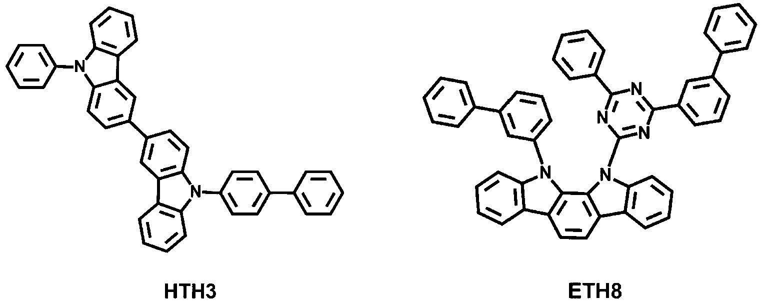

### Evaluation Example 2

Compound HTH3 and Compound FE1 were vacuum-deposited at a weight ratio of 99:1 on a quartz substrate at a vacuum degree of 10⁻⁷ torr to form Film FE1 having a thickness of 40 nm. Using the same method, except that Compound FE2 to Compound FE11 were each used instead of instead of Compound FE1, Films FE2 to FE11 were formed.

Regarding Films FE1 to FE11, by using a TRPL measuring system FluoTime 300 manufactured by PicoQuant Company and a pumping source Xenon flash lamp (excitation wavelength = 340 nanometers) manufactured by PicoQuant Company, the PL spectrum was evaluated at room temperature, and the wavelength of the main peak of the PL spectrum was determined. The number of photons, which were emitted at the wavelength of the main peak from each film by a photon pulse (pulse time width = 400 nanoseconds) applied to each film by the Xenon flash lamp, was repeatedly measured over time based on a multichannel scaler (MCS), so as to obtain a TRPL curve that is sufficiently good for fitting. From the results thus obtained, two or more exponential decay functions were fit to obtain T_{decay}(Ex) of a delayed fluorescence in a TRPL curve of each of Films FE1 to FE11, i.e., DT^{FE}(µs) which is a decay time of a delayed fluorescence component in a TRPL spectrum, and the results are summarized in Table 3. A function used for the fitting is as shown in Equation 100, and a greatest T_{decay} value from among the T_{decay} values obtained from each exponential decay function used for the fitting was obtained as T_{decay} (Ex). Here, the same measurement was repeated one more time during the same measurement time for obtaining the TRPL curve in a dark state (i.e., a state in which pumping signals incident on the predetermined film are blocked), so that a baseline or a background signal curve was obtained and used as a baseline for the fitting. $f \left(t\right) = {\sum }_{i = 1}^{n} {A}_{i} exp \left(-t/{T}_{decay , i}\right)$

Next, coefficient A of the T_{decay} (Ex) was obtained as A_{DF} and used for calculation of Equation 101 to evaluate a proportion of a delayed fluorescence component (DF^{FE}, %) of the total luminescence component of Films FE1 to FE11, and the results are summarized in Table 3. $DF = {A}_{DF} {T}_{decay} \left(EX\right) / {\sum }_{i = 1}^{n} {A}_{i} {T}_{decay , i}$

Next, Compound HTH3, Compound SE1, and Compound FE1 were vacuum-deposited at a weight ratio shown in Table 3 on a quartz substrate at a vacuum degree of 10⁻⁷ torr to form Film SE1_FE1 having a thickness of 40 nm. Using the same method, except that compounds shown in Table 3 were each used instead of Compound SE1 and/or Compound FE1 and co-deposited at a weight ratio shown in Table 3, Films SE2_FE1, SE3_FE1, SE1_FE2, SE1_FE3, SE1_FE4, SE1_FE5, SE1_FE6, SE1_FE7, SE1_FE8, SE1_FE9, SE1_FE10, and SE1_FE11 were formed and for each of Film SE1_FE1, SE2_FE1, SE3_FE1, SE1_FE2, SE1_FE3, SE1_FE4, SE1_FE5, SE1_FE6, SE1_FE7, SE1_FE8, SE1_FE9, SE1_FE10, and SE1_FE11, a proportion of delayed fluorescence components (DF^{SE+FE}, %) to the total luminescence component was evaluated using the same method as described above, and the results are shown in Table 3.

Lastly, the proportion of delayed fluorescence components to the total luminescence component in Film SE1_FE1 was divided by the proportion of delayed fluorescence components to the total luminescence component in Film FE1 to evaluate DF^{SE+FE} / DF^{FE} for a combination of Compounds HTH3, SE1, and FE1, and the results are shown in Table 3. Using the same method, DF^{SE+FE} / DF^{FE} for the remaining combination was evaluated, and the results are shown in Table 3.

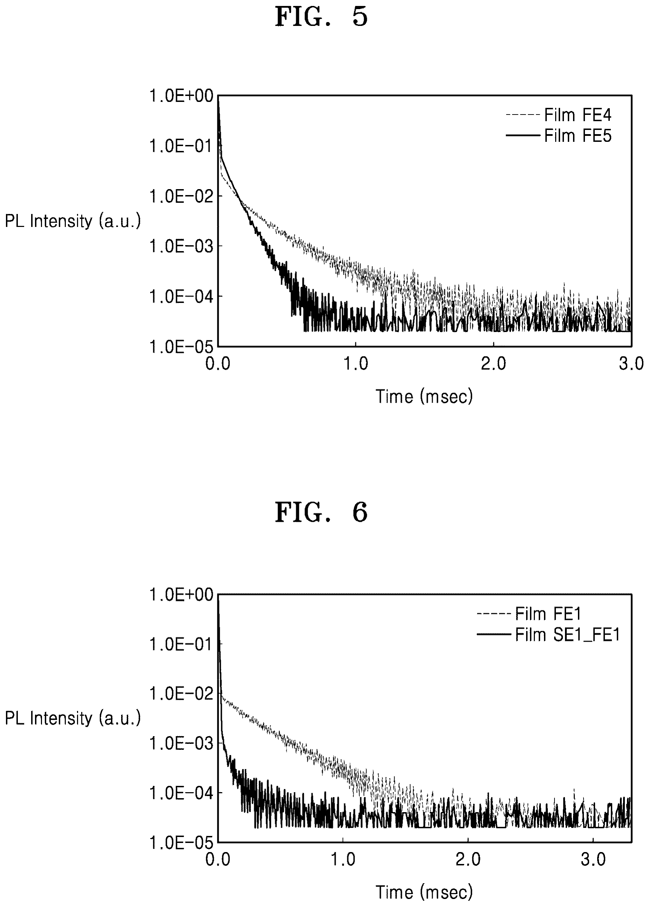

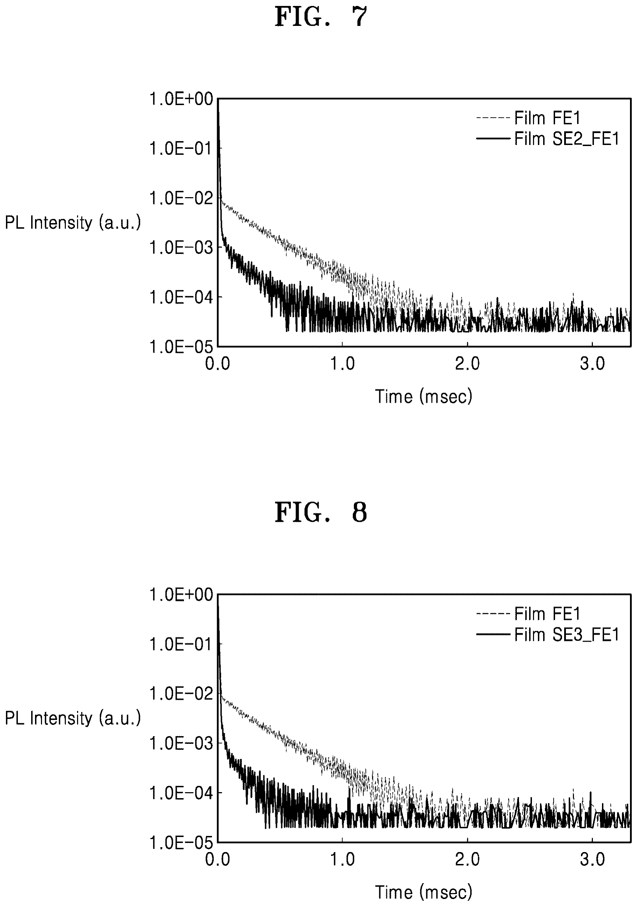

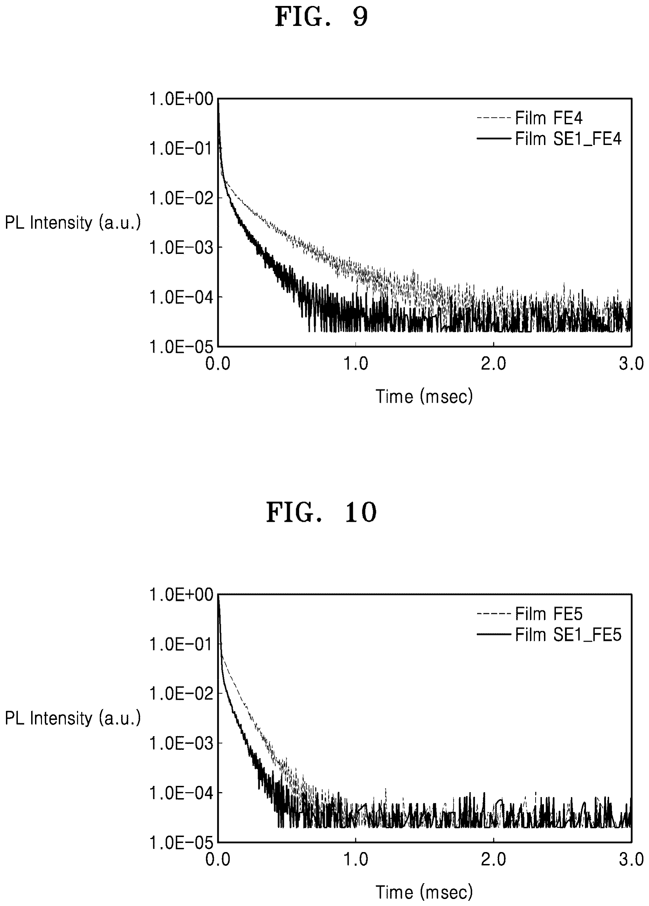

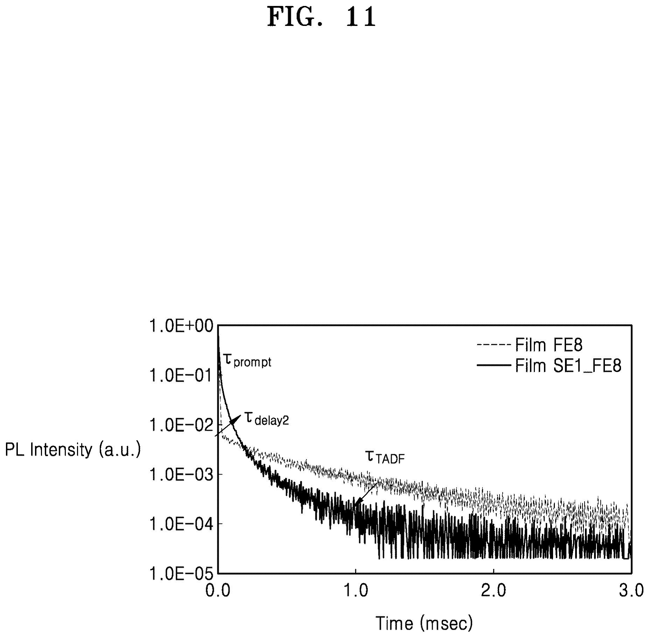

FIG. 4 shows the TRPL spectrum of Film FE1, FIG. 5 shows the TRPL spectra of Films FE4 and FE5, FIG. 6 shows the TRPL spectra of Films FE1 and SE1_FE1, FIG. 7 shows the TRPL spectra of Films FE1 and SE2_FE1, FIG. 8 shows the TRPL spectra of Films FE1 and SE3_FE1, FIG. 9 shows the TRPL spectra of Films FE4 and SE1_FE4, FIG. 10 shows the TRPL spectra of Films FE5 and SE1_FE5, and FIG. 11 shows the TRPL spectra of Films FE8 and SE1_FE8.

**Table 3**

| Film No. | Film composition | DT^{FE} (µs) | DF^{FE} (%) | Film No. | Film composition (co-deposited weight ratio) | DF^{SE+FE} (%) | DF^{SE+FE} / DF^{FE} |
|---|---|---|---|---|---|---|---|
| FE1 | HTH3 : FE1 | 360 | 44 | SE1_FE1 | HTH3 : SE1 : FE1 (89 : 10 : 1) | 2.06 | 0.05 |
| FE1 | HTH3 : FE1 | 360 | 44 | SE2_FE1 | HTH3 : SE2 : FE1 (89: 10 : 1) | 5.55 | 0.13 |
| FE1 | HTH3 : FE1 | 360 | 44 | SE3_FE1 | HTH3 : SE3 : FE1 (89: 10 : 1) | 2.89 | 0.07 |
| FE2 | HTH3 : FE2 | 379 | 64 | SE1_FE2 | HTH3 : SE1 : FE2 (91 : 7 : 2 ) | 3.66 | 0.06 |
| FE3 | HTH3 : FE3 | 400 | 57 | SE1_FE3 | HTH3 : SE1 : FE3 (91 : 7 : 2) | 10.53 | 0.18 |
| FE4 | HTH3 : FE4 | 152 | 58 | SE1_FE4 | HTH3 : SE1 : FE4 (89: 10: 1) | 34.64 | 0.60 |
| FE5 | HTH3 : FE5 | 81 | 47 | SE1_FE5 | HTH3 : SE1 : FE5 (92 : 7 : 1) | 11.79 | 0.25 |
| FE6 | HTH3 : FE6 | 524 | 42 | SE1_FE6 | HTH3 : SE1 : FE6 (92 : 7 : 1) | 27.03 | 0.64 |
| FE7 | HTH3 : FE7 | 836 | 50 | SE1_FE7 | HTH3 : SE1 : FE7 (91 : 7: 2) | 40.39 | 0.81 |
| FE8 | HTH3 : FE8 | 475 | 38 | SE1_FE8 | HTH3 : SE1 : FE8 (92 : 7 : 1) | 48.6 | 1.28 |
| FE9 | HTH3 : FE9 | 594 | 36 | SE1_FE9 | HTH3 : SE1 : FE9 (92 : 7 : 1) | 44.66 | 1.24 |
| FE10 | HTH3 : FE10 | 520 | 49 | SE1_FE10 | HTH3 : SE1 : FE10 (91 : 7: 2) | 7.32 | 0.15 |
| FE11 | HTH3 : FE11 | 650 | 10 | SE1_FE11 | HTH3 : SE1 : FE11 ( 91 : 7 : 2 ) | 2.5 | 0.25 |

Referring to Table 3, it was confirmed that
i) the decay time (DT^{FE}) of delayed fluorescence components in each of Films FE1, FE2, FE3, FE10, and FE11 was 200 µs or more, and
ii) a combination of Compounds HTH3, SE1, and FE1, a combination of Compounds HTH3, SE2, and FE1, a combination of Compounds HTH3, SE3, and FE1, a combination of Compounds HTH3, SE1, and FE2, a combination of Compounds HTH3, SE1, and FE3, a combination of Compounds HTH3, SE1, and FE10, and a combination of Compounds HTH3, SE1, and FE11 had DF^{SE+FE} of 20 % or less and DF^{SE+FE} / DF^{FE} of 0.5 or less.

### Manufacture of OLED 1

A glass substrate on which ITO as an anode was deposited at a thickness of 1,500 Å was cut to a size of 50 mm x 50 mm x 0.5 mm, sonicated with isopropyl alcohol and deionized (DI) water, each for 5 minutes, and then cleaned by irradiation with UV and exposure to ozone for 30 minutes. The resulting glass substrate was loaded onto a vacuum deposition apparatus.

Compounds HT3 and F6-TCNNQ were co-deposited at a weight ratio of 98 : 2 on the anode to form a hole injection layer having a thickness of 10 nm, Compound HT3 was deposited on the hole injection layer to form a hole transport layer having a thickness of 150 nm, and Compound HTH1 was vacuum-deposited on the hole transport layer to form an electron-blocking layer having a thickness of 5 nm.

Next, hosts (Compound HTH3 and Compound ETH8), a sensitizer (Compound SE1), and a fluorescent emitter (Compound FE1) were co-deposited at a weight ratio of 89:10:1 on the electron-blocking layer to form an emission layer having a thickness of 40 nm. Here, a weight ratio of Compound HTH3 and Compound ETH8 was adjusted to 75:25.

Next, Compound ET3 was vacuum-deposited on the emission layer to form a hole-blocking layer having a thickness of 5 nm, Compound ET3 and Compound ET-D1 were co-deposited at a volume ratio of 50:50 on the hole-blocking layer to form an electron transport layer having a thickness of 31 nm, and AI was deposited on the electron transport layer to form a cathode having a thickness of 100 nm, thereby completing the manufacture of an organic light-emitting device, OLED1.

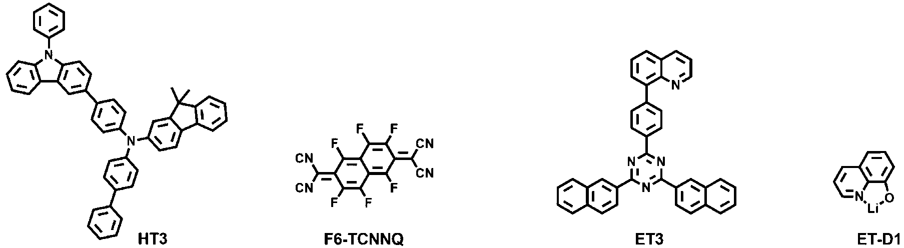

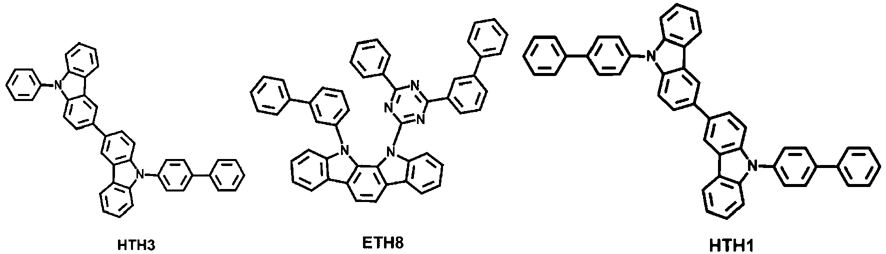

### Manufacture of OLEDs 2 to 11

OLEDs 2 to 11 were manufactured in the same manner as in the manufacture of OLED 1, except that compounds shown in Table 4 were used instead of Compound FE1 as the fluorescent emitter in the emission layer.

### Evaluation Example 3

Regarding each of OLEDs 1 to 11, external quantum efficiency (EQE, %) was evaluated under the luminance and current density conditions described in Tables 4 and 5, and the results are summarized in Tables 4 and 5. As evaluation apparatuses, a current-voltage meter (Keithley 2400) and a luminance meter (Topcon SR3) were used.

**Table 4**

| | Example | Example | Example | Comparative Example | Comparative Example | Comparative Example | Comparative Example | Comparative Example | Comparative Example | Example | Example |
|---|---|---|---|---|---|---|---|---|---|---|---|
| OLED No. | 1 | 2 | 3 | 4 | 5 | 6 | 7 | 8 | 9 | 10 | 11 |
| Fluorescent emitter | FE1 | FE2 | FE3 | FE4 | FE5 | FE6 | FE7 | FE8 | FE9 | FE10 | FE11 |
| DT^{FE} (µs) | 360 | 379 | 400 | 152 | 81 | 524 | 836 | 475 | 594 | 520 | 650 |
| DF^{SE+FE} (%) | 2.06 | 3.66 | 10.53 | 34.64 | 11.79 | 27.03 | 40.39 | 48.6 | 44.66 | 7.32 | 2.5 |
| DF^{SE+FE} / DF^{FE} | 0.05 | 0.06 | 0.18 | 0.60 | 0.25 | 0.64 | 0.81 | 1.28 | 1.24 | 0.15 | 0.25 |
| Max EQE (%) | 27.5 | 27.5 | 27.4 | 25.6 | 27.7 | 22.7 | 21.9 | 21.0 | 18.6 | 26.1 | 26.5 |
| EQE at 8,000 nit (%) | 24.3 | 24.1 | 23.7 | 19.3 | 23.8 | 16.9 | 14.8 | 15.1 | 13.7 | 24.1 | 24.0 |
| EQE at 100,000 nit (%) | 19.4 | 19.3 | 17.9 | 13.1 | 16.7 | 10.7 | 10.2 | 10.3 | 9.4 | 19.5 | 19.2 |
| EQE at 500,000 nit (%) | 10.7 | 11.3 | 10.0 | 6.8 | 7.4 | 4.7 | 5.2 | 4.8 | 4.2 | 11.0 | 11.2 |

**Table 5**

| | Example | Example | Example | Comparative Example | Comparative Example | Comparative Example | Comparative Example | Comparative Example | Comparative Example | Example | Example |
|---|---|---|---|---|---|---|---|---|---|---|---|
| OLED No. | 1 | 2 | 3 | 4 | 5 | 6 | 7 | 8 | 9 | 10 | 11 |
| Fluorescent emitter | FE1 | FE2 | FE3 | FE4 | FE5 | FE6 | FE7 | FE8 | FE9 | FE10 | FE11 |
| DT^{FE} (µs) | 360 | 379 | 400 | 152 | 81 | 524 | 836 | 475 | 594 | 520 | 650 |
| DF^{SE+FE} (%) | 2.06 | 3.66 | 10.53 | 34.64 | 11.79 | 27.03 | 40.39 | 48.6 | 44.66 | 7.32 | 2.5 |
| DF^{SE+FE} / DF^{FE} | 0.05 | 0.06 | 0.18 | 0.60 | 0.25 | 0.64 | 0.81 | 1.28 | 1.24 | 0.15 | 0.25 |
| EQE at 1 mA/cm² (%) | 26.3 | 26.2 | 26.1 | 23.8 | 26.3 | 20.9 | 19.2 | 19.5 | 17.4 | 26.1 | 26.1 |
| EQE at 10 mA/cm² (%) | 24.0 | 23.8 | 23.4 | 19.2 | 23.6 | 17.1 | 15.1 | 15.3 | 14.0 | 23.8 | 23.9 |
| EQE at 100 mA/cm² (%) | 19.9 | 19.8 | 19.5 | 14.8 | 18.3 | 12.6 | 11.7 | 11.8 | 10.8 | 19.8 | 19.7 |
| EQE at 1000 mA/cm² (%) | 11.5 | 11.7 | 11.5 | 8.5 | 9.4 | 7.1 | 7.3 | 7.2 | 6.7 | 11.3 | 11.3 |

Referring to Tables 4 and 5, it was confirmed that, under the same luminance and/or current density conditions, OLEDs 1 to 3, 10 and 11 had excellent EQE compared to OLEDs 4 and 6 to 9.

Next, regarding OLEDs 1 to 3, 5, 10 and 11, a standard deviation of EQE by luminance and a standard deviation of EQE by current density were calculated, and the results are summarized in Table 6.

**Table 6**

| | Example | Example | Example | Comparative Example | Example | Example |
|---|---|---|---|---|---|---|
| OLED No. | 1 | 2 | 3 | 5 | 10 | 11 |
| Fluorescent emitter | FE1 | FE2 | FE3 | FE5 | FE10 | FE11 |
| DT^{FE} (µs) | 360 | 379 | 400 | 81 | 520 | 650 |
| DF^{SE+FE} (%) | 2.06 | 3.66 | 10.53 | 11.79 | 7.32 | 2.5 |
| DF^{SE+FE} / DF^{FE} | 0.05 | 0.06 | 0.18 | 0.25 | 0.15 | 0.25 |
| Max EQE (%) | 27.5 | 27.5 | 27.4 | 27.7 | 26.1 | 26.5 |
| EQE at 8,000 nit (%) | 24.3 | 24.1 | 23.7 | 23.8 | 24.1 | 24.0 |
| EQE at 100,000 nit (%) | 19.4 | 19.3 | 17.9 | 16.7 | 19.5 | 19.2 |
| EQE at 500,000 nit (%) | 10.7 | 11.3 | 10.0 | 7.4 | 11.0 | 11.2 |
| Standard deviation of EQE by luminance | 6.34 | 6.08 | 6.57 | 7.72 | 5.81 | 5.83 |
| EQE at 1 mA/cm² (%) | 26.3 | 26.2 | 26.1 | 26.3 | 26.1 | 26.1 |
| EQE at 10 mA/cm² (%) | 24.0 | 23.8 | 23.4 | 23.6 | 23.8 | 23.9 |
| EQE at 100 mA/cm² (%) | 19.9 | 19.8 | 19.5 | 18.3 | 19.8 | 19.7 |
| EQE at 1000 mA/cm² (%) | 11.5 | 11.7 | 11.5 | 9.4 | 11.3 | 11.3 |
| Standard deviation of EQE by current density | 5.64 | 5.51 | 5.50 | 6.45 | 5.64 | 5.66 |

Referring to Table 6, it was confirmed that the standard deviation of EQE by luminance and the standard deviation of EQE by current density for OLEDs 1 to 3, 10 and 11 were each smaller than the standard deviation of EQE by luminance and the standard deviation of EQE by current density for OLED 5.

Therefore, referring to Tables 4 to 6, it was confirmed that
i) OLEDs 1 to 3, 10 and 11 had improved EQE values under the same luminance and current density conditions, compared to OLEDs 4 and 6 to 9,
ii) OLEDs 1 to 3, 10 and 11 had, compared to OLED 5, even EQE values within a specific luminance range (e.g., about 0 nit to about 500,000 nit) and a specific current density range (e.g., about 0 mA/cm² to about 1,000 mA/cm²). In addition, OLEDs 1 to 3, 10 and 11 had improved EQE values within a relatively high luminance (e.g., within a range from about 100,000 nit to about 500,000 nit) and a relatively high current density (e.g., within a range from about 100 mA/cm² to about 1,000 mA/cm²), compared to OLED 5.

Accordingly, it was confirmed that OLEDs 1 to 3, 10 and 11 could exhibit excellent luminescence efficiency evenly within relatively wide luminance range and current density range, compared to OLEDs 4 to 9. In addition, it was confirmed that OLEDs 1 to 3, 10 and 11 could exhibit improved luminescence efficiency at a relatively high luminance and a relatively high current density, compared to OLEDs 4 to 9.

According to the one or more embodiments, a light-emitting device has improved luminescence efficiency characteristics, and thus a high-quality electronic apparatus may be manufactured by using the light-emitting device.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A light-emitting device, comprising:
a first electrode;
a second electrode; and
an interlayer arranged between the first electrode and the second electrode,
wherein the interlayer comprises an emission layer,
wherein the emission layer comprises a host, a sensitizer, and a fluorescent emitter,
the host comprises a first host,
the sensitizer comprises a transition metal,
the fluorescent emitter is metal-free,
DT^{FE} is 200 microseconds or more,
the DT^{FE} is a decay time of a delayed fluorescence component from a time-resolved photoluminescence (TRPL) spectrum of a first film,
the first film is a two-component film comprising the first host and the fluorescent emitter, and
the light-emitting device satisfies at least one of Condition A or Condition B: is 20 % or less ${{DF}^{SE}}^{+ FE}$ $\left({DF}^{SE + FE} / {DF}^{FE}\right)$ is 0.5 or less, wherein, in Condition A and Condition B,
DF^{SE+FE} is a proportion of a delayed fluorescence component to total luminescence components of a second film, as evaluated from a TRPL spectrum of the second film,
the second film is a three-component film comprising the first host, the sensitizer, and the fluorescent emitter, and
DF^{FE} is a proportion of a delayed fluorescence component to total luminescence components of the first film, as evaluated from a TRPL spectrum of the first film.

2. The light-emitting device of claim 1, wherein the DT^{FE} is 200 microseconds to 1,000 microseconds; and/or
wherein the DF^{SE+FE} is 1 % to 12 %; and/or
wherein the (DF^{SE+FE} / DF^{FE}) is 0.01 to 0.3.

3. The light-emitting device of claims 1 or 2, wherein
(S1^{FE} - T1^{FE}) is 0.8 electron volts (eV) or less,
wherein,
S1^{FE} is a lowest excited singlet energy level (eV) of the fluorescent emitter,
T1^{FE} is a lowest excited triplet energy level (eV) of the fluorescent emitter, and
S1^{FE} and T1^{FE} are evaluated from a photoluminescence spectrum of the fluorescent emitter.

4. The light-emitting device of any of claims 1-3, wherein
(S1^{FE} - T1^{FE}) is 0.4 electron volts (eV) or less; or
(S1^{FE} - T1^{FE}) is greater than 0.4 electron volts (eV) and less than or equal to 0.8 electron volts (eV),
wherein,
S1^{FE} is a lowest excited singlet energy level (eV) of the fluorescent emitter,
T1^{FE} is a lowest excited triplet energy level (eV) of the fluorescent emitter, and
S1^{FE} and T1^{FE} are evaluated from a photoluminescence spectrum of the fluorescent emitter.

5. The light-emitting device of any of claims 1-4, wherein the first host is a hole-transporting compound;
preferably wherein the host further comprises a second host, and the second host is an electron-transporting compound.

6. The light-emitting device of any of claims 1-5, wherein
the sensitizer comprises a platinum-containing organometallic compound,
the platinum-containing organometallic compound comprises platinum and a tetradentate ligand bonded to the platinum, and
at least one chemical bond between the platinum and the tetradentate ligand is a platinum-carbon chemical bond, preferably wherein at least one chemical bond between the platinum and the tetradentate ligand is a platinum-oxygen chemical bond.

7. The light-emitting device of any of claims 1-6, wherein
the sensitizer comprises an iridium-containing organometallic compound,
the iridium-containing organometallic compound comprises iridium; and a first ligand, a second ligand, and a third ligand that are each bonded to the iridium,
the first ligand, the second ligand, and the third ligand are each a bidentate ligand bonded to the iridium of the iridium-containing organometallic compound via a nitrogen atom and a carbon atom, and
a) the first ligand, the second ligand, and the third ligand are identical to each other, b) the first ligand and the second ligand are identical to each other, and the second ligand and the third ligand are different from each other, c) the first ligand and the second ligand are different from each other, and the second ligand and the third ligand are identical to each other, or d) the first ligand, the second ligand, and the third ligand are different from each other.

8. The light-emitting device of claim 7, wherein the iridium-containing organometallic compound comprises a benzofuran group, a benzothiophene group, a benzoselenophene group, a benzosilole group, a benzogermole group, a dibenzofuran group, a dibenzothiophene group, a dibenzoselenophene group, a dibenzosilole group, a dibenzogermole group, a naphthobenzofuran group, a naphthobenzothiophene group, a naphthobenzoselenophene group, a naphthobenzosilole group, a naphthobenzogermole group, a phenanthrobenzofuran group, a phenanthrobenzothiophene group, a phenanthrobenzoselenophene group, a phenanthrobenzosilole group, a phenanthrobenzogermole group, an azabenzofuran group, an azabenzothiophene group, an azabenzoselenophene group, an azabenzosilole group, an azabenzogermole group, an azadibenzofuran group, an azadibenzothiophene group, an azadibenzoselenophene group, an azadibenzosilole group, an azadibenzogermole group, an azanaphthobenzofuran group, an azanaphthobenzothiophene group, an azanaphthobenzoselenophene group, an azanaphthobenzosilole group, an azanaphthobenzogermole group, an azaphenanthrobenzofuran group, an azaphenanthrobenzothiophene group, an azaphenanthrobenzoselenophene group, an azaphenanthrobenzosilole group, or an azaphenanthrobenzogermole group, each bonded to the iridium via a carbon atom; or
wherein the iridium-containing organometallic compound comprises a benzimidazole group, a benzoxazole group, a benzthiazole group, a naphthoimidazole group, a naphthoxazole group, a naphthothiazole group, a phenanthroimidazole group, a phenanthrooxazole group, a phenanthrothiazole group, a pyridoimidazole group, a pyridooxazole group, a pyridothiazole group, a pyridine group, a pyrimidine group, a pyrazine group, a pyridazine group, a quinoline group, or an isoquinoline group, each bonded to the iridium via a nitrogen atom.

9. The light-emitting device of any of claims 1-8, wherein
the sensitizer comprises an iridium-containing organometallic compound,
the iridium-containing organometallic compound comprises: iridium; and a first ligand, a second ligand, and a third ligand that are each bonded to the iridium,
the first ligand and the second ligand are each a bidentate ligand bonded to the iridium of the iridium-containing organometallic compound via a nitrogen atom and a carbon atom,
the third ligand is a bidentate ligand bonded to the iridium of the iridium-containing organometallic compound via two oxygen atoms,
the first ligand and the second ligand are identical to or different from each other, and
the iridium-containing organometallic compound comprises a quinoline group, an isoquinoline group, a benzoquinoline group, a benzoisoquinoline group, a naphthoquinoline group, a naphthoisoquinoline group, a thienopyridine group, a benzothienopyridine group, a thienopyrimidine group, a benzothienopyrimidine group, a furopyridine group, a benzofuropyridine group, a furopyrimidine group, or a benzofuropyrimidine group, each bonded to the iridium via a nitrogen atom.

10. The light-emitting device of any of claims 1-9, wherein
the fluorescent emitter comprises:
a) a first ring;
b) a second ring; and
c) a third ring, a fifth ring, or a combination thereof,
wherein each of the first ring and the second ring is a 6-membered ring comprising one boron atom, one nitrogen atom, and four carbon atoms,
the third ring is i) a 6-membered ring comprising one nitrogen atom and five carbon atoms, or ii) a 6-membered ring comprising one nitrogen atom, four carbon atoms, and one silicon atom,
the fifth ring is a condensed ring in which at least one thiophene or at least one furan is condensed with at least one 6-membered ring,
the first ring and the second ring are condensed with each other while sharing a boron atom,
if present, the third ring is condensed with the second ring while sharing a nitrogen atom, and
if present, the fifth ring i) is condensed with the first ring but is not condensed with the second ring, or ii) is condensed with the second ring but is not condensed with the first ring.

11. The light-emitting device of any of claims 1-10, wherein
the fluorescent emitter comprises a compound represented by Formula 3: 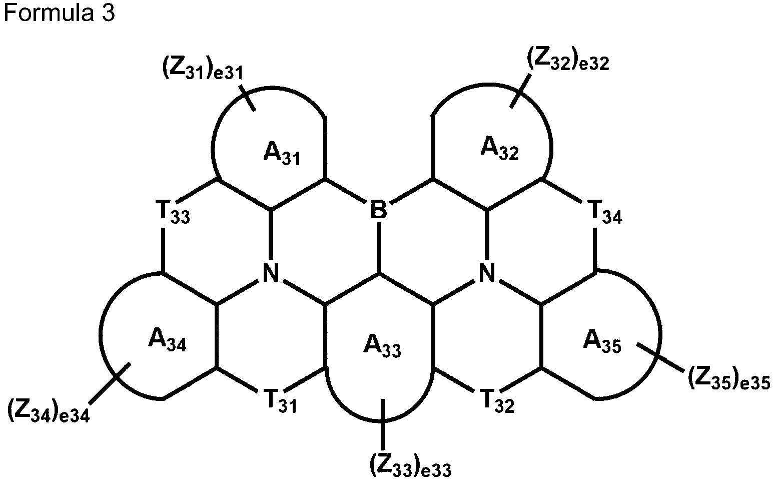 wherein, in Formula 3,
ring A₃₁ to ring A₃₅ are each independently a C₅-C₆₀ carbocyclic group or a C₃-C₆₀ heterocyclic group,
T₃₁ is not present, or is a single bond, O, S, N(R₉₁), C(R₉₁)(R₉₂), or Si(R₉₁)(R₉₂),
T₃₂ is not present, or is a single bond, O, S, N(R₉₃), C(R₉₃)(R₉₄), or Si(R₉₃)(R₉₄),
T₃₃ is not present, or is a single bond, O, S, N(R₉₅), C(R₉₅)(R₉₆), or Si(R₉₅)(R₉₆),
T₃₄ is not present, or is a single bond, O, S, N(R₉₇), C(R₉₇)(R₉₈), or Si(R₉₇)(R₉₈),
Z₃₁ to Z₃₅ and R₉₁ to R₉₈ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
e31 to e35 are each independently an integer from 0 to 10,
at least two of Z₃₁, Z₃₂, Z₃₃, Z₃₄, Z₃₅, R₉₁, R₉₂, R₉₃, R₉₄, R₉₅, R₉₆, R₉₇, and R₉₈ are optionally linked together to form a substituted or unsubstituted C₅-C₃₀ carbocyclic group or a substituted or unsubstituted C₁-C₃₀ heterocyclic group,
substituents of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group are each independently:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), - P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), - Ge(Q₂₃)(Q₂₄)(Q₂₅), -B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof,
Q₁ to Q₉, Q₁₁ to Q₁₉, Q₂₁ to Q₂₉, and Q₃₁ to Q₃₉ are each independently a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with deuterium, -F, a cyano group, a C₁-C₆₀ alkyl group, a C₆-C₆₀ aryl group, or a combination thereof,
Formula 3 satisfies at least one of Condition 3a or Condition 3b:
Condition 3a
in Formula 3, T₃₂ is C(R₉₃)(R₉₄) or Si(R₉₃)(R₉₄)
Condition 3b
in Formula 3, at least one of ring A₃₁ or ring A₃₂ is each independently a condensed ring in which at least one thiophene or at least one furan is condensed with at least one 6-membered ring.

12. The light-emitting device of claim 11, wherein
Formula 3 satisfies Condition 3a, and
i) R₉₃ and R₉₄ are each a substituted or unsubstituted C₁-C₆₀ alkyl group, or
ii) R₉₃ and R₉₄ are each independently a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and R₉₃ and R₉₄ are optionally linked to each other via a single bond, a di(C₁-C₁₀ alkyl)methylene group, a di(C₆-C₁₀ aryl)methylene group, O, or S, wherein at least one hydrogen in the di(C₁-C₁₀ alkyl)methylene group and the di(C₆-C₁₀ aryl)methylene group is optionally substituted with deuterium.

13. The light-emitting device of claims 11 or 12, wherein
Formula 3 satisfies Condition 3b, and
at least one of ring A₃₁ or ring A₃₂ is a benzothiophene group, or a benzofuran group.

14. The light-emitting device of any of claims 1-13, wherein
the interlayer comprises:
light emitting units in the number of m, each comprising at least one emission layer; and
m-1 charge generation layers arranged between every two adjacent light emitting units among the light emitting units in the number of m,
m is an integer of 2 or more, and
at least one of the light emitting units in the number of m comprises the emission layer of claim 1.

15. An electronic apparatus, comprising the light-emitting device of any of claims 1-14.
